(19) Europäisches Patentamt / European Patent Office / Office européen des brevets

(11) **EP 1 962 493 B1**

(12) **EUROPÄISCHE PATENTSCHRIFT**

(45) Veröffentlichungstag und Bekanntmachung des Hinweises auf die Patenterteilung:
**19.04.2017   Patentblatt 2017/16**

(51) Int Cl.:
***H04N 5/217*** *(2011.01)*

(21) Anmeldenummer: **07022632.9**

(22) Anmeldetag: **21.11.2007**

(54) **Pixelzelle, Verfahren zum Betreiben einer Pixelzelle, Verfahren zum Bestimmen einer Position eines Maximums einer Hüllkurve eines analogen amplitudenmodulierten Signals, Vorrichtung zum Bestimmen einer Ladungsmenge, Vorrichtung und Verfahren zum Bestimmen einer Ladungsmenge auf einem kapazitiven Element, Vorrichtung und Verfahren zum Setzen eines Schaltungsknotens auf eine vorbestimmte Spannung, Vorrichtung und Verfahren zum ladungsbasierten Analog-/Digital-Wandeln und Vorrichtung und Verfahren zur ladungsbasierten Signalverarbeitung**

Pixel cell, method for operating a pixel cell, method for determining the position of the maximum on the envelope of an analogue amplitude modulation signal, device for determining a load, device and method for determining the load of a capacitive element, device and method for setting a circuit node to a predetermined voltage, device and method for charge-based analogue/digital transformation and device and method for charge-based signal processing

Cellule de pixel, procédé d'utilisation d'une cellule de pixel, procédé de détermination d'une position du maximum d'une enveloppante d'un signal analogique à amplitude modulée, dispositif de détermination d'une quantité de charge, dispositif et procédé de détermination d'une quantité de charge sur un élément capacitif, dispositif, procédé et fixation d'un noeud de circuit sur une tension préréglée, dispositif et procédé de conversion analogue-numérique basée sur la charge et dispositif et procédé de traitement de signal basé sur la charge

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **24.02.2007   DE 102007009146**
**29.06.2007   DE 102007030315**
**06.08.2007   DE 102007036973**

(43) Veröffentlichungstag der Anmeldung:
**27.08.2008   Patentblatt 2008/35**

(73) Patentinhaber: **Fraunhofer-Gesellschaft zur Förderung der angewandten Forschung e.V.**
**80686 München (DE)**

(72) Erfinder: **Döge, Jens**
**01279 Dresden (DE)**

(74) Vertreter: **Schenk, Markus**
**Schoppe, Zimmermann, Stöckeler**
**Zinkler, Schenk & Partner mbB**
**Patentanwälte**
**Radlkoferstrasse 2**
**81373 München (DE)**

(56) Entgegenhaltungen:
**US-A- 4 166 980          US-A- 5 581 252**
**US-A1- 2002 012 405     US-B1- 6 243 034**

- **ZHENG YANG ET AL: "A CMOS Linear Voltage/Current Dual-Mode Imager" 2006 IEEE INTERNATIONAL SYMPOSIUM ON CIRCUITS AND SYSTEMS 21-24 MAY 2006 ISLAND OF KOS, GREECE, IEEE - PISCATAWAY, NJ, USA LNKD-DOI:10.1109/ISCAS.2006.1693399, 21. Mai 2006 (2006-05-21), Seiten 3574-3577, XP010939324 ISBN: 978-0-7803-9389-9**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- COULOMBE J ET AL: "Variable resolution CMOS current mode active pixel sensor" CIRCUITS AND SYSTEMS, 2000. PROCEEDINGS. ISCAS 2000 GENEVA. THE 2000 I EEE INTERNATIONAL SYMPOSIUM ON MAY 28-31, 2000, PISCATAWAY, NJ, USA, IEEE, Bd. 2, 28. Mai 2000 (2000-05-28), Seiten 293-296, XP010502719 ISBN: 978-0-7803-5482-1
- AKAHANE N ET AL: "A 200dB Dynamic Range Iris-less CMOS Image Sensor with Lateral Overflow Integration Capacitor using Hybrid Voltage and Current Readout Operation" DIGEST OF TECHNICAL PAPERS / 2006 IEEE INTERNATIONAL SOLID-STATE CIRCUITS CONFERENCE : SAN FRANCISCO, CA, 5 - 9 FEBRUARY 2006, IEEE SERVICE CENTER, PISCATAWAY, NJ , US LNKD-DOI:10.1109/ISSCC.2006.1696161, 6. Februar 2006 (2006-02-06), Seiten 1161-1170, XP010940505 ISBN: 978-1-4244-0079-9
- TRIMPL M ET AL: "A fast readout using switched current techniques for a DEPFET-pixel vertex detector at TESLA" NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL LNKD-DOI:10.1016/S0168-9002(03)01803-5, Bd. 511, Nr. 1-2, 21. September 2003 (2003-09-21), Seiten 257-264, XP004451048 ISSN: 0168-9002
- ERIC R FOSSUM: "CMOS Image Sensors: Electronic Camera-On-A-Chip" IEEE TRANSACTIONS ON ELECTRON DEVICES, IEEE SERVICE CENTER, PISACATAWAY, NJ, US, Bd. 44, Nr. 10, 1. Oktober 1997 (1997-10-01), XP011016264 ISSN: 0018-9383
- HUANG Y ET AL: "CURRENT-MODE CMOS IMAGE SENSOR USING LATERAL BIPOLAR PHOTOTRANSISTORS" IEEE TRANSACTIONS ON ELECTRON DEVICES, IEEE SERVICE CENTER, PISCATAWAY, NJ, US LNKD-DOI:10.1109/TED.2003.820123, Bd. 50, Nr. 12, 1. Dezember 2003 (2003-12-01), Seiten 2570-2573, XP001186546 ISSN: 0018-9383
- MCCREARY J L ET AL: "All-MOS CHARGE REDISTRIBUTION ANALOG-TO-DIGITAL CONVERSION TECHNIQUES-PART I" IEEE JOURNAL OF SOLID-STATE CIRCUITS, IEEE SERVICE CENTER, PISCATAWAY, NJ, US LNKD-DOI:10.1109/JSSC.1975.1050629, Bd. SC-10, Nr. 6, 1. Dezember 1975 (1975-12-01), Seiten 371-379, XP000916718 ISSN: 0018-9200
- PING WAI LI ET AL: "A RATIO-INDEPENDENT ALGORITHMIC ANALOG-TO-DIGITAL CONVERSION TECHNIQUE" IEEE JOURNAL OF SOLID-STATE CIRCUITS, IEEE SERVICE CENTER, PISCATAWAY, NJ, US LNKD-DOI:10.1109/JSSC.1984.1052233, Bd. 19, Nr. 6, 1. Dezember 1984 (1984-12-01), Seiten 828-836, XP001146644 ISSN: 0018-9200
- SUAREZ R E ET AL: "ALL.MOS CHARGE REDISTRIBUTION ANALOG-TO DIGITAL-CONVERSION TECHNIQUES-PART II" IEEE JOURNAL OF SOLID-STATE CIRCUITS, IEEE SERVICE CENTER, PISCATAWAY, NJ, US LNKD-DOI:10.1109/JSSC.1975.1050630, Bd. SC-10, Nr. 6, 1. Januar 1975 (1975-01-01), Seiten 379-385, XP000916717 ISSN: 0018-9200
- MCCHARLES R H ET AL: "An Algorithmic Analog-to-Digital Converter" IEEE INTERNATIONAL SOLID STATE CIRCUITS CONFERENCE, IEEE SERVICE CENTER, NEW YORK, NY, US, [Online] 17. Februar 1977 (1977-02-17), Seiten 96-97, XP002487067 ISSN: 0193-6530 Gefunden im Internet: URL:http://ieeexplore.ieee.org/iel6/8292/2 5924/01155701.pdf?tp=&isnumber= &arnumber=1155701> [gefunden am 1977-02-17]
- Ignjatovic, Z., Bocko, M.F.: "A 0.88nW/pixel, 99.6 dB Linear-Dynamic-Range Fully-Digital Image Sensor Employing a Pixel-Level Sigma-Delta ADC", VLSI Circuits, 2006. Digest of Technical Papers. 2006 Symposium on CONFJO - VLSI Circuits, 2006. Digest of Technical Papers. 2006 Symposium on, 2006, pages 23-24, DOI: 10.1109/VLSIC.2006.1705293 ISBN: 1-4244-0006-6 Retrieved from the Internet: URL:http://ieeexplore.ieee.org/xpls/abs_al l.jsp?arnumber=1705293&tag=1 [retrieved on 2015-04-29]
- PAIN B ET AL: "LOW-POWER LOW-NOISE ANALOG CIRCUITS FOR ON-FOCAL-PLANE SIGNAL PROCESSING OF INFRARED SENSORS", PROCEEDINGS OF SPIE, S P I E - INTERNATIONAL SOCIETY FOR OPTICAL ENGINEERING, US, vol. 1946, 14 April 1993 (1993-04-14), pages 365-374, XP000578669, ISSN: 0277-786X, DOI: 10.1117/12.158688 ISBN: 978-1-62841-388-5
- SATOMI OGAWA ET AL: "A SWITCHED-CAPACITOR SUCCESSIVE-APPROXIMATION A/D CONVERTER", IEEE TRANSACTIONS ON INSTRUMENTATION AND MEASUREMENT, IEEE SERVICE CENTER, PISCATAWAY, NJ, US, vol. 42, no. 4, 1 August 1993 (1993-08-01) , pages 847-853, XP000399902, ISSN: 0018-9456, DOI: 10.1109/19.234496
- PEIZERAT A ET AL: "Pixel-level ADC by small charge quantum counting", ELECTRONICS, CIRCUITS AND SYSTEMS, 2006. ICECS '06. 13TH IEEE INTERNAT IONAL CONFERENCE ON, IEEE, PI, 1 December 2006 (2006-12-01), pages 423-426, XP031111516, ISBN: 978-1-4244-0394-3
- AZIZ PERVEZ M ET AL: "An Overview of Sigma-Delta Converter", IEEE SIGNAL PROCESSING MAGAZINE, IEEE SERVICE CENTER, PISCATAWAY, NJ, US, 1 January 1996 (1996-01-01), pages 61-84, XP002683448, ISSN: 1053-5888, DOI: 10.1109/79.482138

**Beschreibung**

Vorrichtung und Verfahren zum Bestimmen einer Ladungsmenge auf einem kapazitivem Element.

Die vorliegende Erfindung bezieht sich auf die im Titel genannten Aspekte.

In der Bildverarbeitung, zum Beispiel in der Weißlichtinterferometrie nach Michelson zur Vermessung von Oberflächen von Objekten, bestehen hohe Anforderungen an die Erfassung und/oder Verarbeitung von Bildinformationen. Aber auch in anderen Bereichen, in denen Sensoren große Mengen an Daten erzeugen, ist deren schnelle und effiziente Verarbeitung wünschenswert.

Die Abhandlung "A 0,88W/pixel, 99,6 dB Linear-Dynamic-Range Fully-Digital Image Sensor Employing a Pixel-Level Sigma-Delta ADC", Z. Ignjatovic, M. F. Bocko, beschreibt eine Pixelzelle mit einem integrierten $\Sigma\Delta$ AD-Wandler in dem die Rückkopplung durch den DAC eine Zufuhr von einem positiven Ladungen in die Photodiode bewirkt, um die Ladungsmenge auf der Photodiode zu messen.

Zusammenfassung

Die Erfindung schafft eine Vorrichtung zum Bestimmen einer Ladungsmenge auf einem kapazitivem Element nach Anspruch 1 und ein Verfahren zum Bestimmen einer Ladungsmenge auf einem kapazitivem Element nach Anspruch 8.

Ein Ausführungsbeispiel der vorliegenden Erfindung bezieht sich auf eine ladungsbasierte analog-digitale Signalverarbeitung am Beispiel eines schnellen CMOS-Bildsensors (Complementary Metal Oxide Semiconductor) mit integrierter Vorverarbeitung.

Dieses Ausführungsbeispiel enthält verschiedene Aspekte, die im Folgenden kurz aufgeführt werden.

Ein Aspekt der vorliegenden Anmeldung betrifft eine Pixelzelle mit: einem Ausgang; einem Photosensor, der ausgebildet ist, um abhängig von einer Strahlung in einem ersten Messzyklus einen ersten Messstrom und in einem zweiten Messzyklus einen zweiten Messstrom zu erzeugen; einem Ausgangsknoten; einer Stromspeichervorrichtung, die so ausgebildet ist, dass in einem ersten Betriebsmodus ein Strom durch die Stromspeichervorrichtung abhängig von dem ersten Messstrom einprägbar ist, und dass in einem zweiten Betriebsmodus die Stromspeichervorrichtung ausgebildet ist, den eingeprägten Strom zu halten, so dass der eingeprägte Strom an dem Ausgangsknoten erfassbar ist; und einer Schalteinheit, die ausgebildet ist, um in einem Auslesezyklus eine Differenz des eingeprägten Stroms und des zweiten Messstroms an dem Ausgangsknoten zu bilden und den Ausgangsknoten mit dem Ausgang zu koppeln.

Ein Aspekt der vorliegenden Anmeldung schafft ferner eine Pixelzelle mit: einem Ausgang; einem Photosensor, der ausgebildet ist, um abhängig von einer Strahlung in einem Messzyklus einen Messstrom zu erzeugen; einem Ausgangsknoten; einer Stromspeichervorrichtung, die so ausgebildet ist, dass in einem ersten Betriebsmodus durch die Stromspeichervorrichtung ein Strom abhängig von dem Messstrom einprägbar ist, und dass in einem zweiten Betriebsmodus die Stromspeichervorrichtung ausgebildet ist, den eingeprägten Strom zu halten, so dass der eingeprägte Strom an dem Ausgangsknoten erfassbar ist; und einer Schalteinheit, die ausgebildet ist, um in einem Auslesezyklus den eingeprägten Strom mit umgekehrten Vorzeichen an dem Ausgangsknoten zu bilden und den Ausgangsknoten mit dem Ausgang zu koppeln.

Zudem betrifft ein Aspekt der vorliegenden Anmeldung ein Verfahren zum Bestimmen einer Position eines Maximums einer Hüllkurve eines analogen amplitudenmodulierten Signals, mit: Abtasten des amplitudenmodulierten Signals, um eine Folge von analogen Abtastwerten zu erzeugen; Erzeugen einer Folge von analogen Differenzwerten, wobei ein analoger Differenzwert der Folge von analogen Differenzwerten auf einer Differenz zweier aufeinanderfolgender analoger Abtastwerte der Folge von analogen Abtastwerten basiert; Digitalisieren der analogen Differenzwerte, um eine Folge von digitalen Differenzwerten zu erzeugen; und Bestimmen der Position des Maximums der Hüllkurve basierend auf der Folge von digitalen Differenzwerten.

Die vorliegende Anmeldung betrifft eine Vorrichtung und ein Verfahren zum Bestimmen einer Ladungsmenge auf einem kapazitivem Element nach den Ansprüchen 1 und 14

Außerdem schafft ein Aspekt der vorliegenden Erfindung eine Vorrichtung zum Setzen eines Schaltungsknotens auf eine vorbestimmte Spannung; mit: einer Einrichtung zum Vergleichen einer Spannung an dem Schaltungsknoten mit einer Referenzspannung; einer Einrichtung zum Bewirken einer Ladungszufuhr/-Abfuhr zu/von dem Schaltungsknoten bis der Vergleich ergibt, dass die Spannung an dem Schaltungsknoten eine vorbestimmte Beziehung zu der vorbestimmten Spannung aufweist.

Daneben betrifft ein Aspekt der vorliegenden Anmeldung eine Vorrichtung zum Setzen eines Schaltungsknotens auf eine vorbestimmte Spannung; mit: einer Einrichtung zum Vergleichen einer Spannung an dem Schaltungsknoten mit einer Referenzspannung; einem inneren kapazitiven Element; einer Treiberstufe, wobei der Schaltungsknoten mit einem Ausgang der Treiberstufe gekoppelt ist und das innere kapazitive Element mit einem Eingang der Treiberstufe gekoppelt ist; einer Einrichtung zum Bewirken einer Ladungszufuhr/-Abfuhr zu/von dem inneren kapazitiven Element bis der Vergleich ergibt, dass die Spannung an dem Schaltungsknoten eine vorbestimmte Beziehung zu der vorbestimmten Spannung aufweist.

Außerdem betrifft ein Aspekt der vorliegenden Anmeldung eine Vorrichtung zum Bestimmen einer Ladungsmenge auf einem kapazitiven Element, mit: einer Einrichtung zum Vergleichen einer Spannung an dem kapazitivem Element mit einer Referenzspannung; einer Einrichtung zum Bewirken einer Ladungszufuhr/-abfuhr zu/von dem kapazitiven Element; einer Einrichtung zum Rückschließen auf die Ladung auf dem kapazitiven Element auf Basis der Ladungszufuhr/-abfuhr und dem Vergleich der Spannung; und einer Vorrichtung zum Setzen des kapazitiven Elements auf eine vorbestimmte Spannung.

Ein Aspekt der vorliegenden Anmeldung betrifft eine Vorrichtung zur ladungsbasierten Signalverarbeitung mit: einem kapazitiven Element; einem ersten Ladungsgeber; einem zweiten Ladungsgeber ; einer Ladungsgebersteuerung, zum Koppeln des ersten Ladungsgebers und/oder zweiten Ladungsgebers mit dem kapazitiven Element; einer Vorrichtung zum Bestimmen einer Ladungsmenge auf dem kapazitivem Element.

Zudem betrifft ein Aspekt der vorliegenden Anmeldung eine Vorrichtung zur ladungsbasierten Signalverarbeitung mit: einer ersten Leitung; einer zweiten Leitung; Vorrichtung zum Setzen der zweiten Leitung auf eine vorbestimmte Spannung, einem ersten Ladungsgeber mit einem Ausgangsknoten; einem zweiten Ladungsgeber mit einem Ausgangsknoten; einer Ladungsgebersteuerung, zum Koppeln eines Ausgangsknotens des ersten Ladungsgebers und/oder eines Ausgangsknotens des zweiten Ladungsgebers mit der ersten Leitung und/oder zweiten Leitung; und einer Vorrichtung zum Bestimmen einer Ladungsmenge auf der ersten Leitung.

Ein Aspekt der vorliegenden Anmeldung ist eine Pixelzelle mit: einem Photosensor, der ausgebildet ist, um abhängig von einer Strahlung eine Spannung über dem Photosensor zu erzeugen; einem Kondensator; einem ersten Transistor, der ausgebildet ist, die in dem Photosensor erzeugte Spannung an dem Kondensator anzulegen, um die Spannung durch den Kondensator zu speichern; einem zweiten Transistor, der ausgebildet ist, um die Spannung an dem Kondensator auf eine Rücksetzspannung zurückzusetzen; einem dritten Transistor, dessen Gate mit dem Kondensator gekoppelt ist, und der ausgebildet ist, abhängig von einer an dem Kondensator anliegenden Spannung einen Drainstrom an einem Drainausgang des dritten Transistors zu erzeugen; einem vierten Transistor, der ausgebildet ist, den Drainausgang mit einem Ausgang zu koppeln; und einem fünften Transistor, der ausgebildet ist, wahlweise die Spannung über dem Photosensor auf ein gegebenes Referenzpotential zurückzusetzen oder von dem gegebenen Referenzpotential zu entkoppeln.

Die vorgenannten Aspekte der Anmeldung ermöglichen alleine oder in Kombination eine effizientere Erfassung von Daten und/oder Verarbeitung von Daten.

Kurzbeschreibung der Figuren

Ausführungsbeispiele und Aspekte der vorliegenden Anmeldung werden nachfolgend unter Bezugnahme auf beiliegende Zeichnungen näher erläutert.

Fig. 1 zeigt ein Signaldomänen bei ladungsbasierter Signalverarbeitung.

Fig. 2 zeigt ein Schaltungselement gepulste ideale Stromquelle.

Fig. 3 zeigt Ladung auf einem Kondensator.

Fig. 4 zeigt ein Architekturkonzept für Bildsensoren mit ladungsbasiertem analogem Datenpfad.

Fig. 5 zeigt einen Auslesepfad des Bildsensors mit ladungsbasiertem analogen Datenpfad.

Fig. 6 zeigt eine Prinzipschaltung einer bipolaren gepulsten Stromquelle mit Last.

Fig. 7 zeigt eine Ansteuerung der Ladungsquelle im gekoppelten (a) und ungekoppelten Betrieb (b) mit dem Aktivierungseingang $S_Q$ für den ausgewählten Quellenblock dem Eingang $S_{Set}$, zum Vorladen der internen Kapazität und dem Eingang $S_{Out}$ zur Ausgabe der Ladung.

Fig. 8 zeigt einen einfachen Stromspiegel.

Fig. 9 zeigt einen Kaskode-Stromspiegel.

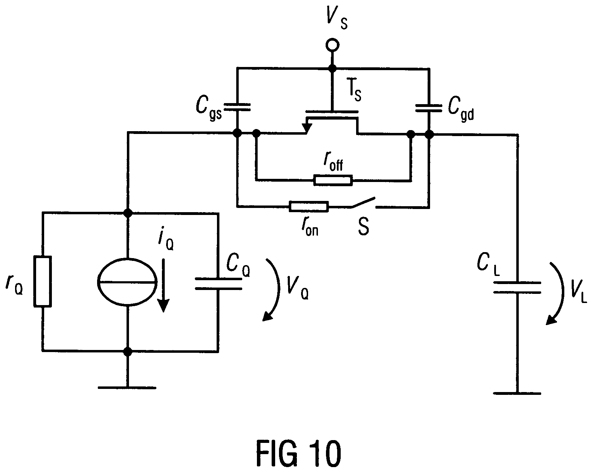

Fig. 10 zeigt ein Ersatzschaltbild für die Anordnung mit Stromquelle, Transistorschalter und Lastkapazität.

Fig. 11 zeigt eine Prinzipschaltung einer einfachen Stromspeicherzelle (SI-Zelle).

Fig. 12 zeigt eine SI-Zelle im Pixel.

Fig. 13 zeigt eine Schaltung (a) und statische Übertragungsfunktion (b) eines Ladungs-Komparators.

Fig. 14 zeigt eine Prinzipschaltung des AD-Teils des ladungsbasierten Auslesepfades.

Fig. 15 zeigt eine Transistorschaltung des Komparators.

Fig. 16 zeigt ein Taktdiagramm für den Wandlungszyklus eines zählenden CP-ADC mit einer Auflösung von 5 Bit.

Fig. 17 zeigt ein Taktdiagramm für den Wandlungszyklus eines dreistufigen kombinierten CP-ADC mit sukzessiver Approximation und Zählen.

Fig. 18 zeigt einen Querschnitt eines p-Kanal Photo-FET (a) und Grundschaltung (b) einer Pixelzelle für den kontinuierlichen Betrieb.

Fig. 19 zeigt eine Grundschaltung der Pixelzelle mit einem Photo-FET in einer mittels Transistor rücksetzbaren Wanne.

Fig. 20 zeigt eine Grundschaltung der Pixelzelle mit ladungsbasiertem Reset.

Fig. 21 zeigt eine Simulation des Zeitverlaufs wichtiger Signale beim ladungsbasierten Reset der Pixelzelle.

Fig. 22 zeigt eine Ersatzschaltung für den ladungsbasierten Rücksetzvorgang.

Fig. 23 zeigt eine Photographie eines Speckle-Musters [Wik06].

Fig. 24 zeigt einen schematischer Aufbau eines Weißlicht-Interferometers [Häu91].

Fig. 25 zeigt Spektren thermischer Strahler mit unterschiedlichen Farbtemperaturen und deren mittlere Wellenlänge $\overline{\lambda}$ (visueller Bereich: 380nm...760nm).

Fig. 26 zeigt eine Interferenzmodulation (offsetfrei) $y_H \cdot y_T$ für einen thermischen Strahler mit $T$=6000K ($\overline{\lambda}$=580nm) bei gleicher Dämpfung im Mess- und Referenzarm sowie einer Phasenverschiebung $\varphi = \frac{\pi}{4}$ .

Fig. 27. zeigt eine Zeitfunktion des Photostroms $I_{Ph}$ entsprechend der Bestrahlungsstärke.

Fig. 28 zeigt einen Drainstrom $I_D$ des strahlungsempfindlichen FET und in der SI-Zelle gespeicherter Strom $I_{SI}$, mit der Abtastperiodendauer $\tau_C$ zum Abtastzeitpunkt $t_k$:

$$I_{SI}\left(t_k\right) = I_D\left(t_k - \tau_C\right) + \delta I(t_k) \ .$$

Fig. 29 zeigt einen Pixel-Ausgangsstrom $I_{Pix}$ und Vorzeichen des Anstiegs, sowie Bezugspunkte für die Beschreibung.

Fig. 30 zeigt einen Zählerstand der Wendepunkte.

Fig. 31A zeigt eine FET-Pixelzelle als Ladungsquelle.

Fig. 31B zeigt eine FET-Pixelzelle ähnlich zu Fig. 31A als Stromquelle.

Fig. 32 zeigt einen analogen Datenpfad in der Pixelzelle. Fig. 33 zeigt ein Blockschaltbild des Analogteils.

Fig. 34 zeigt ein Blockschaltbild des Digitalteils.

Fig. 35 A und B zeigen einen gemessenen Signalpegel in Abhängigkeit von der Sample-Nummer (a: komplette Sequenz und b: Interferenz-Ausschnitt) Quelle: [Sch05].

Fig. 36 zeigt eine äquivalente Zeitfunktion des Photostroms $I_{Ph}$.

Fig. 37 zeigt ein Simulationsergebnis für den Pixel-Ausgangsstrom $I_{Pix}$.

Fig. 38 zeigt einen Zählerstand der Nulldurchgänge für die $I_{Pix}$ aus Fig. 37.

Fig. 39A zeigt ein Blockdiagramm eines Aspekts einer Pixelzelle mit einem Photosensor und einer Stromspeichervorrichtung.

Fig. 39B zeigt ein Flussdiagramme eines Aspekts eines Verfahrens zum Betreiben einer Pixelzelle nach Fig. 39A.

Fig. 39C zeigt ein Flussdiagramm eines Aspekts eines weiteren Verfahrens zum Betreiben einer Pixelzelle nach Fig. 39A.

Fig. 40 zeigt ein Flussdiagramm eines Aspekts eines Verfahrens zum Bestimmen einer Position eines Maximums einer Hüllkurve eines analogen Amplitudenmodulierten Signals.

Fig. 41A zeigt ein Blockschaltbild eines Aspekts einer Vorrichtung zum Bestimmen einer Leitungsmenge auf einem kapazitiven Element.

Fig. 41B zeigt ein Flussdiagramm eines Aspekts eines Verfahrens zum Bestimmen einer Ladungsmenge auf einem kapazitiven Element.

Fig. 41C zeigt ein Blockdiagramm eines Aspekts einer Vorrichtung zum Setzen eines Schaltungsknotens auf eine vorbestimmte Spannung.

Fig. 41D zeigt ein Flussdiagramm eines Aspekts eines Verfahrens zum Setzen eines Schaltungsknotens auf eine vorbestimmte Spannung.

Fig. 41E zeigt ein Blockschaltbild eines weiteren Aspekts einer Vorrichtung zum Setzen eines Schaltungsknotens auf eine vorbestimmte Spannung.

Fig. 41F zeigt ein Flussdiagramm des weiteren Aspekts eines Verfahrens zum Setzen eines Schaltungsknotens auf eine vorbestimmte Spannung..

Fig. 41G zeigt ein Blockdiagramm eines Aspekts einer Vorrichtung zum Bestimmen einer Ladungsmenge auf einem kapazitivem Element in Kombination mit einer Vorrichtung zum Setzen des kapazitiven Elements auf eine vorbestimmte Spannung.

Fig. 41H zeigt ein Flussdiagramm eines Aspekts eines weiteren Verfahrens zum Bestimmen einer Ladungsmenge auf einem kapazitivem Element in Kombination mit einem Vorfahren zum Setzen des kapazitiven Elements auf eine vorbestimmte Spannung.

Fig. 41I zeigt ein Blockdiagramm eines Aspekts einer Vorrichtung zur ladungsbasierten Signalverarbeitung mit einem kapazitiven Element, einem ersten und einem zweiten Ladungsgeber, einer Steuerung zum Koppeln des ersten und/oder zweiten Ladungsgebers mit dem kapazitiven Element und einer Vorrichtung zum Bestimmen einer Ladungsmenge auf dem kapazitiven Element.

Fig. 41J zeigt ein Flussdiagramm eines Aspekts eines Verfahrens zur ladungsbasierten Signalverarbeitung mittels einem kapazitiven Element, einem ersten und zweiten Ladungsgebers, mit Koppeln des ersten und/oder zweiten Ladungsgebers mit dem kapazitiven Element und dem Bestimmen einer Ladungsmenge auf dem kapazitiven Element.

Die Fig. 41K zeigt ein Blockschaltbild eines Aspekts einer Vorrichtung zur ladungsbasierten Signalverarbeitung mit einer ersten und einer zweiten Leitung, einer Vorrichtung zum Setzen der zweiten Leitung auf eine vorbestimmte Spannung, einem ersten und zweiten Ladungsgeber, einer Ladungsgebersteuerung zum Koppeln eines Ausgangsknotens des ersten und/oder des zweiten Sensors mit der ersten und/oder zweiten Leitung, und einer Vorrichtung zum Bestimmen einer Ladungsmenge auf der ersten Leitung.

Fig. 41L zeigt ein Flussdiagramms eines Verfahrens zur ladungsbasierten Signalverarbeitung mittels einer ersten und einer zweiten Leitung, einem ersten und zweiten Ladungsgeber, mit einem Setzen der zweiten Leitung auf eine vorbestimmte Spannung, Koppeln eines Ausgangsknotens des ersten und/oder zweiten Sensors mit der zweiten Leitung, Koppeln des Ausgangsknotens des ersten und/oder zweiten Ladungsgebers mit der ersten Leitung, und Bestimmen einer Ladungsmenge auf der ersten Leitung.

Fig. 42 zeigt ein Blockschaltbild einer APS-Pixelzelle (Active Pixel Sensor) mit einem zusätzlichen Transistor zum Rücksetzen eines Spannungspotentials in der Photodiode der Pixelzelle.

Gleiche Bezugszeichen beziehen sich auf gleiche oder ähnliche Elemente bzw. auf Elemente mit gleichen oder ähnlichen Funktionen und/oder Eigenschaften.

Kurzbeschreibung der Tabellen

Tabelle 1 zeigt die Anzahl der Approximationsschritte in Abhängigkeit von der Bitstufenzahl.

Tabelle 2 zeigt Kohärenzlängen typischer thermischer Strahler bzw. einer weißen LED.

Tabelle 3 zeigt Daten von Hochleistungs-LEDs (Luxeon K2) [Lux05].

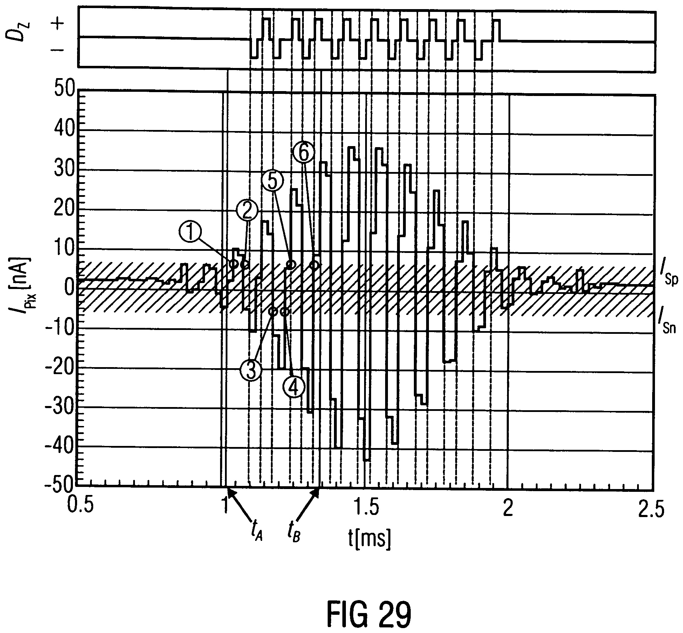

Tabelle 4 zeigt Beispielwerte für die Berechnung der Nulldurchgänge für das Diagramm in Fig. 29.

Tabelle 5 zeigt Parameter des Weißlicht-Interferometer-SoC (teilweise anhand von Simulationen abgeschätzt).

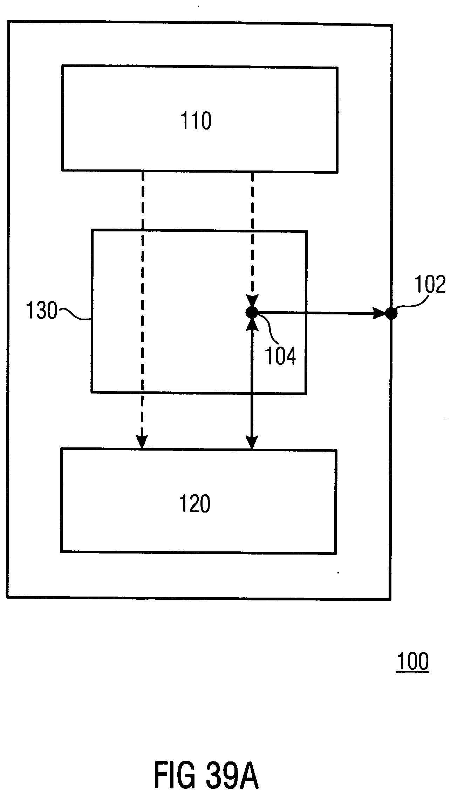

Im Folgenden werden Aspekte der Anmeldung, basierend auf den Figuren 39A bis 42 näher beschrieben.

Die Fig. 39A zeigt ein Blockschaltbild eines Aspekts einer Pixelzelle 100 mit einem Ausgang 102, einem Photosensor 110, einem Ausgangsknoten 104, einer Stromspeichervorrichtung 120 und einer Schalteinheit 130.

Der Photosensor 110 ist ausgebildet, abhängig von einer Strahlung einen Messstrom zu erzeugen. Der Photosensor kann beispielsweise eine Photodiode oder eine photoempfindliche Diodenstruktur in einem Feldeffekttransistor bzw. allgemein ein lichtempfindlicher pn-Übergang sein.

Die Empfindlichkeit des Photosensors bzw. die Höhe der Ladungserzeugung in dem Photosensor ist abhängig von der Strahlung und kann über den Arbeitspunkt des pn-Übergangs bzw. der Photodiode oder des Feldeffekttransistors beeinflusst werden.

Der Photosensor kann in einem kontinuierlichen oder integrierenden Betriebsmodus betrieben werden. Bei dem kontinuierlichen Betriebsmodus wird die durch die Strahlung erzeugte Ladung in dem Photosensor nicht zurückgesetzt. Die durch die Ladung beeinflusste Photospannung des pn-Übergangs verändert sich somit kontinuierlich, abhängig von dem Verlauf der Strahlung, und der daraus resultierende Messstrom, z.B. ein Drainstrom eines lichtempfindlichen Feldeffekttransistors entsprechend auch. In einem integrierenden Betriebsmodus wird die durch die Bestrahlung erzeugte Ladung und damit auch die an dem pn-Übergang anliegende Photospannung zurückgesetzt bevor eine Messung der Strahlung durchgeführt wird. In dem integrierenden Betriebsmodus wird die Ladung in dem Photosensor über eine Messzeit $\tau_{int}$ akkumuliert bzw. integriert, und am Ende dieser Messzeit ein der aufakkumulierten Ladung entsprechender Messstrom, z.B. ein Drainstrom eines lichtempfindlichen Feldeffekttransistors erzeugt. Aspekte eines lichtempfindlichen Feldeffekttransistors bzw. eines Feldeffekttransistors mit einem lichtempfindlichen pn-Übergang werden später ausführlicher beschrieben.

Die Stromspeichervorrichtung 120 ist ausgebildet in einem ersten Betriebsmodus, der auch als Einprägmodus oder Speichermodus bezeichnet werden kann, den Messstrom des Photosensors 110 zu empfangen, beispielsweise über den Ausgangsknoten 104 oder über einen anderen Strompfad (siehe gestrichelte Linien) und kann zwischen einem ersten Betriebsmodus und einem zweiten Betriebsmodus umgeschaltet werden. In dem ersten Betriebsmodus ist die Stromspeichervorrichtung so ausgebildet, dass ein Strom durch die Stromspeichervorrichtung, abhängig von dem ersten Messstrom einprägbar ist. Das Einprägen des Stroms, hier des Messstroms, wird auch als Speichern des Stroms bezeichnet. Dabei kann sowohl die Stromstärke des Messstroms wie auch die Stromrichtung des Messstroms gespeichert werden. In dem zweiten Betriebsmodus, der auch als Ausgabemodus bezeichnet werden kann, ist die Stromspeichervorrichtung 120 ausgewählt, den eingeprägten Strom zu halten.

Ein Beispiel für eine Stromspeichervorrichtung ist eine Stromspeicherzelle, die abgekürzt auch als SI-Zelle bezeichnet wird. Stromspeicherzellen weisen beispielsweise einen Stromquellentransistor und eine mit Spannungswert geladen wird, bei dem durch den Stromquellentransistor ein Source- bzw. Drain-Strom fließt, der dem zuvor gespeicherten bzw. eingeprägten Strom in Stromstärke und Stromrichtung bzw. Vorzeichen entspricht. In dem zweiten Betriebsmodus bzw. Ausgabemodus hält der Speicherkondensator bzw. die Speicherkapazität die aufgeladene Spannung und damit das Gatepotential des Stromquellentransistors auf der während des Speichermodus erreichten Spannung, und bewirkt so, dass durch den Stromquellentransistor weiterhin ein Source- bzw. Drainstrom fließt, der dem zuvor von extern angelegten bzw. einzuprägenden Strom entspricht.

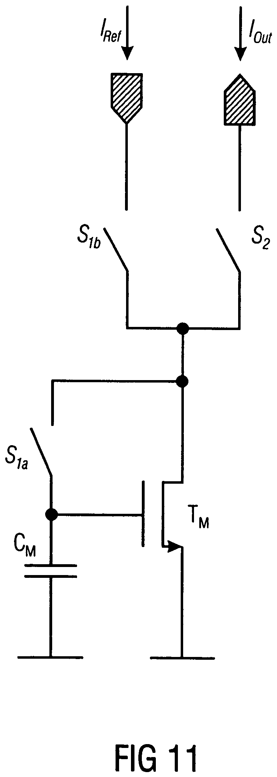

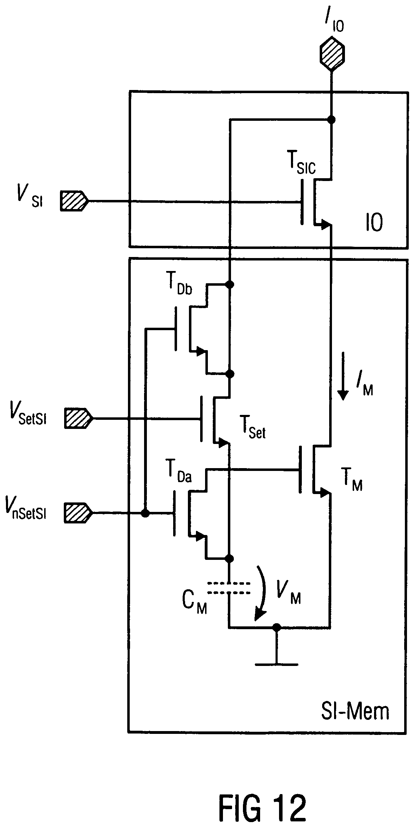

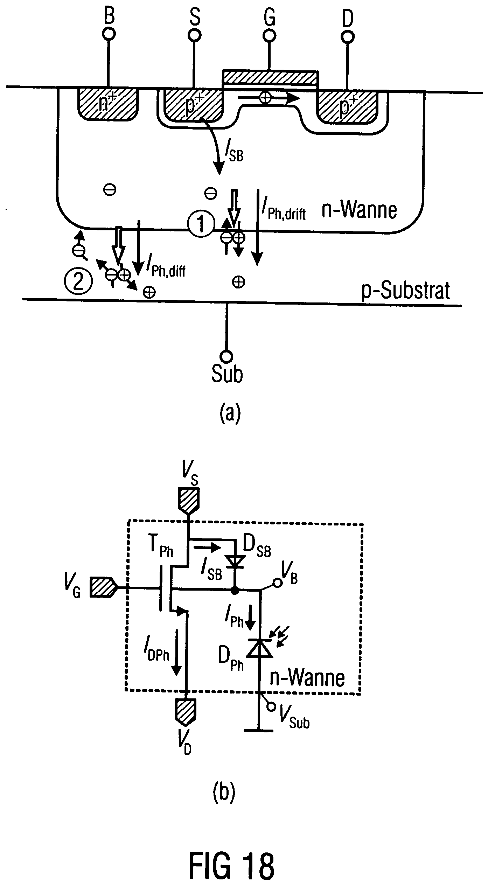

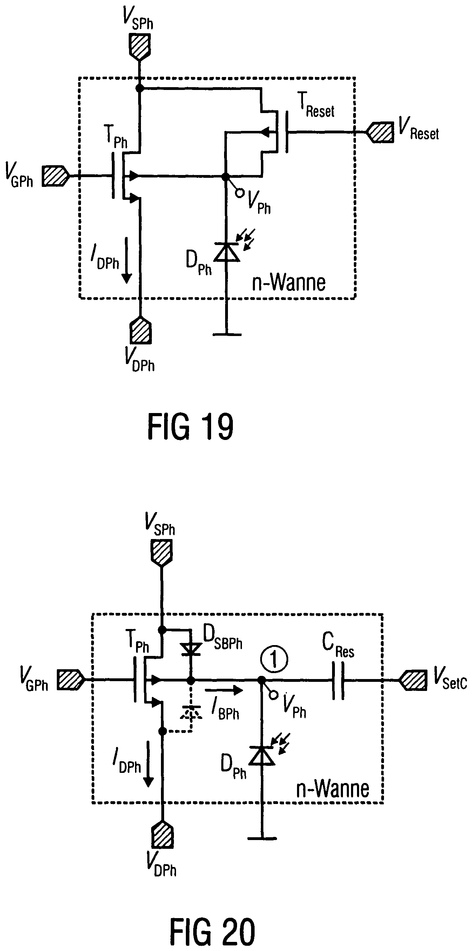

Photosensoren und insbesondere strahlungsempfindliche Feldeffekttransistoren werden näher anhand der Fig. 18 und 19 beschrieben und Stromspeicherzellen anhand der Figuren 11 und 12.

In dem in Fig. 39A gezeigten Aspekt der Pixelzelle wird beispielsweise der durch den Photosensor 110 erzeugte Messstrom in der Stromspeichervorrichtung in einem ersten Betriebsmodus eingeprägt und in dem zweiten Betriebsmodus ein eingeprägter Strom der dem Messstrom entspricht weiter erzeugt, auch nach beispielsweise einem Abschalten des Messstroms.

Die Schalteinheit 130 ist ausgebildet, einen Messstrom des Photosensors 110 und einen von der Stromspeichervorrichtung 120 eingeprägten Strom gleichzeitig an den Ausgangsknoten 104 zu koppeln. So kann beispielsweise in einem ersten Messzyklus in einem Speichermodus ein erster Messstrom $I_{DPh1}$ des Photosensors 110 in der Stromspeichervorrichtung 120 eingeprägt werden und in einem zweiten Messzyklus ein zweiter Messstrom $I_{DPh2}$ durch den Photosensor 110 erzeugt werden und in einem Auslesezyklus der zweite Messstrom und der eingeprägte Strom $I_{M1}$, der dem Messstrom $I_{DPh1}$ des ersten Messzyklus entspricht, an den Ausgangsknoten 104 gekoppelt werden, so dass beispielsweise, wenn die Schalteinheit 130 den Ausgangsknoten 104 zusätzlich mit dem Ausgang 102 koppelt, an dem Ausgangsknoten 104 und dem Ausgang 102 eine Differenz der beiden Ströme, also des ersten und des zweiten Messstroms gebildet wird.

Bei einem alternativen Aspekt kann die Schalteinheit 130 ausgebildet sein, beispielsweise nur den eingeprägten Strom der Stromspeichervorrichtung 120 an den Ausgangsknoten 104 anzulegen bzw. diesen zudem mit dem Ausgang 102 zu koppeln, so dass die Stromspeicherzelle abhängig von der Art der Kopplung den eingeprägten Strom beispielsweise mit gleichem oder ungekehrtem Vorzeichen ausgibt.

Allgemein ausgedrückt, kann die Steuerschaltung 130 ausgebildet sein, den Messstrom $I_{DPh}$ des Photosensors 110 allein mit dem Ausgangsknoten 104 und dem Ausgang 102 zu koppeln, den eingeprägten Strom $I_M$ der Stromspeichervorrichtung 120 allein mit dem Ausgangsknoten 104 und dem Ausgang 102 zu koppeln, oder sowohl einen Messstrom des Photosensors 110 als auch einen eingeprägten Strom der Stromspeichervorrichtung 120 gleichzeitig mit dem Knoten 104 zu koppeln und an dem Ausgang 102 auszugeben. Abhängig von der Art der Kopplung werde dabei die Ströme addiert oder subtrahiert.

Die in Fig. 39A gezeigte Pixelzelle kann sowohl strombasiert wie auch ladungsbasiert betrieben werden.

Bei einem strombasierten Betriebsmodus bzw. strombasierten Signalverarbeitung spielt die Dauer der Ausgabe an den Ausgang 102 bis auf beispielsweise etwaige Einschwingvorgänge keine Rolle, da die an dem Ausgang 102 ausgegebene Stromstärke selbst als Messgröße bzw. Information weiter verarbeitet wird. Entsprechend spielt auch das Spannungspotential des Ausgangsknotens 104 zu dem Zeitpunkt, an dem der Messstrom und/oder der eingeprägte Strom mit dem Ausgangsknoten 104 gekoppelt werden, eine untergeordnete Rolle, da die hier der Messstrom und der eingeprägte Strom nach einem Einschwingen, unabhängig von dem ursprünglichen Spannungspotential des Ausgangsknotens 104 sind, und die Ausgabegröße der Pixelzelle an dem Ausgang 102, nämlich der Strom bzw. die Stromstärke dadurch nur geringfügig beeinflusst wird.

Demgegenüber werden bei dem ladungsbasierten Betriebsmodus bzw. bei der ladungsbasierten Signalverarbeitung der Messstrom und/oder eingeprägte Strom für eine Zeit $\tau_{out}$ mit dem Ausgangsknoten 104 und dem Ausgang 102 gekoppelt und die Information liegt sowohl in der Stromstärke als auch in der der Dauer des Stromflusses, bzw. in der Ladung, die innerhalb der Zeit $\tau_{out}$ durch den Strom an dem Ausgang ausgegeben wird. Bei dem ladungsbasierten Betriebsmodus ist das Spannungspotential vor dem Koppeln des Messstroms und/oder des eingeprägten Stroms mit dem Ausgangsknoten 104 von wesentlicher Bedeutung, da bei der ladungsbasierten Signalverarbeitung die ausgegebene Ladung von dem Potential des Ausgangsknotens 104 vor der Kopplung mit dem Photosensor und/oder der Stromspeichervorrichtung beeinflusst wird bzw. durch diese verschoben wird (Offset).

Bei einem ladungsbasierten Betrieb kann im Gegensatz zu dem strombasierten Betrieb durch eine Änderung der Dauer der Kopplung des Messstroms und/oder des eingeprägten Stroms mit dem Ausgangsknoten 104 und dem Ausgang 102 das Signal gewichtet bzw. verstärkt bzw. geschwächt werden.

Beide Möglichkeiten, die strombasierte und die ladungsbasierte Pixelzelle ermöglichen damit eine analoge Signalverarbeitung in der Pixelzelle selbst, z.B. Differenzbildung oder Invertierung der Ströme oder Ladungen.

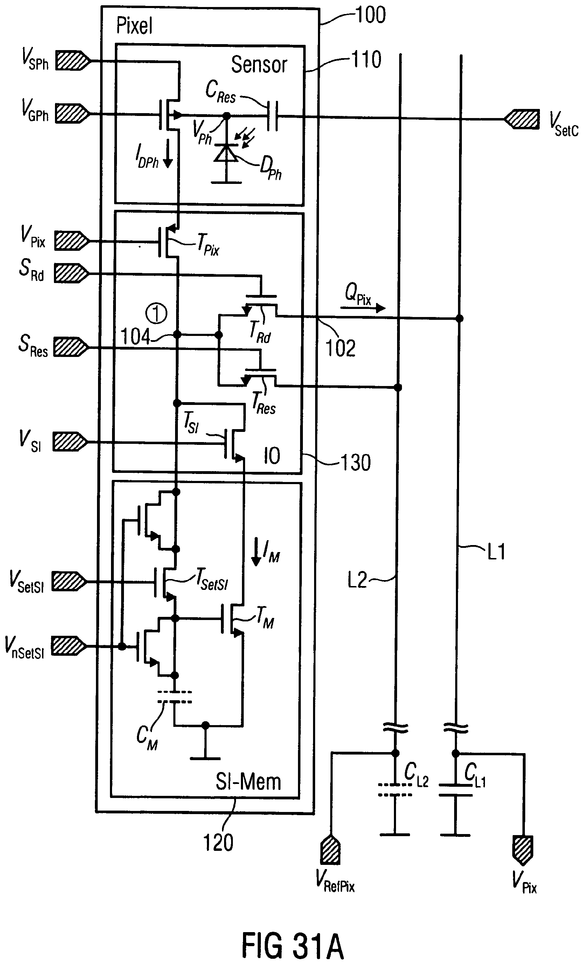

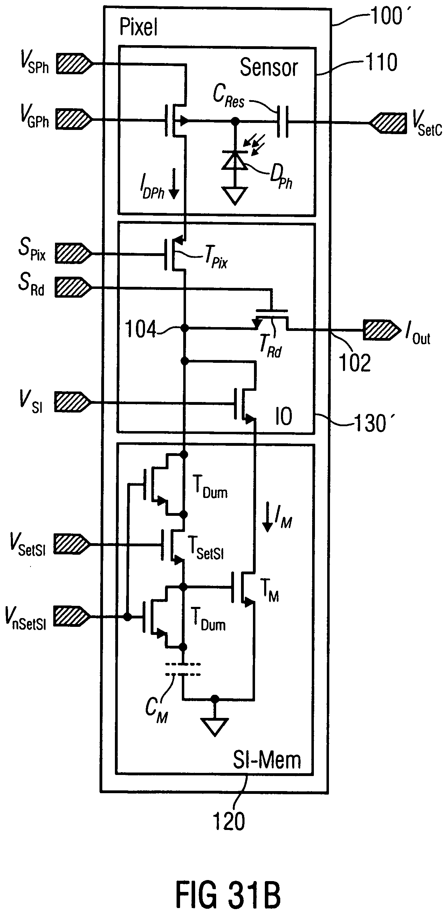

Anhand der Fig. 31A und 31B wird später eingehender auf Aspekte ladungsbasierter und strombasierter Pixelzellen gemäß Fig. 39A eingegangen.

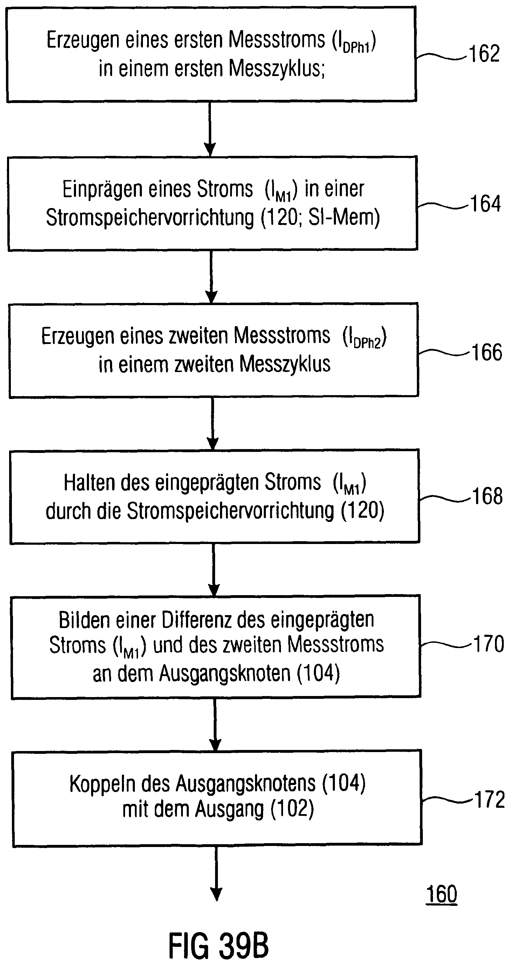

Fig. 39B zeigt ein Flussdiagramm eines Aspekts eines Verfahrens zum Betreiben einer Pixelzelle nach Fig. 39A, bei dem ein Differenzwert zwischen einer ersten Messung einer Strahlung in einem ersten Messzyklus und einer zweiten Messung in einem zweiten Messzyklus gebildet wird.

Das Verfahren 160 zum Betreiben einer Pixelzelle umfasst das Erzeugen 162 eines ersten Messstroms $I_{DPh1}$ durch den Photosensor 110, abhängig von einer Strahlung in einem ersten Messzyklus. Es folgt das Einprägen 164 eines Stroms $I_{M1}$ in der Stromspeichervorrichtung 120 in einem ersten Betriebsmodus, abhängig von dem ersten Messstrom $I_{DPh1}$, um in einem zweiten Betriebsmodus den eingeprägten Strom $I_{M1}$ zu erhalten. Das Einprägen 164 des ersten Messstroms kann beispielsweise über den Ausgangspunkt 104 erfolgen oder über einen anderen Strompfad und beispielsweise durch die Schalteinheit 130 gesteuert werden oder durch andere Einheiten. Nach dem Speichern des ersten Messstroms in der Stromspeichervorrichtung wird diese beispielsweise von dem Photosensor entkoppelt und es folgt ein Erzeugen 166 eines zweiten Messstroms $I_{DPh2}$ durch den Photosensor, abhängig von einer Strahlung in einem zweiten Messzyklus. Währenddessen wird der eingeprägte Strom in dem zweiten Betriebsmodus durch die Stromspeichervorrichtung gehalten bzw. weiterhin gespeichert 168. In Schritt 170 wird der Photosensor 110 und die Stromspeichervorrichtung 120 mit dem Ausgangsknoten gekoppelt, um an dem Ausgangsknoten 104 die Differenz zwischen dem zweiten Messstrom $I_{DPh2}$ und dem eingeprägten Strom $I_{M1}$, der dem ersten Messstrom $I_{DPh1}$ entspricht, zu bilden. Zudem wird der Ausgangsstrom 104 mit dem Ausgang 102 gekoppelt 172.

Aspekte der Pixelzelle gemäß Fig. 39A bzw. eines Verfahrens zum Betreiben derselben gemäß Fig. 39B ermöglichen die zeitliche Differenzbildung bzw. die Differenzbildung zwischen zwei aufeinanderfolgenden Messwerten (Messströmen) in und für eine Pixelzelle (analoge Differenzbildung). Dabei wird abhängig von dem Betriebsmodus, strombasiert oder ladungsbasiert, in dem strombasierten Betriebsmodus eine Differenz der Ströme ausgeben, oder basierend auf der Differenz der Ströme eine entsprechende Differenz der Ladungen an dem Ausgang 102 ausgegeben.

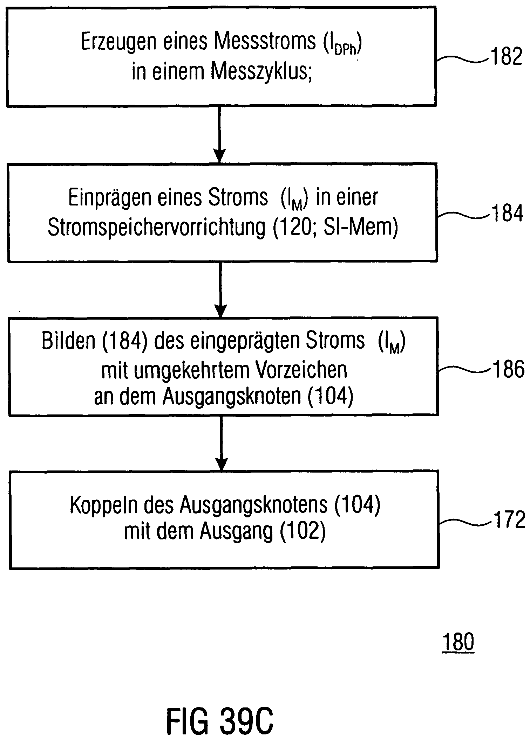

Fig. 39C zeigt ein Flussdiagramm eines Aspekts eines Verfahrens zum Betreiben einer Pixelzelle nach Fig. 39A, bei dem ein Messwert, der in einem Messzyklus erzeugt wird, gespeichert wird und in einem Auslesezyklus über den Ausgangsknoten und den Ausgang ausgegeben wird.

Das Verfahren 180 umfasst das Erzeugen 182 eines Messstroms $I_{DPh}$ durch einen Photosensor 110, abhängig von einer Strahlung in einem Messzyklus. In dem Schritt 184 wird ein Strom IM in der Stromspeichervorrichtung 120 in einem Betriebsmodus eingeprägt, abhängig von dem Messstrom $I_{DPh}$, um in einem zweiten Betriebsmodus den eingeprägten Strom IM zu halten, so dass der eingeprägte Strom IM an dem Ausgangsknoten 104 erfassbar ist. In einem Schritt 184 wird die Stromspeichervorrichtung 120 mit dem Ausgangsknoten 104 gekoppelt, um den Ausgangsknoten den eingeprägte Strom zuzuführen, wobei in diesem Aspekt der eingeprägte Strom mit umgekehrten Vorzeichen bzw. in umgekehrter Stromrichtung an dem Ausgangsknoten 104 angelegt wird. Schließlich wird in Schritt 186 der Ausgangsknoten 104 mit dem Ausgang 102 gekoppelt.

Aspekte der Pixelzelle gemäß Fig. 39A bzw. eines Verfahrens zum Betreiben der Pixelzelle gemäß Fig. 39C ermöglichen es, einen von einer Strahlung abhängigen Messstrom in Bezug auf seine Stromstärke und Stromrichtung zu speichern und in einem Auslesezyklus diesen mit umgekehrten Vorzeichen, also in entgegengesetzter Richtung wieder an dem Ausgang auszugeben. Dabei wird abhängig von dem Betriebsmodus, strombasiert oder ladungsbasiert, in dem strombasierten Betriebsmodus der invertierte Messtrom ausgeben, oder basierend auf dem invertierten Messtrom eine entsprechend invertierte Ladungsmenge an dem Ausgang 102 ausgegeben.

Weitere Aspekte gemäß den Fig. 39A bis 39C werden später, beispielsweise anhand der Fig. 31A und 31B erläutert.

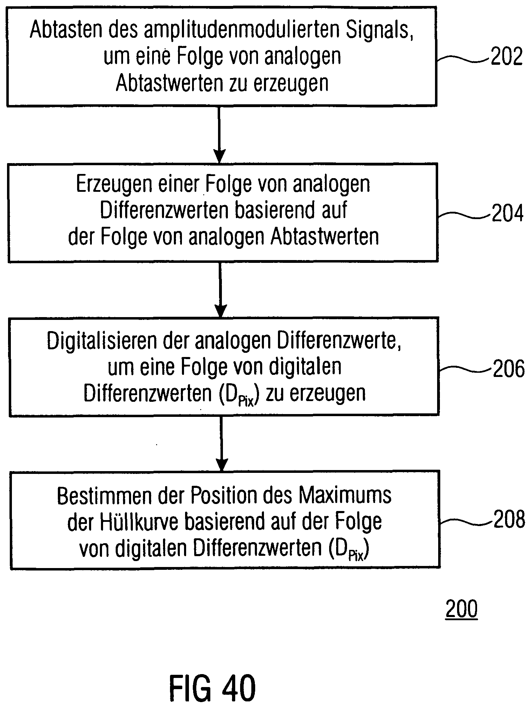

Fig. 40 zeigt ein Flussdiagramm eines Aspekts eines Verfahrens 200 zum Bestimmen einer Position eines Maximums einer Hüllkurve eines analogen amplitudenmodulierten Signals.

Das Verfahren 200 umfasst das Abtasten 202 des amplitudenmodulierten Signals, um eine Folge von analogen Abtastwerten zu erzeugen und das Erzeugen 204 einer Folge von analogen Differenzwerten, wobei ein analoger Differenzwert der Folge von analogen Differenzwerten auf einer Differenz zweier aufeinanderfolgender analoger Abtastwerte der Folge von analogen Abtastwerten basiert. In einem Digitalisierungsschritt 210 werden die analogen Differenzwerte digitalisiert, um eine Folge von digitalen Differenzwerten zu erzeugen. Basierend auf der Folge von digitalen Differenzwerten wird in Schritt 220 die Position des Maximums der Hüllkurve bestimmt.

Bei einem Aspekt des Verfahrens kann das amplitudenmodulierte Signal ein zeitlich amplitudenmoduliertes Signal sein, das beispielsweise bei einem Weißlicht-Interferometrieverfahren durch das Abtasten eines analogen Zeitverlaufs eines Pixelsignals einer Pixelzelle, z.B. eines Stroms, einer Ladung oder einer Spannung, erzeugt wird.

Bei einem anderen Aspekt des Verfahrens kann das amplitudenmodulierte Signal ein räumlich amplitudenmoduliertes Signal sein, das beispielsweise bei einem gleichzeitigen Abtasten der analogen Pixelsignale, z.B. der Ströme, der Ladungen oder der Spannungen, mehrerer benachbarter Pixelzellen erzeugt wird.

Das Verfahren der Weißlicht-Interferometrie wird später näher erläutert. Dort wird ein Verfahren zur Weißlicht-Interferometrie beschrieben, bei dem basierend auf dem Maximum der Hüllkurve des amplitudenmodulierten Pixelsignals, das während der Weißlicht-Interferometrie erzeugt wird, auf die Höhe eines Oberflächenpunktes eines zu vermessenden Objekts rückgeschlossen werden kann.

Gemäß einem Aspekt des Verfahrens 200 zum Bestimmen einer Position eines Maximums, basiert das Bestimmen der Position des Maximums auf einem Bestimmen einer Anzahl einer Folge von Nulldurchgängen der Folge von digitalen Differenzwerten. Dabei wird gemäß einem weiteren Aspekt bei dem Bestimmen der Anzahl der Nulldurchgänge nur ein Teil der Folge von digitalen Differenzwerten berücksichtigt. Dieser Teil der Folge von digitalen Differenzwerten beginnt mit dem ersten digitalen Differenzwert der Folge von Differenzwerten, dessen Wert größer als ein oberer Schwellwert oder kleiner als ein unterer Schwellwert ist. Das Ende des Teils der Folge von digitalen Differenzwerten, der für die Bestimmung der Anzahl der Nulldurchgänge berücksichtigt wird, wird durch den letzten digitalen Differenzwert der Folge von digitalen Differenzwerten bestimmt, dessen Wert größer als der obere Schwellwert oder kleiner als der untere Schwellwert ist. Die Position des Maximums der Hüllkurve kann dann als die Position eines mittleren Nulldurchgangs der Folge von Nulldurchgängen bestimmt werden bzw. die Position des Maximums der Hüllkurve entspricht der Position eines mittleren Nulldurchgangs der Folge von Nulldurchgängen.

Dabei können der obere und der untere Schwellwert beide positive oder negative Werte sein oder der obere Schwellwert ein positiver Schwellwert sein und der untere Schwellwert ein negativer Schwellwert sein.

Gemäß einem Aspekt des Verfahrens umfasst das Digitalisieren das Erzeugen der Folge von digitalen Differenzwerten basierend auf der Folge von analogen Differenzwerten, so dass einem Digitalwert der Folge von digitalen Differenzwerten ein erster Wert (z.B. "0") zugeordnet ist, wenn ein entsprechender analoger Differenzwert der Folge von analogen Differenzwerten oder eine vordigitalisierte Version desselben kleiner als ein oberer Schwellwert und größer als ein unterer Schwellwert ist, einem Digitalwert der Folge von digitalen Differenzwerten ein zweiter Wert (z.B. "+1") zugeordnet ist, wenn ein entsprechender analoger Differenzwert der Folge von analogen Differenzwerten oder eine vordigitalisierte Version desselben größer als der obere Schwellwert ist, und einem Digitalwert der Folge von digitalen Differenzwerten ein dritter Wert (z.B. "-1") zugeordnet ist, wenn ein entsprechender analoger Differenzwert der Folge von analogen Differenzwerten oder eine vordigitalisierte Version desselben kleiner als der untere Schwellwert ist.

Gemäß einem weiteren Aspekt des Verfahrens umfasst das Digitalisieren ein Vordigitalisieren der analogen Differenzwerte, um eine erste Folge von digitalen Differenzwerten zu erzeugen; und ein Erzeugen einer zweiten Folge von digitalen Differenzwerten als die Folge von digitalen Differenzwerten basierend auf der ersten Folge von digitalen Differenzwerten, wobei einem Digitalwert der zweiten Folge von digitalen Differenzwerten ein erster Wert (z.B. "0") zugeordnet wird, wenn ein entsprechender digitaler Differenzwert der ersten Folge von Differenzwerten kleiner als ein oberer digitaler Schwellwert und größer als ein unterer digitaler Schwellwert ist, einem Digitalwert der zweiten Folge von digitalen Differenzwerten ein zweiter Wert (z.B. "+1") zugeordnet wird, wenn ein entsprechender digitaler Differenzwert der ersten Folge von Differenzwerten größer als ein oberer digitaler Schwellwert ist, und einem Digitalwert der zweiten Folge von digitalen Differenzwerten ein dritter Wert (z.B. "-1") zugeordnet wird, wenn ein entsprechender digitaler Differenzwert der ersten Folge von Differenzwerten kleiner als ein unterer digitaler Schwellwert ist.

Gemäß einem Aspekt umfasst des Verfahrens ein Erzeugen einer dritten Folge von digitalen Differenzwerten basierend auf der zweiten Folge von digitalen Differenzwerten, wobei einem ersten digitalen Differenzwert der dritten Folge der erste Wert ("0") zugeordnet wird, einem digitalen Differenzwert der dritten Folge von Differenzwerten der Wert eines in der Folge entsprechenden digitalen Differenzwerts der zweiten Folge zugeordnet wird, wenn letzterem nicht der erste Wert zugeordnet ist ("ungleich 0"), und einem Differenzwert der dritten Folge von digitalen Differenzwerten ein digitaler Differenzwert der zweiten Folge von digitalen Differenzwerten eines vorhergehenden digitalen Differenzwertes der zweiten Folge zugeordnet wird, wenn der dem Differenzwert der dritten Folge von digitalen Differenzwerten in der Folge entsprechende digitale Differenzwert der zweiten Folge von digitalen Differenzwerten der erste Wert ("0") zugeordnet ist.

Weitere Aspekte des Verfahrens umfassen das Detektieren von direkten und/oder indirekten Nulldurchgängen basierend auf der dritten Folge von Differenzwerten und das Erhöhen eines Zählers, wenn ein Nulldurchgang bzw. direkter Nulldurchgang detektiert wird und/oder wenn zwei aufeinanderfolgende undirekte Nulldurchgänge detektiert werden, sowie das Ermitteln eines digitalen Differenzwertes der dritten Folge von Differenzwerten mit einer mittleren Position in Bezug auf einen ersten Nulldurchgang und einen letzten Nulldurchgang der dritten Folge von Differenzwerten; und Bestimmen der Position des Mittelwertes des amplitudenmodulierten Signals basierend auf der Position des digitalen Differenzwertes der dritten Folge von Differenzwerten mit der mittleren Position.

Gemäß einem weiteren Aspekt eines Verfahrens zum Bestimmen einer Position eines Maximums einer Höhenkurve kann auch direkt aus einer Folge von analogen Abtastwerten eine Folge von digitalen Differenzwerten gebildet werden. Ein entsprechendes Verfahren kann beispielsweise zunächst das Abtasten des amplitudenmodulierten Signals umfassen, um eine Folge von analogen Abtastwerten zu erzeugen. Aus der Folge von analogen Abtastwerten wird dann eine erste Folge von digitalen Differenzwerten erzeugt, wobei ein digitaler Differenzwert der Folge von digitalen Differenzwerten auf einer Differenz zweier aufeinander folgender analoger Abtastwerte basiert. Basierend auf der ersten Folge von digitalen Differenzwerten wird dann die zweite Folge von digitalen Differenzwerten erzeugt, wobei ein Digitalwert der zweiten Folge von digitalen Differenzwerten ein erster Wert, zum Beispiel "0" zugeordnet wird, wenn ein entsprechender digitaler Differenzwert der ersten Folge von Differenzwerten kleiner als ein oberer digitaler Schwellwert und größer als ein unterer digitaler Schwellwert ist, ein Digitalwert einer zweiten Folge von digitalen Differenzwerten ein zweiter Wert, zum Beispiel "+1" zugeordnet wird, wenn ein entsprechender digitaler Differenzwert der ersten Folge von digitalen Differenzwerten größer als ein oberer digitaler Schwellwert ist, und einem Digitalwert der zweiten Folge von digitalen Differenzwerten ein dritter Wert "-1" zugeordnet ist, wenn ein entsprechender digitaler Differenzwert der ersten Folge von Differenzwerten kleiner als ein unterer digitaler Schwellwert ist.

Dabei kann, wie in Bezug auf die anderen Aspekte ausgeführt, die Folge von analogen Abtastwerten eine Folge von analogen Strom-, Ladungs-, oder Spannungswerten eines amplitudenmodulierten Signals, z.B. eines amplitudenmodulierten Helligkeitssignals für eine Weißlicht-Interferometrie sein.

Weitere Aspekte des Verfahrens 200 zum Bestimmen einer Position eines Maximums einer Hüllkurve werden später unter anderem anhand der "Variante 1" und "Variante 2" beschrieben.

Gemäß einem Aspekt der Anmeldung kann eine Pixelzelle 100 nach Fig. 39A beispielsweise zum Abtasten eines amplitudenmodulierten Helligkeitssignals bei einem Weißlicht-Interometrieverfahren verwendet werden.

Gemäß dem Verfahren 160 zum Betreiben der Pixelzelle kann auch das Erzeugen 204 der Folge von analogen Differenzwerten des amplitudenmodulierten Helligkeitssignals in der Pixelzelle 100 selbst durchgeführt werden, d.h. beispielsweise eine zeitliche Abtastung und zeitliche Differenzbildung durchgeführt werden.

Gemäß einem Verfahren 180 zum Betreiben der Pixelzelle 100 können beispielsweise auch die analogen Abtastwerte zweier verschiedener, z.B. benachbarter Pixelzellen gespeichert und voneinander subtrahiert werden, um eine räumliche Abtastung und eine räumliche Folge von Differenzwerten zu erzeugen.

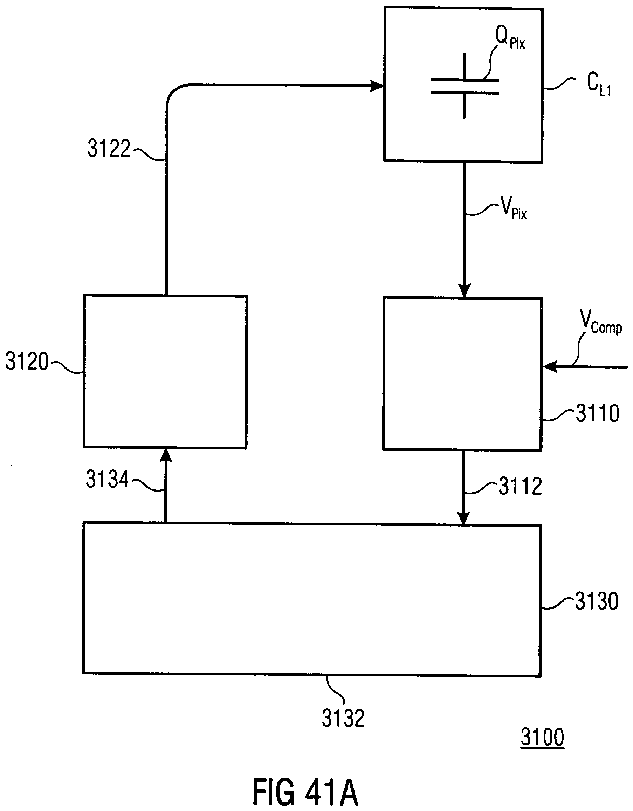

Fig. 41A zeigt ein Blockschaltbild eines Aspekts einer Vorrichtung zum Bestimmen einer Ladungsmenge $Q_{pix}$ auf einem kapazitiven Element $C_{L1}$ mit einer Einrichtung zum Vergleichen 3110, eine Einrichtung zum Bewirken 3120 und eine Einrichtung 3130 zum Rückfließen.

Die Einrichtung zum Vergleichen 3110 vergleicht die Spannung $V_{pix}$ an dem kapazitiven Element $C_{L1}$ mit einer Referenzspannung $V_{comp}$. Die Referenzspannung $V_{comp}$ kann eine positive oder negative Spannung oder auch eine Nullspannung bei 0 V sein.

Die Einrichtung 3130 ist ausgebildet, eine Ladungszufuhr/- abfuhr zu/von dem kapazitiven Element $C_{L1}$ zu bewirken (3122). Die Einrichtung 3130 zum Rückschließen ist ausgebildet auf die Ladung $Q_{pix}$ auf dem kapazitiven Element $C_{L1}$ auf Basis der Ladungszuführ-/abfuhr 3122 und dem Vergleich der Spannung 3112 rückzuschließen bzw. diese zu bestimmen.

Die Einrichtung zum Vergleichen 3110 kann beispielsweise ein Spannungskomparator sein, an dessen Eingänge die Spannung $V_{Pix}$ an dem kapazitiven Element und die Referenzspannung $V_{comp}$ angelegt werden und der ein abhängig von dem Vergleich abhängiges Differenzsignal, ggf. auch verstärkt, 3112 ausgibt.

Die Einrichtung 3120 zum Bewirken einer Ladungszufuhr-/abfuhr kann eine Stromquelle sein, die beispielsweise einen Strom einer konstanten Stromstärke abgibt oder eine gepulste Stromquelle sein, die Ladungspakete einer bestimmten Stromstärke und Dauer abgibt, oder eine Ladungspumpe sein. Auf diese Möglichkeiten wird in der späteren Beschreibung noch genauer eingegangen.

Gemäß einem Aspekt der Vorrichtung 3100 ist die Einrichtung zum Vergleichen 3110 der Spannung ausgebildet, um zu bestimmen, ob die Spannung $V_{pix}$ an dem kapazitiven Element größer oder kleiner als die Referenzspannung ist, und die Einrichtung 3130 zum Bewirken der Ladungszufuhr/-abfuhr, um abhängig von der Bestimmung, welche der Spannungen größer ist, von dem kapazitiven Element $C_{L1}$ Ladungen derart ab-/zuzuführen, dass eine Differenz zwischen der Spannung $V_{pix}$ an dem kapazitiven Element $C_{L1}$ und der Referenzspannung $V_{comp}$ geringer wird. Ist beispielsweise die Spannung an dem kapazitiven Element $V_{Pix}$ größer als die Referenzspannung $V_{comp}$, wird die Einrichtung 3120 zum Bewirken negative Ladung zuführen, um die Spannung $V_{Pix}$ an dem kapazitiven Element $C_{L1}$ zu reduzieren und somit auch die Differenz zwischen den beiden Spannungen reduzieren. Dies ist unabhängig davon, ob die Referenzspannung ein positives Spannungspotential oder ein negatives Spannungspotential oder ein Nullpotential aufweist. Entsprechend umgekehrt verhält es sich, wenn die Spannung $V_{Pix}$ an dem kapazitiven Element $C_{L1}$ kleiner als die Referenzspannung $V_{comp}$ ist. In diesem Fall wird die Einrichtung zum Bewirken 3120 negative Ladungen abführen, um die Spannung $V_{Pix}$ an dem kapazitiven Element $C_{L1}$ zu erhöhen. Auch dies ist, unabhängig von dem Spannungspotential der Referenzspannung $V_{comp}$.

Gemäß einem weiteren Aspekt ist die Einrichtung zum Rückschließen ausgebildet, einen Vorzeichenwechsel bei dem Ausgangssignal bzw. Vergleichsergebnis 3112 der Einrichtung zum Vergleichen gegenüber einem vorhergehenden Ausgangssignal derselben zu detektieren. Dies kann beispielweise auf analoger Basis erfolgen, indem das Differenzsignal 3112 kontinuierlich verfolgt wird und der Nulldurchgang detektiert wird, oder in digitaler Weise, indem z. B. das Vorzeichen eines vorhergenden Vergleichs als binärer oder digitaler Wert gespeichert wird und mit dem Vorzeichen eines aktuellen Vergleichs, das ebenfalls in binärer oder digitaler Form vorliegt, verglichen wird.

Gemäß einem Aspekt, bei dem die Einrichtung 3120 zum Bewirken einer Ladungszufuhr/-abfuhr einen kontinuierlichen Strom einer konstanten Stromstärke abgibt und die Einrichtung 3130 zum Rückschließen kontinuierlich den Verlauf eines Differenzsignals 3112 verfolgt, kann beispielsweise durch einen Zeitmesser, der die Zeit zwischen einem Beginn einer Ladungszufuhr/-abfuhr und dem Zeitpunkt eines Nulldurchgangs des Differenzsignals misst, über die Stromstärke des kontinuierlichen Stroms, die dem kapazitiven Element $C_{L1}$ zu-/abgeführte Ladungsmenge bestimmt werden. Die Ladungsmenge $Q_{Pix}$ auf dem kapazitiven Element vor der Ladungszufuhr/-abfuhr entspricht der insgesamt zu-/abgeführten Ladungsmenge 3122 und unterscheidet sich nur in dem Vorzeichen von dieser. Die Genauigkeit der Bestimmung der Ladung $Q_{Pix}$ auf dem kapazitiven Element $C_{L1}$ wird durch die Reaktionszeit, zwischen dem Nulldurchgang bzw. der Detektion des Nulldurchgangs und dem Abschluss der Zeitmessung sowie der Genauigkeit, mit der die Stromstärke der Einrichtung zum Bewirken bestimmt ist, bestimmt.

Bei einem Aspekt der Vorrichtung 3100, bei der die Einrichtung zum Bewirken 3120 Ladungspakete erzeugt, kann diese ausgebildet sein, Ladungspakete mit konstanter Ladungsmenge ab-/zuzuführen oder Ladungspakete mit variabler Ladungsmenge ab-/zuzuführen. Die Ladungsmenge eines Ladungspakets wird, wie zuvor dargestellt, durch die Stromstärke des Ladungspakets und die Dauer des Ladungspakets definiert.

Bei einer Zu-/Abfuhr von Ladungspaketen konstanter Ladungsmenge kann die Anzahl der Ladungspulse gezählt werden, beispielsweise durch einen digitalen Zähler, und mit der Ladungsmenge der Ladungspakete multipliziert werden, um die Ladungsmenge $Q_{Pix}$ des kapazitiven Elements $C_{L1}$ zu bestimmen.

Entsprechend kann eine solche Lösung auch als zählende Analog-/Digital-Wandlung bzw. inkrementierende Analog-/Digital-Wandlung bezeichnet werden.

Ist die Ladungsmenge eines Ladungspakets eine Referenzladungsmenge oder ein Vielfaches einer in einem System bestimmten Referenzladungsmenge, so repräsentiert dieser Zählwert die Ladung $Q_{Pix}$ in digitaler Form, und kann in einem digitalen System weiter verarbeitet werden, z.B. mit anderen digitalen Zählwerten, die sich auf die gleiche Referenzladungsmenge beziehen, verglichen bzw. verarbeitet werden. Gemäß einem solchen Aspekt realisiert eine Vorrichtung 3100 einen Ladungs-Analog-Digital/Wandler, bei der die Vorrichtung zum Rückschließen 3130 ausgebildet ist, einen der Ladung auf dem kapazitiven Element $C_{L1}$ entsprechenden digitalen Wert 3132 zu bestimmen.

Gemäß einem alternativen Aspekt einer Vorrichtung 3100, bei der die Einrichtung zum Bewirken 3120 ausgebildet ist, Leitungspakete mit variabler Ladungsmenge ab-/zuzuführen, bestimmt die Einrichtung 3130 zum Rückschließen die Ladung $Q_{Pix}$ auf Basis der Ladungsmengen der verschiedenen Ladungspakete und der Anzahl der Ladungspakete, die mit den entsprechenden Ladungsmengen ab-/zugeführt werden. Auch hier kann die tatsächliche Ladung als ein Vielfaches einer Referenzladungsmenge in digitaler Form 3132 dargestellt und für eine weitere Verarbeitung als digitaler Wert 3132 ausgegeben werden.

Ein weiterer Aspekt gemäß der Vorrichtung 3100 ist eine ladungsbasierte Analog/Digital-Wandlung mit binärer sukzessiver Approximation, bei der Ladungspakete mit binär abgestufter Ladungsmenge dem kapazitiven Element zu-/abgeführt werden, beginnend mit dem Ladungspaket mit der größten Ladungsmenge und sequentiell fortfahrend mit dem Zu-/Abführen eines Ladungspakets mit der nächstkleineren Ladungsmenge. Die Einrichtung 3120 zum Bewirken einer Ladungszufuhr/- Abfuhr ist ferner ausgebildet, bei der Ladungsbestimmung mit dem Ladungspaket der binär abgestuft höchsten Ladungsmenge zu beginnen und in einer nächsten Stufe ein Ladungspaket der nächst niedrigeren binär abgestuften Ladungsmenge zu-/abzuführen, etc. Die Einrichtung zum Rückschließen 3130 ist ausgebildet, einen der jeweiligen binär abgestuften Ladungsmenge entsprechenden digitalen Wert zu addieren beziehungsweise zu subtrahieren, um einen der Ladung auf dem kapazitiven Element $C_{L1}$ entsprechenden digitalen Wert 3132 zu bestimmen.

Gemäß einem weiteren Aspekt der Vorrichtung 3100 kann die Einrichtung 3120 zum Bewirken ausgebildet sein, allgemein mit einem Ladungspaket einer ersten Ladungsmenge zu beginnen und solange Ladungspakete mit derselben Ladungsmenge zu-/abzuführen, bis ein Vorzeichenwechsel detektiert wird, und dann Ladungspakete einer zweiten Ladungsmenge, die kleiner als die erste Ladungsmenge ist, zu- bzw. abzuführen, usw. Entsprechend kann eine solche Lösung auch als "kombinierte beziehungsweise gemischte zählende/sukzessive Analog/Digital-Wandlung" bezeichnet werden. Die Einrichtung zum Rückschließen 3130 ist ausgebildet, einen der jeweiligen Ladungsmenge entsprechenden digitalen Wert zu addieren beziehungsweise zu subtrahieren, um einen der Ladung auf dem kapazitiven Element $C_{L1}$ entsprechenden digitalen Wert 3132 zu bestimmen.

Im Folgenden werden anhand eines einfachen Zahlenbeispiels die "zählende Ladungs-Analog-Digital-Wandlung", die "binäre sukzessive Ladungs-Analog-Digital-Wandlung" und die "kombiniert zählende/sukzessive Ladungs-Analog-Digital-Wandlung" erläutert. Ein der Ladung $Q_{Pix}$ entsprechender 3-Bit Digitalwert 3132 soll ermittelt werden. Die Ladung $Q_{Pix}$ auf dem kapazitiven Element $C_{L1}$ entspricht dem 4,9-fachen einer Referenzladung. Für eine bessere Lesbarkeit wird in den folgenden Beispielen, beispielsweise von einer Ladung "+/-2" gesprochen, wenn diese Ladung dem zweifachen beziehungsweise inversen zweifachen der Referenzladung entspricht. Entsprechend weist die Ladung $Q_{Pix}$ in diesem Beispiel also den Wert "+4,9" auf.

Bei einem Aspekt der "zählenden Ladungs-Analog-Digital-Wandlung" ist die Einrichtung 3120 zum Bewirken einer Ladungszufuhr/-Abfuhr beispielsweise ausgebildet, Ladungspakete "+/-1" zu erzeugen. Zunächst wird das Vorzeichen der Ladung "+4,9" bestimmt, in diesem Fall positiv bzw. "+", und dann beispielsweise mit Ladungspaketen der konstanten Ladung und mit umgekehrtem Vorzeichen in Bezug auf das bestimmte Vorzeichen ein Ladungspaket "-1" zu-/abgeführt und ein digitaler Zähler um den entsprechenden Wert "+1" erhöht. Der Zählerstand ist "+1" und die verbleibende Ladung auf dem kapazitiven Element $C_{L1}$ ist "+3,9". Somit wird kein Vorzeichenwechsel detektiert, und in einem nächsten Schritt das konstante Ladungspaket mit demselben Vorzeichen zu-/abgeführt, hier "-1" und ein digitaler Zähler um den entsprechenden Wert "+1" erhöht. Der resultierende Zählerstand ist "+2" und die verbleibende Ladung auf dem kapazitiven Element $C_{L1}$ ist "+2,9". Somit wird wieder kein Vorzeichenwechsel detektiert, und in einem nächsten Schritt wieder das konstante Ladungspaket mit demselben Vorzeichen zu-/abgeführt, hier "-1". Der resultierende Zählerstand ist "+3" und die verbleibende Ladung auf dem kapazitiven Element $C_{L1}$ ist "+1,9". Somit wird wieder kein Vorzeichenwechsel detektiert, und in einem nächsten Schritt wieder das konstante Ladungspaket mit demselben Vorzeichen zu-/abgeführt, hier "-1". Der resultierende Zählerstand ist "+4" und die verbleibende Ladung auf dem kapazitiven Element $C_{L1}$ ist "+0,9". Somit wird wieder kein Vorzeichenwechsel detektiert, und in einem nächsten Schritt wieder das konstante Ladungspaket mit demselben Vorzeichen zu-/abgeführt, hier "-1". Der resultierende Zählerstand ist "+5" und die verbleibende Ladung auf dem kapazitiven Element $C_{L1}$ ist "-0,1". Somit wird ein Vorzeichenwechsel detektiert, und die Wandlung abgebrochen, d.h. kein Ladungspaket mehr zu-/abgeführt. Der letzte Zählerstand "+5" ist der digitale Wert 3132, der der Ladung $Q_{Pix}$ entspricht bzw. diese repräsentiert. In anderen Worten, es wird eine konstante Ladungsmenge desselben Vorzeichens zu-/abgeführt bis ein Vorzeichenwechsel detektiert wird, der letzte Zählerstand entspricht der zu bestimmenden Ladung.

Bei einem Aspekt der "binären sukzessiven Ladungs-Analog-Digital-Wandlung" ist die Einrichtung zur Ladungszufuhr/- Abfuhr ausgebildet, Ladungspakete in binär abgestufter Ladungsmenge abzugeben, beispielsweise "+/-4", +/-2 und +/-1". Zunächst wird bei diesem Aspekt das Vorzeichen der Ladung $Q_{Pix}$ "+4,9" festgestellt, und entsprechend ein Ladungspaket mit der binär abgestuften größten Ladungsmenge und zu dem bestimmten Vorzeichen inversen Vorzeichen zu-/abgeführt, in diesem Falle "-4". Der Zähler wird entsprechend um "+4" erhöht. Der resultierende Zählerstand ist "+4" und die verbleibende Ladung auf dem kapazitiven Element $C_{L1}$ ist "+0,9". Somit wird kein Vorzeichenwechsel detektiert, und es wird ein Ladungspaket der binär nächst niedrigeren Ladungsmenge mit gleichem Vorzeichen zu-/abgeführt, in diesem Falle "-2", und der Zähler entsprechend um "+2" erhöht. Der resultierende Zählerstand ist "+6" und die verbleibende Ladung auf dem kapazitiven Element $C_{L1}$ ist "-1,1". Somit wird ein Vorzeichenwechsel detektiert, und entsprechend im nächsten Schritt ein Ladungspaket der binär nächst niedrigeren beziehungsweise hier geringsten Ladungsmenge mit umgekehrtem Vorzeichen zu-/abgeführt, in diesem Falle "+1", und der Zähler entsprechend um "-1" reduziert. Der resultierende Zählerstand ist "+5" und die verbleibende Ladung auf dem kapazitiven Element $C_{L1}$ ist "-0,1". Nach der Zufuhr/Abfuhr des kleinsten Ladungspaketes wird die Wandlung beendet. Der letzte Zählerstand bildet den digitalen Wert 3132 der zu bestimmenden Ladung $Q_{Pix}$, hier also "+5".

Bei einem Aspekt der "kombinierten zählenden/sukzessiven Ladungs-Analog-Digital-Wandlung" ist die Einrichtung 3120 zum Bewirken einer Ladungszufuhr/-Abfuhr ausgebildet, z.B. die Ladungspakete "+/-4" und "+/-1" zu erzeugen. Zu Beginn der Wandlung wird das Vorzeichen der Ladung $Q_{Pix}$ "+4,9" bestimmt und entsprechend ein Ladungspaket der größten Ladungsmenge mit zu dem bestimmten Vorzeichen inversen Vorzeichen zu-/abgeführt, in diesem Falle "-4" und der Zähler entsprechend um "+4" erhöht. Der resultierende Zählerstand ist "+4" und die verbleibende Ladung auf dem kapazitiven Element $C_{L1}$ ist "+0,9". Somit wird kein Vorzeichenwechsel detektiert, entsprechend wird ein Ladungspaket derselben Ladungsmenge und desselben Vorzeichens zu-/abgeführt, in diesem Falle "-4" und der Zähler entsprechend um "+4" erhöht. Der resultierende Zählerstand ist "+8" und die verbleibende Ladung auf dem kapazitiven Element $C_{L1}$ ist "-3,1". Somit wird ein Vorzeichenwechsel detektiert und im nächsten Schritt ein Ladungspaket der nächst niedrigeren Ladungsmenge mit umgekehrten Vorzeichen, in diesem Fall "+1" zu-/abgeführt, und der Zähler entsprechend um "-1" reduziert. Der resultierende Zählerstand ist "+7" und die verbleibende Ladung auf dem kapazitiven Element $C_{L1}$ ist "-2,1". Somit wird kein Vorzeichenwechsel detektiert, entsprechend wird wieder ein Ladungspaket derselben Ladungsmenge und desselben Vorzeichens zu-/abgeführt, in diesem Fall "+1" und der Zähler entsprechend "-1" reduziert. Der resultierende Zählerstand ist "+6" und die verbleibende Ladung auf dem kapazitiven Element $C_{L1}$ ist "-1,1". Somit wird wiederum kein Vorzeichenwechsel detektiert, entsprechend wird wieder ein Ladungspaket derselben Ladungsmenge und desselben Vorzeichen zu-/abgeführt, in diesem Fall "+1" und der Zähler um "-1" reduziert. Der resultierende Zählerstand ist "+5" und die verbleibende Ladung auf dem kapazitiven Element $C_{L1}$ ist "-0,1". Hier wird die Wandlung gemäß einem Aspekt beendet, da eine weitere Ladungszufuhr/-Abfuhr die vier Ladungspakete "+/-1" der Ladungsmenge der nächst höheren beziehungsweise vorangegangenen Ladungsstufe "+/-4" entspräche. Der letzte Zählerstand bildet den digitalen Wert 3132 der zu bestimmenden Ladung $Q_{Pix}$, hier also "+5".

Bei einem alternativen Aspekt wird die Anzahl der Zufuhren/Abfuhren von Ladungspaketen gleicher Ladungsmenge nicht nach einer durch die nächst höhere Ladungsmenge definierten Anzahl beschränkt, sondern weiter Ladungspakete zugeführt, bis ein Vorzeichenwechsel detektiert wird. Entsprechend wird gemäß diesem Aspekt wiederum ein Ladungspaket derselben Ladungsmenge und desselben Vorzeichens zu-/abgeführt, in diesem Fall "+1", und der Zähler um "-1" reduziert. Der resultierende Zählerstand ist "+4" und die verbleibende Ladung auf dem kapazitiven Element $C_{L1}$ ist "+0,9". Der letzte Zählerstand bildet wieder den digitalen Wert 3132 der zu bestimmenden Ladung $Q_{Pix}$, in diesem Fall jedoch "+4".

In anderen Worten, durch den analogen Ladungszufuhr/- Abfuhren entsprechende Additionen beziehungsweise Subtraktionen im digitalen Bereich, Wird der digitale Wert 3132 der Ladung $Q_{Pix}$ bestimmt.

Die Genauigkeit der Bestimmung der Ladung $Q_{Pix}$ auf dem kapazitiven Element $C_{L1}$ hängt von der kleinsten Ladungsmenge ab, die während der Bestimmung der Ladung $Q_{Pix}$ zu-/abgeführt wird. Je kleiner das kleinste Ladungspaket ist, umso genauer kann die Ladung $Q_{Pix}$ auf dem kapazitiven Element $C_{L1}$ bestimmt werden.

Die "zählende Ladungs-Analog-Digital-Wandlung" erfordert lediglich eine Stromquelle oder Ladungspumpe für eine Ladungszufuhr/-abfuhr, und ist über einen Zähler einfach zu realisieren. Bei großen Ladungswerten werden jedoch entsprechend viele Ladungspakete und damit viele Schritte bzw.

Iterationen der Ladungszufuhr/-abfuhr benötigt, so dass die gesamte Analog/Digital-Wandlung zeitaufwändig wird.

Bei der "binären sukzessiven Ladungs-Analog-Digital-Wandlung" werden nur so viele Schritte benötigt, wie der digitale Ladungswert Stellen aufweist, jedoch werden auch entsprechend viele verschiedene Ladungsquellen benötigt, um die entsprechenden Ladungsmengen, jeweils zu-/abführen zu können.

Die zuletzt dargestellte Variante benötigt weniger verschiedene Stromquellen als eine sukzessive Analog-/Digital-Wandlung, verkürzt aber im Vergleich zu der zählenden Analog-/Digital-Wandlung abhängig von der Anzahl der verschiedenen Stromquellen die Anzahl der maximalen Schritte erheblich.

Weitere Aspekte in Bezug auf die Vorrichtung 3100 zum Bestimmen einer Ladungsmenge $Q_{Pix}$ auf einem kapazitiven Element folgen in späteren Abschnitten.

Gemäß einem weiteren Aspekt der Anmeldung ist die Einrichtung 3130 zum Rückschließen ausgebildet, die Einrichtung 3120 zum Bewirken der Ladungszufuhr/-abfuhr zu steuern 3134. Abhängig von der Methode, mit der die Ladung $Q_{Pix}$ auf dem kapazitiven Element bestimmt wird, stoppt die Einrichtung 3130 eine kontinuierliche Ladungszufuhr/-abfuhr durch die Einrichtung 3120 zum Bewirken, initiiert bzw. steuert, ob und wann die Einrichtung 3120 ein Ladungspaket ab-/zuführt, und welche Ladungsmenge das Ladungspaket hat, und ob dieses Ladungspaket zu- oder abgeführt wird, das heißt, welches "Vorzeichen" das Ladungspaket hat.

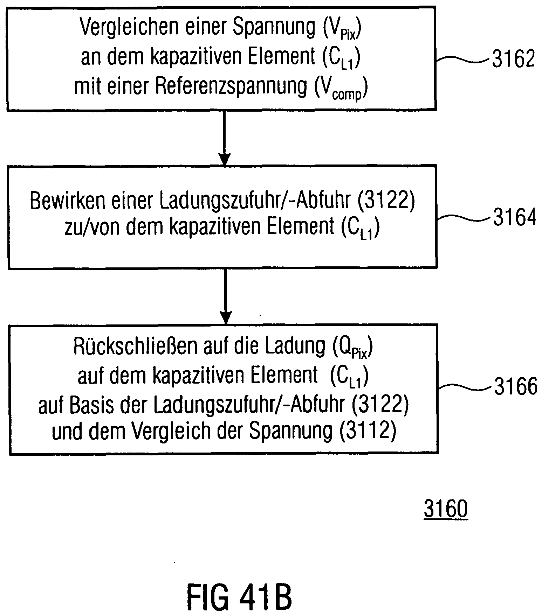

Fig. 41B zeigt ein Flussdiagramm eines Aspekts eines Verfahrens 3160 zum Bestimmen einer Ladungsmenge $Q_{Pix}$ auf einem kapazitiven Element $C_{L1}$.

Das Verfahren 3160 umfasst das Vergleichen 3162 einer Spannung $V_{Pix}$ an dem kapazitiven Element $C_{L1}$ mit einer Referenzspannung $V_{comp}$, das Bewirken 3164 einer Ladungszufuhr-/abfuhr 3122 zu/von dem kapazitiven Element $C_{L1}$ und das Rückschließen 3166 auf die Ladung $Q_{Pix}$ auf dem kapazitven Element $C_{L1}$ auf Basis der Ladungszufuhr-/abfuhr 3122 und dem Vergleich 3112 der Spannung, wie es zuvor schon anhand der Vorrichtung 3100 zum Bestimmen einer Ladungsmenge gemäß Fig. 41A näher erläutert wurde.

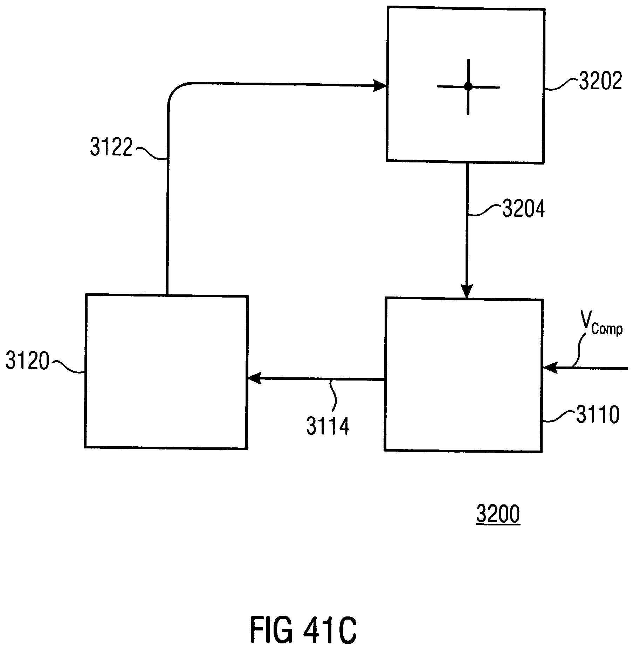

Fig. 41C zeigt einen Aspekt einer Vorrichtung 3200 zum Setzen eines Schaltungsknotens 3202 auf eine vorbestimmte Spannung $V_{PixRef}$ mit einer Einrichtung zum Vergleichen 3110 und einer Einrichtung 3120 zum Bewirken einer Ladungszufuhr/-abfuhr.

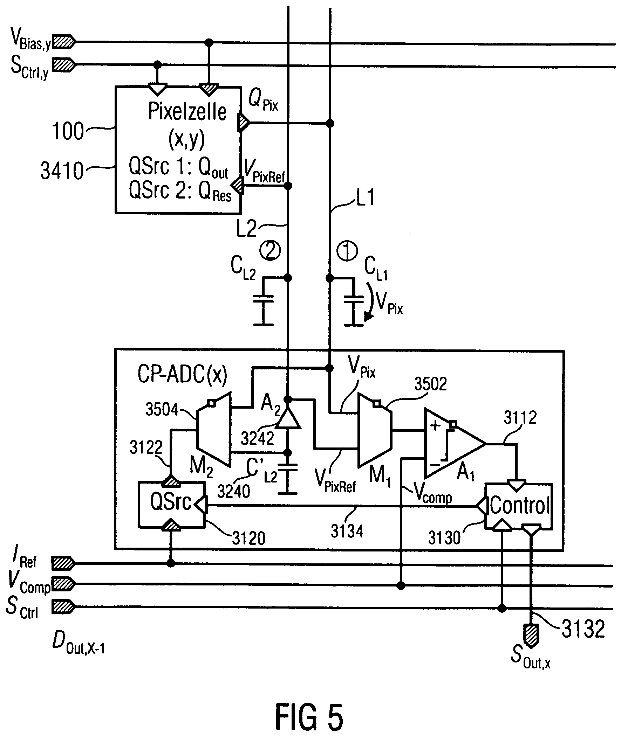

Die Einrichtung 3110 zum Vergleichen ist ausgebildet, eine Spannung an dem Schaltungsknoten 3202 mit einer Referenzspannung $V_{comp}$ zu vergleichen. Die Einrichtung 3120 zum Bewirken ist ausgebildet, um eine Ladungszufuhr/-abfuhr zu/von dem Schaltungsknoten zu bewirken, bis der Vergleich 3114 ergibt, dass die Spannung an dem Schaltungsknoten 3202 eine vorbestimmte Beziehung zu der vorbestimmten Spannung $V_{PixRef}$ aufweist. Dabei kann $V_{PixRef}$ beispielsweise $V_{comp}$ bis auf eine durch die Einrichtung zum Vergleichen oder durch die Vorrichtung zum Setzen bedingte Offsetspannung entsprechen, wie dies später anhand der Fig. 5 näher erläutert wird. Unter Vernachlässigung dieser Offsetspannungen kann ein Aspekt der Vorrichtung 3200 zum Setzen eines Schaltungsknotens 3202 auf eine vorbestimmte Spannung ausgebildet sein, den Schaltungsknoten auf die Referenzspannung $V_{comp}$ zu setzen.

Dabei kann der Knoten 3202 auch ein kapazitives Element sein oder mit diesem gekoppelt sein, und die Vorrichtung zum Setzen ausgebildet sein, das kapazitive Element auf die vorbestimmte Spannung $V_{PixRef}$ zu setzen bzw. so lange Ladung von/zu dem kapazitiven Element zu-/abzuführen bis die Spannung $V_{Pix}$ an dem kapazitiven Element die vorbestimmte Beziehung zu der vorbestimmten Spannung $V_{PixRef}$ aufweist. Die Ausführungen in Bezug auf die Aspekte gemäß Fig. 41A gelten entsprechend auch für die Aspekte gemäß Fig. 41C, und unterscheiden sich dadurch, dass die Ladungsmenge $Q_{pix}$ nicht bestimmt werden muss bzw. bestimmt wird, um den Schaltungsknoten 3202 auf die vorbestimmte Spannung zu setzen, und dass die Spannung an dem Knoten 3202 mit der Referenzspannung $V_{comp}$ verglichen wird, um diese auf die vorbestimmte Spannung $V_{PixRef}$ zu setzen.

Bei einem weiteren Aspekt einer Vorrichtung zum Setzen kann diese eine Steuerung 130 ähnlich der Einrichtung 130 zum Rückschließen aufweisen, die die Einrichtung zum Bewirken steuert, jedoch, wie zuvor erläutert, die Ladung selbst nicht bestimmt. Entsprechend ist die Einrichtung 3100 zum Bestimmen einer Ladungsmenge auf einem kapazitiven Element auch ausgebildet, die Spannung an dem kapazitiven Element auf eine vorbestimmte Spannung zu setzen, da durch den Vergleich mit der Referenzspannung $V_{comp}$ die Spannung durch Ladungszufuhr/-abfuhr kompensiert wird, bis die Spannung an dem kapazitiven Element ein vorbestimmmtes Verhältnis zu der Referenzspannung aufweist, wobei das vorbestimmte Verhältnis beispielsweise abhängig von der Ladungsmenge der kleinsten für die Ladungszufuhr/-abfuhr verwendeten Ladungspakete ist.

In anderen Worten, wie gerade und in den Ausführungen zu Fig. 41A dargelegt, hängt die Genauigkeit, mit der die Spannung an den Schaltungsknoten 3202 auf die vorbestimmte Spannung "$V_{pixRef}$ gesetzt wird, von der Größe der zu-/abgeführten Ladungspakete ab. Das Setzen der Spannung an dem Schaltungsknoten 3202 auf die vorbestimmte Spannung erfolgt indirekt und als Schlussfolgerung aus der Ladungszufuhr und einem oder mehrerer Vorzeichenwechsel. Das Ergebnis des Setzens des Schaltungsknotens auf die vorbestimmte Spannung enthält einen Restfehler zwischen der Differenz an dem Schaltungsknoten und der Referenzspannung $V_{comp}$, die jedoch bekannt ist bzw. vorgegeben werden kann bzw. durch die minimale Ladungsmenge des kleinsten Ladungspakets eingestellt werden kann.

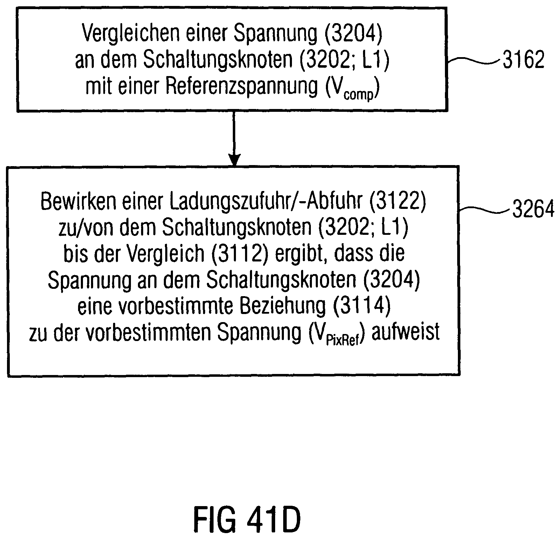

Fig. 41D zeigt ein Flussdiagramm eines Verfahrens 3260 zum Setzen eines Schaltungsknotens 3202 auf eine vorbestimmte Spannung $V_{PixRef}$. Das Verfahren 3260 umfasst das Vergleichen 3162 einer Spannung 3204 an dem Schaltungsknoten 3202 mit einer Referenzspannung $V_{comp}$ und dem Bewirken 3264 einer Ladungszufuhr/-abfuhr zu von dem Schaltungsknoten 3202 bis der Vergleich 3114 ergibt, dass die Spannung 3204 an dem Schaltungsknoten 3202 eine vorbestimmte Beziehung zu der vorbestimmten Spannung $V_{pixRef}$ aufweist.

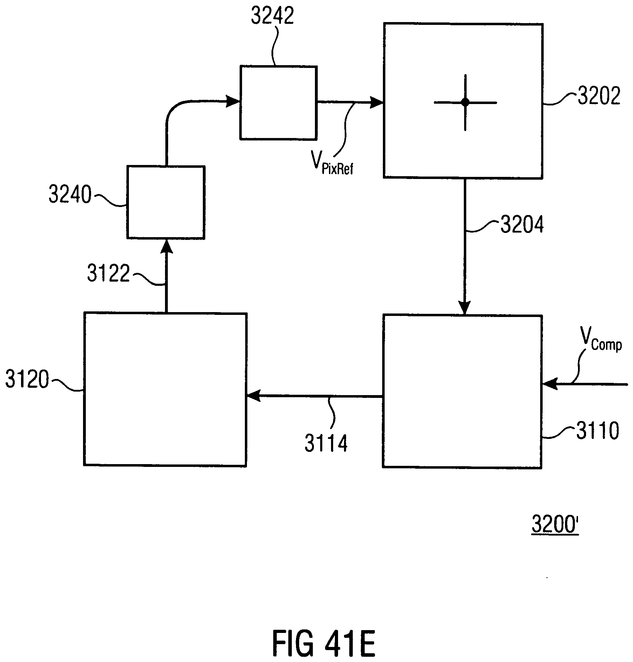

Fig. 41E zeigt einen Aspekt einer Vorrichtung zum Setzen 3200' eines Schaltungsknotens 3202 auf eine vorbestimmte Spannung $V_{PixRef}$, mit den Elementen aus Fig. 41C, wobei diese im Gegensatz zu der Fig. 41C zusätzlich ein inneres kapazitives Element 3240 und eine Treiberstufe 3242 aufweist.

Gemäß Fig. 41E ist der Schaltungsknoten 3202 mit einem Ausgang der Treiberstufe 3242 gekoppelt und das kapazitive Element 3240 mit einem Eingang der Treiberstufe 3242 gekoppelt. Die Einrichtung 3120 zum Bewirken ist ausgebildet, eine Ladungszufuhr/-abfuhr 3122 zu/von dem kapazitiven Element 1240 und nicht direkt zu dem Knoten 3202 zu bewirken.

Eine Vorrichtung gemäß Fig. 41E ermöglicht es, die Spannung 3204 an dem Schaltungsknoten 3202 konstant zu halten bzw. unabhängiger von einem möglichen Ladungsabfluss zu gestalten, beispielsweise bei einer Kopplung des Schaltungsknotens als Referenzspannungsgeber mit kapazitiven Elementen oder Knoten mit anderen Spannungspotentialen.

Aspekte einer Vorrichtung gemäß Fig. 41E mit einer Treiberstufe 3242 und einem kapazitiven Element 3240 werden später anhand von Fig. 5 näher erläutert.

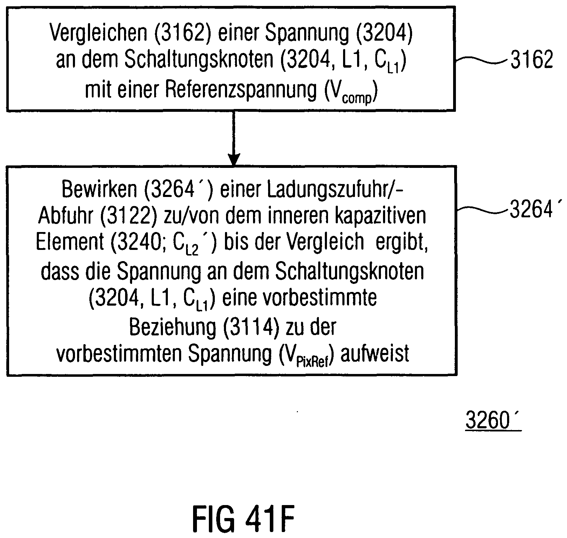

Fig. 41F zeigt ein Flussdiagramm eines Aspekts eines Verfahrens 3260' zum Setzen eines Schaltungsknotens 3202 auf eine vorbestimmte Spannung $V_{PixRef}$.

Das Verfahren 3260' umfasst das Vergleichen 3162 einer Spannung 3204 an dem Schaltungsknoten 3202 mit einer Referenspannung $V_{comp}$, wobei der Schaltungsknoten 3202 mit einem Ausgang einer Treiberstufe 3242 gekoppelt und ein kapazitives Element 3240 mit einem Eingang der Treiberstufe 3242 gekoppelt ist. Ferner umfasst das Verfahren 3260' den Schritt bewirken 3264' einer Ladungszufuhr/-abfuhr zu/von dem kapazitiven Element 3240 bis der Vergleich 3114 ergibt, dass die Spannung 3204 an dem Schaltungsknoten 3202 eine vorbestimmte Beziehung zu der vorbestimmten Spannung $V_{PixRef}$ aufweist.

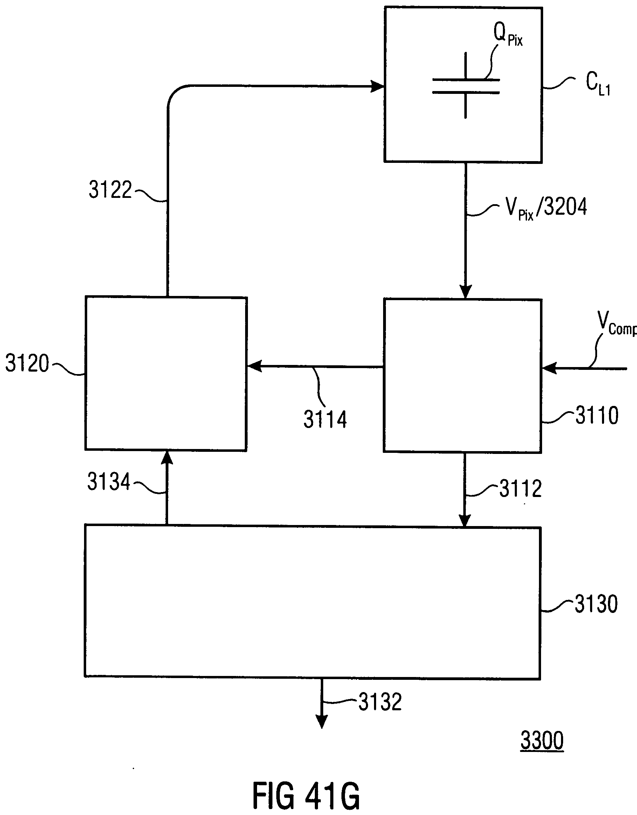

Fig. 41G zeigt einen Aspekt einer Vorrichtung 3300 zum Bestimmen einer Ladungsmenge $Q_{Pix}$ auf einem kapazitiven Element $C_{L1}$ wie sie anhand von Fig. 41A beschrieben ist, die zusätzlich eine Vorrichtung 3200 zum Setzen des kapazitiven Elements $C_{L1}$ auf eine vorbestimmte Spannung $V_{PixRef}$ analog zu Fig. 41C aufweist.

Dabei ist die Vorrichtung 3300 ausgebildet, in einem ersten Betriebsmodus, der auch als Ladungsbestimmungs-Modus bezeichnet werden kann, gemäß den Aspekten der Fig. 41A und101B auf die Ladung $Q_{Pix}$ auf dem kapazitiven Element $C_{L1}$ rückzuschließen bzw. diese als analogen oder digitalen Wert 3132 auszugeben, und in einem zweiten Betriebsmodus, der auch als Rücksetzmodus bezeichnet werden kann, die Spannung an dem kapazitiven Element $C_{L1}$ auf eine vorbestimmte Spannung $V_{comp}$ bzw. $V_{PixRef}$ zu setzen.

In dem ersten Betriebsmodus bzw. Ladungsbestimmungsmodus wird zum Bestimmen der Ladung $Q_{Pix}$ auf dem kapazitiven Element $C_{L1}$ Ladung 3122 zu-/abgeführt bis die Ladung $Q_{Pix}$ im Rahmen der Genauigkeit, die wie schon zuvor erläutert wurde, von dem kleinsten Ladungspaket, das bei der Ladungsbestimmung zu-/abgeführt wird, vorgegeben ist, bestimmt. In Anwendungen, bei denen eine grobe Bestimmung der Ladung $Q_{Pix}$ ausreichend ist, bei denen beispielsweise nur eine einstufige Schwellwertbestimmung mittels eines einzelnen Ladungspakets erfolgt, verbleibt somit eine Restladung auf dem kapazitiven Element $C_{L1}$, die ggf. eine folgende Ladungsbestimmung verfälscht bzw. für eine solche nicht vernachlässigbar ist. Dies gilt unabhängig davon, ob die darauffolgende Ladungsbestimmung wieder nur eine grobe Ladungsbestimmung oder eine feinere Ladungsbestimmung ist.

Mit denselben Funktionselementen, mit denen zuvor die Ladungsbestimmung durchgeführt wurde, kann nun die Spannung bzw. die Restladung auf dem kapazitiven Element $C_{L1}$ auf eine vorgegebene Spannung bzw. vorgegebene Ladung zurückgesetzt werden: die Einrichtung zum Vergleichen 3110, die Einrichtung zum Bewirken 1120, und ggf. auch die Einrichtung 3130 in der Funktion einer Steuerung, die die Einrichtung 3120 zum Bewirken einer Ladungszufuhr/-abfuhr steuert, bis der Vergleich ergibt, dass die Spannung an dem kapazitiven Element $C_{L1}$ der vorbestimmten Spannung entspricht.

Im Gegensatz zu einem impliziten Rücksetzen durch das Bestimmen der Ladung wird bei dem Rücksetzen der Restladung bzw. der Restspannung kein Zähler mehr benötigt und kann parallel zu einer weiteren Signalverarbeitung des Ergebnisses der Ladungsbestimmung erfolgen.

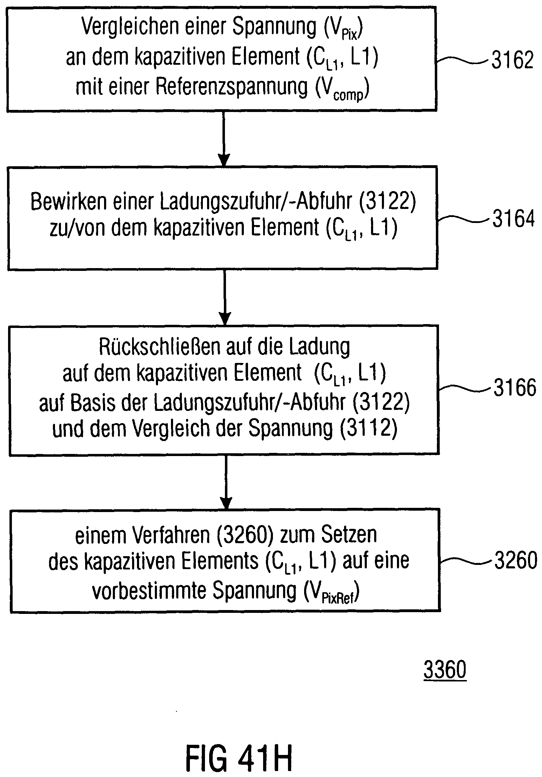

Fig. 41H zeigt ein Flussdiagramm eines Aspekts eines Verfahrens 3360 zum Bestimmen einer Ladungsmenge $Q_{Pix}$ auf einem kapazitiven Element $C_{L1}$, das Schritte des Verfahrens zum Bestimmen einer Ladungsmenge 3160 gemäß Fig. 41B und Schritte des Verfahrens zum Setzen des kapazitiven Elements auf eine vorbestimmte Spannung gemäß Fig. 41D aufweist.

Im Einzelnen umfasst das Verfahren 3360 den Schritt Vergleichen 3162 einer Spannung $V_{Pix}$ an dem kapazitiven Element $C_{L1}$ mit einer Referenzspannung $V_{comp}$ und den Schritt Bewirken 3164 einer Ladungszufuhr/-abfuhr zu/von dem kapazitiven Element $C_{L1}$. Im Schritt 3166 wird auf Basis der Ladungszufuhr-/abfuhr 3122 und dem Vergleich der Spannung 3112 auf die Ladung $Q_{Pix}$ auf dem kapazitiven Element $C_{L1}$ rückgeschlossen. Zudem umfasst das Verfahren 3160 das Setzen des kapazitiven Elements $C_{L1}$ auf eine vorbestimmte Spannung $V_{PixRef}$ durch Vergleichen der Spannung an dem kapazitiven Element $C_{L1}$ mit einer Referenzspannung $V_{comp}$ und dem Schritt Bewirken 3264 einer Ladungszufuhr/-abfuhr zu/von dem kapazitiven Element $C_{L1}$ bis sich der Vergleich ergibt, dass die Spannung an dem kapazitiven Element $C_{L1}$ der vorbestimmten Spannung entspricht.

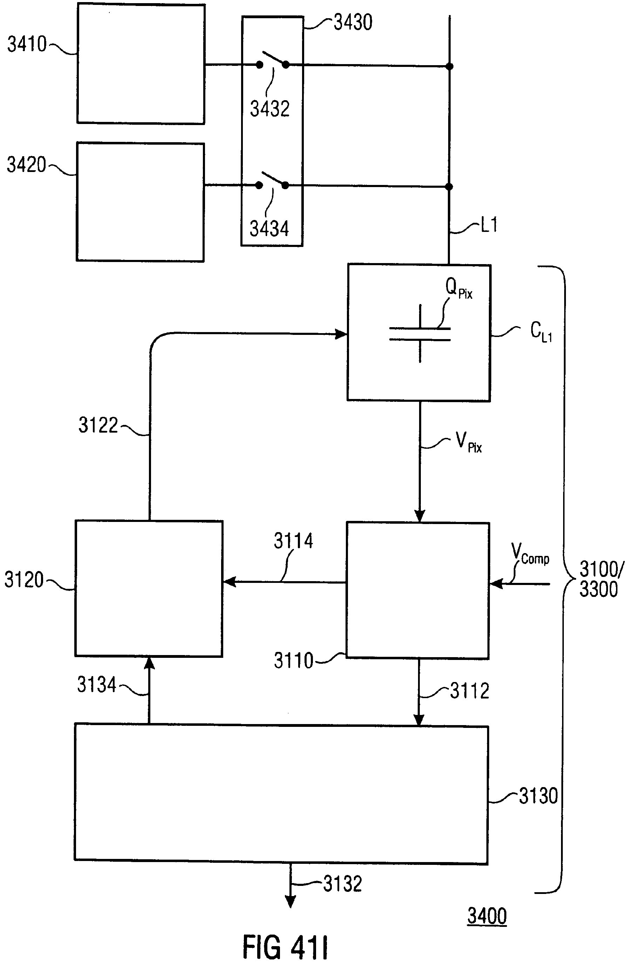

Fig. 41I zeigt ein Blockdiagramm eines Aspekts einer Vorrichtung 3400 zur ladungsbasierten Signalverarbeitung mit einem kapazitiven Element $C_{L1}$, einem ersten Ladungsgeber 3410, einem zweiten Ladungsgeber 3420, einer Ladungsgebersteuerung 3430, und einer Vorrichtung 3100, 3300 zum Bestimmen einer Ladungsmenge $Q_{Pix}$ auf dem kapazitiven Element $C_{L1}$.

Der erste und zweite Ladungsgeber 3410, 3420 können jeweils auch als erste und zweite Vorrichtung zur Ausgabe einer ersten bzw. zweiten Ladungsmenge bezeichnet werden und sind beispielsweise eine Pixelzelle 100 gemäß Fig. 39A. Weitere mögliche Ladungsgeber sind aktive und/oder passive Sensoren, die abhängig von einer zu messenden Größe eine entsprechende Ladungsmenge erzeugen, die von diesen Ladungsgebern bzw. Sensoren dann ausgegeben werden kann.

Der Ladungsgeber kann jedoch beispielsweise auch eine Stromspeichervorrichtung 120 sein, die einen eingeprägten Strom für eine gegebene Auslesezeit $\tau_{out}$ ausgibt, also damit eine Ladung abhängig von dem eingeprägten Strom ausgibt.

Dieser eingeprägte Strom kann von einem Messstrom wie in Pixelzelle 100 stammen, kann jedoch auch allgemein eine Information sein, die in Form des eingeprägten Stroms gespeichert wird, um diese dann mit der Vorrichtung 3400 weiter zu verarbeiten.

Das kapazitive Element $C_{L1}$ kann die Leitungskapazität einer Leitung L1 sein oder ein zusätzliches kapazitives Element, z.B. ein Kondensator sein, wobei sich dann die Gesamtkapazität $C_{L1}$ aus der Leitungskapazität der Leitung L1 und der des Kondensators ergibt.

Die Ladungsgebersteuerung 3430 kann ausgebildet sein, nur den ersten oder den zweiten, oder beide gleichzeitig mit der Leitung L1 bzw. dem kapazitiven Element $C_{L1}$ zu koppeln. Die Ladungsgebersteuerung 3430 kann beispielsweise Transistorschalter aufweisen, um den ersten und zweiten Ladungsgeber 3410, 3420 mit der Leitung L1 zu koppeln, kann jedoch auch alternative Kopplungselemente aufweisen.

Die Ladungsgebersteuerung 3430 weist beispielsweise ein erstes Kopplungselement 3432 auf, um den ersten Ladungsgeber 3410 mit der Leitung L1 einzukoppeln und ein zweites Kopplungselement 3434 auf, um den zweiten Ladungsgeber 3420 mit der Leitung L1 zu koppeln. Bei der ladungsbasierten Signalverarbeitung können die Ladungen des ersten und zweiten Ladungsgebers 3410, 3420 gleichzeitig ausgelesen werden, um diese auf die Leitung bzw. auf das kapazitive Element $C_{L1}$ zu addieren oder auch nacheinander oder nur teilweise gleichzeitig, d.h. zeitlich versetzt. Weitere Aspekte der Vorrichtung zur ladungsbasierten Signalverarbeitung können auch ein invertierendes Element aufweisen, um beispielsweise eine Ladung bzw. den entsprechenden Strom des ersten und/oder zweiten Ladungsgebers 3410, 3420 mit umgekehrten Vorzeichen auszugeben, um eine Subtraktion der Ladungen des ersten Ladungsgebers 3410 und des zweiten Ladungsgebers 3420 zu realisieren. Eine Möglichkeit, die Ladung bzw. den Strom zu invertieren, ist die Stromspeichervorrichtung, die anhand von Fig. 39A schon beschrieben wurde, und die bei entsprechender Kopplung mit dem Ausgang der Stromspeicherzelle 3410 oder 3420 den eingeprägten Strom mit umgekehrten Vorzeichen ausgibt.

Ferner können über eine Veränderung der Auslesedauer $T_{out}$ die Ausgabe der Ladungsgeber 3410, 3420 gewichtet werden, insbesondere bei Ladungsgebern 3410, 3420, die einen konstanten Strom ausgeben, so dass durch eine Verdopplung der Auslesezeit $T_{out}$ beispielsweise eine Verdopplung der Ladungsmenge bzw. des Signals realisiert werden kann.

Wird beispielsweise eine Pixelzelle 100, als erster und/oder zweiter Ladungsgeber 3410, 3420 eingesetzt, so kann die Differenz eines Stroms oder einer Ladung aus zwei Messzyklen direkt in den Pixelzellen 3420, 3430 gebildet werden und über das Kopplungselement 3432 bzw. 3434 auf die Leitung gegeben werden und beispielsweise über die Vorrichtung zum Bestimmen 3100, 3300 eine einzelne Differenzladungsmenge einer Pixelzelle bestimmt werden. Alternativ können aber auch die Differenzladungen mit anderen Ladungen gemeinsam auf das kapazitive Element $C_{L1}$ addiert werden, um dann entsprechende Gesamtladung zu bestimmen.

Die Vorrichtung zum bestimmten der Ladungsmenge $Q_{Pix}$ auf dem kapazitiven Element $C_{L1}$ kann beispielsweise gemäß den Aspekten 3100 (siehe Fig. 41A) oder 3300 (siehe Fig. 41G) realisiert sein.

Wie zuvor anhand der Fig. 41A und 101G erläutert, kann die Vorrichtung 3100, 3300 zum Bestimmen ausgebildet sein, einen analogen oder digitalen Wert 3132 auszugeben, der die Ladungsmenge $Q_{Pix}$ repräsentiert.

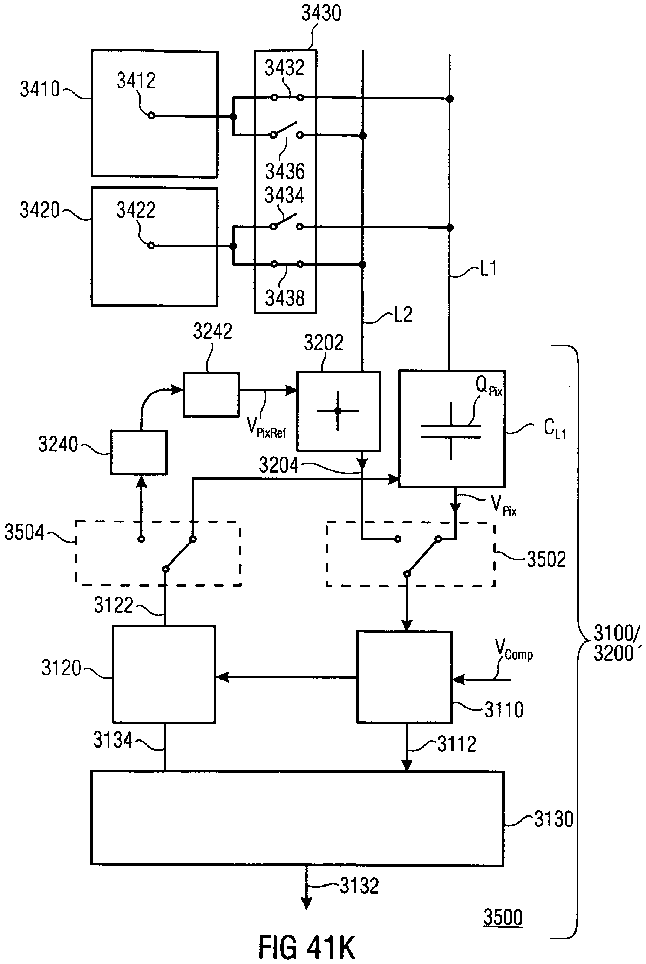

Damit realisieren Aspekte gemäß Fig. 41K eine analoge Signalverarbeitung für analoge Ladungen der Ladungsgeber 3410, 3420 über die getrennte und/oder gemeinsame Kopplung auf die Leitung L1 bzw. das kapazitive Element $C_{L1}$ (Addition, Subtraktion von Ladungen verschiedener Ladungsgeber, z.B. für räumliche Differenzbildung zwischen benachbarten Zellen, etc.) und/oder in den Ladungsgebern 3410, 3420 selbst, siehe z.B. den Aspekt der Pixelzelle 100 mit der Differenzbildung in der Pixelzelle selbst, die auch bei anderer Verschaltung eine Addition zweier aufeinanderfolgender Ladungen bzw. Ströme erlaubt, bzw. eine Signalinvertierung durch die Stromspeichervorrichtung.

Abhängig von der Realisierung der Vorrichtung 3100, 3300 zum Bestimmen der Ladungsmenge $Q_{Pix}$ und der Art der Ausgabe 3132 des Wertes (analog oder digital), der die Ladung repräsentiert realisiert der Aspekt gemäß Fig. 41I eine analoge Signalverarbeitung oder eine gemischt analog-digitale Signalverarbeitung.

Unabhängig davon ist die erste Stufe der Signalverarbeitung im analogen Bereich: ladungsgeberparallel bzw. pixelzellenparallel (z.B. Differenzbildung im Ladungsgeber bzw. Invertierung im Ladungsgeber) oder leitungsparallel (Addition, Subtraktion, Gewichtung der Ladungsgeber pro Leitung, bei Vorrichtungen zur ladungsbasierten Signalverarbeitungen mit mehreren parallelen Vorrichtungen 3400 zur ladungsbasierten Signalverarbeitung).

Die Digitalisierung wird erst in einer zweiten Verarbeitungsstufe durchgeführt, so dass die gesamte Signalverarbeitung der Ladungen bzw. Informationen effizienter erfolgen kann. Dies wird später anhand des Beispiels der Weißlicht-Interferometrie noch näher erläutert.

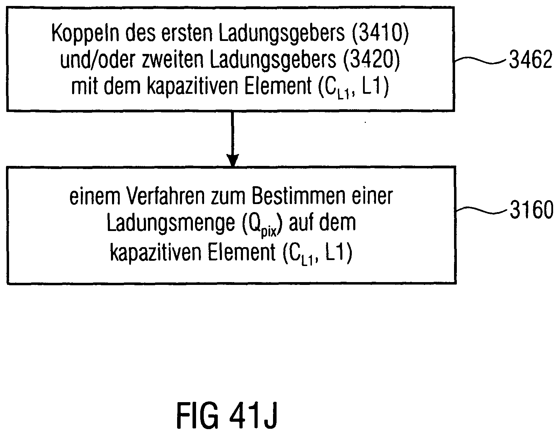

Fig. 41J zeigt ein Flussdiagramms eines Verfahrens 3460 zur ladungsbasierten Signalverarbeitung mit einem kapazitiven Element $C_{L1}$, einem ersten Ladungsgeber 3410, einem zweiten Ladungsgeber 3420.

Bei dem Verfahren 3460 zur ladungsbasierten Signalverarbeitung werden in einem Schritt 3462 der erste Ladungsgeber und/oder der zweite Ladungsgeber mit dem kapazitivem Element $C_{L1}$ gekoppelt, und in einem Schritt 3160 eine Ladungsmenge $Q_{Pix}$ auf dem kapazitivem Element $C_{L1}$ bestimmt. Der Schritt des Bestimmens 3160 der Ladungsmenge umfasst die Schritte Vergleichen 3162 einer Spannung $V_{Pix}$ an dem kapazitiven Element $C_{L1}$ mit einer Referenzspannung $V_{comp}$, das Bewirken 3164 einer Ladungszufuhr/-abfuhr von dem kapazitiven Element $C_{L1}$, und das Rückschließen 3166 auf die Ladung $Q_{Pix}$ auf dem kapazitiven Element $C_{L1}$ auf Basis der Ladungszufuhr/-abfuhr und dem Vergleich der Spannung $V_{Pix}$.

Fig. 41K zeigt ein Blockschaltbild eines weiteren Aspekts einer Vorrichtung 3500 zur ladungsbasierten Signalverarbeitung mit einem ersten Ladungsgeber 3410 mit einem Ausgangsknoten 3412, und einem zweiten Ladungsgeber 3420 mit einem Ausgangsknoten 3422. Der erste Ladungsgeber und der zweite Ladungsgeber 3410, 3420 sind ausgebildet, an ihrem Ausgangsknoten 3412, 3422 eine Ladung bzw. einen Strom für eine bestimmte Zeit auszugeben. Ein Beispiel für den ersten und/oder zweiten Ladungsgeber 3410, 3420 ist die Pixelzelle 100, wobei der Ausgangsknoten 104 der Pixelzelle dem Ausgangsknoten 3412 bzw. 3422 entspricht. Alternativ können jedoch auch andere Ladungsgeber eingesetzt werden, wie dies in Bezug auf die Vorrichtung 3400 zur ladungsbasierten Signalverarbeitung erläutert wurde.

Die Vorrichtung 3500 weist ferner eine erste Leitung L1, eine zweite Leitung L2 und eine Ladungsgebersteuerung 3430 auf, um den Ausgangsknoten 3412 des ersten Ladungsgebers 3410 und/oder den Ausgangsknoten 3422 des zweiten Ladungsgebers 3420 mit der ersten Leitung und/oder der zweiten Leitung zu koppeln.

Die Ladungsgebersteuerung 3430 weist ein erstes Schaltelement 3432 auf, um den ersten Ladungsgeber 3410 mit der ersten Leitung zu koppeln, ein zweites Schaltungselement 3434 auf, um den zweiten Ladungsgeber 3420 mit der ersten Leitung zu koppeln, ein drittes Schaltelement 3436, um den ersten Ladungsgeber 3410 mit der zweiten Leitung zu koppeln und ein viertes Schaltelement 3438, um den zweiten Ladungsgeber 3420 mit der zweiten Leitung L2 zu koppeln.

Die erste Leitung L1 bildet das erste kapazitive Element $C_{L1}$ oder ist mit einem kapazitiven Element $C_{L1}$ gekoppelt, wie dies in Bezug auf die Vorrichtung 3400 erläutert ist. Die zweite Leitung L2 bildet den Schaltungsknoten 3200 bzw. ist mit diesem gekoppelt.

Über ein fünftes Schaltelement 3502 kann das kapazitive Element $C_{L1}$ bzw. L1 oder der Schaltungsknoten 3202 bzw. die Leitung L2 mit der Vorrichtung 3110 zum Vergleichen gekoppelt werden. Die Vorrichtung 3110 ist ausgebildet, die Spannung $V_{Pix}$ auf dem kapazitiven Element $C_{L1}$ oder die Spannung 3204 an der zweiten Leitung L2 mit einer Referenzspannung $V_{comp}$ zu vergleichen.

Die Einrichtung 3120 zum Bewirken einer Ladungszufuhr/- abfuhr 3122 kann über ein sechstes Schaltelement 3504 mit dem kapazitiven Element $C_{L1}$ bzw. L1 oder mit einem zweiten kapazitiven Element bzw. inneren kapazitiven Element 3240 gekoppelt werden, um Ladung von/zu dem kapazitiven Element $C_{L1}$ oder zu/von dem inneren kapazitiven Element 3240 zu-bzw. abzuführen.

In einem ersten Betriebsmodus, der auch als Ladungsbestimmungsmodus bezeichnet werden kann, koppelt das fünfte Schaltelement 3502 das erste kapazitive Element $C_{L1}$ mit der Vorrichtung 3110 zum Vergleichen und das sechste Schaltelement 3504 die Vorrichtung 3120 zum Bewirken einer Ladungszufuhr/-abfuhr mit dem kapazitiven Element $C_{L1}$. In diesem Ladungsbestimmungsmodus bilden das kapazitive Element $C_{L1}$, die Vorrichtung 3110 zum Vergleichen, die Vorrichtung 3120 zum Bewirken und die Vorrichtung 3130 zum Rückschließen eine Vorrichtung 3100, 3300 zum Bestimmen einer Ladungsmenge $Q_{Pix}$ auf dem kapazitiven Element $C_{L1}$, wie es z.B. anhand der Fig. 41A erläutert ist.

In einem zweiten Betriebsmodus, der auch als Kalibrierungsmodus bezeichnet werden kann, koppelt das fünfte Schaltelement 3502 die zweite Leitung L2 mit der Einrichtung 3110 zum Vergleichen und das sechste Schaltelement 3504 die Einrichtung 3120 zum Bewirken mit dem inneren kapazitiven Element 3240. In diesem Kalibrierungsmodus bilden die zweite Leitung L2 bzw. der Schaltungsknoten 3202, die Einrichtung 3110 zum Vergleichen, die Einrichtung 3120 zum Bewirken einer Ladungszufuhr/-abfuhr, das innere kapazitive Element 3240 und die Treiberstufe 3242 eine Vorrichtung 3200' zum Setzen eines Schaltungsknotens bzw. einer Leitung L2 auf eine vorbestimmte Spannung $V_{pixRif}$, wie dies anhand der Fig. 41E beschrieben ist. Alternativ kann auch eine Vorrichtung 3100 zum Setzen eines Schaltungsknoten bzw. einer Leitung in der Vorrichtung 3500 verwendet werden.

Im Folgenden werden Gemeinsamkeiten und Unterschiede der Vorrichtung 3500 gegenüber der Vorrichtung 3400 näher erläutert.

Wie schon anhand von Fig. 41I in Bezug auf die Vorrichtung 3400 dargelegt, kann über die Ladungsgeberschaltung 3430 bzw. das erste und zweite Schaltelement 3432, 3434 der erste und/oder der zweite Ladungsgeber 3410, 3420 mit der ersten Leitung L1 bzw. dem kapazitiven Element $C_{L1}$ gekoppelt werden, um die Ladungen, die an den Ausgangsknoten 3412 bzw. 3422 des ersten und/oder zweiten Ladungsgebers 3410, 3420 anliegen, auf das kapazitive Element $C_{L1}$ auszugeben. In dem Ladungsbestimmungsmodus ist die Vorrichtung 3500 dann ausgebildet, die Ladung $Q_{Pix}$ auf dem kapazitiven Element $C_{L1}$ zu bestimmen, und als analogen oder digitalen Wert 3132 zu bestimmen.

Zusätzlich ist die Vorrichtung 3500 jedoch ausgebildet, die zweite Leitung L2 als Referenz für die Ausgangsknoten der Ladungsgeber auf eine vorbestimmte Spannung $V_{PixRef}$ zu setzen. Werden die Ausgangsknoten 3412, 3422 des ersten Ladungsgebers 3410, und des zweiten Ladungsgebers 3420 über das dritte und vierte Schaltelement 3436, 3438 mit der zweiten Leitung L2 gekoppelt, so werden auch die Ausgangsknoten 3412, 3422 auf das bestimmte Spannungspotential $V_{PixRif}$ gesetzt. Dies kann auch als Kalibrierungsmodus bzw. Spannungsrücksetzmodus bezeichnet werden.

Wie zuvor anhand der Pixelzelle in der Fig. 39A dargelegt, kann das Spannungspotential des Ausgangsknotens der Pixelzelle nicht vernachlässigt werden, da ansonsten ein unbestimmter Ladungsoffset zw. Spannungsoffset besteht, der die Genauigkeit der Ladungsbestimmung beeinträchtigen kann. Die Vorrichtung zum Setzen der Leitung L2 auf eine vorbestimmte Spannung zusammen mit der Ladungsgebersteuerung 3430 ermöglichen so, die Schaltungsgeber bzw. die Ausgangsknoten der Schaltungsgeber auf ein definiertes Spannungspotential zu setzen, um die Genauigkeit der ladungsbasierten Signalverarbeitung zu erhöhen. Das Setzen der zweiten Leitung L2 auf das bestimmte Potential $V_{PixRef}$ kann beispielsweise in regelmäßigen Abständen durchgeführt werden, um parasitäre Effekte und damit verbundene Spannungsveränderungen an der zweiten Leitung zu kompensieren.

Die zusätzlichen Elemente, inneres kapazitives Element 3240 und Treiberstufe 3242 ermöglichen es, die Leitung L2 auf das vorbestimmte Spannungspotential $V_{PixRef}$ zu setzen, und diese auf diesen Spannungspotential zu fixieren, da die Treiberstufe 3242 verhindert, dass bei einem Koppeln der zweiten Leitung L2 mit einem oder mehreren Ausgangsknoten der Ladungsgeber und dem damit verbundenen Ladungsfluss, das innere kapazitive Element bzw. dessen Spannung verändert wird bzw. bewirkt, dass dieses nahezu unverändert bestehen bleibt. Somit ist es möglich, eine Vielzahl von Ausgangsknoten verschiedener Ladungsgeber auf ein gemeinsames vorbestimmtes Spannungspotential $V_{PixRif}$ zu setzen.

Fig. 41K zeigt die Vorrichtung 3500 in einem Ladungsbestimmungsmodus (siehe Stellung der Schaltelemente 3502, 3504), wobei in diesem Fall der Ausgangsknoten 3412 des ersten Ladungsgebers 3410 mit der ersten Leitung L1 gekoppelt ist, und von der zweiten Leitung L2 entkoppelt ist, um eine Ladung des ersten Ladungsgebers 3410 auf das kapazitive Element $C_{L1}$ zu laden und darüber die Ladung des ersten Ladungsgebers zu bestimmen. Der zweite Ladungsgeber 3420 wird gemäß Fig. 41K gesetzt bzw. die Spannung des Ausgangsknotens 3422 des zweiten Ladungsgebers 3420 wird auf das vorbestimmte Potential $V_{PixRef}$ gesetzt, indem das zweite Schaltelement 3434 den Ausgangsknoten 3422 von der ersten Ladung entkoppelt und das vierte Schaltelement 3438 die zweite Leitung L2 mit dem Ausgangsknoten 3422 koppelt. Die Schalterstellung zweites Schaltelement 3434 entkoppelnd und viertes Schaltelement 3438 koppelnd, kann daher auch als Rücksetzmodus des zweiten Ladungsgebers 3420 bezeichnet werden. Entsprechendes gilt für den ersten Ladungsgeber. Die Schaltelementstellung erstes Schaltelement 3432 koppelnd und drittes Schaltelement 3436 entkoppelnd kann auch als Auslesemodus des ersten Ladungsgebers bezeichnet werden, entsprechendes gilt für den zweiten Ladungsgeber.

In Vorrichtung 3500 zur ladungsbasierten Signalverarbeitung können eine oder mehrere Ladungsgeber gleichzeitig mit der ersten Leitung L1 gekoppelt werden, und ein oder mehrere Ladungsgeber mit der zweiten Leitung L2. Jeder Ladungsgeber bzw. dessen Ausgangsknoten wird typischerweise in dem Rücksetzmodus auf die vorbestimmte Spannung $V_{PixRef}$ gesetzt, bevor die Ladung auf den Ausgangsknoten der Ladungsgeber gegeben wird, um diese in dem Auslesemodus auszulesen und zu verarbeiten bzw. zu bestimmen. Das Setzen bzw. Rücksetzen der Ausgangsknoten der Ladungsgeber kann beispielsweise sequentiell erfolgen. Bei einer Signalverarbeitung, bei der die Ladung der einzelnen Ladungsgeber einzeln bestimmt werden, kann z.B. ein Ladungsgeber, hier beispielsweise der erste Ladungsgeber 3410, ausgelesen werden bzw. dessen Ladung bestimmt werden, während in Richtung der Reihenfolge der Ladungen der einzelnen Ladungsgeber, der nächstfolgende Ladungsgeber, in Fig. 41K beispielsweise der zweite Ladungsgeber 3420 gleichzeitig auf das vorbestimmte Spannungspotential gesetzt wird, um in einem nächsten Zyklus bzw. Takt das Auslesen einer Ladung aus dem zweiten Ladungsgeber 3420 vorzubereiten.

Abhängig von der Art der Signalverarbeitung (Signalverarbeitung der Ladungen einzelner Zellen oder mehrerer Zellen) können einzelne oder mehrere Zellen gleichzeitig auf die vorbestimmte Spannung gesetzt werden, während eine oder mehrere andere Ladungsgeber ausgelesen werden.

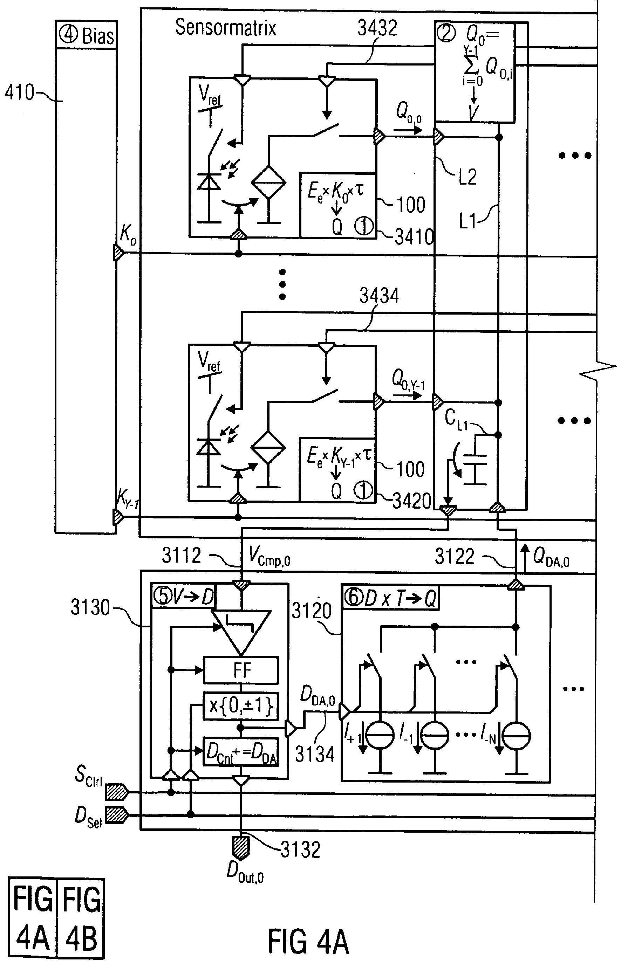

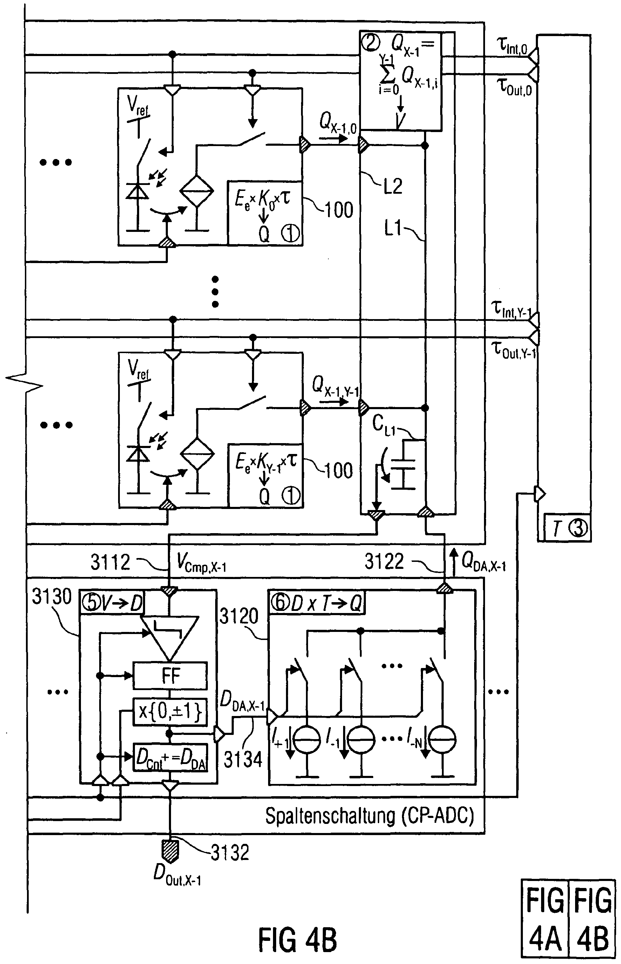

Ähnlich wie anhand von Fig. 41I erläutert, können mehrere Vorrichtungen 3500 zur ladungsbasierten Signalverarbeitung parallel eingesetzt werden, um parallel Ladungen einer oder mehrerer Ladungsgeber zu bestimmen. In Fig. 4 wird ein Beispiel für einen Bildsensor mit einer Mehrzahl von Pixelzellen, die mit mehreren parallelen Vorrichtungen zur ladungsbasierten Signalverarbeitung gekoppelt werden können, beschrieben.

Dabei kann die Ladungsgebersteuerung 3430 eine separate Schaltung sein, oder in den Ladungsgebern integriert sein, z.B. das erste Schaltelement 3432 und das dritte Schaltelement 3436 in dem ersten Ladungsgeber 3410 und das zweite Schaltelement 3434 und das vierte Schaltelement 3438 in dem zweiten Ladungsgeber 3420 integriert sein.

Ein weiterer Aspekt der Vorrichtung 3500 zu ladungsbasierten Signalverarbeitung wird anhand von Fig. 4 und 5 näher beschrieben.

Gemäß einem weiteren Aspekt in Anlehnung an die Vorrichtung 3500 zur ladungsbasierten Ladungsverarbeitung kann die Spannung an der zweiten Leitung L2 auch kontinuierlich auf die Spannung der ersten Leitung L1 beziehungsweise des kapazitiven Elements $C_{L1}$ gesetzt werden bzw. dieser folgen. Dabei wird durch eine Einrichtung zum Setzen der zweiten Leitung auf eine Spannung der ersten Leitung die Spannung der ersten Leitung L1 während der Ladungswandlung der Ladung $Q_{Pix}$ auf der ersten Leitung L1 beziehungsweise dem kapazitiven Element $C_{L1}$ kontinuierlich an die aktuelle Spannung auf der ersten Leitung L1 angepasst, so dass nach Abschluss der Ladungswandlung die zweite Leitung L2 eine Spannung aufweist, die der Spannung der ersten Leitung L1 entspricht, und somit auch die Ausgangsknoten der Ladungsgeber entsprechend auf die Spannung der ersten Leitung gesetzt werden können. Das Setzen der zweiten Leitung L2 auf die Spannung der ersten Leitung L1 kann dabei beispielsweise durch einen hochpräzisen Operationsverstärker erfolgen, und erfolgt beispielsweise schneller als die Ladungszufuhr/-Abfuhr zu/von der ersten Leitung L1 beziehungsweise dem kapazitiven Element $C_{L1}$, um Überschwingungen zu vermeiden.

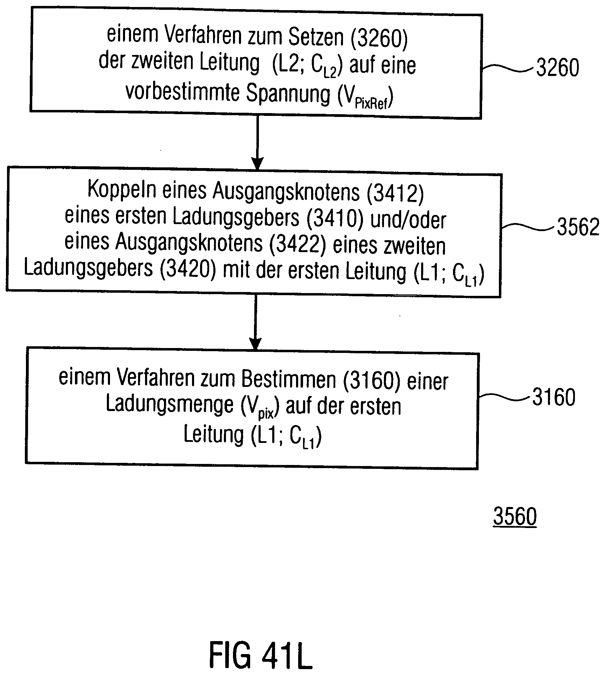

In Fig. 41L wird ein Flussdiagramm eines Aspekts eines Verfahrens 3560 zur ladungsbasierten Signalverarbeitung mit einem ersten Ladungsgeber 3410, einem zweiten Ladungsgeber 3420, einer ersten Leitung L1, einer zweiten Leitung L2 gezeigt, wobei die zweite Leitung L2 mit einem Ausgang einer Treiberstufe 3242 gekoppelt ist und ein inneres kapazitives Element 3420 mit einem Eingang der Treiberstufe 3442 gekoppelt ist.

Das Verfahren 3560 umfasst das Verfahren Setzen 3260 einer zweiten Leitung auf eine vorbestimmte Spannung $V_{PixRef}$, wobei das Setzen der zweiten Leitung die Schritte Vergleichen 3162 einer Spannung 3204 an der zweiten Leitung L2 mit einer Referenzspannung $V_{comp}$, und Bewirken 3164 einer Ladungszufuhr/-Abfuhr zu/von dem inneren kapazitiven Element 3240 umfasst, bis der Vergleich ergibt, dass die Spannung an der zweiten Leitung der vorbestimmten Spannung entspricht.

Zudem umfasst das Verfahren 3560 das Koppeln (3562) eines Ausgangsknotens (3412) eines ersten Ladungsgebers (3410) und/oder eines Ausgangsknotens (3422) eines zweiten Ladungsgebers (3420) mit der ersten Leitung (L1; $C_{L1}$), um eine Ladung von einem oder mehreren Ausgangsknoten bzw. Ladungsgebern auf die Leitung auszugeben.

Das Verfahren 3560 umfasst ferner das Verfahren 3160 zum Bestimmen einer Ladungsmenge $V_{Pix}$ auf der ersten Leitung L1, wobei das Bestimmen der Ladungsmenge folgende Schritte beinhaltet, Vergleichen 3162 einer Spannung $V_{Pix}$ auf der ersten Leitung L1, wobei das Bestimmen der Ladungsmenge folgende Schritte beinhaltet, Vergleichen 3162 einer Spannung $V_{Pix}$ an der ersten Leitung L1 mit der Referenzspannung $V_{comp}$, Bewirken 3164 einer Ladungszufuhr/-Abfuhr zu/von der ersten Leitung, und Rückschließen 3166 auf die Ladung $V_{Pix}$ auf Basis der Ladungszufuhr/-abfuhr und dem Vergleich der Spannung.

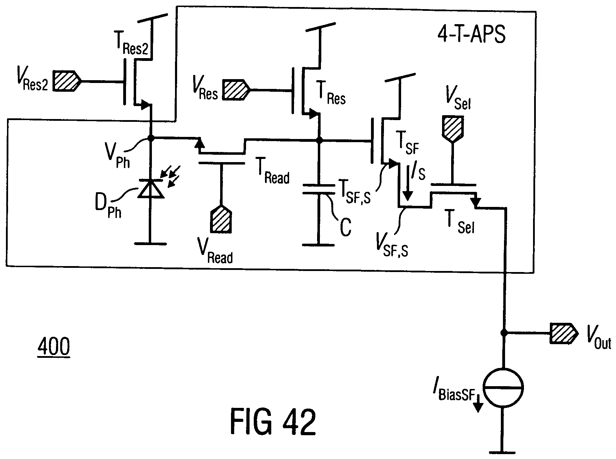

Fig. 42 zeigt eine Schaltskizze eines Aspekts einer aktiven Pixelzelle 400 mit Grauwertspeicher und Spannungsausgang $V_{Out}$. Fig. 42 zeigt eine 5-Transistor-APS-Pixelzelle 400, die gegenüber herkömmlichen 4-Transistor-APS-Pixelzellen einen zusätzlichen zweiten Rücksetztransistor $T_{Res2}$ aufweist.

Fig. 42 zeigt eine 5-Transistor-APS-Pixelzelle 400 mit einem Photosensor $D_{Ph}$, einem ersten Transistor bzw. Lesetransistor $T_{Read}$, einem zweiten Transistor bzw. ersten Rücksetztransistor $T_{Res}$, einem dritten Transistor $T_{SF}$, einem vierten Transistor bzw. Auswahltransistor $T_{Sel}$, und einem Ausgang der Pixelzelle $V_{Out}$, wobei das Gate des dritten Transistors $T_{SF}$, der als Source-Folger verschaltet ist, die Gate-Kapazität bzw. ein kapazitives Element C bildet. Die 5-Transistor-APS-Pixelzelle 400 weist ferner eine Biasstromquelle $I_{BiasSF}$ auf. Der Photosensor kann beispielsweise ein pn-Übergang eines lichtempfindlichen fünften Transistors $T_{Res2}$ sein, und z.B. ein Feldeffekttransistor sein, wie er analog für den Photosensor der ladungs- oder strombasierten Pixelzelle beschrieben ist.

Die Photodiode $D_{Ph}$ ist ausgebildet, um abhängig von einer Strahlung eine Spannung $V_{Ph}$ über dem Photosensor zu erzeugen. Die Kathode der Photodiode kann über den ersten Transistor $T_{Read}$, mit dem Gate-Anschluss bzw. der Gate-Kapazität C gekoppelt werden, um die Spannung $V_{Ph}$ über dem Photosensor an die Gate-Kapazität C zu transferieren. Der Gate-Anschluss bzw. die Gate-Kapazität C ist zudem mit dem Source-Anschluss des zweiten Transistors $T_{Res}$, der auch als erster Rücksetztransistor bezeichnet werden kann, verbunden, um die Spannung der Gate-Kapazität auf eine gegebene Spannung zurücksetzen zu können. Der dritte Transistor $T_{SF}$ ist ausgebildet, um abhängig von der Gatespannung bzw. der Spannung der Gate-Kapazität C - z.B. der an der Gate-Kapazität anliegenden von der gemessenen Strahlung abhängigen Spannung $V_{Ph}$ - und einem Source-Strom $I_S$ an einem Sourceausgang $T_{SF,S}$ des dritten Transistors eine Spannung $V_{SF,S}$ zu erzeugen. Der Sourcestrom $I_S$ ist konstant und durch die Biasstromquelle $I_{BiasSF}$ vorgegeben. Anhand dieses Stroms stellt sich die Gate-Source-Spannung des dritten Transistors $T_{SF}$ ein, mit der die Spannung $V_{SF,S}$ am Sourceanschluss $T_{SF,S}$ der am Gateanschluss folgt. Der Sourceanschluss $T_{SF,S}$ kann über den vierten Transistor $T_{Sel}$ mit dem Ausgang der Pixelzelle gekoppelt werden, um eine Spannung $V_{Out}$ an dem Ausgang auszugeben, die von der an der Gate-Kapazität anliegenden Spannung, z.B. $V_{Ph}$ und somit von der Bestrahlung, abhängt. Ferner ist ein Sourceanschluss des fünften Transistors $T_{Res2}$ mit der Kathode der Photodiode $D_{Ph}$ gekoppelt, um die Spannung $V_{Ph}$ über der Photodiode auf eine gegebene Referenzspannung zurücksetzen zu können.

Im folgenden wird auf Aspekte eines Betriebs einer Pixelzelle 400 eingegangen. Zunächst wird der erste Transistor $T_{Read}$ gesperrt und die Photodiode $D_{Ph}$ des fünften Transistors $T_{Res2}$ auf eine gegebene Rücksetzspannung zurückgesetzt. Ferner wird die Spannung auf der Gate-Kapazität C des dritten Transistors $T_{SF}$ mittels dem zweiten Transistor $T_{Res}$ auf eine gegebene Spannung zurückgesetzt. Daraufhin folgt in einem ersten Messzyklus das Erzeugen einer ersten Spannung $V_{Ph1}$ über dem Photosensor $D_{Ph}$ abhängig von einer Strahlung in dem ersten Messzyklus bei sperrend geschaltetem ersten Transistor $T_{Read}$. Nach der Messung bzw. Bestrahlung für eine gegebene Zeit folgt das Transferieren der ersten Spannung $V_{Ph1}$ auf die Gate-Kapazität C des dritten Transistors $T_{SF}$ bei leitend geschaltetem ersten Transistor $T_{Read}$, um die erste Spannung $V_{Ph1}$ auf der Gate-Kapazität C zu speichern. In Vorbereitung eines zweiten Messzyklus wird danach der erste Transistor $T_{Read}$ gesperrt und die Photodiode $D_{Ph}$ mittels des fünften Transistors $T_{Res2}$ zurückgesetzt. Danach wird in dem zweiten Messzyklus bei sperrend geschaltetem ersten Transistor $T_{Read}$ eine zweite Spannung $V_{Ph2}$ über dem Photosensor $D_{Ph}$ abhängig von einer Strahlung in dem zweiten Messzyklus erzeugt. In einem Auslesezyklus wird abhängig von der auf der Gate-Kapazität C gespeicherten ersten Spannung $V_{Ph1}$ und einen Source-Strom $I_{S1}$, an einem Sourceausgang $T_{SF,S}$ des dritten Transistors eine Spannung $V_{SF,S1}$ erzeugt und der Sourceausgang $T_{SF,S}$ des dritten Transistors $T_{SF}$ mit einem Ausgang der Pixelzelle mittels des vierten Transistors $T_{Sel}$ gekoppelt, um an dem Ausgang der Pixelzelle eine von der ersten Strahlung bzw. ersten Spannung $V_{Ph1}$ abhängige Spannung $V_{Out1}$ auszugeben. Die Spannung $V_{Out1}$ kann beispielsweise auf einem externem Kondensator für eine weitere Verarbeitung gespeichert werden. Nach der Ausgabe der Spannung wird der vierte Transistor $T_{Sel}$ gesperrt. Vor dem Transferieren der zweiten Spannung $V_{Ph2}$ auf die Gate-Kapazität C des dritten Transistors $T_{SF}$ wird die Spannung auf der Gate-Kapazität C des dritten Transistors $T_{SF}$ mittels dem zweiten Transistor $T_{Res}$ auf eine gegebene Rücksetzspannung zurückgesetzt. Nach dem Rücksetzen wird die zweite Spannung $V_{Ph2}$ auf die Gate-Kapazität C des dritten Transistors $T_{SF}$ bei leitend geschaltetem ersten Transistor $T_{Read}$ transferiert, um jetzt die zweite Spannung $V_{Ph2}$ auf der Gate-Kapazität C zu speichern. In Vorbereitung eines dritten Messzyklus kann danach der erste Transistor $T_{Read}$ gesperrt und die Photodiode $D_{Ph}$ mittels des fünften Transistors $T_{Res2}$ zurückgesetzt werden und in dem dritten Messzyklus bei sperrend geschaltetem ersten Transistor $T_{Read}$ eine dritte Spannung $V_{Ph3}$ über dem Photosensor $D_{Ph}$ abhängig von einer Strahlung in dem dritten Messzyklus erzeugt werden. In dem Auslesezyklus wird ferner abhängig von der nun auf der Gate-Kapazität gespeicherten zweiten Spannung $V_{Ph2}$ an dem Sourceausgang $T_{SF,S}$ des dritten Transistors $T_{SF}$ und einem Source-Strom $I_{S2}$ an einem Sourceausgang $T_{SF,S}$ des dritten Transistors eine Spannung $V_{SF,S2}$ erzeugt, und der Sourceausgang $T_{SF,S}$ des dritten Transistors ($T_{SF}$) mit dem Ausgang der Pixelzelle mittels des vierten Transistors $T_{Sel}$ gekoppelt, um an dem Ausgang der Pixelzelle eine von der zweiten Strahlung bzw. zweiten Spannung $V_{Ph2}$ abhängige Spannung $V_{Out2}$ auszugeben. Die Spannung $V_{Out2}$ kann beispielsweise ähnlich der Spannung $V_{Out1}$ auf eine zweiten Kondensator zwischengespeichert werden, um weiter verarbeitet zu werden, z.B. an einen differentiellen Analog-Digital-Wandler angelegt werden, um einen digitalen Differenzwert für die Differenz zwischen $V_{Out1}$ und $V_{Out2}$ zu erzeugen. Das Ausgeben der zweiten Spannung $V_{Ph2}$ aus dem zweiten Messzyklus erfolgt in dem gleichen Auslesezyklus, z.B. einem ersten Auslesezyklus, wie das Ausgeben der zuvor auf der Gate-Kapazität C gespeicherten ersten Spannung $V_{Ph1}$. In einem zweiten Auslesezyklus kann dann ähnlich für die zweite Spannung $V_{Ph2}$, die noch auf der Gate-Kapazität C gespeichert ist, und die in dem dritten Messzyklus erzeugte dritte Spannung $V_{Ph3}$, die auf dem Photosensor anliegt, verfahren werden, um hintereinander die zweite und dritte Spannung auszulesen und beispielsweise an dem differentiellen Analog-Digital-Wandler einen digitalen Differenzwert für die Differenz $V_{Out2}$ und $V_{Out3}$ zu erzeugen.

Bei Aspekten der Pixelzelle 400 können im Gegensatz zu bekannten Pixelzellen, bei denen lediglich eine Rücksetzspannung an dem Ausgang $V_{Out}$ der Pixelzelle gemessen wird, um diese später zur Rauschunterdrückung von dem danach gemessenen Spannungswert an dem Ausgang $V_{Out}$ der Pixelzelle abzuziehen, zwei zeitlich aufeinander folgende Spannungsmesswerte derselben Pixelzelle bestimmt und deren Differenz über einen differentiellen Analog-Digital-Wandler gebildet werden.

Bei herkömmlichen spannungsbasierten Pixelzellen wird beispielsweise bei der korrelierten Doppelabtastung vor der Messung der Photosensor der Pixelzelle zurückgesetzt, und dann die Messspannung $V_{Ph}$ erzeugt. Dabei erfolgt die Speicherung der Rücksetzspannung vor der Messung und das Auslesen derselben kurz vor dem Auslesen des Messwerts im selben Auslesezyklus. Die Messspannung und die Rücksetzspannung werden dann an die Eingänge eines differentiellen Analog-Digital-Wandlers gelegt, um eine Differenz zwischen der Messspannung und der Rücksetzspannung zu bilden, und somit Rauschanteile zu reduzieren. In anderen Worten, bei herkömmlichen spannungsbasierten Pixelzellen und Systemen zur Verarbeitung der spannungsbasierten Pixelsignale werden von den analogen Spannungsmesswerten die entsprechenden analogen Rücksetzspannungswerte subtrahiert, um eine Folge von digitalen Spannungsmesswerten zu erzeugen. Die Differenzbildung zwischen beispielsweise zwei aufeinanderfolgenden Spannungsmesswerten einer Pixelzelle erfolgt auf Basis dieser Folge von digitalen Messwerten.

Aspekte der spannungsbasierten Pixelzelle 400 ermöglichen es, bekannte Systeme zu verbessern, indem auf der Gate-Kapazität der Spannungswert einer ersten Messung zwischengespeichert wird, während auf dem Photosensor ein Spannungswert einer zweiten Messspannung erzeugt wird, und dann in einem Auslesezyklus aufeinanderfolgend der erste und der zweite Spannungswert beispielsweise auf den ersten und zweiten Kondensator ausgegeben werden, um dann mittels dem differenzierenden Analog-Digital-Wandler aus den zwei analogen Spannungswerten direkt einen digitalen Differenzwert zu erzeugen. Dies kann für weitere Messzyklen entsprechen wiederholt werden, um so aus einer Folge von analogen Spannungswerten direkt eine Folge von digitalen Differenzwerten zu bilden, und so die erforderliche Rechenleistung im digitalen Bereich zu reduzieren.

Entsprechend können Aspekte der Pixelzelle 400 beispielsweise für Verfahren zum Bestimmen einer Position eines Maximums einer Hüllkurve eines analogen amplitudenmodulierten Signals verwendet werden, wie sie beispielsweise für die Weißlicht-Interferometrie beschrieben werden.

Im Folgenden werden weitere Aspekte einer ladungsbasierten Analog-Digitalsignalverarbeitung am Beispiel eines schnellen CMOS-Bildsensors, ladungsbasierte Schaltungstechnik, ladungsbasierte Datenpfade, Stromspeicherzellen, ladungsbasierte Analog-Digital-Wandler, Pixelzellen mit ladungsbasiertem Rücksetzen, sowie Bildsensoren für Weißlicht-Interferometrie beschrieben.

Ein Gegenstand dieser Anmeldung ist die analoge und gemischt analog-digitale Signalverarbeitung auf der Basis von Ladungspaketen als Träger der Informationen. Ladungen können genau wie Ströme addiert und einfach verteilt werden. Ebenso ist es möglich sie parallel abzugreifen, da sie auf Kondensatoren in Abhängigkeit von deren Kapazität zu einer Spannungsänderung führen, die hochohmig abgegriffen werden kann. Zusätzlich zu den analogen Strom- oder Spannungspegeln können Signale aber auch über die Zeit repräsentiert werden. Schnittstellen zur digitalen Signalrepräsentation lassen sich in beide Richtungen sehr gut anhand von Ladungen realisieren. Digital kann eine Zeit vorgegeben werden, innerhalb der die Integration eines Stromes erfolgt, oder invers dazu eine Ladung kontinuierlich oder getaktet abgebaut werden, wobei die dafür benötigte Zeit oder Anzahl von Takten erfasst wird.

In vielen Anwendungsbereichen bietet sich der Einsatz dieser Signalrepräsentation an. Durch den hochparallelen Einsatz von Schaltungselementen geringer Komplexität, die Einbeziehung parasitärer Strukturen in die Signalverarbeitung und den Verzicht auf Einschwingvorgänge in zeitkritischen Pfaden lassen sich gemischt analog-digitale Systeme mit sehr großer Rechenleistung pro Fläche bei einem geringen Leistungsverbrauch realisieren.

In der neuartigen Pixelzelle auf der Basis eines Photo-FETs kommen Ladungen als Informationsträger an mehreren Stellen zum Einsatz. Das Rücksetzen erfolgt durch "Pumpen" einer bestimmten Ladungsmenge, die nur von der Breite und der Höhe eines analogen Steuerimpulses abhängig ist. Dabei kann auf direkt mit der strahlungsempfindlichen Wanne verbundene Schalttransistoren als eine der wichtigsten Quellen von Leckströmen in aktuellen CMOS-Bildsensoren verzichtet werden. Die Ausgabe des Helligkeitssignals erfolgt als gepulster Strom bzw. als Ladung auf die parasitäres Kapazität der Spaltenleitung.

Im folgenden wird auf die ladungsbasierte Schaltungstechnik eingegangen.

Die Ladung oder auch Elektrizitätsmenge beschreibt die Größe der elektromagnetischen Wechselwirkung von Materie und ist stets an einen Träger gebunden [Wik06]. Bewegte Ladungen werden als elektrischer Strom bezeichnet. Die elektrische Ladung wird im internationalen Einheitensystem in Coulomb (1C=1As) angegeben.

Ihr kleinstes frei auftretendes Quantum ist die Elementarladung ($q$=1.602·10$^{-19}$C). Es gibt zwei gegensätzliche Elementarladungen, wobei festgelegt wurde, dass Elektronen negativ und Protonen positiv geladen sind. Aufgrund dieser festen Zuordnung kann Ladung nicht erzeugt, sondern nur unter Aufwendung von Energie getrennt werden. Dieser Vorgang wird im Folgenden Ladungsgeneration genannt.

Die direkte Verwendung von Ladungen als Träger von Informationen bei deren Übertragung ist bekannt. So sind z.B. bei qualitativ hochwertigen Bildsensoren im Consumer-Bereich CCD-Sensoren (*Charge-Coupled Devices*) seit vielen Jahren gebräuchlich. *Charge-Coupled Device*: Vor allem in Bildsensoren verwendete Technologie basierend auf dem Transport von Informationen in Form von Ladungen. Die zu Grunde liegende Technologie zeichnet sich durch einen speziellen relativ einfachen Fertigungsprozess aus, der zu sehr günstigen Kosten mit einer hohen Ausbeute beherrscht wird. Andere ladungsbasierte Techniken (*Charge-Domain Devices* CDD: Schaltungstechnik basierend auf dem Transport, der Aufteilung und der Zusammenführung von Ladungen) z.B. Filter (CDF *Charge-Domain Filter*: Filter basierend auf der Verarbeitung von Ladungen) [BS84, FKBL91, Fos91] sind bisher relativ wenig verbreitet, da die Implementierung aktiver Elemente wie z.B. Transistoren in der CCD-Technologie nicht ohne weiteres möglich ist. Eine Integration komplexerer Strukturen wie z.B. Ladungs-Digital-Wandler (*Charge-to-Digital Converter*, CDC: Wandler, der Ladungen direkt in digitale Signale umsetzt) wurde zwar demonstriert [PL96], hat sich jedoch bisher nicht durchgesetzt.

Das zweite wichtige Anwendungsgebiet sind dynamische Speicher (DRAM), bei denen digitale Informationen aus Speicherzellen ausgelesen werden. Nur durch den kleinstmöglichen Aufbau dieser Zellen, typischerweise aus einem Kondensator und einem Auswahl-Transistor, ist die heute erzielbare sehr hohe Informationsdichte möglich. Der Zugriff anhand von Ladungen ist eine umittelbare Konsequenz dieses einfachen Aufbaus. Im Gegensatz zu CCD-Technologien sind in DRAM-Technologien auch aufwendige analoge und digitale Schaltungsblöcke möglich und nötig. Eine Optimierung des Zugriffs ist ein wichtiger Gegenstand der Forschung und Entwicklung auf diesem Gebiet. Die Einbettung von DRAM-Zellen in Standard-CMOS-Prozesse ist eine Schlüsselkomponente bei der Entwicklung hin zu SoC mit hoher Packungsdichte und großer Zugriffsgeschwindigkeit [IK99, MHM+05]. Ein wichtiger Aspekt dabei ist der wachsende Widerspruch zwischen der Speicherkapazität und der Geschwindigkeit. Während sich die Kapazität in den letzten Jahren alle drei Jahre vervierfacht, steigt die Speicherbandbreite nur um 10% pro Jahr. Durch die direkte Integration des Speichers auf den Chips ist ein hochparalleler kontinuierlicher Zugriff mit sehr geringer Latenz möglich [KSW01].

Ladungen spielen auch in der Messtechnik z.B. im Zusammenhang mit der Erfassung ionisierender Strahlung bei physikalischen Experimenten eine wichtige Rolle. In einer Vielzahl von Anordnungen werden für die Datenerfassung sogenannte Ladungs-Ausleseschaltungen (*Charge Readout Integrated Circuits*, CRIC: Schaltkreise deren Eingangsinformationen in Form von Ladungen vorliegen) [GSB95, BJB+98] verwendet.

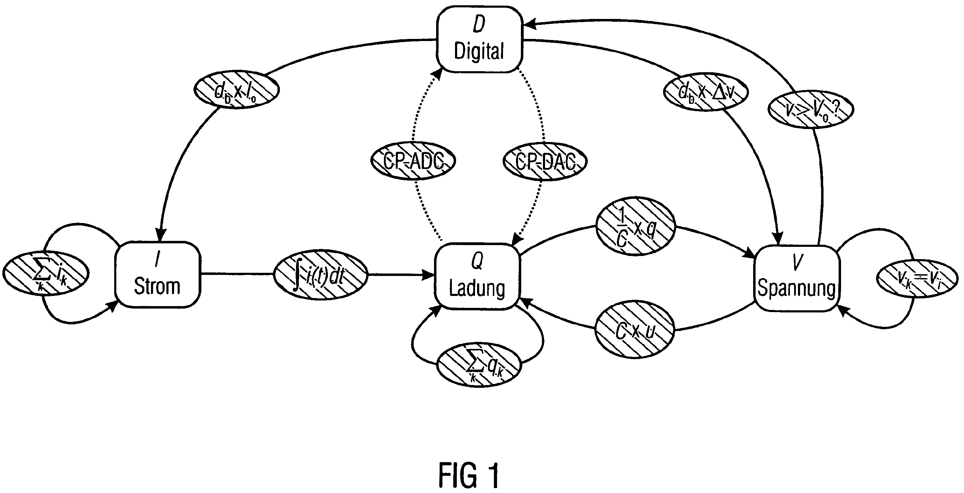

Systemlösungen in CMOS-Technologie für die Übertragung analoger Informationen mittels Ladungen auf einem Chip von der Generation in einer speziellen Quelle über eine Verbindungsstrecke bis hin zur Empfängerschaltung sind nicht bekannt. Eine derartige Anordnung bringt eine Reihe technischer Vorteile. Sie kann eine analoge Signalübertragung mit einer großen Datenrate bei möglichst geringer statischer und dynamischer Verlustleistung ermöglichen. Das RLC-Verhalten der Verdrahtung darf sich nicht unmittelbar über die damit verbundene kapazitive Last und die Vergrößerung der Signallaufzeiten auswirken, was sich nur durch einen minimalen Pegelhub erreichen lässt. Die statische Leistungsaufnahme der gesamten Übertragungsstrecke, d.h. sender- und empfängerseitig soll minimiert werden. Parameterstreuungen z.B. der Geometrien (Leitungsbreiten, -abstände und -längen) oder elektrischen Größen (Schwellspannungen) sollten einen möglichst geringen Einfluss auf das Übertragungsverhalten haben. Eine Kalibrierung ist, wenn überhaupt nötig, der Vergrößerung von Strukturen vorzuziehen. Die verwendeten Schaltungen sollen in einer Standard-CMOS-Technologie implementiert werden und eine einfache Kopplung mit anderen analogen und digitalen Blöcken ermöglichen. Diese Kopplungen sind in Fig. 1 dargestellt. Im Mittelpunkt steht als Informationsträger die Ladung. Sie stellt den zentralen Zusammenhang zwischen den verschiedenen Signaldomänen dar. Innerhalb jeder einzelnen Domäne kann die Signalverarbeitung wie gehabt erfolgen.

Fig. 1 zeigt Signaldomänen bei ladungsbasierter Signalverarbeitung.

Der Zusammenhang zwischen Strom und Ladung ergibt sich aus der Definition des Stromes $I$ als bewegte, also zeitlich veränderliche Ladung

$$I(t) = \frac{dQ}{dt} \qquad (1)$$

zu

$$Q = \int I(t)\, dt. \qquad (2)$$

Für eine zeitkonstante Stromquelle vereinfacht sich die Gleichung zu

$$Q = I\, t. \qquad (3)$$

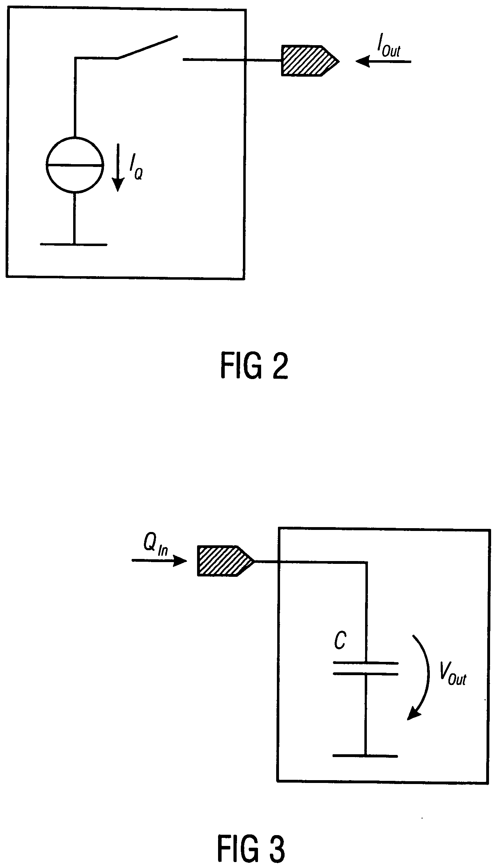

Als Modell für die Ladungsgeneration unter Verwendung einer idealen Stromquelle $I_Q$ mit unendlichem Innenwiderstand dient die in Fig. 2 dargestellte gepulste Stromquelle. Aus ihrem Klemmverhalten

$$I_{Out} = \begin{cases} 0 & \forall \quad t < t_0, t > t_1 \\ I_Q & \forall \quad t_0 \leq t \leq t_1 \end{cases} \qquad (4)$$

kann eine generierte Ladung von

$$Q_{Out} = I_Q\, t_Q \qquad (5)$$

für

$$t_Q = t_2 - t_1$$

abgleitet werden.

Fig. 2 zeigt ein Schaltungselement "gepulste ideale Stromquelle".

Diese Schnittstelle eignet sich für Schaltungen, die als Ausgangssignal einen Strom liefern. Die direkte Umsetzung einer Ladung in einen konstanten Strom ist schaltungstechnisch schwierig und soll an dieser Stelle nicht betrachtet werden.

Der Zusammenhang zwischen Spannung und Ladung besteht über die Kapazität eines Kondensators gemäß der Gleichung

$$Q = CV. \qquad\qquad (6)$$

Die in dessen Feld gespeicherte elektrische Energie ist proportional zu der anliegenden Spannung $V$ und der Kapazität $C$. Aufgrund dieses Zusammenhangs wird mitunter auch von der Speicherung von Ladung gesprochen [Wik06]. Als Synonym für den Kondensator wird in der Schaltungstechnik häufig der Begriff "Kapazität" verwendet. In Fig. 3 ist die Grundschaltung zur Repräsentation einer Ladung $Q_{in}$ durch eine Spannung $V_{Out}$ dargestellt.

Fig. 3 zeigt Ladung auf einem Kondensator.

Kommt es auf einen linearen Zusammenhang zwischen Ladung und Spannung an, müssen spannungsunabhängige Kapazitäten verwendet werden. Ein typisches Beispiel dafür sind Metall-Metall-Leitungskapazitäten. Die Gate-Kapazität eines MOS-Transistors weist hingegen eine stark nichtlineare Strom-Spannungs-Charakteristik auf. Sie wird aufgrund ihres großen Betrags dennoch häufig als Schaltungselement verwendet. Die Richtung des Informationsflusses der Schnittstelle wird von der Art und Weise der Ansteuerung bestimmt. So kann die Ladung auf einer Kapazität hochohmig abgegriffen (Ladungs-Spannungs-Wandlung) oder niederohmig verändert werden (Spannungs-Ladungs-Wandlung). Als Ladungsquelle auf der Basis geschalteter Spannungen kann z.B. eine Ladungspumpe eingesetzt werden.

Im folgenden wird Zusammenhang zwischen digitaler Information und Ladung erläutert.

Die Umsetzung digitaler Signale in Ladungen erfolgt nicht direkt sondern stets über den Umweg Spannung oder Strom durch gezielte Ansteuerung der bereits angesprochenen Ladungsquellen. Dabei können Ladungspakete (*Charge Packets*, CP: Ladungspaket) in einem Digital-Analog-Wandler (DAC *Digital to Analog Converter*: Digital-Analog-Wandler) auf der Basis von Ladungspaketen (CP-DAC) aus einer oder mehreren gepulsten Stromquellen, geschalteten Kapazitäten oder Ladungspumpen aufakkumuliert werden. Die Digitalisierung einer unbekannten Ladung geschieht in ähnlicher Weise in einem Analog-Digital-Wandler (ADC) auf der Basis von Ladungspaketen (CP-ADC *Analog to Digital Converter*: Analog-Digital-Wandler). Die Ladung wird zunächst auf eine Kapazität übertragen und dann interativ durch Einbringen kleiner Ladungsportionen bekannter Größe kompensiert. Die Größe der zu minimierenden Restladung wird durch Vergleich der Spannung auf der Kapazität mit einer "Nullpunktspannung", also der Spannung über der Kapazität vor dem Einbringen der zu messenden Ladung, ermittelt. In der Literatur findet sich dazu die Bezeichnung"Charge-Packet *Counting*" (CPC *Charge-Packet Counting*: Analog-Digital-Wandlung durch Zählen von Ladungspaketen) [NYN[+]87].

Ausgehend von dem im vorangehenden Abschnitt skizzierten Konzept wird zunächst eine Bildsensorarchitektur für sogenannte *Systems on Chip* (SoC *System on Chip)* mit integrierter Signalverarbeitung und hoher Bildrate in einer modernen CMOS-Technologie (*Complementary Metal-Oxide Semiconductor)* dargestellt.

Es folgt der Entwurf einer Pixelzelle mit Stromausgang auf der Basis eines Photo-FET für Anwendungen mit hohen Anforderungen an Dynamikumfang und Ausleserate.

Im Anschluss ist ein SoC mit einem eingebetteten Hochgeschwindigkeits-Bildsensor für ein Weißlicht-Interferometriesystem auf der Basis der neuen Pixelzelle mit Photo-FET erarbeitet. Neben Architektur und Schaltungstechnik ist auch ein neuer Algorithmus zur hochparallelen Auswertung der Korellogramm-Bilddaten direkt auf dem Bildsensor dargestellt.

Im folgenden wird auf einen Systementwurf des ladungsbasierten Datenpfads und ein Architekturkonzept eingegangen.

Das Architekturkonzept eines Bildsensors mit ladungsbasiertem analogem Datenpfad ist in Fig. 4 dargestellt. Anhand dieser Prinzipdarstellung soll die grundlegende Funktionsweise unter Vernachlässigung parasitärer Effekte erläutert werden.

Fig. 4 zeigt ein Architekturkonzept für Bildsensoren mit ladungsbasiertem analogem Datenpfad.

Kern des Sensors ist eine Matrix von Pixelzellen (1), die in $X$ Spalten und $Y$ Zeilen angeordnet sind. Die Ladungen aller ausgebenden Pixel der Spalte $x$ werden auf der entsprechenden Spaltenleitung (2) addiert. Die resultierende Summenladung $Q_x$ führt aufgrund der endlichen Leitungskapazität zu einem Spannungsoffset $V_{Cmp,x}$. Für die folgenden Betrachtungen soll das Vorzeichen von $V_{Cmp,x}$ gleich dem von $Q_x$ sein und für $Q_x \rightarrow 0$ gelten $V_{Cmp,x} \rightarrow 0$. Die Ausgabe in einer Zeile $y$ wird von der digitalen Zeilenansteuerung (3) initiiert, indem die Ausgangsstromquellen aller Pixel dieser Zeile während eines Pulses der Länge $\tau_{Out,y}$ einen Strom ausgeben. Dieser Strom ist von den spezifischen Bedingungen in jeder Pixelzelle abhängig. Ein von der einfallenden Strahlung durch Ladungstrennung generierter Photostrom wird während einer Zeit $\tau_{Int}$ auf der Kapazität der als Photodiode wirkenden Wannen-Substrat-Diode eines Photo-FET integriert. Die Größe des Ausgangsstroms der Pixelzellen in Zeile $y$ ist in erster Näherung proportional zur Bestrahlungsstärke $E_e$ an dieser Stelle, zur Integrationszeit $\tau_{Int,y}$ und einem Proportionalitätsfaktor $K_y$. In den von der analogen Zeilenansteuerung (4) 410 zeilenweise vorgegebenen Wert $K_y$ geht z.B. der Arbeitspunkt des Photo-FET ein.

**EP 1 962 493 B1**

Die Analog-Digital-Wandlung der Ladungen $Q_x$ geschieht für alle Spalten parallel. Dazu befinden sich in jeder ein analog-digitaler (AD) (5) und ein digital-analoger Teil (DA) (6). Der AD-Teil besteht aus einem Spannungskomparator, einem Zustandsspeicher für das erste Vergleichsergebnis des Zyklus, einer Auswahllogik und einem Zähler. Der DA-Block beinhaltet jeweils eine oder mehrere gepulste Quellen für positive und negative Ströme, die direkt mit einem Digitalwort $D_{DA}$ angesteuert werden. Alle ADC werden von einer externen digitalen Ablaufsteuerung über einen Befehlseingang $S_{Ctrl}$ und einen Dateneingang $D_{Sel}$ gleichzeitig angesteuert. Zu Beginn einer Wandlung werden alle Zustandsspeicher und Zähler zurückgesetzt. Im ersten Teil jedes Umsetzungsschritts wird das Vorzeichen des Spannungsoffsets $V_{Cmp,x}$ untersucht. So lange sich $V_{Cmp,x}$ nicht ändert, wird im zweiten Teil für positive $V_{Cmp,x}$ eine negative Ladung $Q_{DA,x}$ ausgegeben und der Zähler $D_{Cnt}$ inkrementiert, für negative Vorzeichen eine positives $Q_{DA,x}$ ausgegeben und $D_{Cnt}$ dekrementiert. Die Beträge von Zählerschritt und ausgegebener Ladung stehen für die gesamte Wandlung im selben Verhältnis und werden von außen über $D_{Sel}$ vorgegeben. Ändert sich $V_{Cmp,x}$ während der Wandlung wird das im Zustandsspeicher festgehalten und ab diesem Zeitpunkt weder eine Ladung ausgegeben, noch der Zählerstand verändert. Ist dieser Zustand in allen Spalten erreicht, ist die Wandlung beendet und die digitalen Spaltenergebnisse $D_{Out}$ können ausgegeben werden. Zur Vergrößerung der Auflösung, kann der Vorgang nach dem Rücksetzen der Zustandsspeicher mit einem kleinerem $D_{Cnt}$ wiederholt werden. Die Zählerstände werden dazu nicht gelöscht.

Die verschiedenen Möglichkeiten zur Ansteuerung der Sensormatrix sollen im folgenden anhand einiger Beispiele gezeigt werden.

Beispiel 1, Auslesen eines Graustufenbilds:

Werden $K_y$, $\tau_{Int,y}$ und $\tau_{Out,y}$ für alle Pixel gleich gewählt und die Matrix beginnend mit Zeile $y=0$ linear aufsteigend bis $y=Y$-1, ausgelesen, so ergibt sich ein Graustufenbild für die gesamte Matrix. Ebenso ist es möglich, auf bestimmte Zeilen oder Gruppen von Zeilen zuzugreifen.

Beispiel 2, Mittelwertbildung über mehrere Zeilen eines Graustufenbilds:

Werden bei den gleichen Einstellungen wie im Beispiel 1 entweder mehrere Zeilen gleichzeitig ausgewählt, oder die Wandlung erst nach der Ausgabe mehrerer Zeilen auf die Spaltenleitung begonnen, ergibt sich das Ergebnis aus der Summe der Helligkeitswerte der aktivierten Zeilen. Auf diese Weise ist es möglich, eine einfache räumliche Tiefpassfilterung durchzuführen.

Beispiel 3, Multiplikation mit einem Digitalwert bei der Ausgabe:

Durch die Einstellung der Breite $\tau_{Out,y}$ des Strompulses in Zeile $y$ bei der Ausgabe, z.B. durch einen digitalen Monoflop, werden alle Helligkeitswerte dieser Zeile mit $\tau_{Out,y}$ bzw. dem Zugrunde liegenden Digitalwert multipliziert.

Beispiel 4, Faltung von Graustufenbildern mit beliebigen Kernen:

Besteht die Möglichkeit zur Ausgabe negativer Werte, so können durch Kombination von Beispiel 2 und Beispiel 3 Faltungen mit beliebigen Kernen in Form digitaler Werte bei serieller oder synchroner Aktivierung mehrerer Zeilen realisiert werden. Insbesondere die Faltung des gesamten Bildes bei der vollen Ausleserate ist ein interessantes Merkmal.

Beispiel 5, Filterung über mehrere Einzelbilder:

Eine Filterung über mehrere Bilder, d.h. mit zwischenzeitlichem Rücksetzen einzelner oder aller Pixel und unter Verwendung eines konstanten oder variablen $\tau_{Int}$ bei Beibehaltung der auf den Kapazitäten der Spalten gespeicherten Werte ist ebenfalls möglich.

In der Architektur gemäß Fig. 4 kann die Pixelzelle (1) beispielsweise eine Pixelzelle 100 sein, die Spaltenleitungen die erste und zweite Leitung L1 und L2 gemäß Fig. 41K sein, der Analog-Digital-Wandler (5) und der Digital-Analog-Wandler (6) ein Aspekt einer Vorrichtung zum Bestimmen einer Ladungsmenge gemäß Fig. 41A bzw. Fig. 41K sein bzw. die gesamte Pixelmatrix ein Aspekt einer Vorrichtung 3500 zur ladungsbasierten Signalverarbeitung nach Fig. 41K sein. Z.B. kann der Analog-Digital-Wandler (5) ein Aspekt einer Einrichtung 3110 zum Vergleichen und einer Einrichtung 3130 zum Rückschließen sein und Digital-Analog-Wandler (6) ein Aspekt einer Einrichtung 3120 zum Bewirken sein, die von der Einrichtung 3130 zum Rückschließen gesteuert wird.

Nach der Einführung in die Architektur und die Funktionsweise des ladungsbasierten Bildsensors sollen im Folgenden grundlegende Systemparameter vorgestellt und Kriterien für den Entwurf der Grundschaltungen abgeleitet werden. Für eine reale Bildsensorimplementierung müssen noch zwei Erweiterungen vorgenommen werden.

Die erste Erweiterung betrifft die Grundfunktionen der Pixelzelle. Für viele Anwendungen ist die lokale Spei-

24

cherung eines Helligkeitswertes zu einem beliebigen Zeitpunkt wichtig. Diese Funktion wird z.B. benötigt, um ein komplettes Bild einfrieren und dann seriell ausgeben zu können ("Snapshot"-Modus) oder um einen abgespeicherten Rücksetzwert vom aktuellen Helligkeitswert subtrahieren zu können ("*Correlated Double Sampling*": korrelierte Doppelabtastung, Verfahren in Bildsensoren, bei dem in jeder Pixelzelle der Helligkeitswert nach dem Rücksetzen gespeichert wird, um ihn vom Helligkeitswert zum Auslesezeitpunkt abziehen zu können). Die zweite Erweiterung betrifft die Bereitstellung einer Referenz für die Nullpunktspannung der Spaltenleitung. Diese wird benötigt, um die internen Knoten in den Pixelzellen vor dem Auslesen entladen zu können, d.h. auf die "Nullpunktspannung" vorzuladen.

Fig. 5 zeigt den erweiterten Auslesepfad des Bildsensors mit ladungsbasiertem analogen Datenpfad und der zusätzlichen Referenzleitung. Sie soll in der folgenden Beschreibung der Implementierung als Bezug dienen.

In einer Sensormatrix befindet sich, wie bereits erläutert wurde, in Spalte x und Zeile y eine Pixelzelle, die über verschiedene analoge und digitale Zeilenleitungen $V_y$ bzw. $S_y$ mit einer Biasschaltung und einer Zeilenansteuerung verbunden ist. Außerdem ist die Pixelzelle über zwei Spaltenleitungen mit dem ladungsbasierten Analog-Digital-Wandler (CP-ADC) der gleichen Spalte verbunden. Sie besitzen die Lastkapazitäten $C_{L1}$, bzw. $C_{L2}$. Die Ausgabe einer Referenzspannung $V_{PixRef}$, die den Nullpunkt der Ladung auf $C_{L1}$ repräsentiert, geschieht über die durch den Treiber $A_2$ angesteuerte Spaltenleitung (2). Nach dem Rücksetzen der Ausgangsschaltung der Pixelzelle erfolgt die Übertragung des Sensorsignals in Form der Pixel-Ladung $Q_{Pix}$ auf die Kapazität $C_{L1}$ der hochohmigen Spaltenleitung (1). In der Folge verändert sich die Spannung gemäß

$$V_{Pix,1} = V_{Pix,0} + V_{Pix,q} \qquad\qquad (7)$$

$$V_{Pix,q} = \frac{Q_{Pix}}{C_{L1}}. \qquad\qquad (8)$$

Die Spannung wird von (1) abgegriffen und über den Multiplexer $M_1$ dem Komparator $A_1$ zugeführt. Entsprechend der Relation von $V_{Pix}$ zum Vergleichswert $V_{Comp}$ steuert die Steuerlogik (Control) die Ladungsquelle (QSrc). Diese speist über den zweiten Multiplexer $M_2$ Ladungen auf $C_{L1}$, mit dem Ziel $Q_{Pix}$ zu kompensieren und den Ausgangszustand $V_{Pix,2}=V_{Pix,0}$ wieder herzustellen. Die Menge und Größe der eingespeisten Ladungsportionen ist abhängig vom Wandlungsverfahren. In regelmäßigen Abständen wird die Spannung auf der Kapazität $C_{L2}$ ebenfalls unter Berücksichtigung von $V_{Comp}$ über $A_1$ kalibriert, so dass der von einem Spannungsfolger $A_2$ ausgegebene Wert für $V_{PixRef}$ tatsächlich dem Start- bzw. Abbruchwert $V_{Pix,0}=V_{Pix,2}$ entspricht. Für die Ladungsquelle QSrc werden gepulste Stromquellen mit Stromspeicherzellen hoher Genauigkeit verwendet. Deren Beträge müssen in regelmäßigen Abständen aus einem für alle Spalten gemeinsamen hochauflösenden Strom-DAC aufgefrischt werden.

Fig. 5 zeigt einen weiteren Aspekt einer Vorrichtung zur ladungsbasierten Signalverarbeitung gemäß Fig. 41K, bei dem der Ladungsgeber eine Pixelzelle 100 beispielsweise nach Fig. 39A ist, das erste kapazitive Element $C_{L1}$ die Leitungskapazität der ersten Leitung L1 ist, der Multiplexer $M_1$ dem fünften Schaltelement 3502, und der Multiplexer $M_2$ dem sechsten Schaltelement 2504 entspricht, die innere Kapazität $C_{L2}'$ der 3240 in Fig. 41K entspricht und der Spannungstreiber $A_2$ der Treiberstufe 3242 entspricht. Ferner zeigt der Spannungskomparator $A_1$ einen Aspekt einer Einrichtung 3110 zum Vergleichen einer Spannung, die Ladungsquelle (QSrc) einen Aspekt der Einrichtung 3120 zum Bewirken einer Ladungszu-/Abfuhr, und die Steuerlogik (Control) einen Aspekt der Einrichtung 3130 zum Rückschließen auf die Ladung $Q_{Pix}$. In Fig. 5 ist stellvertretend nur ein Ladungsgeber beispielhaft für eine mögliche Vielzahl von Ladungsgebern pro Spalte gezeigt, um die Anbindung der Pixelzelle an den ladungsbasierten Analog-Digital-Wandler CP-ADC und an die Signalleitungen zu zeigen.

6. Gepulste Stromquelle zur Ladungsgeneration

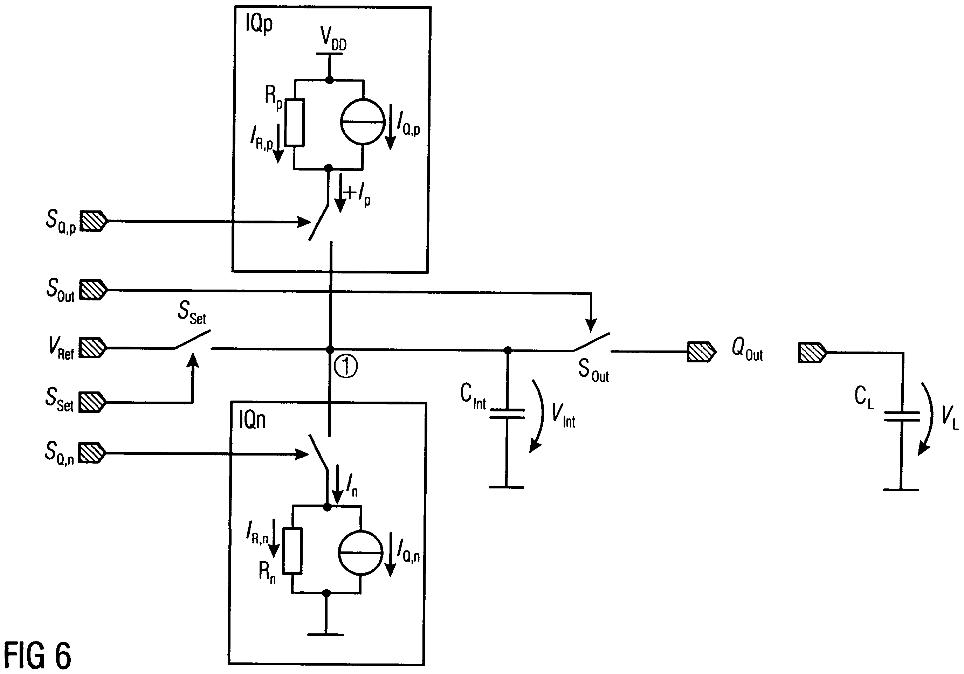

Die gepulste Stromquelle ist eine im Hinblick auf Realisierung und Anwendung sehr universelle Ladungsquelle. Sie kann unipolar und bipolar implementiert werden und der Aufwand lässt sich je nach den Anforderungen an die Genauigkeit wählen. Als Teil der Pixelzelle muss sie vor allem sehr klein und in den Spalten-ADC möglichst schnell und genau sein. Fig. 6 zeigt eine Prinzipdarstellung der Anordnung.

Fig. 6 zeigt eine Prinzipschaltung einer bipolaren gepulsten Stromquelle mit Last.

Die symmetrische Ladungsquelle besteht aus einer positiven und einer negativen gepulsten Stromquelle (Quellenblöcke IQp und IQn), die die Ströme $I_{Q,P}$ und $I_{Q,n}$ mit unterschiedlichem Vorzeichen liefern. Es sind die Innenwiderstände der beiden Quellen mit $R_p$ bzw. $R_n$ und die Eingänge zur Aktivierung des jeweiligen Quellenblocks mit $S_{Q,p}$ bzw.

$S_{Q,n}$ bezeichnet.

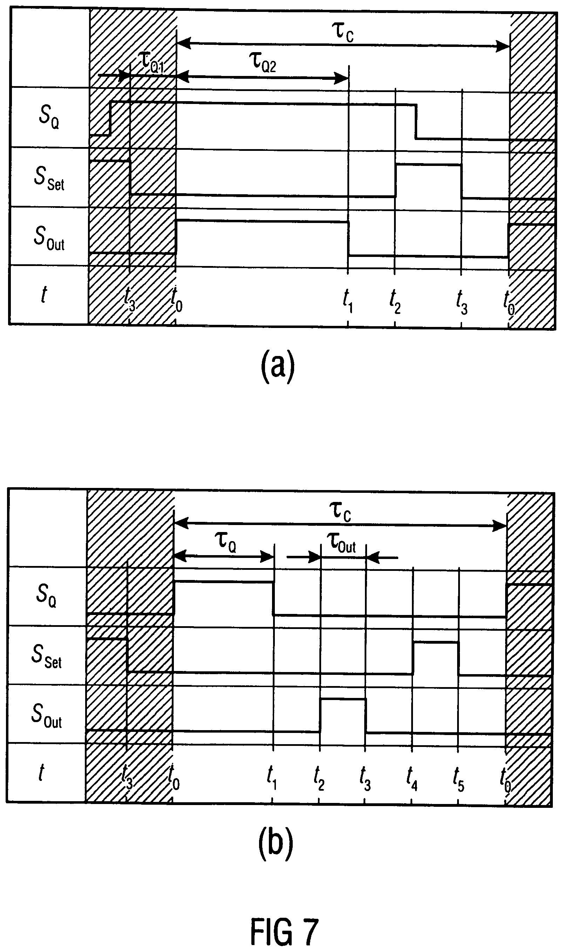

Fig. 7 zeigt eine Ansteuerung der Ladungsquelle im gekoppelten (a) und ungekoppelten Betrieb (b) mit dem Aktivierungseingang $S_Q$ für den ausgewählten Quellenblock dem Eingang $S_{Set}$ zum Vorladen der internen Kapazität und dem Eingang $S_{Out}$ zur Ausgabe der Ladung.

Zwei Beispiele für die Ansteuerung der Schalter einer Ladungsquelle sind in Fig. 7 dargestellt. Beim gekoppelten Betrieb (s. Fig. 7a) wird die Stromquelle eines Quellenblocks bereits vor dem Ende des Vorladens ($t_3$) aktiviert und bleibt bis zum Ende der Ausgabe in diesem Zustand ($S_Q$=1). Die für die abgegebene Ladung relevante Pulsbreite $\tau_Q$ setzt sich aus einem Anteil $\tau_{Q1}$ vor und einem Anteil $\tau_{Q2}$ nach der Aktivierung des Ausgangs ($S_{Out}$=1) zusammen, d.h. der Aktivierungspuls für die Stromquelle im Quellenblock und der Ausgabepuls der Ladungsquelle sind nicht identisch. Zum Vorladen der internen Kapazität $C_{Int}$ wird der innere Summationsknoten (1) über $S_{Set}$ mit der externen Referenzspannung $V_{Ref}$ verbunden und somit vorgeladen. Bei sehr kleinen Kapazitäten sollte $\tau_{Q1}$ möglichst kurz sein, um zu verhindern, dass die Spannung $V_{Int}$ einen Wert erreicht, bei dem der Stromfehler $I_R=I_{R,p}-I_{R,n}$ durch den Innenwiderstand $R_Q = R_p||R_n$ der Quelle zu groß wird. Die Betriebsart mit $\tau_{Q1}\rightarrow 0$ eignet sich besonders für die Pixelzellen, da sie einen kompakten internen Aufbau bei gleichzeitig maximaler Ausgabezeit $\tau_Q=\tau_{Q1}+\tau_{Q2}$ in Relation zur Sampling-Periodendauer $\tau_C$ ermöglicht.

Der ungekoppelte Betrieb (s. Fig. 7b) zeichnet sich dadurch aus, dass die Quellenblöcke die Ladung zunächst nur an die dann möglichst große interne Kapazität $C_{Int}$ abgeben. Während dieses Zeitraums $\tau_Q$ mit $S_Q$=1 sind die Schalter $S_{Set}$ und $S_{Out}$ deaktiviert. Das ermöglicht eine sehr präzise Ladungsgeneration mit langen Integrationszeiten innerhalb mehrerer paralleler Quellen. Die externe Kapazität $C_L$ ist nur während eines sehr kurzen Zeitraums $\tau_{Out}$ zugeschaltet, wodurch verschiedene Quellen kurz hintereinander noch innerhalb einer Periodendauer $\tau_C$ darauf zugreifen können. Diese Betriebsart ermöglicht eine wesentlich größere Genauigkeit der Ladungspakete. Sie ist jedoch aufgrund des benötigten Flächenverbrauchs nur in den spaltenparallelen Wandlern einsetzbar.

Ein Betrieb mit permanent aktiven Stromquellen ist zur Flächenersparnis ebenfalls denkbar. Er eignet sich jedoch insbesondere bei großen Bias-Strömen aufgrund einer hohen statischen Leistungsaufnahme nur bedingt für die Anwendung in Pixelzellen.

Bei der Implementierung wird ein $\tau_{Q1}\rightarrow 0$ und damit $\tau_Q\rightarrow\tau_{Q2}$ angestrebt, um auch bei sehr großen $I_Q$ die Abweichungen vom Nominalwert z.B. aufgrund der Abschnürung der Quelle zu minimieren. Der Wert der abgegebenen Gesamtladung für beide Betriebsarten

$$Q_{Out} = \int\limits_{t=t_0}^{t_1} I_Q(t)\,dt + Q_{err} \qquad (9)$$

ergibt sich aus dem Integral des Gesamtstroms der idealen Quelle $I_Q$ und einer Fehlerladung $Q_{err}$. Die Fehlerladung

$$Q_{err} = \int\limits_{t=t_0}^{t_1} I_R(t)\,dt + Q_{Int,0} + Q_S \qquad (10)$$

setzt sich aus drei Anteilen zusammen, dem Integral des Stromes $I_R$ durch den Ausgangswiderstand $R_Q$ der Quelle, der zum Startzeitpunkt auf $C_{Int}$ vorliegenden Ladung $Q_{Int,0}$ und der durch Vorgänge in den Schaltern generierten Ladung $Q_S$. Die jeweilige Größe der Fehleranteile hängt von verschiedenen Randbedingungen ab. Dazu gehören z.B

- die Differenz $V_{L,0}-V_{int,0}$ zum Beginn der Ladungsabgabe,
- das Verhältnis der beiden beteiligten Kapazitäten $C_L$ und $C_{Int}$,
- Abweichungen im Timing der Ansteuerung von $S_{Set}$ und $S_{Out}$ sowie
- der Spannungsverlauf an den Schaltern.

Diese Fehlereinflüsse sowie die der Nichtidealitäten der Stromquellen sollen in den folgenden Abschnitten genauer untersucht werden, um dadurch eine Auslegung des Bildsensor smit ladungsbasierter Signalverarbeitung abzusichern.

Im folgenden werden Stromquellen beschrieben, z.B. einfache und Kaskode-Stromquellen.

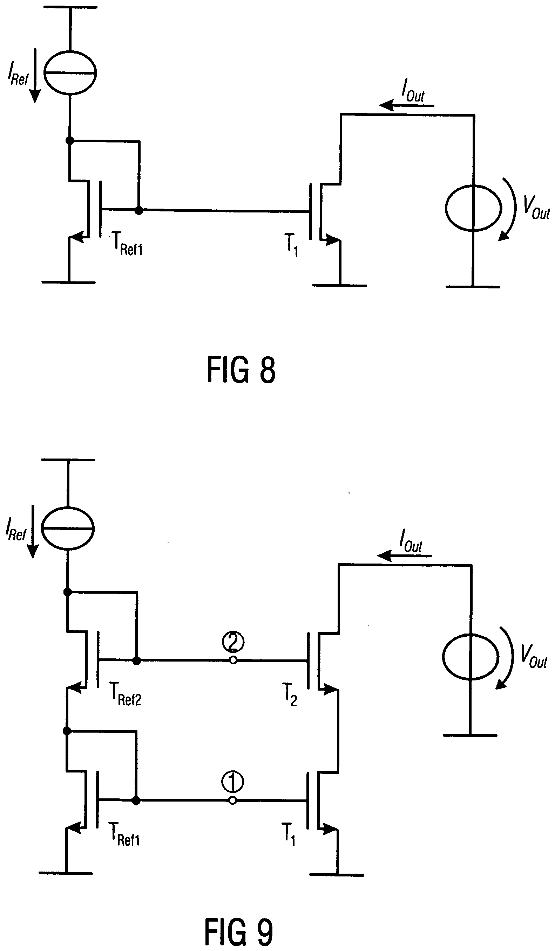

Fig. 8 zeigt einen einfachen Stromspiegel.

Ein MOS-Transistor in Source-Schaltung ist die einfachste in einer CMOS-Technologie verfügbare gesteuerte Stromquelle. In Fig. 8 ist der Quellentransistor $T_1$ als Teil eines PMOS-Stromspiegels dargestellt. Es sind der Ausgangsstrom $I_{Out}$ gleich dem Drainstrom $I_D$ von $T_1$ und die Ausgangsspannung $V_{Out}$ gleich der Drain-Source-Spannung $V_{DS}$.

Im Anhang 27 ist das Klemmverhalten eines MOS-Transistors unter Verwendung des Transistormodells nach Enz, Krummenacher und Vittoz (EKV) [EKV95] dargestellt. Es zeigt sich, dass im vorwärts gesättigten Betrieb der Ausgangsleitwert $g_{ds}$ linear von $I_D$ abhängig ist, woraus sich ein Ausgangswiderstand von

$$r_{Out1} = \frac{1}{g_{ds}} = \frac{1}{\lambda I_{Out}} \qquad (11)$$

für die Schaltung in Fig. 8 ergibt. Die entscheidende Einflussgröße ist der Kanallängenmodulationsfaktor $\lambda$. Er beschreibt die Verkürzung der effektiven Kanallänge mit steigender Drain-Source-Spannung $V_{DS}$ in diesem Arbeitsbereich. Im Interesse eines großen $r_{Out1}$ muss der MOS-Transistor demzufolge möglichst lang sein.

Fig. 9 zeigt einen Kaskode-Stromspiegel.

Einen wesentlich höheren Ausgangswiderstand erzielt man durch die in Fig. 9 dargestellte Kaskode-Anordnung. Der in Gate-Schaltung betriebene Kaskode-Transistor $T_2$ sorgt dafür, dass $T_1$ in der Sättigung bleibt und seine Drainspannung möglichst konstant ist. Unter Berücksichtigung der Transkonduktanz $g_{m2}$ und des Ausgangsleitwerts $g_{ds2}$ von $T_2$ vergrößert sich der Kleinsignal-Ausgangswiderstand der Kaskodequelle auf

$$r_{Out2} \approx \frac{g_{m2}}{g_{ds2}} r_{Out1}. \qquad (12)$$

An den beiden Knoten (1) und (2) können weitere Kaskode-Quellen angeschlossen werden.

Mit einer Abstufung der Weiten der Ausgangstransistoren ($T_1$ in Fig. 9) in Zweierpotenzen innerhalb dieser Strombank durch Parallelschaltung einer geeigneten Zahl von Einzeltransistoren ergibt sich eine Anordnung, die für Strom-DAC verwendet wird. Bei Wandlern mit Auflösungen größer als 6 Bit werden die oberen Quellenblöcke häufig nicht binär sondern linear gewichtet und unter Verwendung des Thermometercodes angesteuert. Aufgrund der mit der Auflösung etwa exponentiell steigenden Fläche spielt deren Optimierung eine wichtige Rolle. Die Dimensionierung des Einzeltransistors und damit des LSB (*Least Significant Bit*: Niederwertigstes Bit eines Digitalworts) erfolgt unter Berücksichtigung der statistischen Streuung von dessen Bauelementeparametern, wie der Schwellspannung $V_t$ und der Tran-sistorkonstanten $\beta$. In [Gra03] ist dafür eine Methodik beschrieben. In [PVS$^+$99] wird unter der Bezeichnung "$Q^2$ *Random Walk*" ein Entwurfsverfahren beschrieben, bei dem durch die geschickte räumliche Verteilung der Einzeltransistoren und die pseudozufällige Auswahl der oberen linear gewichteten Quellenblöcke eine für Stromquellen-DAC bis dahin unerreichte Genauigkeit von 14 Bit erzielt wurde.

Selbst unter Einbeziehung aller Optimierungen ist der resultierende Flächenverbrauch so groß, dass auf einem SoC wie dem avisierten Bildsensor insgesamt nur ein einziger Strom-DAC mit einer großen Auflösung von 10 Bit oder mehr realisierbar ist. Er wird zur Kalibrierung bzw. Auffrischung dynamischer Stromspeicherzellen, wie sie im Folgenden noch genauer betrachtet werden, verwendet.

Im folgenden werden Stromquellen mit Stromspeicherzellen (SI-Zelle) beschrieben.

Wie bereits zuvor erwähnt, kann auf einem SoC aufgrund der dazu notwendigen Transistorfläche meist nur ein hochpräziser DAC auf der Basis statischer Stromspiegel realisiert werden. Trotzdem ist es notwendig, die Stromquellen in den Spalten ADC mit hoher Genauigkeit und großem Wertebereich zu realisieren. Unter Verwendung von Stromspeicherzellen (SI-Zellen) ist es möglich, diese Anforderungen mit einem verhältnismäßig geringem Flächenaufwand zu erfüllen.

Fig. 11 zeigt eine Prinzipschaltung einer einfachen Stromspeicherzelle (SI-Zelle).

In Fig. 11 ist die Prinzipschaltung einer SI-Zelle mit einfachem Stromquellen-Transistor $T_M$ angegeben. Die Funktion kann in zwei Modi unterteilt werden. Im Speichermodus (1) mit den beiden leitenden Schaltern $S_{1a}$ und $S_{1b}$ wird die Zelle als Diodenlast betrieben und die Kapazität $C_M$ auf einen Spannungswert aufgeladen, bei dem der Drainstrom von $T_M$ gleich dem eingespeisten Strom $I_{Ref}$ ist. Im Ausgabemodus (2) ist nur der Schalter $S_2$ leitend und die auf $C_M$ abgespeicherte Ladung hält die Gate-Spannung von $T_M$ auf dem Wert $I_{Out}=I_{Ref}$. Im Unterschied zu einem kontinuierlichen Stromspiegel wird $T_M$ abwechselnd als Eingangs- und Ausgangstransistor betrieben, so dass sich eine Streuung der Transistorparameter (Unterschiede zwischen $T_{Ref1}$ und $T_1$ in 9) nicht auf den Ausgangsstrom auswirken kann. Dieser Zugewinn an Genauigkeit wird allerdings durch Fehler aufgrund des getakteten Betriebs erkauft. So wird z.B. die Speicherkapazität durch Schalterleckströme langsam entladen, und muss in regelmäßigen Abständen aufgefrischt werden. Die erhebliche Flächenersparnis vor allem bei sehr hohen Genauigkeitsanforderungen rechtfertigt dennnoch den erforderlichen Schaltungsaufwand.

Eine gute Zusammenstellung der unterschiedlichen Effekte und erforderlichen Maßnahmen ist beispielsweise in [Gra03] angegeben. Zu den Quellen von Abweichungen gehören

- der Leckstrom der Schalttransistoren,
- ein unzureichender Ausgangswiderstand der sich im Speicher- und Ausgabemodus auswirkt,
- Ladungsinjektionen, hervorgerufen durch die Schaltvorgänge,
- Probleme im Zusammenhang mit dem Einschwingen und
- Rauschen der Komponenten und deren Auswirkungen auf den getakteten Betrieb.

Die Ausführungen zu den aufgezählten Punkten in den vorherigen Abschnitten gelten selbstverständlich auch im Zusammenhang mit den SI-Zellen. Da es sich um in der Literatur sehr umfassend beschriebene und in den verschiedensten Technologien erprobte Strukturen (z.B. [Vit94, WVR87, LHRP97, WAS99, Get02]) handelt, wird an dieser Stelle auf eine detaillierte Beschreibung der Grundlagen verzichtet.

Im folgenden wird eine SI-Zelle im Pixel beschrieben.

Die SI-Zelle dient der zuvor erwähnten Speicherung des aktuellen Helligkeitswerts in Form des Drainstroms des Photo-FET. Auf diese Art und Weise kann z.B. der Bias-Strom im Rahmen der CDS-Korrektur kompensiert oder ein negatives Ausgangssignal berechnet werden. Im Gegensatz zu spannungsbasierten aktiven Pixelzellen erfolgt die Differenzbildung direkt im Pixel beim Auslesen der Speicherzelle. Im Interesse eines geringen zeitlichen Versatzes zwischen der Speicherung und der Ausgabe des gespeicherten Wertes, sollte beides möglichst in zwei aufeinander folgenden Halbtakten, also bei der maximalen Abtastrate von 5MHz in weniger als 100ns geschehen.

Fig. 12 zeigt eine SI-Zelle im Pixel.

In der Pixelschaltung wird die in Fig. 12 dargestellte Standard-SI-Zelle, mit dem Speicher-Transistor $T_M$, seiner Gate-Kapazität $C_M$, zwei Dummy-Transistoren $T_{Da}$ und $T_{Db}$ und einem Ausgabe-Transistor $T_{SIC}$, der in der bereits beschriebenen Art und Weise analog als Kaskode angesteuert wird, verwendet. Eine Unterscheidung zwischen Ein- und Ausgang ist nicht notwendig. Das wichtigste Kriterium bei der Wahl der Größe der Transistoren ist neben der Genauigkeit die von der Zelle belegte Fläche. Eine Optimierung der Elemente im Hinblick auf die Parameterstreuung ist also nur bedingt möglich.

Im folgenden werden SI-Zellen im Spalten-ADC beschrieben.

Die SI-Zellen zur Ladungsgeneration in den spaltenparallelen ADC müssen eine Genauigkeit von mindestens 8 Bit aufweisen, wobei ein neuntes Bit als Reserve hinzugenommen wird. In jeder Spalte befinden sich im ADC vier PMOS und vier NMOS-Zellenbänke, die jeweils etwa alle 10ms aufgefrischt werden sollen. Die Festlegung der Anzahl der SI-Zellen wird später beschrieben. Bei 128 Spalten ergibt sich insgesamt eine Auffrischrate von etwas mehr als 100kHz. Werden die Wandler zwischen den Messungen nicht umkonfiguriert, muss nur der durch Leckströme hervorgerufene Ladungsverlust ausgeglichen werden, was keine sehr hohen Anforderungen an das Zeitverhalten stellt. Die kapazitiv hoch belasteten Zuleitungen werden nur beim Wechsel von einer der Bänke auf die nächste, also insgesamt acht Mal komplett umgeladen. Bei einer Vergrößerung der Spaltenzahl des Sensors oder der Erhöhung der erforderlichen Auffrischrate der SI-Zellenbänke, kann auf eine Parallelisierungseinheit zurückgegriffen werden. Der Steueraufwand steigt bei dieser Lösung zwar erheblich, jedoch ist dann eine Auffrischrate bis in den MHz-Bereich möglich.

Im folgenden werden Komparatoren erläutert.

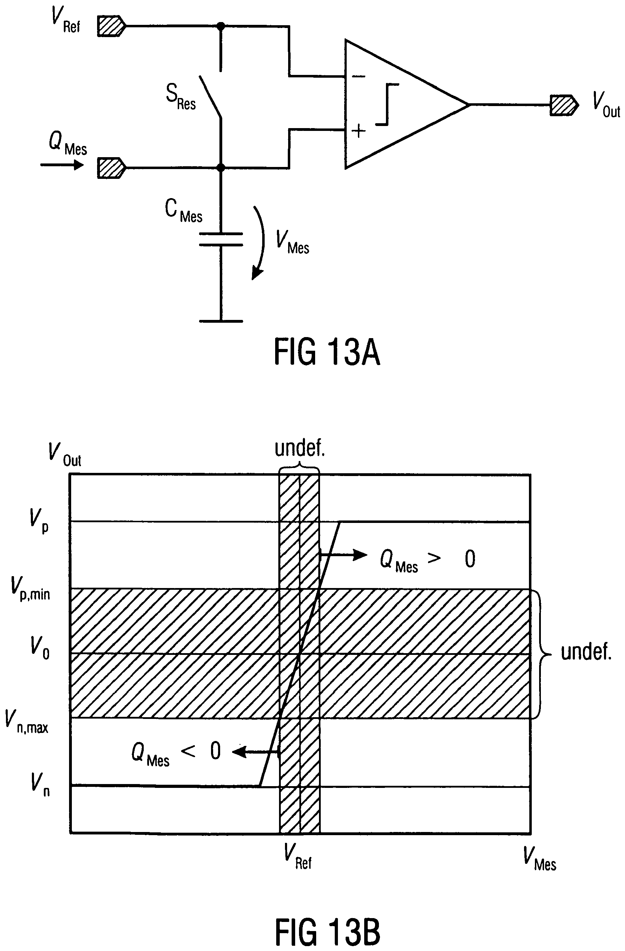

Das im Architekturkonzept und in der Spezifikation dargestellte Grundprinzip des Vergleichs von Ladungen soll an dieser Stelle etwas vertieft werden. Dazu sollen die Schaltung und de statische Übertragungsfunktion in Fig. 13 dienen.

Fig. 13 zeigt eine Schaltung (a) und statische Übertragungsfunktion (b) eines Ladungs-Komparators.

Zur Vorbereitung dess Messvorgangs wird die Kapazität $C_{Mes}$ auf eine Spannung $V_{Mes,0}=V_{Ref}$ vorgeladen ($S_{Res}=1$). Im Anschluss daran wird die zu untersuchende Ladung $Q_{Mes}$ übertragen, worauf sich die Spannung über der Kapazität auf einen Wert

$$V_{Mes} = \frac{Q_{Mes}}{C_{Mes}} + V_{Mes,0} \qquad (13)$$

zum Endzeitpunkt für die Übertragung $t_1$ ändert. Danach erfolgt ein Vergleich der Spannung $V_{Mes}$ mit $V_{Ref}$. Beide Spannungswerte können unterschieden werden, wenn der Ausgangspegel $V_{Out}$ des Komparators im Verlauf der vorgegebenen Einschwingzeit einen Wert außerhalb des undefinierten Bereiches

$$V_{Out} > V_{p,min} \wedge V_{Out} < V_{n,max} \qquad (14)$$

erreicht. In Fig. 13b ist der Entscheidungsvorgang vereinfacht für einen statischen Komparator dargestellt. Es ergibt sich für die erfassbare Ladung ein Minimum des Betrags

$$|Q_{Mes}|! > Q_{min}. \qquad\qquad (15)$$

Bei Werten $|Q_{Mes}| \leq Q_{min}$ könnte zwar für die Ladung der Wert $Q_{Mes}$=0C angenommen werden, das Ziel ist jedoch, den unbestimmten Zustand, $V_{n,max} \leq V_{Out} \leq V_{p,min}$ zu vermeiden. In der Literatur wird dieser Fall auch als Fehlerfall (engl. *Failure*) bezeichnet, dessen Häufigkeit mit einer Fehlerrate (*Mean-Time to Failure*, MTF: Fehlerrate, z.B. Angabe über die Wahrscheinlichkeit des Nicht-Einschwingens eines Komparators) angegeben wird. Für jeden Komparator gilt, je größer dessen Verstärkung ist, umso größer ist die Wahrscheinlichkeit des Einschwingens. Ein sehr großer Wert wird durch eine Mitkopplung verbunden mit der dazu erforderlichen getakteten Arbeitsweise erreicht. Die folgenden Ausführungen beschränken sich aus diesem Grund auf die Klasse von Komparatoren mit bistabilen Kippstufen *(Latch)*. Nur sie stellen für die erforderlichen Auflösung eine ausreichende Schaltgeschwindigkeit bei moderater Verlustleistung bereit.

Durch die Streuung von Transistorparametern ist der Umschaltpunkt eines jeden Komparators ($V_{Out}=V_{Out,0}$) nicht exakt bei $V_{Mes}-V_{Ref}$=0, sondern verschoben um eine Offsetspannung $V_{os}$. Der Wert $V_{os}$ ist typischerweise mittelwertfrei und gaußverteilt. Durch die Wahl eines günstigen Arbeitspunktes und hinreichend großer Transistoren kann die Offsetspannung minimiert werden. Häufig sind der Optimierung allerdings Grenzen gesetzt, z.B. durch die Anforderungen im Hinblick auf Verlustleistung und Einschwingzeit. Die Genauigkeit kann dann nur durch eine Kalibrierung (*Autozero*) des Komparators in einem zusätzlichen Schritt erreicht werden. In [Gra03] sind geeignete Methoden zur statistischen Optimierung analoger Schaltungsblöcke dargestellt.

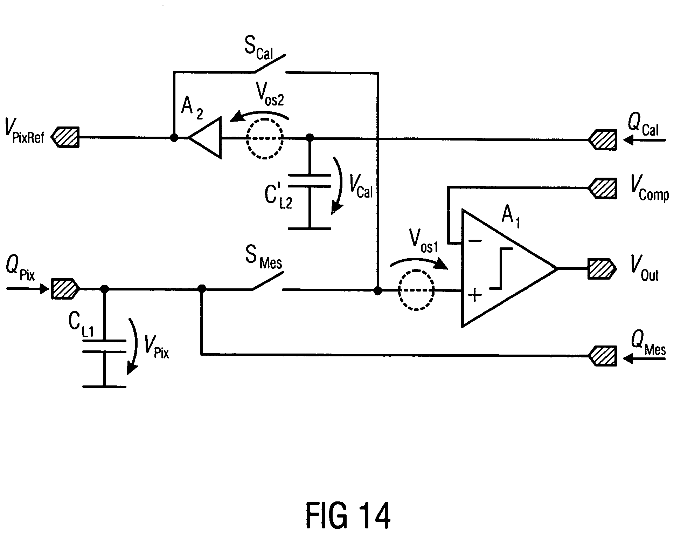

Bei dem hier vorgestellten Wandlungsverfahren spielt die absolute Spannung $V_{Mes,0}$ zum Startzeitpunkt nur eine untergeordnete Rolle. Im Zusammenhang mit der Auslegung der gepulsten Stromquellen muss nur darauf geachtet werden, dass sie im gesamten Arbeitsbereich einen hinreichend kleinen Fehler aufweisen und die Offsetspannung $V_{os1}$ kleiner als $\Delta V_{Ref}$ ist. Außerdem muss die Referenzspannung $V_{PixRef}$ gleich der Spannung $V_{Pix}$ auf der Spaltenleitung sein. Dies wird anhand der in Fig. 14 dargestellten Schaltung gewährleistet. Sie entspricht dem dem AD-Teil der Spaltenschaltung in Fig. 5.

Fig. 14 zeigt eine Prinzipschaltung des AD-Teils des ladungsbasierten Auslesepfades.

Die Schaltung besteht aus dem Komparator $A_1$, einem Spannungsfolger $A_2$ zum Treiben von $V_{PixRef}$, der externen Kapazität der Spaltenleitung $C_{L1}$, der internen Kalibrierkapazität $C'_{L2}$ und den beiden Schaltern $S_{Cal}$ und $S_{Mes}$ (entspr. Multiplexer $M_1$ in Fig. 5). Weiterhin eingezeichnet sind die Offsetspannungen $V_{os1}$, und $V_{os2}$ von $A_1$ bzw. $A_2$. Zur Vorbereitung des Messvorgangs wird $V_{PixRef}$ an den von außen vorgegebenen Vergleichswert $V_{Comp}$ unter Berücksichtigung des Offsets gemäß $V_{PixRef} \rightarrow V_{Comp}+V_{os1}$ angenähert. Dies geschieht in der gleichen Art und Weise wie die Analog-Digital-Wandlung iterativ durch den Vergleich von $V_{PixRef}$ mit $V_{Comp}$ und die anschließende Einkopplung eines Ladungspaketes über den Kalibriereingang $Q_{Cal}$, nur dass der Digitalwert nicht gespeichert wird. Die Genauigkeit der Ladungspakete spielt keine sehr große Rolle, wichtig ist nur, dass sie deutlich kleiner als die für die anschließende Analog-Digital-Wandlung ist. In regelmäßigen Abständen muss eine Auffrischung von $V_{Cal}$ durchgeführt werden, um der Entladung durch Schalterleckströme entgegen zu wirken. Die Offsetspannung $V_{os2}$ wird bei dieser Vorgehensweise ebenfalls kompensiert. Nach der Kalibrierung $V_{Ref}$ wird $S_{Cal}$ deaktiviert, der positive Komparatoreingang über $S_{Mes}$ mit $C_{L1}$, verbunden und die Messung kann beginnen.

An den Spannungsfolger $A_2$ werden keine hohen Anforderungen gestellt. Er soll während des Auffrischzyklus von $C'_{L2}$ den relativ niederfrequenten Eingangssignalen folgen können und ansonsten die Referenzspannung $V_{RefPix}$ stabil halten. Ein einfacher als Spannungsfolger geschalteter Differenzverstärker erfüllt diese Bedingungen. Im Folgenden sind Auswahl, Funktion und Auslegung des Komparators $A_1$ genauer beschrieben.

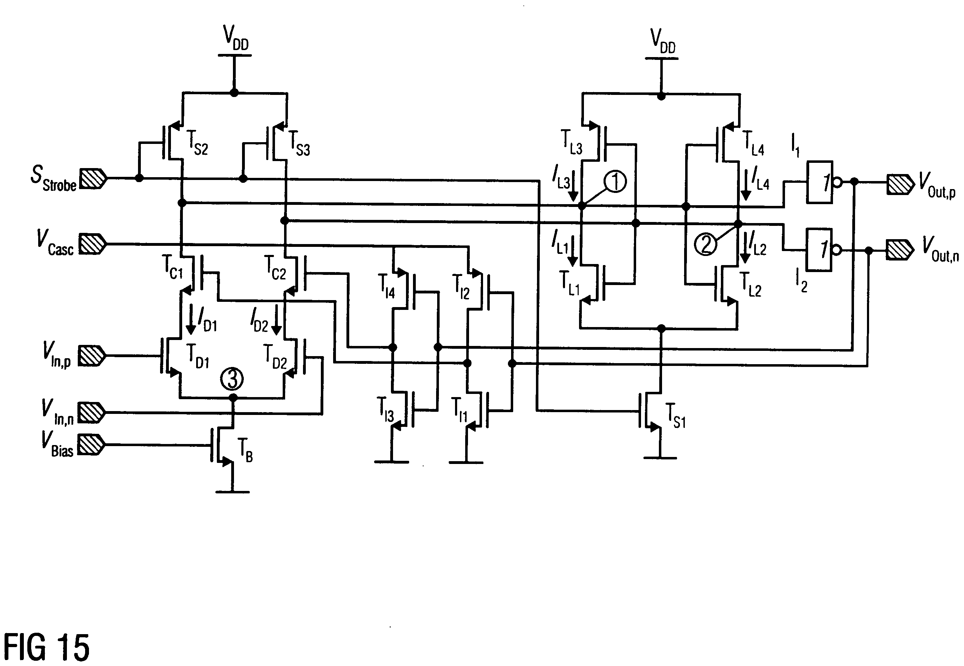

Die Schaltung des Komparators ist in Fig. 15 dargestellt. Eine ähnliche Topopogie ist in [AGPS02] beschrieben.

Funktionsbestimmende Bestandteile sind das Differenzpaar $T_{D\{1,2\}}$ mit der Biasquelle $T_B$ und den Kaskodetransistoren $T_{C\{1,2\}}$, die mittels $T_{S1}$ schaltbare bistabile Kippstufe $T_{L\{1,4\}}$ und die beiden digitalen Inverter $I_{\{1,2\}}$ zur Entkopplung des Ausgangs. Darüber hinaus sind Schaltungselemente zur Sicherstellung eines optimalen Betriebs enthalten. Die gemeinsam mit $T_{S1}$, geschalteten Lasttransistoren $T_{S\{2,3\}}$ sorgen dafür, dass die beiden internen Knoten (1) und (2) der Kippstufe im Rücksetzfall ein definiertes Potential aufweisen, damit die Digitalschaltungen am Ausgang des Komparators statisch nicht im verbotenen Bereich angesteuert werden. Über einen der beiden Inverter $T_{I\{1,2\}}$ und $T_{I\{3,4\}}$ wird der Kaskode-Transistor des Zweigs der Differenzstufe mit der geringeren Eingangsspannung deaktiviert. Dadurch wird verhindert, dass nach der Regenerationsphase ein relativ großer Längsstrom durch das Differenzpaar fließt und das Potential am Knoten (3) zu stark abfällt.

Fig. 15 zeigt eine Transistorschaltung des Komparators.

Im folgenden werden verschiedene Aspekte ladungsbasierter Analog-Digital-Wandler (CP-ADC) beschrieben.

Zählender CP-ADC

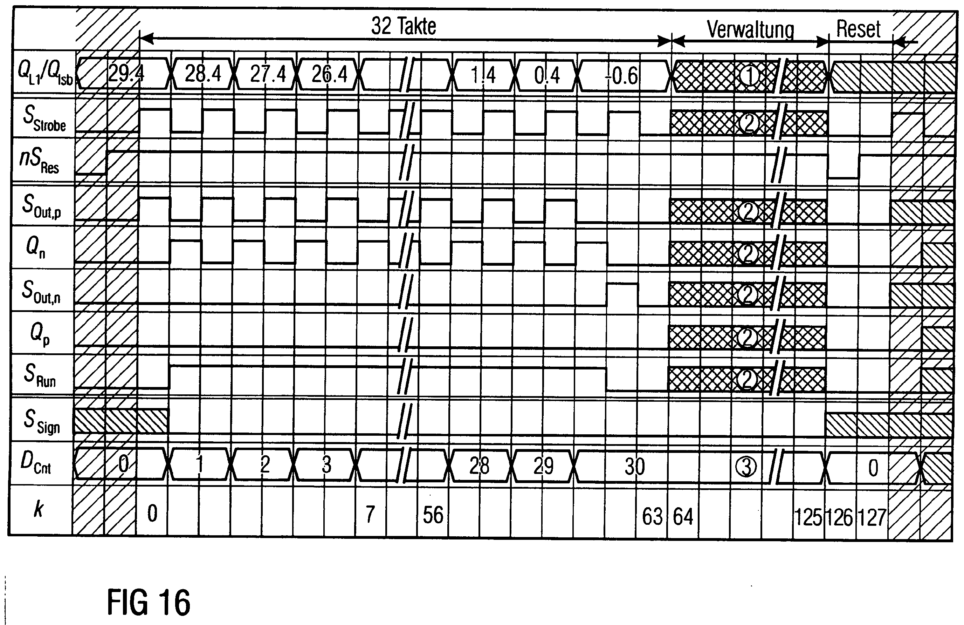

Im einfachsten Fall wird die zu messende Ladung mit vielen kleinen Ladungspaketen einer bekannten Größe kompensiert. Aus deren Anzahl ergibt sich das Ergebnis der Wandlung. Das Taktdiagramm dieses Wandlers nach dem Zählverfahren ist in Fig. 16 dargestellt. Beispielhaft wurde eine Auflösung des Wandlers von 5 Bit gewählt.

Fig. 16 zeigt ein Taktdiagramm für den Wandlungszyklus eines zählenden CP-ADC mit einer Auflösung von 5 Bit.

Das Abtastsignal $S_{Strobe}$ zur Ansteuerung des Komparators stellt die Zeitbasis des ADC dar. Ein Messintervall besteht entsprechend der Auflösung von 5 Bit aus $2^5$=32 Voll- bzw. 64 Halbtakten ($k$=0..63). Daran schließt sich ein Intervall ($k$=64..125) an, in dem verschiedene Verwaltungsoperationen statt finden. Dazu gehören die Ausgabe des digitalen Messergebnisses $D_{Cnt}$ (3), die Kalibrierung der Quellen und des Auslesepfades (2) sowie die Aufnahme des Ausgangssignals der Pixelzelle für den folgenden Messvorgang durch Integration des Stroms $I_{Pix}$ auf der Messkapazität $C_{L1}$ (1). Die Länge dieses Intervalls kann an die Anforderungen z.B. bezüglich des Kalibrieraufwands für die Quellen oder der erforderlichen Integrationszeit für $Q_{Pix}$ angepasst werden. Mit dem anschließenden Rücksetztakt ($k$=126..127) wird die lokale Steuerung in den Ausgangszustand zurückversetzt und der nächste Messzyklus kann beginnen.

Bei der Implementierung dieses ADC gibt es zwei Möglichkeiten für die Anordnung des Zählers im Design. Er kann entweder lokal in der Spaltensteuerung oder global für alle Spalten gemeinsam verfügbar sein. In letzterem Fall werden die von einem zentralen Zähler verteilte Bits in den lokalen Speicher der ADC übernommen, wenn ein Null-durchgang von $Q_{L1}$ detektiert wird. Beide Varianten haben ihre Vor- und Nachteile. Aufgrund des hohen Flächenverbrauchs eines statischen Zählers wird in der Literatur meist auf dessen vielfache Verwendung verzichtet und die zweite Variante bevorzugt z.B. in [KLLEG01]. Eine dynamische Zählerkette wie in [DKK03] lässt sich hingegen sehr kompakt aufbauen und eignet sich aus diesem Grund ausgezeichnet für einen parallelen Einsatz. Der Verdrahtungsaufwand und die damit verbundene kapazitive Last ist bei dieser Lösung wesentlich geringer, wobei die Fläche pro Zählerbit ähnlich der eines Flipflop ist. Die folgenden Beschreibungen beziehen sich auf diese Lösung.

Das Vorzeichen der auf der Messkapazität $C_{L1}$ vorliegenden Ladung $Q_{L1}$ wird während des aktivierten *Strobe*-Signals $S_{Strobe}$=1 ermittelt und über die beiden Ausgänge des Komparators $S_{Out,p}$ und $S_{Out,n}$ ausgegeben. Schwingt der Komparator innerhalb dieses Halbtaktes ein, ist genau einer der beiden Ausgänge auf 1. Sind, wie in Fig. 16 dar-gestellt, $Q_{L1}$>0 und somit $S_{Out,p}$>0, wird eine negative Ladung $Q_n$ auf $C_{L1}$ ausgegeben wodurch $Q_{L1}$ um diesen Wert sinkt. Aus der ersten Entscheidung jedes Wandlerzyklus ergibt sich zum Zeitpunkt $k$=1 das Vorzeichen des Messsignals, hier $S_{Sgn}$=0. Der Nulldurchgang von $Q_{L1}$ und damit das Ende des Zählvorgangs ($S_{Run}$=0) wird mit dem ersten Wechsel der Polarität, in Fig. 16 im Halbtakt $k$=62 erreicht.

CP-ADC mit sukzessiver Approximation

Der Nachteil des ADC auf Zählerbasis besteht in der großen Anzahl erforderlicher Takte bis ein Ergebnis vorliegt. Bei einer Auflösung von sieben Bit dauert der Umsetzungsprozess 127 Takte. Für einen schnellen Bildsensor ist das zu viel. Ein ADC auf der Basis der sukzessiven Approximation benötigt im Gegensatz dazu nur so viele Takte, wie seine Auflösung ist, wobei binär abgestufte Größen zum Vergleich herangezogen werden.

Bei einer ladungsbasierten Implementierung bedeutet das, dass für einen 8 Bit ADC insgesamt 16 Quellen, jeweils acht mit jeder Polarität, benötigt werden. Zur Verringerung dieser Zahl bietet sich eine Kombination aus beiden Varianten an, wobei für einzelne oder alle Quellen eine Abstufung von 2' mit $i$>1 gewählt wird. Daraus ergibt sich der in Tabelle 1 dargestellte Zusammenhang zwischen der Anzahl der Quellen, deren Abstufung und der Zahl der Wandlungstakte.

Tabelle 1 zeigt die Anzahl der Approximationsschritte in Abhängigkeit von der Bitstufenzahl

| Anzahl der Quellen | Anzahl der Schritte | $i$ | Beispiel |
|---|---|---|---|
| 2 | 255 | 0 | 255 |
| 4 | 30 | 4 | 2×15 |
| 6 | 17 | 2 und 3 | 3+2×7 |
| 8 | 12 | 2 | 4×3 |
| 10 | 11 | 1 und 2 | 2×1+3×3 |
| 12 | 10 | 1 und 2 | 4×1+2×3 |

(fortgesetzt)

| Anzahl der Quellen | Anzahl der Schritte | $i$ | Beispiel |
|---|---|---|---|
| 14 | 9 | 1 und 2 | $6\times1+3$ |
| 16 | 8 | 1 | $8\times1$ |

Es ist ersichtlich, dass ab einer Quellenzahl von acht jeder eingesparte Takt mit zwei zusätzlichen Ladungsquelle erkauft wird. Da diese aus SI-Speicherzellen bestehen, die aufgefrischt werden müssen, ist der Preis für die sehr moderate Beschleunigung erheblich. Einen guten Kompromiss stellt die Abstufung von 4 ($i=2$) bei 12 Takten für eine Wandlung dar.

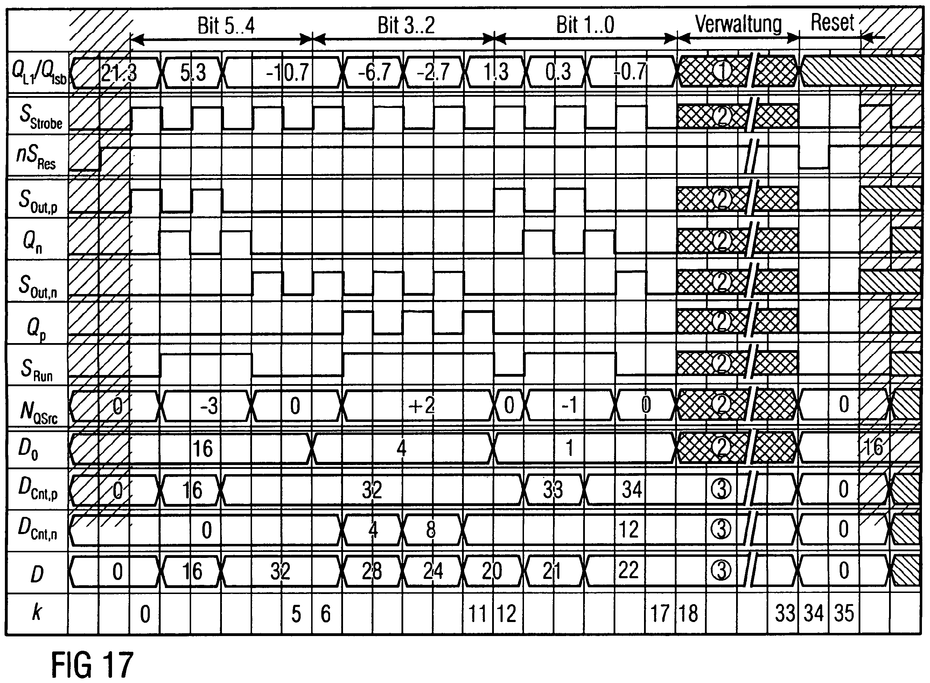

In Fig. 17 ist das Taktdiagramm eines dreistufiger CP-ADC in dieser Konfiguration dargestellt. Aus dem verbleibenden Rest ist ersichtlich, dass er nur eine effektive Auflösung von 5 Bit aufweist, das LSB also wandlungsbedingt nicht zuverlässig ist.

Fig. 17 zeigt ein Taktdiagramm für den Wandlungszyklus eines dreistufigen kombinierten CP-ADC mit sukzessiver Approximation und Zählen.

Im folgenden wird auf eine Pixelzelle mit ladungsbasiertem Rücksetzen eingegangen.

Die Einsatzgebiete von Bildsensoren sind heutzutage sehr vielfältig und reichen von einfachen und billigen CMOS-Kamerachips in Mobiltelefonen über Bildsensoren in hochwertigen z.B. Spiegelreflexkameras bis hin zu teuren und aufwendigen Speziallösungen für industrielle Anwendungen oder in der Luft- und Raumfahrt. Neben den Sensoreigenschaften

- räumliche Anordnung der Bildpunkte (Einzelpunkt, Zeile, Matrix, hexagonal, konzentrisch),
- Auflösung (Anzahl der Bildpunkte, Punktabstand),
- Helligkeitsumfang und -charakteristik (linear, logarithmisch, großer Dynamikumfang),
- spektrale Empfindlichkeit (Quantenwirkungsgrad, Farbe oder Grauwerte, Infrarot, Ultraviolett),
- Bildwiederholrate (Integrationszeit, Auslesezeit) und
- Reproduzierbarkeit und Nichtidealitäten (Streuung, Rauschen)

spielt die Möglichkeit zur Integration zusätzlicher Systemkomponenten auf einem Chip (SoC) eine immer wichtigere Rolle. Im Gegensatz zur CCD-Technologie, die nur die Einbettung einfachster Schaltungskomponenten ermöglicht, sind in einer CMOS-Technologie die strahlungsempfindlichen Strukturen weitestgehend Prozess-kompatibel. Neben der eigentlichen Sensormatrix können so komplexe Systeme von der Ansteuerung über die Analog-Digital-Wandlung bis hin zur Datenverarbeitung realisiert werden. Anhand der Aufteilung des Datenpfades der Signalverarbeitung zwischen Pixelzelle, Spalten- und Sensoransteuerung ist der Grad der Parallelität frei wählbar. Z.B. von [KLLEG01] wurde ein Bildsensor mit einem Analog-Digital-Wandler in jeder Pixelzelle vorgestellt. Viele der Beispiele zeigen, dass der Übergang zu immer neuen Technologien für die SoC viele Chancen bietet. Wie sich zeigen wird, ermöglicht die Integration von schnellen Speichern in Verbindung mit einem hoch parallelen Zugriff auf die Pixelmatrix Möglichkeiten für Algorithmen, die bei einer Multichip-Lösung schwer zu realisieren wären.

Im folgenden wird näher auf Photo-Feldeffekttransistoren (Photo-FET) eingegangen.

Fig. 18 zeigt einen Querschnitt eines p-Kanal Photo-FET (a) und Grundschaltung (b) einer Pixelzelle für den kontinuierlichen Betrieb.

Fig. 18 zeigt einen Querschnitt durch einen p-MOS Photo-FET sowie das Ersatzschaltbild der entsprechenden Schaltung. Die entscheidende strahlungsempfindliche Struktur ist eine Wannen-Substrat-Photodiode $D_{Ph}$. Sie generiert einen Photostrom $I_{Ph}$. Ihre photoelektrischen Eigenschaften entsprechen denen einer gewöhnlichen Photodiode, wie sie zuvor dargestellt wurde. Der Photo-FET kann in erster Näherung als $V_{BS}$-gesteuerte Stromquelle unter Verwendung der Bulk-Source-Transkonduktanz $g_{mb}$ und der Bulk-Source-Kleinsignalspannung $v_{BS}$ gemäß

$$i_{DPh} = g_{mb}v_{BS} \qquad (16)$$

beschrieben werden.

Im folgenden wird auf die Schaltungstechnik einer Pixelzelle mit Photo-FET eingegangen.

Zuvor wurden die Grundlagen zum Verständnis der strahlungsempfindlichen Sensoren auf der Basis von Feldeffekttransistoren in nicht kontaktierten Wannen gelegt. An dieser Stelle soll etwas näher auf bekannte Schaltungsrealisierungen für die verschiedenen Ausprägungen dieser Pixelzelle eingegangen werden. Aufgrund ihrer Komplexität sind Photo-FETbasierte Pixelzellen nicht so weit verbreitet wie einfache Dioden-basierte. Sie finden sich vor allem in Spezialanwendungen mit hohen Anforderungen an die Empfindlichkeit und den Dynamikumfang.

Aus den verschiedenen technologischen Varianten der Implementierung strahlungsempfindlicher FET-Strukturen wurden verschiedenen Realisierungen von Pixelzellen entwickelt. Es kommen wie auch bei der einfachen Photodiode der kontinuierliche und der integrierende Betrieb in Frage.

Beispiele für Pixelzellen mit ausschließlich kontinuierlich betriebenem Photo-FET finden sich z.B. in [SBH+97]. Für die folgenden Betrachtungen spielen derartige Zellen jedoch keine weitere Rolle.

Der Vorteil von Pixelzellen mit Photo-FET in rücksetzbaren Wannen besteht in der möglichen Doppelnutzung im integrierenden und kontinuierlichen Betrieb. Wird auf ein Rücksetzen der Wannen-Substrat-Diode verzichtet, geht der Photo-FET aufgrund seiner Source-Wannen-Diode automatisch in den kontinuierlichen Betrieb mit nahezu logarithmischem Zusammenhang zwischen Bestrahlungsstärke und Drainstrom über. Ein Beispiel für diese Anordnung findet sich in [BHP+98]. Die Grundlage bildet dabei die in Fig. 19 dargestellte Grundschaltung die in [SK96] bzw. [SK99] patentiert wurde. Sie ist auf Grund der Anordnung des Rücksetz-Transistors in der strahlungsempfindlichen Wanne sehr platzsparend.

Fig. 19 zeigt eine Grundschaltung der Pixelzelle mit einem Photo-FET in einer mittels Transistor rücksetzbaren Wanne.

Basierend darauf wurde ein hochdynamischer Zeilensensor mit einer selbstschwingenden Pixelzelle (Licht-FrequenzWandler) [DSSK02, DKSS99], pixelparalleler Analog-Digital-Wandlung und variabler Wertauflösung implementiert. Die Arbeit zeigt, dass das direkte digitale Schalten des Reset-Transistors zu einer erheblichen aufgrund der geringen Kapazität der Wannen-Photodiode schwer zu kompensierenden Ladungseinkopplung führt. Die implementierte Lösung besteht in der analogen Ansteuerung des Reset sowie einem zusätzlichen Dummy-Transistor.

Im Zuge der weiteren Verkleinerung der Strukturabmessungen steigen auch die Transistor-Leckströme, was sich im Zusammenhang mit dem Reset-Transistor z.B. durch eine sinkende Empfindlichkeit der Pixelzelle äußert. Der Austausch des Reset-Transistors gegen eine in dieser Hinsicht günstigere Schaltung ist Gegenstand der im Folgenden dargestellten Entwicklung.

Im Unterschied zu der in Fig. 19 dargestellten Rücksetzschaltung entfällt in der Pixelzelle mit ladungsbasiertem Reset der Reset-Transistor als Schalter und damit auch der durch ihn hervorgerufene zusätzliche Leckstrom. Die Grundschaltung der Pixelzelle ist in Fig. 20 dargestellt.

Fig. 20 zeigt eine Grundschaltung der Pixelzelle mit ladungsbasiertem Reset.

Der p-Kanal-FET $T_{Ph}$ mit seinen Kontakten Source ($V_{SPh}$), Gate $V_{GPh}$ und Drain ($V_{DPh}$) befindet sich, wie auch bei den bisherigen Photo-FET-Pixelzellen, in einer nicht kontaktierten n-Wanne. Diese n-Wanne bildet gemeinsam mit dem p-Substrat die strahlungsempfindliche Diode $D_{Ph}$. Weiterhin befindet sich in der n-Wanne eine Reset-Kapazität $C_{Res}$. Darüber hinaus dargestellt sind die beiden Dioden zwischen den Transistoranschlüssen Source bzw. Drain und der n-Wanne, wobei der Source-Bulk-Diode $D_{SBPh}$ im Rahmen des Rücksetzvorgangs eine funktionale Bedeutung zukommt. Die Dimensionierung dieser beiden Dioden erfolgt wie schon bei der bisher gebräuchlichen Schaltung ausschließlich unter dem Gesichtspunkt einer möglichst zuverlässigen Unterdrückung der parasitären Bipolartransistoren während des integrierenden Betriebes.

Im folgenden wird auf das kapazitive Rücksetzen der Pixelzelle eingegangen.

Bei den bisher gebräuchlichen Schaltungen wird zum Rücksetzen von Photodioden deren Kathode typischerweise über einen Transistor ($T_{Reset}$ in Fig. 19) mit einem bestimmten Potential, hier $V_{SPh}$, verbunden, auf das sie sich nach einer bestimmten Zeit eingestellt haben.

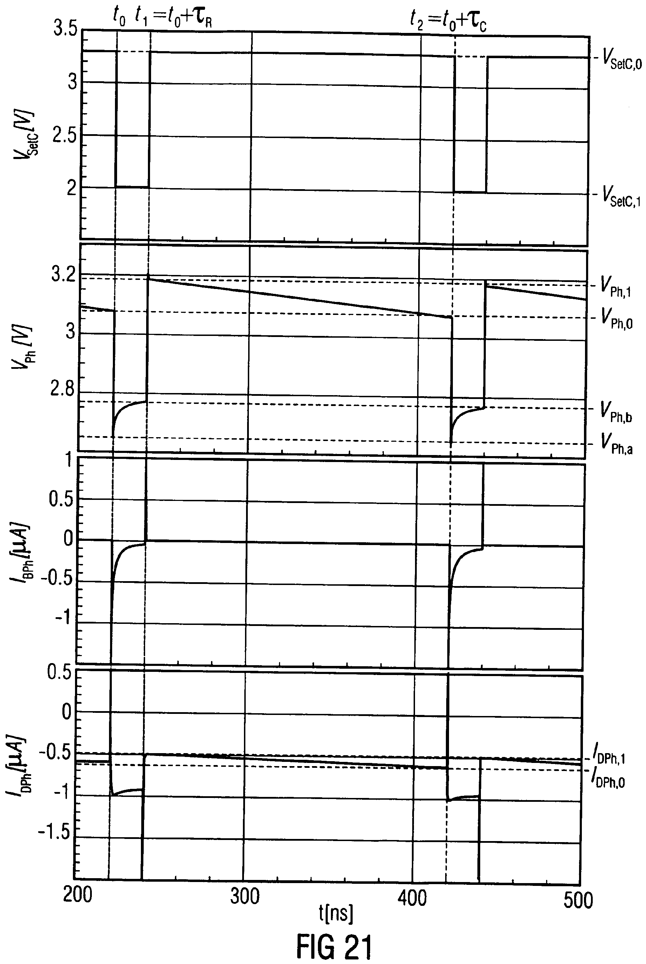

Fig. 21 zeigt eine Simulation des Zeitverlaufs wichtiger Signale beim ladungsbasierten Reset der Pixelzelle.

Bei der neuen Photo-FET-Pixelzelle erfolgt das Rücksetzen ladungsbasiert. Eine Beschreibung des Verhaltens ist aufgrund der vielen beteiligten statischen wie dynamischen Effekte relativ kompliziert. In die etwas vereinfachte Betrachtung sollen die Ströme durch und Spannungen über $D_{SBPh}$, das Potential $V_{Ph}$ der stahlungsempfindlichen Wanne sowie der Ausgangs- (Drain-) Strom des Photo-FET $I_{DPh}$ in Abhängigkeit von der Steuerspannung $V_{SetC}$ und der Zeit einfließen. Der Beitrag des parasitären vertikalen Bipolartransistors soll vernachlässigt werden.

In Fig. 21 ist das Ergebnis der Schaltungssimulation des Zeitverlaufs wichtiger Signale dargestellt. Die Breite des Rücksetzpulses beträgt $\tau_R$=20ns und die Periodendauer $\tau_C$=200ns. Die geometrischen Daten entsprechen denen einer Pixelzelle mit einem Rastermaß von 15µm in einer CMOS-Technologie. Die für Bildsensoren relativ kurzen Zeitintervalle für Rücksetzen und Integration des Photostroms werden gewählt, um die Einschwingvorgänge und die zu erwartenden Geschwindigkeiten zu verdeutlichen.

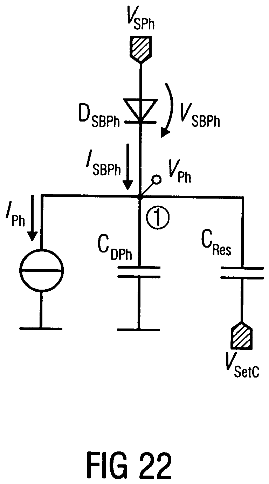

Fig. 22 zeigt eine Ersatzschaltung für den ladungsbasierten Rücksetzvorgang.

Eine Ansteuerung der Kapazität $C_{Res}$ geschieht durch H-L-H-Reset-Pulse der Breite $\tau_R$ ($t_0...t_1$ in Fig. 21) am Steuereingang $V_{SetC}$. Die Pegel H und L entsprechen in der Darstellung $V_{SetC,0}$ bzw. $V_{SetC,1}$. Ein Ersatzschaltbild für die beteiligten Elemente ist in Fig. 22 dargestellt. Mit der H-L-Flanke sinkt die Spannung $V_{Ph}$ des Knotens (1) auf einen Wert $V_{Ph,a}$ ab, was dazu führt, dass die Source-Bulk-Diode $D_{SBPh}$ zu leiten beginnt. Erkennbar ist dies durch eine starke negative Stromspitze von $I_{BPh}$ zum Zeitpunkt $t_0$. Der Strom $I_{BPh}$ lädt während des Reset-Zyklus die Rücksetz-Kapazität $C_{Res}$ und die Kapazität $C_{DPh}$ von $D_{Ph}$ auf. Mit der L-H-Flanke an $V_{SetC}$ wird $V_{Ph}$ von $V_{Ph,b}$ beginnend angehoben, worauf

$D_{SBPh}$ gesperrt und damit der Ladevorgang beendet wird. Die durch den Vorgang zum Zeitpunkt $t_1$, auf die Kapazitäten $C_{Res}$ und $C_{DPh}$ übertragene Ladung verteilt sich entsprechend deren Kapazitätsverhältnis, worauf sich ein neues $V_{Ph}=V_{Ph,1}$ ergibt. Zu diesen Zeitpunkt beginnt der Strahlungsmesszyklus, der sich dadurch auszeichnet, dass die Spannung $V_{Ph}$ wieder sinkt. Entsprechend steigt der Drainstrom $I_{DPh}$ des strahlungsempfindlichen FET, der auch das Ausgangssignal der Pixelzelle repräsentiert. Im Zeitintervall $t=t_1...t_2$ kann dieses Signal erfasst und verarbeitet werden. Der Rücksetzzyklus ist im Folgenden etwas genauer dargestellt.

Während des Betriebes der Pixelzelle verändert sich die Spannung $V_{Ph}$ der strahlungsempfindlichen Wannen-Substrat-Photodiode $D_{NWD}$ ständig. Im kontinuierlichen Modus ist sie für den fließenden Photostrom eingeschwungen und im integrierenden sinkt sie je nach dem Betrag des Photostroms unterschiedlich schnell. Die auf $C_{DPh}$ und $C_{Res}$ integrierten Ladungen stehen im festen Zusammenhang mit $V_{Ph}$ und $V_{SetC}$ sowie den entsprechenden Kapazitätswerten. Aufgrund der Art und Weise der Ladungsspeicherung in der untersuchten Schaltung, im pn-Übergang einer Diode ($C_{DPh}$) und in der MOS-Struktur eines FET ($C_{Res}$) sind die Kapazitäten nicht konstant sondern von der Klemmspannung abhängig.

Das ladungsbasierte Rücksetzen ist sehr robust gegenüber Schwankungen der Rücksetzzeit und damit gegenüber *Jitter* als einem in digitalen Schaltungen schwer zu kontrollierendem Parameter.

Mit einem Strom als Ausgangssignal eignet sich diese Pixelzelle sehr gut sowohl für eine Einbettung in ladungsbasierte oder SI-Schaltungen als auch für die Anwendung in Hochgeschwindigkeits-Bildsensorsystemen.

Im folgenden wird auf Aspekte eines Bildsensors für Weißlicht-Interferometrie eingegangen.

Verfahren zur Profilometrie oder 3D-Oberflächeninspektion gewinnen heute immer mehr an Bedeutung und werden auf verschiedenen Gebieten von Forschung und Entwicklung sowie Produktion eingesetzt. Die Anwendungen in der Elektronik-Technologie, wie z.B.

- die Inspektion von BGA-Gehäusen oder Flip-Chips vor der Montage (Positions- und Volumenmessung der Kontakt-Balls),
- die Inspektion von Leiterplatten vor der Montage (Verwölbung, Koplanarität von Leiterbahnen, Rauigkeit),
- die Inspektion montierter Bauelemente (z.B. Verkippwinkel nach Löten) auf Leiterplatten,
- die Inline-Messungen bei der Fertigung von Dickschicht-Widerständen (Querschnitt, Länge und Bestimmung des Widerstandswerts) bei der Prozesssteuerung,
- die Offline-Messungen bei der Qualitätssicherung bei Lötpastendruck (Höhen-, und Volumenmessungen),
- die Untersuchung von Mikro-Vias,
- die Offline-Messungen bei der Fertigung von Mikro-Linsen sowie Steuerung von deren Umschmelzprozess,
- die Offline-Messungen von Rauigkeiten von Wafern bei deren Fertigung oder Bearbeitung (z.B. *Wafer Back-side Grinding*) sowie
- die Tiefenmessungen bei der Laser-Markierung von Objekten

verdeutlichen diesen Trend. So unterschiedlich wie die Einsatzgebiete sind auch die Anforderungen an die Messtechnik.

Aus dieser Diversität heraus haben sich verschiedene Verfahren etabliert. In [Häu91] sind die wesentlichen zugrunde liegenden Messprinzipien

- Interferometrie,
- Triangulation,
- Fokussuche und
- Laufzeitmessung

gegenüber gestellt. Bei der Untersuchung rauer Oberflächen treten je nach Verfahren unterschiedliche Einschränkungen bezüglich Anwendbarkeit und Genauigkeit auf. Besonders gut eignet sich in diesem Kontext die Weißlicht-Interferometrie. Im Gegensatz zum konventionellen Interferometer mit kohärentem Licht wird dabei nicht deren Phaseninformation sondern das Maximum der Hüllkurve der Interferenzmodulation ausgewertet.

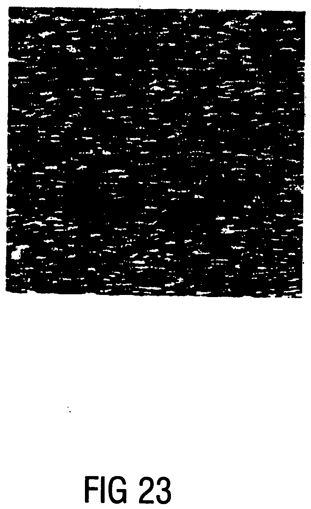

Bei optisch rauen Oberflächen (Rautiefe $R_z > \frac{\lambda}{4}$) begrenzen so genannte *Speckles* die laterale Auflösung der Messung. Specklemuster (engl. sprenkeln, tupfen) sind Lichtflecken, die sich bei der Fig. von an diesen Oberflächen reflektiertem Licht auf einem Schirm, abzeichnen [Wik06] (siehe Fig. 23). Die Phase der reflektierten Strahlung ändert sich innerhalb eines Speckles relativ wenig, jedoch ist sie über das gesamte Sichtfeld zufällig. Deswegen ist die klassische Interferometrie, basierend auf Phasenmessungen, trotz verschiedener Verbesserungen für diese Oberflächen weniger geeignet.

Fig. 23 zeigt eine Photographie eines Speckle-Musters [Wik06] .

Die Eingangs erwähnte Laufzeitmessung wird sich aufgrund der notwendigen Zeitauflösung $\sigma_t$

$$\sigma_z = 1\,\mathrm{m} \rightarrow \sigma_t \approx 3\,\mathrm{fs}$$

auf absehbare Zeit nicht für präzise Profilometrie eignen.

Die Ortsauflösung der Weißlicht-Interferometrie hängt wesentlich von der exakten Untersuchung der Interferenzmodulation ab. Dazu werden bei der kompletten Erfassung einer Oberflächenstruktur sehr viele einzelne Grauwertbilder aufgenommen und verarbeitet. Moderne Weißlicht-Interferometer, wie z.B. das System KORAD[3D] von der Firma 3D SHAPE GmbH [KOR06], erreichen deswegen eine Messgeschwindigkeit von bis zu $28\,\mu$m/s. Der im Folgenden beschriebene Bildsensor und die zugehörigen Algorithmen lassen eine erheblich höhere Messgeschwindigkeit erwarten.

Im folgenden wird auf Aspekte eines Weißlicht-Interferometer eingegangen.

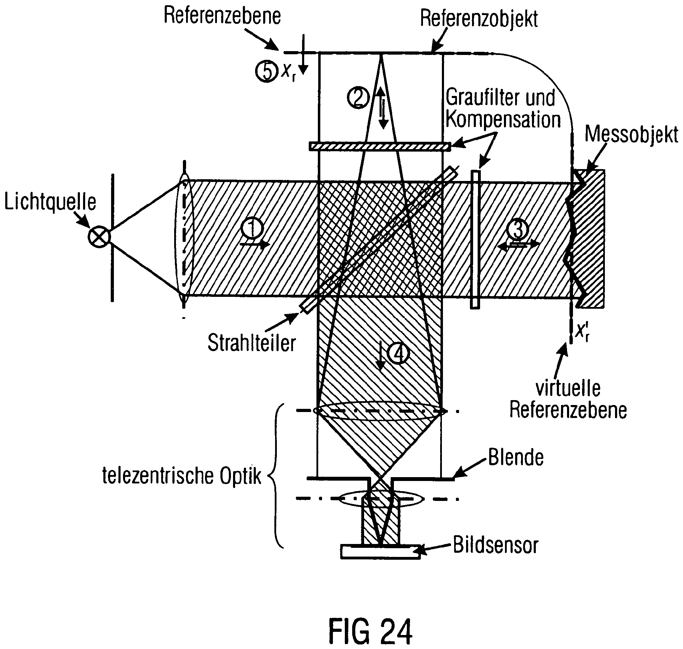

Das Weißlicht-Interferometer basiert auf dem Prinzip des Michelson-Interferometers. Die Fig. 24 zeigt dessen schematischen Aufbau. Ein Lichtstrahl (1) mit einer möglichst geringen Kohärenzlänge $l_c$ (Weißlicht) wird mittels eines Strahlteilers (z.B. halb durchlässiger Spiegel) aufgeteilt. Der eine Teilstrahl wird im Referenzarm (2) an einem Referenzobjekt zurück zum Strahlteiler reflektiert. Die dabei zurückgelegte Weglänge wird durch Veränderung der Lage $x_r$ der Referenzebene (5) mit der Geschwindigkeit $\dot{x}_r$ variiert. Der andere Strahl wird im Messarm (3) an der Oberfläche des Messobjekts reflektiert und dann im Strahlteiler mit dem Referenzarm überlagert. Der resultierende Strahl (4) wird über eine telezentrische Optik auf einen Bildsensor projiziert.

Fig. 24 zeigt einen schematischer Aufbau eines Weißlicht-Interferometers [Häu91].

Erreicht während des Verfahrens des Referenzobjektes die der Referenzebene $x_r$ entsprechende virtuelle Referenzebene $x_r'$ in einem Punkt die Oberfläche $x_0$ des Messobjektes, kommt es in der Projektion dieses Punktes in der Beobachtungsebene zu einer Interferenzmodulation.

Dafür lässt sich die Ortsfunktion des Trägers $y_T(x_r)$ unter Hinzunahme der mittleren Wellenlänge $\overline{\lambda}$ und einer Phase $\varphi$ gemäß

$$y_T(x_r) = \cos\left(\frac{4\pi}{\overline{\lambda}}(x_r - x_0) + \varphi\right) \tag{17}$$

angeben. Dieser Träger ist mit einer für thermische Strahler gaußförmigen Einhüllenden

$$y_H(x_r) = y_{H0}\exp\left(-2\left(\frac{x_r - x_0}{l_c}\right)^2\right) \tag{18}$$

amplitudenmoduliert.

Die mittlere Wellenlänge $\overline{\lambda}$ ergibt sich aus dem Spektrum der verwendeten Strahlungsquelle. Für den thermischen Strahler stellte Max Planck 1900 die Strahlungsgleichung

$$L_e(\lambda, T) = \frac{K_1}{\lambda^5\left(e^{K_2/\lambda T} - 1\right)\Omega_0} \tag{19}$$

für die spektrale Strahldichte auf [HMS89]. Neben dem betrachteten Raumwinkel $\Omega_0$ gehen die beiden Konstanten

$$\begin{aligned} K_1 &= 2hc^2 \\ K_2 &= \frac{hc}{k}, \end{aligned} \tag{20}$$

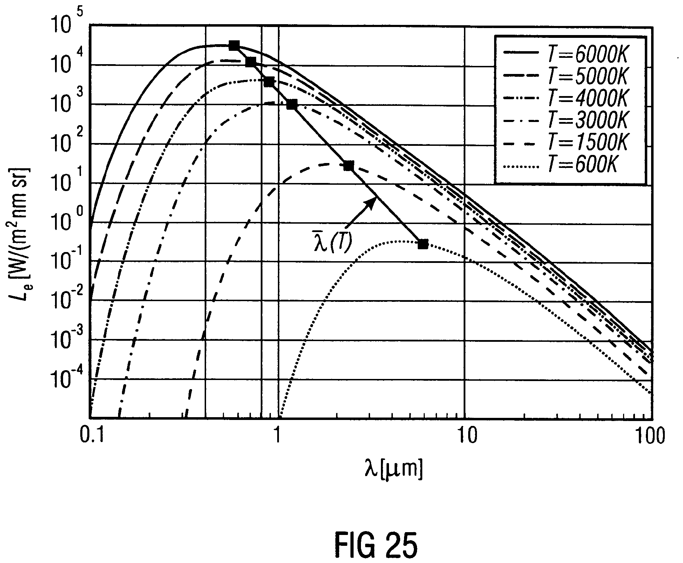

bestimmt aus der Lichtgeschwindigkeit im Vakuum $c$, der Boltzmann-Konstante $k$ und dem Planckschen Wirkungsquantum $h$ ein. Die Spektren thermischer Strahler mit unterschiedlichen Temperaturen und deren mittlere Wellenlängen sind in Fig. 25 dargestellt.

Fig. 25 zeigt Spektren thermischer Strahler mit unterschiedlichen Farbtemperaturen und deren mittlere Wel-

lenlänge $\overline{\lambda}$ (visueller Bereich: 380nm...760nm).

Die Kohärenzlänge $l_c$ entspricht physikalisch der mittleren Länge $\overline{\lambda}$ der interferierenden Wellenzüge und der Bandbreite $\Delta\lambda$ gemäß

$$l_c = \frac{\overline{\lambda}^2}{\Delta\lambda}. \qquad (21)$$

Typische Werte für bestimmte Strahlungsquellen sind in den Tabellen 2 und 3 zusammengefasst.

Tabelle 2 zeigt Kohärenzlängen typischer thermischer Strahler bzw. einer weißen LED.

| $T$[K] | $l_c$[$\mu$m] | typische Quelle |
|---|---|---|
| 6000 | 0.59 | Sonnenlicht / Tageslichtlampe |
| 5000 | 0.71 | Xenon-Lampe / Lichtbogen |
| 4000 | 0.89 | Leuchtstoffröhre (kaltweiß) |
| 3000 | 1.2 | Halogenlampe |
| 1500 | 2.4 | Kerze |
| 600 | 5.9 | Beginn der Sichtbarkeit (Rotglut) |
| 4500...10000 | - | Luxeon K2 LED (weiß) |

Tabelle 3 zeigt Daten von Hochleistungs-LEDs (Luxeon K2) [Lux05].

| $\lambda_p$[nm] | $\Delta\lambda$[nm] | $l_c$[$\mu$m] | Typ |
|---|---|---|---|
| 627 | 20 | 19.7 | rot |
| 617 | 20 | 19.0 | rotorange |
| 590 | 14 | 24.9 | amber |
| 530 | 35 | 8.0 | grün |
| 505 | 30 | 8.5 | cyan |
| 470 | 25 | 8.8 | blau |
| 455 | 20 | 10.3 | royal blau |

Es ist ersichtlich, dass die Farbtemperatur im Interesse einer geringen Kohärenzlänge so hoch wie möglich gewählt werden muss.

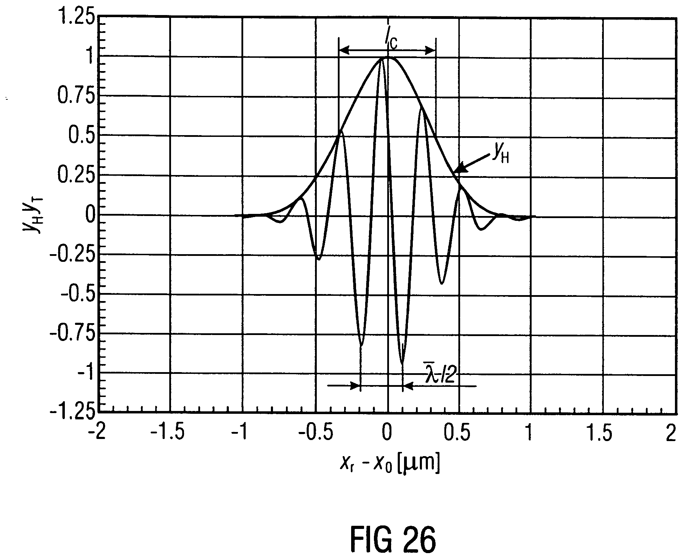

Fig. 26 zeigt eine Interferenzmodulation (offsetfrei) $y_H \cdot y_T$ für einen thermischen Strahler mit $T = 6000$K ($\overline{\lambda} = 580$nm) bei gleicher Dämpfung im Mess- und Referenzarm sowie einer Phasenverschiebung $\varphi = \frac{\pi}{4}$.

Fig. 26 zeigt die aus den Gleichungen 91 und 92 ermittelte Kurve für die Interferenzmodulation $y_H \cdot y_T$ sowie die Hüllkurve für einen thermischen Strahler mit $T = 6000$K. An der Stelle $x_r - x_0 = 0$ bezeichnet das Maximum der Hüllkurve $y_H$ die exakte Position der kohärenten Überlagerung von Mess- und Referenzarm. Bei der Darstellung wurde zur Vereinfachung von einer gleichen Dämpfung des Signals in Mess- und Referenzarm ausgegangen.

Der Aufbau eines Weißlicht-Interferometers erfordert die Einhaltung einer Reihe von Bedingungen, um die dargestellten Interferenzerscheinungen tatsächlich beobachten und messen zu können [Sch05]. Das Kohärenzgebiet auf dem Objekt muss mindestens genauso groß sein wie die Auflösung des beobachtenden Systems, so dass für die Beleuchtungsapertur sin $u_i$ und die Beobachtungsapertur sin $u_o$

$$\sin u_i \le \sin u_o \qquad (22)$$

gelten muss.

Bei der Vermessung optisch rauer Oberflächen (gemittelte Rautiefe $R_Z > \lambda/4$) muss sicher gestellt werden, dass sich die reflektierten Stahlen kohärent überlagern, d.h. dass für die Kohärenzlänge der Strahlungsquelle

$$l_c \geq \frac{4\pi}{\sqrt{2}} R_q \qquad (23)$$

gilt, wobei $R_q$ die quadratische Rauigkeit (Mittel der Abweichungsquadrate) ist.

Die Wahrscheinlichkeit, dass Pixel "dunkel" sind, d.h. keine Interferenzmodulation auftritt und demzufolge auch keine Höheninformation vorliegt, ist sehr groß. Durch eine Reduzierung der Fläche der Speckles kann der Flächenanteil dieser Bereiche reduziert werden. Wird eine geringe Anzahl von Speckles auf ein Pixel abgebildet ist die Interferenzmodulation feststellbar, wenn auch sehr schwach. Am günstigsten sind die Verhältnisse, wenn ein Bildpunkt genau innerhalb eines Speckles liegt. Gemäß Abtasttheorem muss der Speckle-Durchmesser mindestens doppelt so groß sein wie der Pixel-Abstand im Bildsensor.

Die Speckle-Größe kann anhand des Durchmessers des zentralen Airyschen Beugungsscheibchens [HMS89] berechnet werden. Insgesamt sollte der Pixel-Abstand also

$$d_{Pix} \geq \frac{1.22 \lambda x_o}{d_o}$$

sein, mit dem Bildabstand $x_0$ und dem Durchmesser der Austrittsblende $d_o$.

Die fehlenden Informationen an "dunklen" Pixeln müssen durch eine geeignete lokale Filterung des endgültigen Höhenprofils (z.B. Median) rekonstruiert werden.

Die Statistik der Speckles legt nahe, bei der Überlagerung die Strahlungsintensität aus dem Referenzarm etwa fünf mal so groß zu wählen wie aus dem Objektarm um einen optimalen Interferenzkontrast zu erzielen. Dieses Verhältnis kann anhand des Graufilters im Referenzarm angepasst werden. Fehler durch die dadurch hervorgerufene Dispersion lassen sich mittels einer entsprechend dicken Kompensationsscheibe im Messarm korrigieren [DHV92]. Darüber hinaus muss sicher gestellt werden, dass der Dynamikumfang des Bildsensorsystems hinreichend groß ist, um den gesamten Kontrast des optischen Systems aufzunehmen.

Wie bereits dargestellt, besteht die wesentliche messtechnische Aufgabe in der Bestimmung der Position des Ortes der maximalen Interferenzmodulation ($x_r - x_0 = 0$). Dazu muss die Zeitreihe der für jedes Pixel ermittelten Bestrahlungsstärke untersucht werden. Aus der Zuordnung des Abtastzeitpunktes zur Ortsposition des Referenzspiegels für den betrachteten Bildpunkt kann die exakte Position des Oberflächenpunktes im Raum bestimmt werden. An Bildpositionen ohne Signalantwort des Pixels müssen die Ortsinformationen geeignet interpoliert werden.

Die Datenmenge, die bei einer direkten parallelen Bilderfassung mit angeschlossener Signalverarbeitung zu bewältigen ist, soll anhand verschiedener Konfigurationen verdeutlicht werden. Die Methoden unterscheiden sich in verschiedenen Aspekten, z.B. der Art des Antriebs

- kontinuierlich oder
- schrittweise,

in der Position des Antriebs innerhalb des optischen Systems

- am Referenzspiegel,
- bezüglich der Objektposition oder
- beides, z.B. Objektposition grob und
- Referenzspiegel fein,

in der Anzahl der Abtastpunkte

- überabgetastet oder
- unterabgetastet,

sowie in der Art der Beleuchtung. Eine Gegenüberstellung all dieser Methoden und Algorithmen ist nicht Gegenstand dieser Arbeit, so dass zum Vergleich nur eine kleine Auswahl dargestellt ist. Zunächst soll eine Implementierung mit kontinuierlich verfahrenem Referenzspiegel, statischer Beleuchtung mit $T$ = 6000K sowie einem Oversampling-Faktor von 5 bezüglich Gleichung 91 gewählt werden, was bei einer mittleren Wellenlänge von $\overline{\lambda}$ = 580nm einem $\Delta x$ = 58nm entspricht. Bei einem Verfahrweg von 1mm ergibt sich eine Sequenz von knapp 35000 Bildern. Folgende Lösungsmöglichkeiten sind sollen als Beispiele für die Bildaufnahme dienen:

- System basierend auf einer PAL-Videokamera und konstanter Beleuchtung (:
  u.U. mit integriertem DSP zur Bildverarbeitung);
- System basierend auf einem Hochgeschwindigkeits-Bildsensor und konstanter Beleuchtung;
- System basierend auf modulierter Beleuchtung.

Die Bilderfassung ist ein gravierendes, jedoch nicht das einzige Problem für die avisierte Anwendung der beschriebenen Verfahren in der Inline-Inspektion elektronischer Bauelemente. Aus den entstandenen Bildstapeln von bis zu mehreren Gigabyte müssen die Höheninformationen erst unter Verwendung der z.B. in [Häu91] oder [HB95] beschriebenen Algorithmen extrahiert werden. Die nötige Signalverarbeitung ist in vertretbarer Zeit (wenige Sekunden) nur für einen kleinen Bildausschnitt machbar. Nur ein Kamerasystem mit im Bildsensor integrierter massiv-paralleler Vorverarbeitung sowie Kompression für die Ausgabe wäre eine akzeptable Lösung.

Im folgenden wird ein Aspekt eines CMOS-Bildsensors zur Weißlicht-Interferometrie beschrieben.

Der Schlüssel zur schnellen hoch parallelen Verarbeitung der Weißlicht-Interferometer-Bildinformationen liegt im Sensor. Nur dort besteht die Möglichkeit, auf die Daten gleichzeitig

- pixelparallel analog,
- spaltenparallel analog und digital sowie
- seriell digital

zuzugreifen. Die Übertragung der reinen Pixeldaten ist bei einer großen Bildwiederholrate (mehr als 10kHz) sehr aufwändig und bringt einen erheblichen Rechenaufwand in der nachgeschalteten digitalen Signalverarbeitung mit sich.

Prinzipiell ist es angebracht, einen möglichst großen Teil der Bildfilterung in den Pixeln und den Ausleseschaltungen in den Spalten vorzunehmen. Aufgrund der hohen Parallelität muss an diesen Stellen die Verarbeitungsrate nicht sehr groß sein. Pixelfunktionalität und Füllfaktor sind aufeinander so abgestimmt, dass der Sensor die optischen und schaltungstechnischen Anforderungen gleichermaßen erfüllt. Wichtig ist, dass die Funktionalität in der Pixelzelle nicht ausschließlich auf die beschriebenen primäre Anwendung zugeschnitten ist, sondern ein möglichst breites Einsatzgebiet erschließt. Mit der Universalität steigt auch das Nutzen / Kosten-Verhältnis für den Sensor-Chip. Interessant in diesem Zusammenhang sind Modi

- zum hochratigen Auslesen des Bildsensorfeldes,
- zum genauen Auslesen (CDS) des Bildsensorfeldes und
- zum Auslesen mit möglichst großem Dynamikumfang.

Die Implementierung von Zusatzmerkmalen bzw. Betriebsmodi muss allerdings in einen vertretbaren Rahmen bezogen auf den Gesamtaufwand bleiben.

Durch die Verwendung einer Pixelzelle, basierend auf einem strahlungsempfindlichen FET, können die Anforderungen erfüllt werden. Die hohe Auslese- und Bildrate wird durch die zuvor beschriebene ladungsbasierte Analog-Digital-Wandlung verbunden mit einer kompakten digitalen Auswertungslogik in jeder Spalte erzielt. Die Weiterverarbeitung erfolgt in einem zentralen Prozessor, in dem die Zwischenergebnisse aus den Spalten zusammengefasst, komprimiert und ausgegeben werden.

Die in [Häu91, GD93, BH95] beschriebenen Verfahren basieren auf komplizierten Filteralgorithmen, deren direkte Realisierung in Pixelzellen sehr aufwändig ist. Der im Folgenden vorgestellte neue Algorithmus lässt sich sehr gut in

- einen einfachen analogen Teil im Pixel,
- einen gemischt analog-digitalen Teil in der Spaltenansteuerung mit moderaten Geschwindigkeitsanforderungen und
- eine digitale Nachverarbeitung im Sensor bzw. einem externen DSP

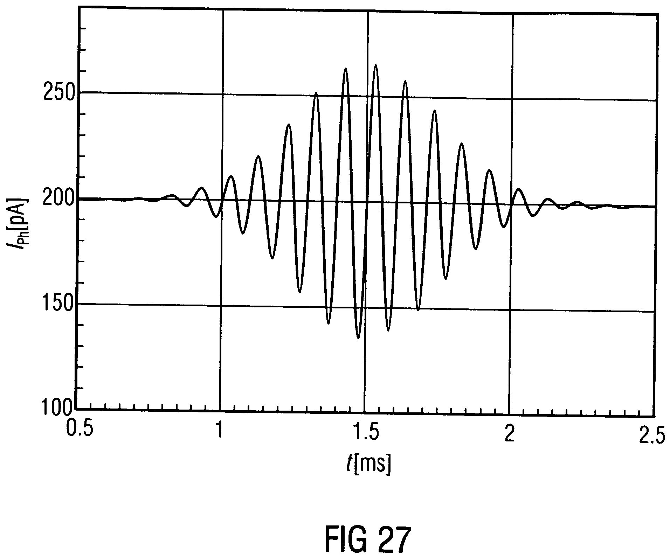

aufteilen. Er basiert auf der Bestimmung der x-Position (bzw. t-Position) aller Extrema des optischen Kohärenzsignals (siehe Fig. 27), die einen bestimmten Betrag überschreiten. Jedes Extremum ist umgeben von jeweils einem monoton steigenden und fallenden Kurvenabschnitt der modulierten Sinus-Funktion. Dessen maximaler Anstieg ist bei Extrema mit nur sehr kleinen Beträgen ebenfalls sehr klein. Durch Festlegung einer Schranke für den Betrag des Anstiegs ergibt sich eine untere und eine obere Grenze für die Position der Einhüllenden. Aus der Menge aller Nulldurchgänge der Anstiege wird der mittlere ausgewählt, dessen Lage als Position des Maximums der Einhüllenden betrachtet wird. Das genaue Vorgehen sowie die Grenzen der technischen Realisierung des Algorithmus sollen im Folgenden näher beleuchtet werden.

Fig. 27 zeigt eine Zeitfunktion des Photostroms $I_{Ph}$ entsprechend der Bestrahlungsstärke.

Als strahlungsempfindliches Element wird ein Photo-FET verwendet, dessen Drainstrom $I_D$ als Messsignal dient. Die erste Ableitung des Zeitsignals wird in der Pixelzelle durch die Berechnung der Differenz zweier direkt auf einander folgender Beträge von $I_D$ bestimmt. Dieser Vorgang erfolgt incl. Einschwingen in den Schritten

1. Rücksetzen der Pixelzelle $I_D(t_0) = I_{D0}$,
2. Integration des Photosignals $I_D \uparrow$,
3. Abspeichern des integrierten Photosignals in eine Speicherzelle $I_{SI} = I_D(t_0 + \tau_C - \tau_{e1})$,
4. Rücksetzen der Pixelzelle $I_D(t_0 + \tau_C) = I_{D0}$,
5. Integration des Photosignals $I_D \uparrow$,
6. Ausgabe der Summe $I_{Pix} = I_D(t_0 + 2\tau_C - \tau_{e1} - \tau_{e2}) - I_{SI}$,
7. Sprung zu 3.

Dabei ist $I_{SI}$ der in der Stromsspeicherzelle im Pixel abgelegte Vorgängerwert des Drainstroms, dessen Startwert zum Startzeitpunkt $t_0$ mit $I_{D0}$ gegeben ist. $\tau_C$ bezeichnet das Samplingintervall und $t_0 + \tau_C - \tau_{e1}$ den Speicherzeitpunkt in der gegebenen Periode. Die enthaltene Zeitdifferenz $\tau_{e1}$ ergibt sich aus der Zeit zur Ansteuerung der Stromspeicherzelle. Der resultierende Ausgangsstrom $I_{Pix}$ für die Dauer von etwa $\tau_{e2}$ bestimmt die von der Pixelzelle im Messintervall ausgegebene Ladung.

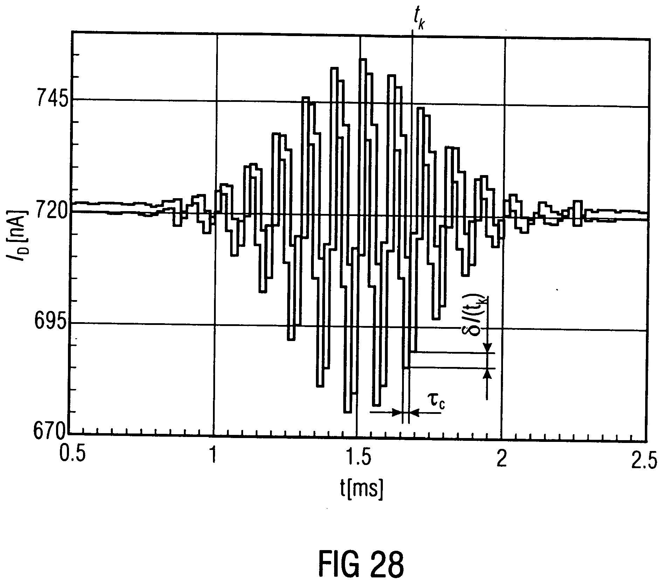

Für die Fig. 28 bis 30 wurde ein synthetisches Kohärenzmodulationssignal als Photostrom (Fig. 27) in die Schaltung der realen Pixelzelle eingespeist und diese mittels eines Schaltungssimulators simuliert.

Fig. 28 zeigt einen Drainstrom $I_D$ des strahlungsempfindlichen FET und in der SI-Zelle gespeicherter Strom $I_{SI}$, mit der Abtastperiodendauer $\tau_C$ zum Abtastzeitpunkt $t_k$ :

$$I_{SI}(t_k) = I_D(t_k - \tau_C) + \delta I(t_k) \ .$$

Die Fig. 28 zeigt den abgetasteten Drainstrom $I_D$ des Photo-FET und den in der Stromspeicherzelle abgespeicherten Strom $I_{SI}$ (gestrichelt). Diese Darstellung dient dem Vergleich beider Größen. Der Fehler $\delta I$ wird durch die sehr einfache Implementierung der Stromspeicherzelle und die durch $\tau_{e1}$ und $\tau_{e2}$ begründeten Verschiebungen der Abtastzeitpunkte hervorgerufen.

Fig. 29 zeigt einen Pixel-Ausgangsstrom $I_{Pix}$ und Vorzeichen des Anstiegs, sowie Bezugspunkte für die Beschreibung.

In Fig. 29 ist der resultierende Pixelstrom $I_{Pix}$ eingezeichnet. Auch für dieses Diagramm wurde eine abgetastete (sample and hold, S&H) Darstellung gewählt. Der graue Bereich markiert den Schlauch ($I_{Sn} \leq I_{Pix} \leq I_{Sp}$) außerhalb dessen die Anstiege für die Vorzeichenuntersuchung herangezogen werden. Dieser Schlauch muss so gewählt werden, dass Rauschen und andere Fehler ohne wesentliche Einschränkungen der Messgenauigkeit unterdrückt werden. Die Digitalisierung erfolgt spaltenparallel mittels des bereits beschriebenen CP-ADC. Mit jedem Digitalisierungsschritt werden gleichzeitig Spaltenleitung und Auslesepfad kalibriert. Die Größe der Ladungspakete kann zur Verringerung des Rechenaufwandes an die gewünschten Schwellen angepasst werden. Die Diskretisierung erfolgt digital, wobei sich die Ergebnisse für die Ausgangswerte innerhalb des Schlauches zu "0", oberhalb zu "1" und unterhalb zu "-1" ergeben.

Die Bestimmung der Nulldurchgänge geschieht durch Analyse der Abfolge der Vorzeichen und gestaltet sich aufgrund des dreiwertigen Signals (-1, 0, 1) etwas komplizierter. Der Wert "0" für den vorhergehenden Schritt bei indirekten Vorzeichenwechseln reicht zu dessen Erkennung nicht aus. Dieses Problem wurde durch die beiden folgenden Logikvarianten gelöst. Basis für beide ist der zum Zeitpunkt $t_k$ digitalisierte und quantisierte Abtastwert $D_{Pix}(k)$ des Pixelstromes $I_{Pix}(t_k)$

$$D_{Pix}(k) = \begin{cases} -1 & wenn & I_{Pix}(t_k) < -I_{Sn} \\ 0 & wenn & -I_{Sn} \leq I_{Pix}(t_k) \leq I_{Sn} \\ 1 & wenn & I_{Pix}(t_k) > I_{Sn} \end{cases} \qquad (24)$$

Variante 1:

Die erste Variante zur Detektion der Nulldurchgänge setzt auf die Vergangenheit der diskretisierten Pixelwerte $D_{Pix}$. Ist der Wert verschieden von 0 wird er in einen Puffer

$$D_{PixM}(k) = \begin{cases} D_{Pix}(k) & wenn & (D_{Pix}(k) \neq 0) \wedge (k > 0) \\ D_{PixM}(k-1) & wenn & (D_{Pix}(k) = 0) \wedge (k > 0) \\ 0 & wenn & k = 0 \end{cases} \qquad (25)$$

abgespeichert. Der Wert "0" für $k = 0$ dient der Einstellung eines definierten Startwertes. Der Nulldurchgang ergibt sich aus dem aktuellen $D_{Pix}(k)$ und dem im vorherigen Verarbeitungsschritt ermittelten $D_{PixM}(k\text{-}1)$ gemäß

$$D_Z(k) = \begin{cases} D_{Pix}(k) & wenn & (D_{Pix}(k) \neq D_{PixM}(k-1)) \wedge (D_{PixM}(k-1) \neq 0) \\ 0 & sonst \end{cases} \qquad (26)$$

Variante 2:

Die zweite etwas aufwändigere Variante funktioniert unter Verwendung des Anstiegs

$$D_S(k) = \begin{cases} D_S(k-1) & wenn & D_{Pix}(k-1) = D_{Pix}(k) \\ -1 & wenn & D_{Pix}(k) - D_{Pix}(k-1) < 0 \\ 1 & wenn & D_{Pix}(k) - D_{Pix}(k-1) > 0 \end{cases} \qquad (27)$$

und der Pixelwerte $D_{Pix}(k)$ und $D_{Pix}(k\text{-}1)$. Es kann zwischen direkten Übergängen $\{-1 \rightarrow 1, 1 \rightarrow -1\}$

$$D_{Zd}(k) = \begin{cases} D_{Pix}(k) & wenn & (D_{Pix}(k) \neq D_{Pix}(k-1)) \wedge (D_{Pix}(k-1) \neq 0) \\ 0 & sonst \end{cases} \qquad (28)$$

und indirekten Übergängen $\{-1 \rightarrow 0, 1 \rightarrow 0\}$

$$D_{Zi10} = \begin{cases} -D_{Pix}(k-1) & wenn & (D_{Pix}(k) = 0) \wedge (D_S(k-1) = D_{Pix}(k-1)) \\ 0 & sonst \end{cases} \qquad (29)$$

bzw. $\{0 \rightarrow -1, 0 \rightarrow 1\}$

$$D_{Zi01} = \begin{cases} D_{Pix}(k) & wenn & (D_{Pix}(k-1) = 0) \wedge (D_S(k-1) = D_{Pix}(k)) \\ 0 & sonst \end{cases} \qquad (30)$$

unterschieden werden. Im Gegensatz zur ersten Variante werden zwar drei Bit pro Pixel also ein Bit pro Pixel mehr an internem Speicher benötigt, aber die Lage der Nullstelle kann durch die Einbeziehung von $D_{Zi10}$ und $D_{Zi01}$ genauer bestimmt werden. Zur Erzielung der gleichen Genauigkeit müsste die Messung bei der ersten Variante zweimal also mit positiver und negativer Orientierung des Vorschubs des Referenzspiegels durchgeführt werden.

Tabelle 4 zeigt Beispielwerte für die Berechnung der Nulldurchgänge für das Diagramm in Fig. 29.

| $D_{Pix}$ | $D_{PixM}$ | $D_Z$ | $D_S$ | $D_{Zd}$ | $D_{Z/10}$ | $D_{Z/01}$ | Bezugspunkte in Fig. 29 |
|---|---|---|---|---|---|---|---|
| 0 | 0 | - | - | - | - | - | $t_A$ |
| 1 | 1 | 0 | 1 | 0 | 0 | 0 | (1) |
| 1 | 1 | 0 | 1 | 0 | 0 | 0 | |

(fortgesetzt)

| $D_{Pix}$ | $D_{PixM}$ | $D_Z$ | $D_S$ | $D_{Zd}$ | $D_{Z/10}$ | $D_{Z/01}$ | Bezugspunkte in Fig. 29 |
|---|---|---|---|---|---|---|---|
| 0 | 1 | 0 | -1 | 0 | -1 | 0 | (2) |
| -1 | -1 | -1 | -1 | 0 | 0 | -1 | |
| 0 | -1 | 0 | 1 | 0 | 1 | 0 | |
| 1 | 1 | 1 | 1 | 0 | 0 | 1 | |
| 1 | 1 | 0 | 1 | 0 | 0 | 0 | |
| -1 | -1 | -1 | -1 | -1 | 0 | 0 | (3) |
| -1 | -1 | 0 | -1 | 0 | 0 | 0 | |
| 0 | -1 | 0 | 1 | 0 | 1 | 0 | (4) |
| 1 | 1 | 1 | 1 | 0 | 0 | 1 | (5) |
| 1 | 1 | 0 | 1 | 0 | 0 | 0 | |
| -1 | -1 | -1 | -1 | -1 | 0 | 0 | |
| -1 | -1 | 0 | -1 | 0 | 0 | 0 | |
| 1 | 1 | 1 | 1 | 1 | 0 | 0 | (6) |
| 1 | 1 | 0 | 1 | 0 | 0 | 0 | $t_B$ |

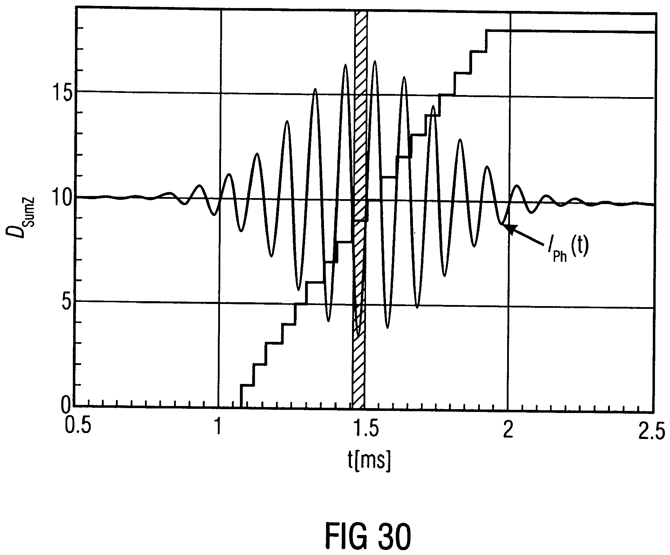

Für das Diagramm in Fig. 29 sind in Tabelle 4 beispielhaft Zahlenwerte entsprechend der beiden Varianten angegeben. Die $D_Z$ (Fig. 29 oben) wurden für die Darstellung in Fig. 30 verwendet. Der grau markierte Bereich stellt die rechnerisch ermittelte Position des Maximums der Hüllkurve dar.

Fig. 30 zeigt einen Zählerstand der Wendepunkte.

Zu deren Bestimmung wird zunächst die Summe aller Nulldurchgänge ermittelt. Bei Variante 2 fließt neben den $D_{Zd}$ nur entweder $D_{Zi10}$ oder $D_{Zi01}$ in die Rechnung ein. Aus der Abtastposition des Mittelwertes $k_2 = \frac{1}{2} max(D_{SumZ})$ wird die Position $t_{k2}$ ermittelt. Über den Weg-Zeit-Zusammenhang oder direkt aus den gemessenen Positionsdaten kann die Ortskoordinate $x_{k2}$ des Maximums der Einhüllenden ermittelt werden.

Zur visuellen Bewertung des Ergebnisses ist der Kurve für den Zählerstand $D_{SumZ}$ in Fig. 30 die Kurve für den Photostrom $I_{Ph}$ aus Fig. 27 hinterlegt. Offensichtlich wird die Position des Maximums der Hüllkurve sehr gut getroffen.

In anderen Worten, die Aspekte der Variante 1 und Variante 2 beschreiben Aspekte eines Verfahrens, bei dem die Position eines Maximums einer Hüllkurve eines analogen amplitudenmodulierten Signals mittels einem Verfahren gemäß Fig. 40 durchgeführt werden. Dabei beschreiben sowohl die Variante 1 wie auch die Variante 2 in der zuvor dargestellten Form, ein Verfahren, bei dem aus der Folge von analogen Differenzwerten eine erste Folge von digitalen Differenzwerten $I_{Pix}$ erzeugt wird, und basierend auf der ersten Folge von digitalen Differenzwerten $I_{Pix}$ eine zweite Folge von digitalen Differenzwerten $D_{Pix}$ erzeugt wird, und basierend wiederum auf der zweiten Folge von digitalen Differenzwerten $D_{Pix}$ eine dritte Folge von Differenzwerten $T_{PixM}$ (bzw. in der zweiten Variante $D_S$) erzeugt wird, und basierend auf dieser dritten Folge von digitalen Differenzwerten $D_{PixM}$ bzw. $D_S$ ein Vorzeichenwechsel $D_Z$ (bzw. in der zweiten Variante ein direkter Vorzeichenwechsel $D_{Zd}$ und zwei indirekte Vorzeichenwechsel/Übergänge $D_{Zi10}$ und $D_{Zi01}$) detektiert und gezählt werden.

In einem alternativen Aspekt kann die Folge von digitalen Differenzwerten bzw. die zweite Folge von digitalen Differenzwerten $D_{Pix}$ direkt aus der Folge von analogen Differenzwerten erzeugt werden, indem nicht wie in Fig. 29 gezeigt, eine mehr als zwei Bit umfassende digitale Repräsentation der analogen Differenzwerte gebildet wird, sondern direkt der erste Wert, zweite Wert oder dritte Wert bzw. die Werte "0", "+1" und "-1" abhängig von den Schwellwerten $I_{Sp}$ und $I_{Sn}$ zugeordnet werden.

Beide Ansätze, mit und/oder ohne Erzeugen der ersten Folge von Differenzwerten $I_{Pix}$ können beispielsweise mittels der Pixelzelle 100 gemäß Fig. 39A und/oder einer Vorrichtung zur ladungsbasierten Signalverarbeitung 3400, 3500 gemäß den Fig. 3I und 3K realisiert werden. Dabei entsprechen die in einem Messzyklus gemessenen Messströme bzw. dadurch definierten Ladungen den analogen Werten, und die Differenzbildung in der Pixelzelle 100 selbst (zeitliche Differenz) oder auf der Spaltenleitung Ll (räumliche Differenz) der Erzeugung der Folge von analogen Differenzwerten bzw. Differenzladungswerten.

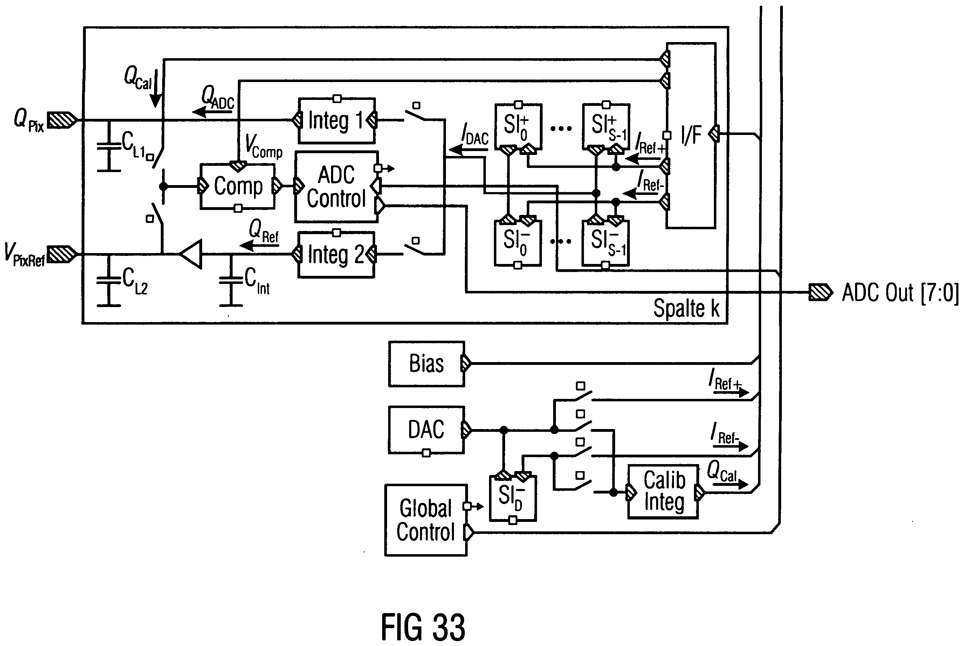

Bei einem Ansatz, bei dem die erste Folge von Differenzwerten $I_{Pix}$ gebildet wird, bestimmt eine Vorrichtung zum Bestimmen einer Ladung $Q_{Pix}$ einen die Ladungsdifferenz repräsentierenden digitalen Wert, der beispielsweise acht Bit aufweist, wie in Fig. 33 (ADC Out [7:0]) gezeigt ist, um mittels eines digitalen Schwellwert $I_{Sp}$ $I_{Sn}$ die zweite Folge von Digitalwerten $D_{Pix}$ zu bilden. Die Bestimmung der Ladung kann beispielsweise gemäß einem der Aspekte, die anhand von Fig. 2A erläutert wurden, zählend, sukzessiv oder zählend/sukzessiv erfolgen.

Bei dem Ansatz ohne Erzeugen der ersten Folge von Differenzwerten $I_{Pix}$ wird beispielsweise nur ein Ladungspaket, das dem Schwellwert $I_{Sp}$ bzw. $I_{Sn}$ entspricht, zu-/abgeführt und basierend auf der Detektion oder Nicht-Detektion eines Vorzeichenwechsels bestimmt, ob dem analogen Differenzwert der Wert "+1" (wenn der Spannungsvergleich vor der Ladungszufuhr/-abfuhr ein positives Vorzeichen ergibt und nach Ladungszufuhr kein Vorzeichenwechsel eintritt), der Wert "-1" zugeordnet wird (wenn vorab ein negatives Vorzeichen detektiert wird und nach Ladungszufuhr kein Vorzeichen detektiert wird) oder der Wert "0" zugeordnet wird (bei Detektion eines Vorzeichenwechsels). Bei diesem Ansatz wird nur eine Ladungszu-/Abfuhr benötigt, um basierend auf den beiden Schwellwerten die Digitalisierung vorzunehmen, bzw. direkt die zweite Folge von Differenzwerten $D_{Pix}$ zu erzeugen. Bei einem solchen Ansatz kann beispielsweise nach der Digitalisierung, die nur eine Zu-/Abfuhr eines Ladungspaktes benötigt, in einem weiteren Schritt gemäß einer Vorrichtung zum Setzen einer Spannung an einem kapazitiven Element 3300 gemäß Fig. 3G die Ladung bzw. Spannung an dem kapazitiven Element auf ein bestimmtes Potential rückgesetzt werden, um das kapazitive Element für eine nächste Ladungsbestimmung vorzubereiten.

Zusammenfassend ist in Fig. 31 die Gesamtschaltung der für den Weißlicht-Interferometer-Sensor entworfene Pixelzelle dargestellt.

Fig. 31 zeigt eine FET-Pixelzelle als Ladungsquelle.

In ihrer Sensorgrundfunktion inkl. kapazitivem Reset entspricht sie der zuvor bzw. in [DGS05] dargestellten Anordnung. Des weiteren enthält das Pixel eine Stromspeicherzelle (SI-Mem) und eine Schaltermatrix (IO) für den Zugriff auf die beiden Spaltenleitungen. Die Pixelzelle als Ladungsquelle und ihre Grundschaltungen wurden bereits zuvor angegeben.

Fig. 31A zeigt eine Feldeffekttransistor-Pixelzelle als Ladungsquelle (bzw. mit Ladungsausgang $Q_{Pix}$) mit einem Photosensor (Sensor) 110, einer Stromspeichervorrichtung in Form einer Stromspeicherzelle (SI-Mem) 120 und einer Schalteinheit (IO) 130 mit einem Ausgangsknoten (1) 104 und einem Ausgang 102. Die in Fig. 31A gezeigte Feldeffekttransistor-Pixelzelle ist entsprechend auch eine mögliche Realisierung eines ersten Ladungsgebers 3410 gemäß Fig. 41K, wobei der Transistor $T_{Rd}$ dem ersten Schaltelement 3432 entspricht und der Transistor $T_{Res}$ dem dritten Schaltelement 3436 entspricht. In anderen Worten, Fig. 31A zeigt eine Variante, bei der die Ladungsgebersteuerung in der Pixelzelle bzw. in der Schalteinheit 130 integriert ist.

Der Photosensor 110 wurde zuvor anhand der Fig. 20 und der vorhergehenden Figuren detailliert beschrieben, die Stromspeicherzelle 120 anhand der Fig. 11 und 12, und werden daher nicht noch einmal besprochen.

Wie aus Fig. 31A ersichtlich, kann die Pixelzelle mittels der Schalteinheit 130 eingesetzt werden, um den Drainstrom $I_{DPh}$ allein an dem Ausgangsknoten 104 und an die erste Leitung L1 auszugeben, (beispielsweise $T_{Pix}$ leitend, $T_{Rd}$ leitend, $T_{Ris}$ sperrend und $T_{SI}$ sperrend), einen invertierten eingeprägten Strom -IM allein an dem Ausgangsknoten 104 bzw. auf die Leitung L1 auszugeben (beispielsweise $T_{Pix}$ sperrend, $T_{Rd}$ leitend, $T_{Res}$ sperrend und $T_{SI}$ leitend), oder sowohl den Messstrom bzw. Drainstrom $I_{DPh}$ und den invertierten eingeprägten Strom -$I_M$ gleichzeitig an dem Ausgangsknoten 104 und an die erste Leitung L1 auszugeben, wobei im letzteren Fall damit eine Differenzbildung in der Pixelzelle realisiert wird. Abhängig von der Auslesezeit $\tau_{out}$ repräsentiert der jeweilige an den Ausgangsknoten 104 resultierende Strom eine Ladung, die auf das kapazitive Element $C_{L1}$ ausgegeben wird.

Im Folgenden wird anhand der Fig. 31A eine zeitliche Differenzbildung durch die Pixelzelle beschrieben. Dabei wird in einem ersten Messzyklus über die Integration $\tau_{int}$ Ladung in der Wanne der Wannen-Substratphotodiode $D_{Ph}$ akkumuliert (Integration), und nach Ablauf der Integrationszeit $\tau_{int}$ ein entsprechender Messstrom $I_{DPh1}$ des ersten Messzyklus von dem Photosensor 110 ausgegeben (Index 1 und 2 stehen für zeitliche Indizes). Dieser erste Messstrom wird in der Stromspeicherzelle 120 als eingeprägter Strom $I_{M1}$ eingeprägt ($T_{Pix}$ leitend, $T_{Rd}$ gesperrt, $T_{Res}$ gesperrt, $T_{SI}$ leitend und $T_{SetSI}$ leitend). Nach dem Einbringen wird der Einprägevorgang bzw. Speichervorgang abgeschlossen ($T_{SetSI}$ sperrend), und die Photospannung $V_{Ph}$ über den Rücksetzkondensator $C_{Res}$ auf eine Ausgangsspannung rückgesetzt, der Transistor $T_{Pix}$ gesperrt, und ein zweiter Integrations- bzw. Messzyklus für die Integrationszeit $\tau_{int}$ durchgeführt. Vor der Ausgabe der Ladung $Q_{Pix}$ wird der Ausgangsknoten 104 auf ein bestimmtes Spannungspotential $V_{RefPix}$ gesetzt ($T_{Pix}$ sperrend, $T_{Ris}$ leitend, $T_{SI}$ sperrend). Nach Ablauf der Integrationszeit $\tau_{int}$ wird der zweite Messstrom $I_{DPh2}$ an den rückgesetzten Ausgangsknoten 104 angelegt und gleichzeitig auch der eingeprägte Messstrom $I_{M1}$ des ersten Messzyklus, so dass an dem Ausgang bzw. der ersten Leitung L1 der resultierende Strom $I_{DPh2}$ - $I_M$ für eine Zeit $\tau_{out}$ ausgegeben wird, und somit die Ladung $Q_{Pix}$ ausgegeben wird. Nach der Ausgabe wird $T_{Rd}$ gesperrt und $T_{SetSI}$ leitend, um nun den zweiten Messstrom $I_{DPh2}$ als eingeprägten Strom $I_{M2}$ in der Stromspeicherzelle einzuprägen, d.h. den eingeprägten Strom $I_{M2}$ zu speichern, bevor in einem dritten Messzyklus ein dritter Messstrom $I_{DPh3}$ erzeugt wird, etc.

Im Folgenden wird eine örtliche Differenzbildung zwischen zwei Pixelzellen 100 beschrieben. Dabei steht der Index a für die erste Pixelzelle und der Index b für die zweite Pixelzelle. In einem ersten Messzyklus integrieren beide Pixelsensoren in ihren Wannen-Substratphotodioden $D_{Pha}$, $D_{Phb}$ Ladung während einer Mess- oder Integrationszeit $\tau_{int}$.

Am Ende der Integrationszeit gibt z.B. der Photosensor b einen ersten Messstrom $I_{DPhb1}$ aus, der in der Stromspeicherzelle 120 als eingeprägter Strom $I_{Mb1}$ gespeichert wird. In einem Ausgabezyklus gibt beispielsweise der Photosensor a den ersten Messstrom $I_{DPha1}$ auf die Leitung L1 aus und der zweite Photosensor b den eingeprägten Strom $I_{Mb1}$, so dass auf der Leitung ein resultierender Strom $I_{DPh1a}$ - $I_{M1b}$ für eine Auslesezeit $\tau_{out}$ ausgegeben wird, d.h. eine Differenz der Ladungen der ersten Pixelzelle a und der zweiten Pixelzelle b aus dem gleichen Messzyklus an die Leitung L1 ausgegeben wird. Die Ladungen in den Photosensoren werden zurückgesetzt und in einem zweiten Messzyklus erneut akkumuliert, um dann wie zuvor erläutert eine räumliche Differenz für den zweiten Messzyklus zu bestimmen.

Fig. 31B zeigt ein Blockschaltbild eines Aspekts einer Pixelzelle mit Stromausgang $I_{out}$, die der Pixelzelle in Fig. 31A im Wesentlichen entspricht, bei der lediglich der Rücksetztransistor $T_{Res}$ aus Fig. 31A entfällt, da wie zuvor dargelegt, bei einer strombasierten Ausgabe das Spannungspotential des Ausgangsknotens 104 meist vernachlässigt werden kann.

Mögliche Betriebsmodi des Sensorfeldes sind

- *Snapshot,*
- rollender Verschluss mit korrelierter Doppelabtastung (true CDS) und
- zeitliche Differenzenbildung (Differenzenquotient).

Die Ergebnisse einerSimulationen spiegeln erfahrungsgemäß sehr gut das reale Verhalten der Pixelzelle wieder. Schaltungen zur Ansteuerung und zum Auslesen wurden durch Modelle ersetzt, die das reale Klemmverhalten, z.B. parasitäre Leitungskapazitäten oder Zeitverhalten, möglichst gut widerspiegeln.

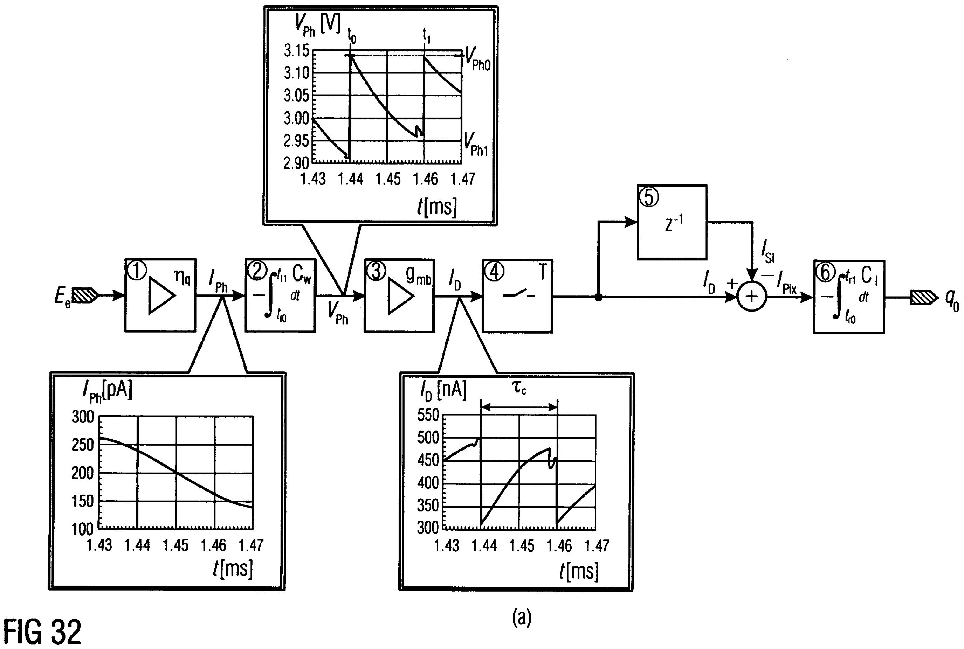

Zur Verdeutlichung des Verhaltens sind der "analoge Datenpfad" der Pixelzelle von der eingehenden Bestrah-lungsstärke $E_e$ bis zur Ausgangsladung $q_o$ auf der Messleitung am Stromausgang $I_{IOPix1}$ und einige simulierte Signale in Fig. 32 dargestellt. Für diese Simulation wurden die gleichen synthetischen Daten wie in der Beschreibung des Algorithmus verwendet.

Fig. 32 zeigt einen analogen Datenpfad in der Pixelzelle mit folgenden Abschnitten bzw. Funktionsblöcken:

1. Optische Filterung und Photogeneration:

Der im Block (1) angegebene Quantenwirkungsgrad beinhaltet den spektralen Transmissionsgrad des Schichtaufbaus über dem aktiven Gebiet und den Absorptionsgrad im aktiven Gebiet. Im Interesse einer guten optischen Auflösung sollten der Anteil an lang welligem (infrarotem) Licht und damit auch das Übersprechen möglichst gering sein. Bei einem thermischen Strahler kann dies z.B. durch einen Infrarot-Sperrfilter erreicht werden. Durch die Aufbringung einer Antireflexbeschichtung lässt sich der Transmissionsgrad der Schicht über dem aktiven Gebiet weiter verbessern. Ausgangssignal dieser Verarbeitungsstufe ist der generierte Photostrom $I_{Ph}$.

2. Akkumulation des Photostroms:

Die Ladungsakkumulation (2) geschieht in der Wannen-Substrat-Photodiode des Photo-FET. Die Integration erfolgt nach dem beschriebenen Schema. Für den dargestellten Integrationszeitraum gilt $t_1 = t_0 + \tau_C$. Die Spannung $V_{Ph1}$ ist das extrapolierte Wannenpotential für diesen Zeitpunkt unter Vernachlässigung der Abweichung $\delta V(t_1)$.

3. Spannungs-Strom-Wandlung:

Die Umwandlung der Bulk-Spannung in einen Drainstrom $I_D$ erfolgt durch den Photo-FET (3). Dabei ist $g_{mb}$ dessen Bulk-Transkonduktanz. Durch eine geeignete Wahl des Arbeitspunktes des Transistors können Empfindlichkeit, Einschwingzeit und Genauigkeit des strahlungsempfindlichen Schaltungsteils und der Stromspeicherzelle eingestellt werden.

4. Abtasten:

Im Block (4) erfolgt eine Abtastung zur Speicherung des Drainstroms in der SI-Zelle. Eine logische Trennung vom Rücksetzen im Teil (2) ist selbstverständlich nicht möglich.

5. Halten des Abtastwertes:

Das Halten des Abtastwertes geschieht durch Speicherung (5) in der SI-Speicherzelle zeitlich nach der Berechnung und Ausgabe der Differenz $I_{Pix} = I_D(k)$-$I_{SI}(k$-1). Die Auswirkungen der für die Operationen benötigten Zeiten auf die Fehler $\delta I_D(k)$ wurden bereits in der Beschreibung des Algorithmus erwähnt.

6. Ausgabe des Ladungspaketes:

Die Ausgabe des Ergebnisses der Verarbeitung erfolgt nicht als Pixelstrom $I_{Pix}$ sondern als Ladungspaket $q_o$ nach dessen Erzeugung in der Ausgangsschnittstelle (6). Der Integrator besteht aus dem mittels des IO-Teils geschaltetem Stromausgang $I_{IOPix1}$ und der Leitungskapazität der zugehörigen Spaltenleitung. Der Vorteil dieser Ausgabemethode besteht in einer kurzen Zugriffszeit (siehe Abschnitt 1.).

Im folgenden wird auf einen Aspekt einer Architektur des Bildsensors eingegangen.

Fig. 33 zeigt ein Blockschaltbild des Analogteils.

In Fig. 33 sind das Blockschaltbild des Analogteils einer Spalte des Bildsensors (oberer Teil, grau hinterlegt) und der zugehörigen Ansteuerung (unterer Teil) dargestellt. Die beiden linken Pins sind mit den Spaltenleitungen an den Ausgängen $I_{IOPix1}$ und $I_{IOPix2}$ der zugehörigen Pixel verbunden.

Dabei stellen $I_{IOPix1} \rightarrow Q_{Pix}$ die Ausgangs- und $V_{PixRef} \rightarrow I_{IOPix2}$ die Referenzleitung für die Pixelschaltung dar. $C_{l1}$ und $C_{l2}$ in der Spaltenschaltung repräsentieren die parasitären Kapazitäten der beiden Spaltenleitungen incl. der angeschlossenen und inaktiven Pixel-Schnittstellen sowie die interne Kapazität des einen aktiven Pixels. Wie bereits in 11 ausgeführt, spielen die exakten Werte in der Größenordnung von $C_{l\{1,2\}} \approx 1...3pF$ für das Messergebnis keine Rolle.

Die analoge Spaltenschaltung besteht aus zwei Ladungsquellen (Integ {1,2}), die aus einem bipolaren DAC auf der Basis von SI-Zellen (*SI+*, *SI-*) gespeist werden. Die obere Ladungsquelle (Integ 1) liefert die Messladung $Q_{ADC}$ und mittels der unteren (Integ 2) wird über $Q_{Ref}$ der Wert $V_{PixRef}$ zum Rücksetzen der Pixelzelle eingestellt. Der Komparator (Comp) und die lokale digitale Steuerung (ADC Control) sind gemeinsamer Bestandteil des spaltenintegrierten Teils des CP-ADC. Über den Schnittstellenblock (I/F) werden die analogen Schaltungen mit Referenzspannungen und -strömen und die digitalen Blöcke mit Signalen von der globalen Steuerung versorgt. Im Interesse der Übersichtlichkeit sind die digitalen Steuerleitungen nicht dargestellt.

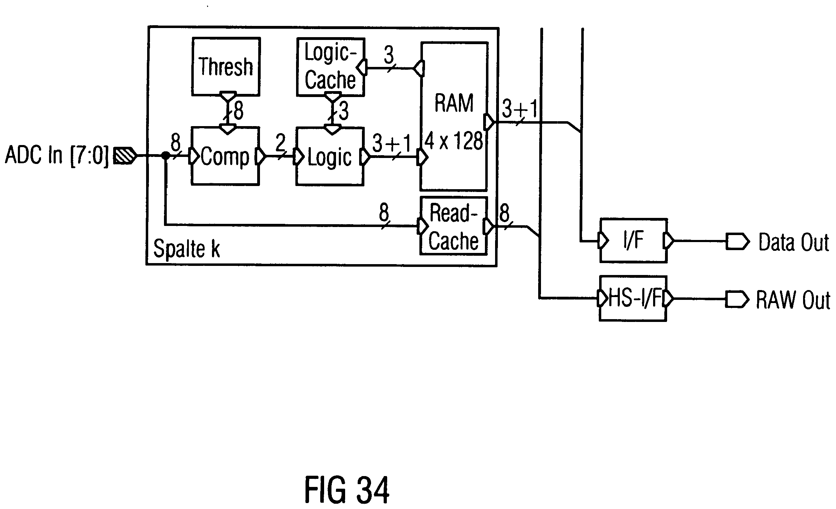

Fig. 34 zeigt ein Blockschaltbild des Digitalteils.

Das Blockschaltbild des Spalten-Digitalteils ist in Fig. 34 dargestellt. Er besteht aus einem digitalen Komparator (Comp) dessen Vergleichswerte (positive und negative Schranke) lokal in einem Register (Thresh) abgelegt sind. Das Ergebnis des Vergleichs wird gemeinsam mit den, aus dem lokalen RAM geholten Werten des vorhergehenden Schrittes für dieses Pixel, verarbeitet und mit einem gesetzten Zugriffs-Tag in den Speicher zurückgeschrieben.

Der lokale Speicher ist als Dual-Port-Variante ausgeführt. Um Fläche zu sparen, werden spaltenexterne lesende Zugriffe gleichzeitig mit dem Rückschreiben des Ergebnisses der Verarbeitung durchgeführt. In der Datenschnittstelle (I/F) erfolgt eine Aufbereitung der gelesenen Daten. Die relevanten Spalten werden anhand des gesetzten Zugriffs-Tags identifiziert. Die zugehörigen Datensätze werden komprimiert und mit einem gemeinsamen Zeitstempel versehen ausgegeben.

Des weiteren ist für die unverarbeiteten Grauwerte eine direkte, ebenfalls komprimierte Ausgabe über die Hochgeschwindigkeitsschnittstelle (HS-I/F) vorgesehen.

Um das Verhalten der Pixelschaltungen unter realistischen Bedingungen testen zu können, wurden für die folgenden Simulationen die Messwerte des Zeitverlaufs der Bestrahlungsstärke eines realen Weißlicht-Interferometers getestet [Nie03].

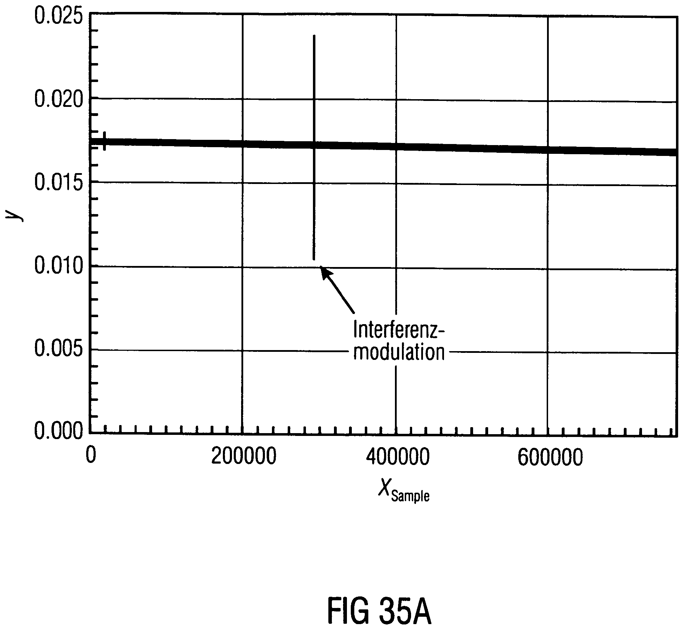

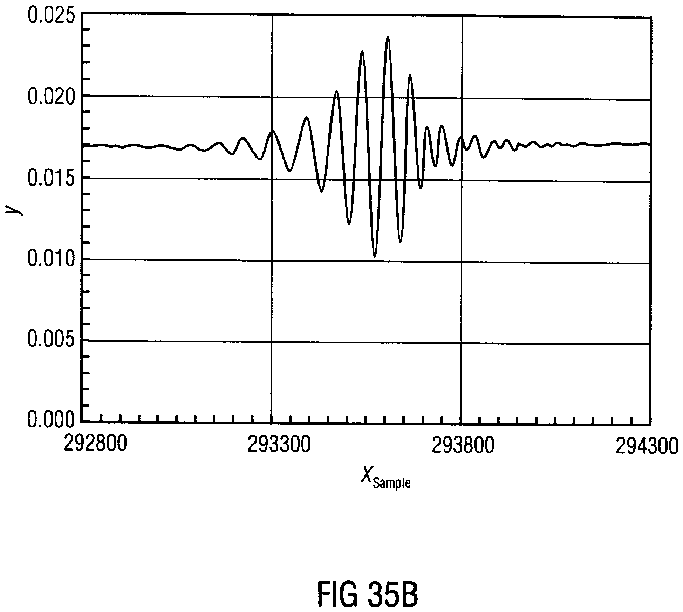

Fig. 35 zeigt einen gemessenen Signalpegel in Abhängigkeit von der Sample-Nummer (a: komplette Sequenz und b: Interferenz-Ausschnitt) Quelle: [Sch05].

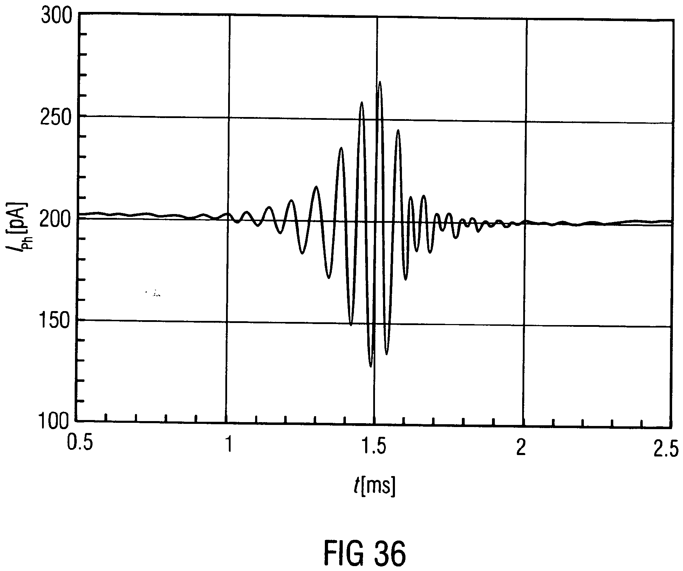

Anhand dieser Simulation soll untersucht werden, wie gut der Algorithmus trotz Rauschen und Jitter des Vorschubs des Referenzspiegels das Maximum der Referenzmodulation detektieren kann. Die digitalisierten Messwerte aus Fig. 35 wurden durch Skalierung beider Achsen in die kontinuierliche Zeitfunktion des Photostroms $I_{Ph}$ in Fig. 36 umgesetzt. Unter der Annahme einer Halogenlampe als Strahlungsquelle ($T$ = 3000K) ergibt sich rechnerisch eine Geschwindigkeit des Referenzspiegels von $\overline{v} = 10 \frac{mm}{s}$ mit einer Standardabweichung von $\sigma_v = 3 \frac{mm}{s}$ .

Fig. 36 zeigt eine äquivalente Zeitfunktion des Photostroms $I_{Ph}$.

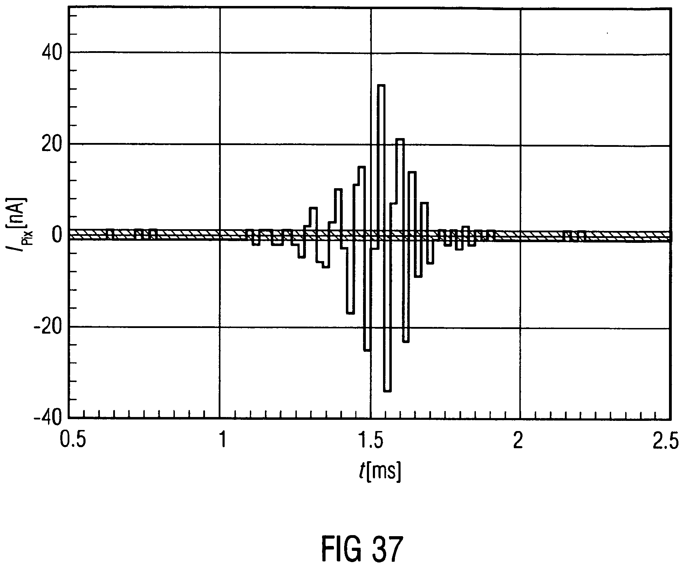

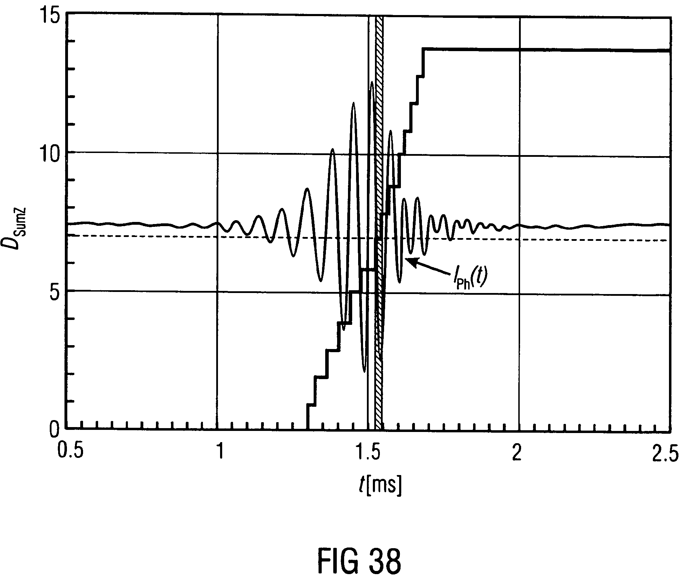

In den folgenden Fig. 37 und 38 sind die Simulationsergebnisse für die gegebene Zeitfunktion dargestellt. Obwohl der Signalverlauf erhebliche Abweichungen von den bisher verwendeten synthetischen Daten aufweist, wurde das Maximum der Hüllkurve bis auf einen Fehler von $\Delta x \approx \frac{\lambda}{4}$ lokalisiert.

Fig. 37 zeigt ein Simulationsergebnis für den Pixel-Ausgangsstrom $I_{Pix}$.

Fig. 38 zeigt einen Zählerstand der Nulldurchgänge für die $I_{Pix}$ aus Fig. 37.

Die Simulationen mit den originalen Messdaten eines Weißlicht-Interferometers haben gezeigt, dass sowohl die Sensorschaltung als auch der Algorithmus trotz erheblicher Nichtidealitäten, wie z.B.

- Jitters des Vorschubs,
- Rauschen des Messsignals und
- Ladungsfehler beim Beschreiben der Stromspeicherzelle

die Position des Maximums mit einer Messunsicherheit von der Hälfte des Abstands zweier Extrema $\left(\frac{1}{4}\overline{\lambda}\right)$ findet.

Bei einer Halogenlampe als Strahlungsquelle (T = 3000K) entspricht das etwa 150nm. Da dieser Fehler direkt mit der mittleren Wellenlänge der eingesetzten Strahlungsquelle verknüpft ist, kann die Auflösung durch die Wahl einer geeigneten kurzwelligeren Strahlungsquelle erheblich verbessert werden. Die Wellenlänge muss dabei auf die spektrale Empfindlichkeit des strahlungsempfindlichen Gebietes abgestimmt sein.

Basierend auf der strahlungsempfindlichen Struktur wurde ein Pixel mit integrierter Stromspeicherzelle entwickelt. Durch diese Erweiterung ist es möglich, eine Vielzahl verschiedener Operationen lokal innerhalb dieser Pixelzelle durch Zeitpunkt und Reihenfolge von Rücksetzen, Speicherung und Ausgabe zu realisieren. Dies umfasst die gebräuchlichen reinen Sensorfunktionen *"Snapshot",* also die gleichzeitige lokale Abspeicherung jedes Helligkeitswertes für das gesamte Bild und deren sequentielle Ausgabe bzw. "rollender Verschluss" bei korrelierter Doppelabtastung CDS, mit der seriellen Ausgabe der Differenz des Rücksetzwerts vom aktuellen Helligkeitswert. Hinzu kommen ein Modus zur Berechnung der Differenz des aktuellen vom vorhergehende Helligkeitswert, womit sich eine diskrete zeitliche Ableitung realisieren lässt, und die Ausgabe des negativen Wertes der aktuellen Helligkeit, z.B. zur Subtraktion vom Helligkeitswert eines anderen Pixels der gleichen Spalte.

Voll wirksam werden die Vorteile der Pixelzelle durch die Verwendung im Kontext der ladungsbasierten Signalverarbeitung und -übertragung. Durch die Ausgabe einer Ladung in Form eines sehr kurzen Strompulses, und der sich anschließenden Analog-Digital-Wandlung durch direkte Einkopplung der Rücksetzladung auf die Leitungskapazität kann eine sehr schnelle Umsetzung bei einem Minimum an Energie für die Signalübertragung realisiert werden. Statische Ströme wie sie beim Auslesen von Bildsensoren z.B. in Source-Folgern fließen, werden nicht benötigt.

Einen erheblichen Zugewinn an Flexibilität stellen die digitale Steuerung der Breite der Strompulse und die Möglichkeit der gleichzeitigen Auswahl mehrerer Pixelzeilen dar. Verbunden mit der vorzeichenbehafteten Ausgabe des Helligkeitssignals können so mit den einfachen Mitteln der digitalen Ansteuerung komplexe Faltungsoperationen bei der vollen Übertragungsrate und Genauigkeit durchgeführt werden.

Unter Verwendung des analogen Auslesepfades von der Pixelzelle bis zum digitalen Ausgangswert des ADC wurde ein Konzept für einen Bildsensor zur Verwendung in einem Weißlicht-Interferometer entworfen. Der entwickelte Algorithmus ermöglicht eine Bewertung der Interferenzmodulation in Bildfolgen unter Verwendung nur eines Minimums an zusätzlicher Logik in der Spaltenschaltung des Sensors. Die Menge der aus dem Sensor zu übertragenden Daten sinkt um bis zu drei Größenordnungen. Die Funktionsfähigkeit der Logik und des Algorithmus konnte durch Schaltungssimulationen unter Verwendung realer Messdaten aus einem Weißlicht-Interferometer bestätigt werden.

Aspekte der Anmeldung betreffen ein Verfahren zur Auswertung von Bilddaten eines Interferometers nach Michelson auf der Basis von Licht aus einer Quelle mit einer geringen Kohärenzlänge, z.B. Weißlicht, gemäß Fig. 83, bei dem das Maximum der Interferenzmodulation und damit die Höheninformation des beobachteten Oberflächenpunktes indirekt aus einem Anstieg des modulierten Helligkeitssignals abgeleitet wird.

Dabei kann der Anstieg des modulierten Helligkeitssignals mittels Differenzbildung zweier aufeinanderfolgender Helligkeitswerte ermittelt werden, und die Helligkeitswerte z.B. in der Pixelzelle zwischengespeichert werden. Die Differenzbildung kann in der Pixelzelle oder beim Auslesen auf der Leitung geschehen. Ferner kann die Differenzbildung eine Bewertung mittels Schwellwert beinhalten. Die Lage der Helligkeitsextrema können digital aus den Nulldurchgängen der Anstiege ermittelt werden, wobei die Nulldurchgänge unter Berücksichtigung eines im Festspeicher, z.B. RAM (RAM - Random Access Memory - Schreib-/Lesespeicher) für jedes Pixel gespeicherten 2- oder 3-Bit Digitalwerts, der je nach Algorithmus Zwischenergebnisse der vorherigen Berechnungen für dieses Pixel enthält, bestimmt werden. Der Speicher RAM kann zeilenweise und synchron mit der ausgewählten Pixelzelle angesteuert werden. Der Zeitpunkt bzw. die Ortsposition der lokalen Helligkeitsextrema des modulierten Signals kann erfasst werden und deren Auftreten gezählt werden, wobei aus dem Zeitpunkt bzw. der Ortsposition des Mittelwertes die Höheninformation ermittelt wird.

Ein weiterer Aspekt ist eine Vorrichtung mit einem Bildsensor, der eine spezielle Pixelzelle mit einem Speicher für Helligkeitswerte aufweist, und eine Schaltung zur Differenzbildung zweier aufeinanderfolgender Helligkeitswerte aufweist. Ferner kann die Vorrichtung eine Spaltenschaltung mit Analog-Digital-Wandler aufweisen, einem analogen oder digitalen Komparator, einer digitalen Logik zur Bewertung des Vorzeichens des Vergleichs, einem Speicher für verschiedenen Zwischenwerte für jedes Pixel aus diesem Vergleich, einer Schnittstellenschaltung zum Auslesen der Speicherinhalte, und/oder eine Sensor-externe Logik zur Auswertung der abgespeicherten Zwischenwerte aus dem Sensor und der Verknüpfung mit Zeitpunkt bzw. der Ortsposition aus der Vorschubsteuerung des Referenzspiegels.

Ein Aspekt der Anmeldung ist die Möglichkeit der Integration eines Teils der Signalverarbeitung in einen CMOS-Bildsensor. Dies ist unter Verwendung bekannter Lösungen aus Gründen der Komplexität nicht möglich. Insbesondere die Reduzierung des Speicherbedarfs für die digitalen Zwischenergebnisse der zeilenweisen Verarbeitung ermöglicht eine System-on-Chip-Lösung. Der beschriebenen Algorithmus zur Bestimmung des Maximums eines amplitudenmodulierten Signals, wie er beispielsweise in Variante 1 und 2 erläutert ist, kann für zeitlich aufgelöste aber auch für örtlich aufgelöste Korrelogramme, also solche, die unter Verwendung optischer Mittel in eine Sensorspalte abgebildet werden, angewendet werden, wobei auf die Pixel einer Spalte seriell unter Berechnung der Differenzen der Grauwerte benachbarter Pixel zugegriffen wird.

Ein weiterer Aspekt der Anmeldung bezieht sich auf ein Verfahren und eine Vorrichtung zum parallelen Auslesen von Zellen, bei dem alle Zellen einer oder mehrerer Zeilen aktiviert werden und einen konstanten oder variablen Strompuls auf eine Spaltenleitung ausgeben, wobei die Breite des Strompulses von der jeweiligen Zeilenschaltung vorgegeben werden kann, und eine oder mehrere Strompulse auf der parasitären oder als Schaltungselement implementierten Kapazität der Spaltenleitung summiert und aufintegriert werden. Die Zellen in der Matrix sind beispielsweise gleichartig ausgeführt und statische Stromquellen und/oder Sensorenelemente und/oder analoge bzw. digitale Rechenelemente und/oder analoge bzw. digitale Speicherzellen enthalten. Die Spannung kann auf allen Spaltenleitungen mittels eines Komparators ein oder mehrfach mit einer für alle Spalten gleichen Referenzspannung verglichen werden, wobei zur Steuerung des Ablaufs detektiert wird, ob sich das Vergleichsergebnis ändert, z.B. um dann den Vergleichsvorgang abzubrechen, wobei bei einem positiven Vergleichsergebnis eine negative Ladungsportion auf die jeweilige Spaltenleitung eingekoppelt wird, bei einem negativen Vergleichsergebnis eine positive Ladungsportion auf die jeweilige Spaltenleitung eingekoppelt wird und bei einem abgebrochenen Vergleichsvorgang gar keine Ladungsportion auf die jeweilige Spaltenleitung eingekoppelt wird. Dabei kann ferner die Größe der Ladungsportion verändert werden und beispielsweise verringert werden. Ferner kann die zur Kompensation verwendete Ladungsportion z.B. mittels einer gepulsten Stromquelle und/oder einer Ladungspumpschaltung erzeugt werden, wobei die größten der Ladungsportionen sich aus in den Spaltenschaltungen vorliegenden und extern eingespeisten Betragskomponenten ergeben, die Betragskomponenten über Spannungspulse, Strompulse, statische oder lokal abgespeicherte Spannung bzw. Ströme vorgegeben werden. Die jeweilige Anzahl und Größe der in der Spalten eingespeisten Ladungspulse kann digital z.B. mittels eines Zählers oder Addierers erfasst bzw. aufkumuliert werden, wobei die Anzahl der Pulse von den Ergebnissen der Vergleichsoperationen in den Spalten vorgegeben werden können. Die Größe der digitalen Inkremente entspricht der Größe der Strompulse bzw. Ladungspakete. Der Auslesevorgang wird beispielsweise verändert, wenn Differenz aus der Spannung der Spaltenleitung und der Vergleichsspannung unterhalb eines Fehlerwertes, bzw. Null ist. Die Spaltenleitungen sind z.B. durch Schalter zurücksetzbar. Die Zellen können nicht nur in quadratischen, sondern auch in anderen Formen, wie z.B. hexagonal oder mit mehreren Spaltenleitungen in einem bestimmten Raster verbunden mit den Zellen angeordnet sein. In den Zellen können logische Operationen zur Verknüpfung der Spalten oder Zeilensignale mit oder ohne Speicher bzw. Zähler enthalten sein.

Abhängig von den Gegebenheiten können die Ausführungsbeispiele der erfindungsgemäßen Verfahren in Hardware oder in Software implementiert werden. Die Implementierung kann auf einem digitalen Speichermedium, insbesondere einer Diskette, CD oder DVD mit elektronisch auslesbaren Steuersignalen erfolgen, die so mit einem programmierbaren Computersystem zusammenwirken, dass eines der Ausführungsbeispiele der erfindungsgemäßen Verfahren ausgeführt wird. Allgemein bestehen die Ausführungsbeispiele der vorliegenden Erfindung somit auch in Software-Programm-Produkten bzw. ComputerProgramm-Produkten bzw. Programm-Produkten mit einem auf einen maschinenlesbaren Träger gespeicherten Programmcode zur Durchführung eines der Ausführungsbeispiele der erfindungsgemäßen Verfahren, wenn eines der Software-Programm-Produkte auf einem Rechner oder auf einem Prozessor abläuft. In anderen Worten ausgedrückt, kann ein Ausführungsbeispiel der vorliegenden Erfindung somit als ein ComputerProgramm bzw. Software-Programm bzw. Programm mit einem Programmcode zur Durchführung eines Ausführungsbeispiels eines erfindungsgemäßen Verfahrens realisiert werden, wenn das Programm auf einem Prozessor abläuft.

Der Prozessor kann hierbei von einem Computer, einer Chipkarte, einem digitalen Signalprozessor oder einem anderen integrierten Schaltkreis gebildet sein.

**Patentansprüche**

1. Vorrichtung (3100) zum Bestimmen der Ladungsmenge ($Q_{Pix}$) auf einem kapazitiven Element, mit einer Einrichtung (3100; $A_1$) zum Vergleichen (3112) einer Spannung ($V_{Pix}$) an dem kapazitiven Element ($C_{L1}$) mit einer Referenzspannung ($V_{comp}$) und Bestimmen, ob die Spannung ($V_{Pix}$) größer oder kleiner als die Referenzspannung ($V_{Comp}$) ist;
einer Einrichtung (3120; QSrc) zum Bewirken einer Ladungszufuhr/-abfuhr (3122) zu/von dem kapazitiven Element ($C_{L1}$) iterativ mittels Ladungspaketen abhängig von dem Vergleich so, dass eine Differenz zwischen der Spannung ($V_{Pix}$) an dem kapazitiven Element ($C_{L1}$) und der Referenzspannung ($V_{Comp}$) geringer wird, wobei die Einrichtung (3120; QSrc) zum Bewirken ausgebildet ist, um eine Ladungszufuhr/abfuhr zu/von dem kapazitiven Element ($C_{L1}$) zu bewirken, um die Spannung an dem kapazitiven Element ($C_{L1}$) zu verringern, wenn die Spannung an dem kapazitiven Element ($C_{L1}$) größer ist als die Referenzspannung, und eine Ladungszufuhr/abfuhr zu/von dem kapazitiven Element ($C_{L1}$) zu bewirken, um die Spannung an dem kapazitiven Element ($C_{L1}$) zu erhöhen, wenn die Spannung an dem kapazitiven Element ($C_{L1}$) kleiner ist als die Referenzspannung; und

einer Einrichtung (3130; Control) zum Rückschließen auf die Ladung ($Q_{Pix}$) auf dem kapazitiven Element ($C_{L1}$) auf Basis der Ladungszufuhr/-abfuhr (3122) und dem Vergleich der Spannung (3112), und zwar auf Basis einer Anzahl der Ladungspakete, die im Rahmen der iterativen Ladungszufuhr/-abfuhr (3122) ab-/zugeführt werden.

2. Vorrichtung nach Anspruch 1, wobei die Einrichtung (3130; Control) zum Rückschließen ausgebildet ist, einen Vorzeichenwechsel bei dem Vergleich der Spannung ($V_{Pix}$) an dem kapazitiven Element ($C_{L1}$) und der Referenzspannung ($V_{comp}$) gegenüber einem vorhergehenden Vergleich derselben zu detektieren, und auf Basis einer Ladungsmenge, die dem kapazitiven Element bis zu der Detektion eines Vorzeichenwechsels zu-/abgeführt wurde, die Ladungsmenge ($Q_{Pix}$) auf dem kapazitiven Element ($C_{L1}$) zu bestimmen.

3. Vorrichtung nach Anspruch 1 oder 2, wobei eine Ladungsmenge eines Ladungspakets durch eine Stromstärke des Ladungspakets und eine Dauer des Ladungspakets definiert ist.

4. Vorrichtung nach einem der Ansprüche 1 bis 3, die einen Ladungs-Analog-Digital-Wandler realisiert, und die Vorrichtung zum Rückschliessen (3130; Control) ausgebildet ist, einen der Ladung auf dem kapazitiven Element ($C_{L1}$) entsprechenden digitalen Wert (3132; $D_{out}$) zu bestimmen.

5. Vorrichtung nach Anspruch 3 oder 4, wobei die Einrichtung (3120; QSrc) zum Bewirken einer Ladungszufuhr/-abfuhr ausgebildet ist, Ladungspakete mit konstanter Ladungsmenge ab-/zuzuführen; und
die Einrichtung zum Rückschließen (3130; Control) ausgebildet ist, die Anzahl der Ladungspakete konstanter Ladungsmenge zu zählen und die Ladungsmenge ($Q_{Pix}$) auf dem kapazitiven Element ($C_{L1}$) auf Basis der Zahl der Ladungspakete zu bestimmen.

6. Vorrichtung nach Anspruch 5, wobei die Einrichtung (3120; QSrc) zum Bewirken einer Ladungszufuhr/-abfuhr ausgebildet ist, Ladungspakete mit variabler Ladungsmenge ab-/zuzuführen; und
die Einrichtung (3130; Control) zum Rückschließen ausgebildet ist, die Anzahl der Ladungspakete zu zählen und die Ladungsmenge ($Q_{Pix}$) auf dem kapazitiven Element ($C_{L1}$) auf Basis der Zahl der Ladungspakete und der entsprechenden Ladungsmengen zu bestimmen.

7. Vorrichtung nach Anspruch 6, wobei die Einrichtung (3120; QSrc) zum Bewirken einer Ladungszufuhr/-abfuhr ausgebildet ist, dem kapazitiven Element ($C_{L1}$) Ladungspakete mit binär abgestufter Ladungsmenge zu-/abzuführen, und ferner ausgebildet ist mit einem Ladungspaket der binär höchsten Ladungsmenge zu beginnen und in einer nächsten Stufe ein Ladungspaket der nächst niedrigeren binären Ladungsmenge zu-/abzuführen; und
die Einrichtung zum Rückschließen (3130; Control) ausgebildet ist, einen der jeweiligen Ladungsmenge entsprechenden digitalen Wert zu addieren bzw. zu subtrahieren, um einen der Ladung auf dem kapazitiven Element ($C_{L1}$) entsprechenden digitalen Wert (3132; $D_{out}$) zu bestimmen.

8. Vorrichtung nach Anspruch 7, wobei die die Einrichtung (3120; QSrc) zum Bewirken einer Ladungszufuhr/-abfuhr ausgebildet ist, Ladungspakete einer ersten Ladungsmenge zu-/abzuführen, bis die Einrichtung (3130; Control) zum Rückschließen einen Vorzeichenwechsel detektiert, um dann Ladungspakete einer zweiten Ladungsmenge, die kleiner als die erste Ladungsmenge ist, zu-/abzuführen, wobei die Einrichtung zum Bewirken ausgebildet ist, Ladungspakete der zweiten Ladungsmenge abzuführen, wenn zuvor ein Ladungspaket der ersten Ladungsmenge zugeführt wurde, und umgekehrt.

9. Vorrichtung nach einem der Ansprüche 1 bis 8, wobei die Einrichtung (3120; QSrc) zum Bewirken einer Ladungszufuhr/-abfuhr mindestens eine Ladungspumpe aufweist.

10. Vorrichtung nach einem der Ansprüche 1 bis 9, wobei die Einrichtung (3120; QSrc) zum Bewirken einer Ladungszufuhr/-abfuhr mindestens eine Stromspeicherzelle (SI-Mem) aufweist.

11. Vorrichtung (3400) zur ladungsbasierten Signalverarbeitung mit:

einem kapazitiven Element ($C_{L1}$, L1) ;
einem ersten Ladungsgeber (3410);
einem zweiten Ladungsgeber (3420) ;
einer Ladungsgebersteuerung (3430), zum Koppeln des ersten Ladungsgebers (3410) und/oder zweiten Ladungsgebers (3420) mit dem kapazitiven Element ($C_{L1}$, L1);

einer Vorrichtung (3100) zum Bestimmen einer Ladungsmenge ($Q_{Pix}$) auf dem kapazitivem Element ($C_{L1}$, L1) gemäß einem der Ansprüche 1 bis 10.

**12.** Vorrichtung (3500) zur ladungsbasierten Signalverarbeitung mit:

einer ersten Leitung (L1; $C_{L1}$);
einer zweiten Leitung (L2; $C_{L2}$);
Vorrichtung zum Setzen der zweiten Leitung (L2; $C_{L2}$) auf eine vorbestimmte Spannung ($V_{PixRef}$) ; mit:

einer Einrichtung (3110; A1) zum Vergleichen einer Spannung (3204) an der zweiten Leitung (L2) mit einer Referenzspannung ($V_{Comp}$) ;
einem inneren kapazitiven Element (3240; $C_{L2}'$);
einer Treiberstufe (3242; $A_2$), wobei die zweite Leitung (L2; $C_{L2}$) mit einem Ausgang der Treiberstufe (3242; $A_2$) gekoppelt ist und das innere kapazitive Element ($C_{L2}'$) mit einem Eingang der Treiberstufe (3242; $A_2$) gekoppelt ist;
einer Einrichtung (3120; QSrc) zum Bewirken einer Ladungszufuhr/-Abfuhr (3122) zu/von dem kapazitiven Element ($C_{L2}'$) bis der Vergleich (3112) ergibt, dass die Spannung an der zweiten Leitung (L2; $C_{L2}$) der vorbestimmten Spannung entspricht ($V_{PixRef}$);

einem ersten Ladungsgeber (3410) mit einem Ausgangsknoten (3412);
einem zweiten Ladungsgeber (3420) mit einem Ausgangsknoten (3422);
einer Ladungsgebersteuerung (3430), zum Koppeln eines Ausgangsknotens (3412) des ersten Ladungsgebers (3410) und/oder eines Ausgangsknotens (3422) des zweiten Ladungsgebers (3420) mit der ersten Leitung (L1; $C_{L1}$) und/oder zweiten Leitung (L2; $C_{L2}$) ; und

einer Vorrichtung (3100) zum Bestimmen einer Ladungsmenge ($Q_{Pix}$) auf der ersten Leitung (L1; $C_{L1}$) gemäß einem der Ansprüche 1 bis 10.

**13.** Vorrichtung zur ladungsbasierten Signalverarbeitung mit:

einer ersten Leitung (L1; $C_{L1}$);
einer zweiten Leitung (L2; $C_{L2}$) ;
einem ersten Ladungsgeber (3410) mit einem Ausgangsknoten (3412);
einem zweiten Ladungsgeber (3420) mit einem Ausgangsknoten (3422);
einer Ladungsgebersteuerung (3430), zum Koppeln eines Ausgangsknotens (3412) des ersten Ladungsgebers (3410) und/oder eines Ausgangsknotens (3422) des zweiten Ladungsgebers (3420) mit der ersten Leitung (L1; $C_{L1}$) und/oder zweiten Leitung (L2; $C_{L2}$) ; und

einer Vorrichtung (3100) zum Bestimmen einer Ladungsmenge ($Q_{Pix}$) auf der ersten Leitung (L1; $C_{L1}$) gemäß einem der Ansprüche 1 bis 10; und

einer Einrichtung zum Setzen der zweiten Leitung (L2; $C_{L2}$) auf eine Spannung der ersten Leitung (L1; $C_{L1}$).

**14.** Verfahren (3260) zum Bestimmen der Ladungsmenge ($Q_{Pix}$) auf einem kapazitiven Element ($C_{L1}$), mit
Vergleich (3162) einer Spannung ($V_{Pix}$) an dem kapazitiven Element ($C_{L1}$) mit einer Referenzspannung ($V_{comp}$), um zu bestimmen, ob die Spannung ($V_{Pix}$) größer oder kleiner als die Referenzspannung ($V_{Comp}$) ist;
Bewirken (3164) eine Ladungszufuhr/-Abfuhr (3122) zu/von dem kapazitiven Element ($C_{L1}$), und zwar iterativ mittels Ladungspaketen abhängig von dem Vergleich, so dass eine Differenz zwischen der Spannung ($V_{Pix}$) an dem kapazitiven Element ($C_{L1}$) und der Referenzspannung ($V_{Comp}$) geringer wird, wobei eine Ladungszufuhr/abfuhr zu/von dem kapazitiven Element ($C_{L1}$) bewirkt wird, um die Spannung an dem kapazitiven Element ($C_{L1}$) zu verringern, wenn die Spannung an dem kapazitiven Element ($C_{L1}$) größer ist als die Referenzspannung, und eine Ladungszufuhr/abfuhr zu/von dem kapazitiven Element ($C_{L1}$) bewirkt wird, um die Spannung an dem kapazitiven Element ($C_{L1}$) zu erhöhen, wenn die Spannung an dem kapazitiven Element ($C_{L1}$) kleiner ist als die Referenzspannung; und
Rückschließen (3166) auf die Ladung ($Q_{Pix}$) auf dem kapazitiven Element ($C_{L1}$) auf Basis der Ladungszufuhr/-Abfuhr (3122) und dem Vergleich der Spannung (3112), und zwar auf Basis einer Anzahl der Ladungspakete, die im Rahmen der iterativen Ladungszufuhr/-abfuhr (3122) ab-/zugeführt werden.

**15.** Verfahren (3560)zur ladungsbasierten Signalverarbeitung,

wobei eine zweite Leitung (L2; $C_{L2}$) mit einem Ausgang einer Treiberstufe (3242; $A_2$) gekoppelt ist und ein inneres kapazitives Element ($C_{L2}$') mit einem Eingang der Treiberstufe (3242; $A_2$) gekoppelt ist, mit:

einem Verfahren zum Setzen (3260) der zweiten Leitung (L2; $C_{L2}$) auf eine vorbestimmte Spannung ($V_{PixRef}$), wobei das Setzen der zweiten Leitung umfasst:

Vergleichen (3162) einer Spannung (3204) an der zweiten Leitung (L2; $C_{L2}$) mit einer Referenzspannung ($V_{comp}$) ;
Bewirken (3262) einer Ladungszufuhr/-Abfuhr zu/von dem inneren kapazitiven Element (3240; $C_{L2}$') bis der Vergleich ergibt, dass die Spannung an der zweiten Leitung (L2; $C_{L2}$) der vorbestimmten Spannung ($V_{PixRef}$) entspricht;

Koppeln (3562) eines Ausgangsknotens (3412) eines ersten Ladungsgebers (3410) und/oder eines Ausgangsknotens (3422) eines zweiten Ladungsgebers (3420) mit der ersten Leitung (L1; $C_{L1}$) ; und

einem Verfahren zum Bestimmen (3160) einer Ladungsmenge ($V_{Pix}$) auf der ersten Leitung (L1; $C_{L1}$) gemäß Anspruch 14.

16. Verfahren zur ladungsbasierten Signalverarbeitung, wobei eine zweite Leitung (L2; $C_{L2}$) mit einem Ausgang einer Treiberstufe (3242; $A_2$) gekoppelt ist und ein inneres kapazitives Element ($C_{L2}$') mit einem Eingang der Treiberstufe (3242; $A_2$) gekoppelt ist, mit:

Koppeln (3562) eines Ausgangsknotens (3412) eines ersten Ladungsgebers (3410) und/oder eines Ausgangsknotens (3422) eines zweiten Ladungsgebers (3420) mit der ersten Leitung (L1; $C_{L1}$); und

einem Verfahren zum Bestimmen (3160) einer Ladungsmenge ($V_{Pix}$) auf der ersten Leitung (L1; $C_{L1}$) gemäß Anspruch 14; und

Setzen der zweiten Leitung (L2; $C_{L2}$) auf eine Spannung der ersten Leitung (L1; $C_{L1}$).

17. Verfahren (200) zum Bestimmen einer Position eines Maximums einer Hüllkurve eines analogen amplitudenmodulierten Signals unter Verwendung einer Vorrichtung gemäß Anspruch 14, mit:

Abtasten (202) des amplitudenmodulierten Signals, um eine Folge von analogen Abtastwerten zu erzeugen;
Erzeugen (204) einer Folge von analogen Differenzwerten, wobei ein analoger Differenzwert der Folge von analogen Differenzwerten auf einer Differenz zweier aufeinanderfolgender analoger Abtastwerte der Folge von analogen Abtastwerten basiert;
Digitalisieren (206) der analogen Differenzwerte, um eine Folge von digitalen Differenzwerten ($D_{Pix}$) zu erzeugen; und
Bestimmen (208) der Position des Maximums der Hüllkurve basierend auf der Folge von digitalen Differenzwerten ($D_{Pix}$).

18. Verfahren nach Anspruch 17, wobei das amplitudenmodulierte Signal ein zeitlich amplitudenmoduliertes Signal ist, und das Abtasten eine zeitliche Folge von analogen Abtastwerten erzeugt.

19. Verfahren nach Anspruch 17, wobei das amplitudenmodulierte Signal ein räumlich amplitudenmoduliertes Signal ist, und das Abtasten eine räumliche Folge von analogen Abtastwerten ergibt.

20. Verfahren nach einem der Ansprüche 17 bis 19, wobei das Bestimmen der Position des Maximums auf einem Bestimmen einer Anzahl einer Folge von Nulldurchgängen ($D_{SumZ}$) der Folge von digitalen Differenzwerten ($D_{Pix}$) basiert.

21. Verfahren nach Anspruch 20, wobei bei dem Bestimmen der Anzahl der Nulldurchgänge ($D_{SumZ}$) nur ein Teil der Folge von digitalen Differenzwerten ($D_{Pix}$; $I_{Pix}$) berücksichtigt wird, wobei
der Teil der Folge von digitalen Differenzwerten ($D_{Pix}$) mit einem ersten digitalen Differenzwert der Folge von Differenzwerten ($I_{Pix}$; $D_{Pix}$) beginnt, dessen Wert größer als ein oberer Schwellwert ($I_{Sp}$) oder kleiner als ein unterer Schwellwert ($I_{Sn}$) ist, und
wobei der Teil der Folge von digitalen Differenzwerten ($I_{Pix}$) mit einem letzten digitalen Differenzwert endet, dessen Wert größer als der obere Schwellwert ($I_{Sp}$) oder kleiner als der untere Schwellwert ($I_{Sn}$) ist.

**22.** Verfahren nach einem der Ansprüche 20 oder 21, wobei die Position des Maximums der Hüllkurve als eine Position eines mittleren Nulldurchgangs der Folge von Nulldurchgängen bestimmt wird.

**23.** Verfahren nach einem der Ansprüche 19 bis 22, bei dem das Digitalisieren folgenden Schritt aufweist:

Erzeugen der Folge ($D_{Pix}$) von digitalen Differenzwerten ($D_{Pix}$) basierend auf der Folge von analogen Differenzwerten, so dass

einem Digitalwert ($D_{Pix}$) der Folge von digitalen Differenzwerten ($D_{Pix}$) ein erster Wert ("0") zugeordnet ist, wenn ein entsprechender analoger Differenzwert der Folge von analogen Differenzwerten oder eine vordigitalisierte Version ($I_{Pix}$) desselben kleiner als ein oberer Schwellwert ($I_{Sp}$) und größer als ein unterer Schwellwert ($I_{Sn}$) ist, einem Digitalwert ($D_{Pix}$) der Folge von digitalen Differenzwerten ($D_{Pix}$) ein zweiter Wert ("+1") zugeordnet ist, wenn ein entsprechender analoger Differenzwert der Folge von analogen Differenzwerten oder eine vordigitalisierte Version ($I_{Pix}$) desselben größer als der obere Schwellwert ($I_{Sp}$) ist, und einem Digitalwert ($D_{Pix}$) der Folge von digitalen Differenzwerten ($D_{Pix}$) ein dritter Wert ("-1") zugeordnet ist, wenn ein entsprechender analoger Differenzwert der Folge von analogen Differenzwerten oder eine vordigitalisierte Version ($I_{Pix}$) desselben kleiner als der untere Schwellwert ($I_{Sp}$) ist.

**24.** Verfahren nach einem der Ansprüche 17 bis 23, bei dem das Digitalisieren folgenden Schritt aufweist:

Vordigitalisieren der analogen Differenzwerte, um eine erste Folge von digitalen Differenzwerten ($I_{Pix}$) zu erzeugen; und

Erzeugen einer zweiten Folge ($D_{Pix}$) von digitalen Differenzwerten ($D_{Pix}$) als die Folge von digitalen Differenzwerten ($D_{Pix}$) basierend auf der ersten Folge von digitalen Differenzwerten ($I_{Pix}$), wobei einem Digitalwert ($D_{Pix}$) der zweiten Folge von digitalen Differenzwerten ($D_{Pix}$) ein erster Wert ("0") zugeordnet wird, wenn ein entsprechender digitaler Differenzwert ($I-_{Pix}$) der ersten Folge von Differenzwerten ($I_{Pix}$) kleiner als ein oberer digitaler Schwellwert ($I_{Sp}$) und größer als ein unterer digitaler Schwellwert ($I_{Sn}$) ist, einem Digitalwert ($D_{Pix}$) der zweiten Folge von digitalen Differenzwerten ($D_{Pix}$) ein zweiter Wert ("+1") zugeordnet wird, wenn ein entsprechender digitaler Differenzwert ($I-_{Pix}$) der ersten Folge von Differenzwerten ($I_{Pix}$) größer als ein oberer digitaler Schwellwert ($I_{Sp}$) ist, und einem Digitalwert ($D_{Pix}$) der zweiten Folge von digitalen Differenzwerten ($D_{Pix}$) ein dritter Wert ("-1") zugeordnet wird, wenn ein entsprechender digitaler Differenzwert ($I-_{Pix}$) der ersten Folge von Differenzwerten ($I_{Pix}$) kleiner als ein unterer digitaler Schwellwert ($I_{Sp}$) ist.

**25.** Verfahren nach einem der Ansprüche 17 bis 24, bei dem das Abtasten und Erzeugen in einer Pixelzelle (100) stattfindet, und zwar unter

Erzeugen (162) eines ersten Messstroms ($I_{DPh1}$) durch einen Photosensor (110), abhängig von einer Strahlung in einem ersten Messzyklus;

Einprägen (164) eines Stroms ($I_{M1}$) in einer Stromspeichervorrichtung (120; SI-Mem) in einem ersten Betriebsmodus, abhängig von dem ersten Messstrom ($I_{DPh1}$), um in einem zweiten Betriebsmodus den eingeprägten Strom ($I_{M1}$) zu halten, so dass der eingeprägte Strom an dem Ausgangsknoten (104) erfassbar ist;

Erzeugen (166) eines zweiten Messstroms ($I_{DPh2}$) durch den Photosensor (110), abhängig von einer Strahlung in einem zweiten Messzyklus;

Halten (168) des eingeprägten Stroms ($I_{M1}$) in einem zweiten Betriebsmodus durch die Stromspeichervorrichtung (120);

Bilden (170) einer Differenz des eingeprägten Stroms ($I_{M1}$) und des zweiten Messstroms ($I_{DPh2}$) in einem Auslesezyklus an dem Ausgangsknoten (104);

Koppeln (172) des Ausgangsknotens mit dem Ausgang (102).

**26.** Verfahren gemäß Anspruch 17, bei dem das Digitalisieren (206) der analogen Differenzwerte, um eine Folge von digitalen Differenzwerten ($D_{Pix}$) zu erzeugen, folgende Schritte aufweist:

Erzeugen einer ersten Folge von digitalen Differenzwerten ($I_{Pix}$), wobei ein digitaler Differenzwert ($I_{Pix}$) der ersten Folge von digitalen Differenzwerten auf einer Differenz zweier aufeinanderfolgender analoger Abtastwerte der Folge von analogen Abtastwerten basiert;

Erzeugen einer zweiten Folge ($D_{Pix}$) von digitalen Differenzwerten ($D_{Pix}$) basierend auf der ersten Folge von digitalen Differenzwerten ($I_{Pix}$), wobei

einem Digitalwert ($D_{Pix}$) der zweiten Folge von digitalen Differenzwerten ($D_{Pix}$) ein erster Wert ("0") zugeordnet wird, wenn ein entsprechender digitaler Differenzwert ($I_{-Pix}$) der ersten Folge von Differenzwerten ($I_{Pix}$) kleiner als ein oberer digitaler Schwellwert ($I_{Sp}$) und größer als ein unterer digitaler Schwellwert ($I_{Sn}$) ist,

einem Digitalwert ($D_{Pix}$) der zweiten Folge von digitalen Differenzwerten ($D_{Pix}$) ein zweiter Wert ("+1") zugeordnet wird, wenn ein entsprechender digitaler Differenzwert ($I_{-Pix}$) der ersten Folge von Differenzwerten ($I_{Pix}$) größer als ein oberer digitaler Schwellwert ($I_{Sp}$) ist, und

einem Digitalwert ($D_{Pix}$) der zweiten Folge von digitalen Differenzwerten ($D_{Pix}$) ein dritter Wert ("-1") zugeordnet wird, wenn ein entsprechender digitaler Differenzwert ($I_{-Pix}$) der ersten Folge von Differenzwerten ($I_{Pix}$) kleiner als ein unterer digitaler Schwellwert ($I_{Sp}$) ist.

**27.** Verfahren nach Anspruch 26, mit:

Erzeugen einer dritten Folge von digitalen Differenzwerten ($D_{PixM}$) basierend auf der zweiten Folge von digitalen Differenzwerten ($D_{Pix}$), wobei

einem ersten digitalen Differenzwert ($D_{PixM}$) der dritten Folge der erste Wert ("0") zugeordnet wird,

einem digitalen Differenzwert ($D_{PixM}(k)$) der dritten Folge von Differenzwerten der Wert eines in der Folge entsprechenden digitalen Differenzwerts ($D_{Pix}(k)$) der zweiten Folge zugeordnet wird, wenn letzterem nicht der erste Wert zugeordnet ist ("ungleich 0"), und

einem Differenzwert ($O_{PixM}(k)$) der dritten Folge von digitalen Differenzwerten ein digitaler Differenzwert ($D_{Pix}$) der zweiten Folge von digitalen Differenzwerten eines vorhergehenden digitalen Differenzwertes ($O_{Pix}(k-1)$) der zweiten Folge zugeordnet wird, wenn der dem Differenzwert ($D_{PixM}(k)$) der dritten Folge von digitalen Differenzwerten in der Folge entsprechende digitale Differenzwert ($D_{Pix}(k)$) der zweiten Folge von digitalen Differenzwerten der erste Wert ("0") zugeordnet ist.

**28.** Verfahren nach Anspruch 27, mit
Bestimmen eines Nulldurchgangs ($D_Z$ = +/-1) in der dritten Folge von digitalen Differenzwerten ($D_{PixM}$), wobei ein Nulldurchgang detektiert ($D_Z$ = +/-1) wird, wenn in der dritten Folge von digitalen Differenzwerten ($D_{PixM}$) zwei aufeinanderfolgende digitale Differenzwerte ($D_{PixM}(k-1)$, $D_{PixM}(k)$) unterschiedliche Werte aufweisen.

**29.** Verfahren nach Anspruch 28, mit
Erhöhen eines Nulldurchgangszählers ($D_{SumZ}$), wenn ein Nulldurchgang ($D_Z$ = +/-1) detektiert wird;
Ermitteln eines digitalen Differenzwertes ($D_{PixM}$) der dritten Folge von Differenzwerten mit einer mittleren Position in Bezug auf einen ersten Nulldurchgang und einen letzten Nulldurchgang der dritten Folge von Differenzwerten ($D_{PixM}$) ; und
Bestimmen der Position des Maximums der Hüllkurve basierend auf der Position des digitalen Differenzwertes ($D_{PixM}$) der dritten Folge von Differenzwerten mit der mittleren Position.

**30.** Verfahren nach Anspruch 29, mit
Erzeugen einer dritten Folge von digitalen Differenzwerten ($D_S$) basierend auf der zweiten Folge von digitalen Differenzwerten ($D_{Pix}$), wobei
einem digitalen Differenzwert ($D_S(k)$) der dritten Folge von Differenzwerten der zweite Wert ("+1") zugeordnet wird, wenn eine Differenz zwischen einem dem digitalen Differenzwert ($D_S(k)$) der dritten Folge von Differenzwerten in der Folge entsprechenden digitalen Differenzwert ($D_{Pix}(k)$) der zweiten Folge von digitalen Differenzwerten ($D_{Pix}$) und einem letzterem vorhergehenden digitalen Differenzwert ($D_{Pix}(k-1)$) der zweiten Folge von digitalen Differenzwerten ($D_{Pix}$) größer als Null ist,
einem digitalen Differenzwert ($D_S(k)$) der dritten Folge von Differenzwerten der dritte Wert ("-1") zugeordnet wird, wenn eine Differenz zwischen einem dem digitalen Differenzwert ($D_S(k)$) der dritten Folge von Differenzwerten in der Folge entsprechenden digitalen Differenzwert ($D_{Pix}(k)$) der zweiten Folge von digitalen Differenzwerten ($D_{Pix}$) und einem letzterem vorhergehenden digitalen Differenzwert ($D_{Pix}(k-1)$) der zweiten Folge von digitalen Differenzwerten ($D_{Pix}$) kleiner als Null ist, und einem Differenzwert ($D_S(k)$) der dritten Folge von digitalen Differenzwerten ein diesem vorhergehender digitaler Differenzwert ($D_S(k-1)$) der dritten Folge zugeordnet wird,
wenn ein dem digitalen Differenzwert ($D_S(k)$) der dritten Folge von Differenzwerten in der Folge entsprechender digitaler Differenzwert ($D_{Pix}(k)$) der zweiten Folge von digitalen Differenzwerten ($D_{Pix}$) der gleiche Wert zugeordnet ist wie einem dem letzteren vorhergehender digitaler Differenzwert ($D_{Pix}(k-1)$) der zweiten Folge von digitalen Differenzwerten ($D_{Pix}$).

**31.** Verfahren nach Anspruch 30, mit:

Bestimmen eines direkten Nulldurchgangs ($D_{Zd}$ = 1 oder $D_{Zd}$ = -1) in der dritten Folge von digitalen Differenzwerten ($D_{Pix}$), wobei ein direkter Nulldurchgang detektiert wird, wenn

in der zweiten Folge von digitalen Differenzwerten ($D_{Pix}$) zwei aufeinanderfolgende digitale Differenzwerte ($D_{Pix}(k-1)$, $D_{Pix}(k)$) unterschiedliche Werte aufweisen und dem vorhergehenden digitalen Differenzwert ($D_{Pix}(k-1)$) nicht der erste Wert zugeordnet ist ("0");

Bestimmen eines ersten Übergangs des indirekten Nulldurchgangs ($D_{Zi10}$ = 1 oder $D_{Zi10}$ = -1) in der dritten Folge von digitalen Differenzwerten ($D_S$), wobei ein erster Übergang des indirekten Nulldurchgangs detektiert wird, wenn

ein dem digitalen Differenzwert ($D_S(k)$) der dritten Folge von Differenzwerten in der Folge entsprechender digitaler Differenzwert ($D_{Pix}(k)$) der zweiten Folge von digitalen Differenzwerten ($D_{Pix}$) der erste Wert("0") zugeordnet ist, und gleichzeitig ein diesem digitalen Differenzwert ($D_S(k)$) vorangehender digitalen Differenzwert ($D_S(k-1)$) der dritten Folge von Differenzwerten und ein diesem in der Folge entsprechender digitaler Differenzwert ($D_{Pix}(k-1)$) der zweiten Folge von Differenzwerten der gleiche Wert zugeordnet ist; und

Bestimmen eines zweiten Übergangs des indirekten Nulldurchgangs ($D_{ZiO1}$ = 1 oder $D_{ZiO1}$ = -1) in der dritten Folge von digitalen Differenzwerten ($D_S$), wobei ein zweiter Übergang des indirekten Nulldurchgangs detektiert wird, wenn

ein einem diesem digitalen Differenzwert ($D_S(k)$) der dritten Folge von Differenzwerten vorangehender digitaler Differenzwert ($D_S(k-1)$) der dritten Folge von Differenzwerten entsprechender digitaler Differenzwert ($D_{Pix}(k-1)$) der zweiten Folge von Differenzwerten der erste Wert ("0") zugeordnet ist; und gleichzeitig ein diesem digitalen Differenzwert($D_S(k)$) vorangehender digitalen Differenzwert ($D_S(k-1)$) der dritten Folge von Differenzwerten und ein ersterem in der Folge entsprechender digitaler Differenzwert ($D_{Pix}(k)$) der zweiten Folge von Differenzwerten der gleiche Wert zugeordnet ist.

**32.** Verfahren nach Anspruch 31, mit
Erhöhen eines Nulldurchgangszählers ($D_{SumZ}$), wenn ein direkter Nulldurchgang oder ein indirekter Nulldurchgang aus zwei aufeinanderfolgenden Übergängen detektiert werden;
Ermitteln eines digitalen Differenzwertes ($D_{Pix}$) der zweiten Folge von Differenzwerten mit einer mittleren Position in Bezug auf einen ersten Nulldurchgang und einen letzten Nulldurchgang der zweiten Folge von Differenzwerten ($D_{Pix}$) ; und
Bestimmen der Position des Maximums der Hüllkurve basierend auf der Position des digitalen Differenzwertes ($D_{Pix}$) der zweiten Folge ($D_{Pix}$) von Differenzwerten mit der mittleren Position.

**33.** Verfahren nach einem der Ansprüche 26 bis 32, wobei der erste Wert "0" ist, der zweite Wert "+1" ist und der dritte Wert "-1 ist.

**34.** Verfahren nach einem der Ansprüche 26 bis 33, wobei der obere Schwellwert ($I_{Sp}$) ein positiver Wert ist und der untere Schwellwert ($I_{Sn}$) ein negativer Schwellwert ist.

**35.** Verfahren (160) nach einem der Ansprüche 26 bis 34, wobei das Abtasten und das Erzeugen der ersten Folge in einer Pixelzelle (100) stattfindet, und zwar unter
Erzeugen (162) eines ersten Messstroms ($I_{DPh1}$) durch einen Photosensor (110), abhängig von einer Strahlung in einem ersten Messzyklus;
Einprägen (164) eines Stroms ($I_{M1}$) in einer Stromspeichervorrichtung (120; SI-Mem) in einem ersten Betriebsmodus, abhängig von dem ersten Messstrom ($I_{DPh1}$), um in einem zweiten Betriebsmodus den eingeprägten Strom ($I_{M1}$) zu halten, so dass der eingeprägte Strom an dem Ausgangsknoten (104) erfassbar ist;
Erzeugen (166) eines zweiten Messstroms ($I_{DPh2}$) durch den Photosensor (110), abhängig von einer Strahlung in einem zweiten Messzyklus;
Halten (168) des eingeprägten Stroms ($I_{M1}$) in einem zweiten Betriebsmodus durch die Stromspeichervorrichtung (120);
Bilden (170) einer Differenz des eingeprägten Stroms ($I_{M1}$) und des zweiten Messstroms ($I_{DPh2}$) in einem Auslesezyklus an dem Ausgangsknoten (104); Koppeln (172) des Ausgangsknotens mit dem Ausgang (102).

**36.** Computerprogramm mit einem Programm-Code zum Ausführen eines Verfahrens gemäß einem der Ansprüche 14 bis 35, wenn das Computerprogramm auf einem Computer abläuft.

**Claims**

1. Device (3100) for determination of a charge amount ($Q_{Pix}$) of a capacitive element, with:

    a device (3100; $A_1$) for comparison (3112) of a voltage ($V_{Pix}$) on the capacitive element ($C_{L1}$) with a reference voltage ($V_{comp}$) and for determining whether the voltage ($V_{Pix}$) on the capacitive element is greater or smaller than the reference voltage ($V_{comp}$);
    a device (3120; QSrc) to cause feed/removal (3122) to/from the capacitive element ($C_{L1}$) iteratively by means of charge packets in dependence of the comparison so that a difference between the voltage ($V_{Pix}$) and the capacitive element ($C_{L1}$) and the reference voltage ($V_{comp}$) becomes smaller, wherein the device (3120; QSrc) to cause is configured to cause a feed/removal to/from the capacitive element ($C_{L1}$) in order to reduce the voltage at the capacitive element ($C_{L1}$) when the voltage at the capacitive element ($C_{L1}$) is greater than the reference voltage, and to cause a feed/removal to/from the capacitive element ($C_{L1}$) in order to raise the voltage at the capacitive element ($C_{L1}$) when the voltage at the capacitive element ($C_{L1}$) is smaller than the reference voltage; and
    a device (3130; control) for inference of the charge ($Q_{Pix}$) on the capacitive element ($C_{L1}$) based on charge feed/removal (3122) and comparison of the voltage (3112) based on a count of the charge packets feed and removed during the iterative feed/removal (3122).

2. Device according to claim 1, in which the device (3130; control) for inference is designed to detect a sign change during comparison of the voltage ($V_{Pix}$) on the capacitive element ($C_{L1}$) and the reference voltage ($V_{comp}$) relative to a previous comparison of same, and on the basis of a charge amount that was fed/removed to/from the capacitive element up to the detection of a sign change, to determine the charge amount ($Q_{Pix}$) on the capacitive element ($C_{L1}$).

3. Device according to claim 1 or 2, in which a charge amount of a charge packet is defined by a current intensity of the charge packet and a duration of the charge packet.

4. Device according to one of the claims 1 to 3, which implements a charge analog/digital converter and the device for inference (3130; control) is designed to determine a digital value (3132; $D_{out}$) corresponding to the charge on the capacitive element ($C_{L1}$).

5. Device according to claim 3 or 4, in which the device (3120; QSrc) to cause charge feed/removal is designed to remove/feed charge packets with constant charge amount; and
    the device for inference (3130; control) is designed to count the number of charge packets of constant charge amount and to determine the charge amount ($Q_{Pix}$) on the capacitive element ($C_{L1}$) based on the number of charge packets.

6. Device according to claim 5, in which the device (3120; QSrc) to cause charge feed/removal is designed to remove/feed charge packets with variable charge amount; and
    the device (3130; control) for inference is designed to count the number of charge packets and to determine the charge amount ($Q_{Pix}$) on the capacitive element ($C_{L1}$) based on the number of charge packets and the corresponding charge amounts.

7. Device according to claim 6, in which the device (3120; QSrc) to cause charge feed/removal is designed to feed/remove charge packets to/from the capacitive element ($C_{L1}$) with a binary stepped charge amount and is further designed to begin with a charge packet of the binary highest charge amount and to feed/remove in a next step a charge packet of the next lower binary charge amount; and
    the device for inference (3130; control) is designed to add or subtract a corresponding digital value from the corresponding charge amount in order to determine a digital value (3132; $D_{out}$ corresponding to the charge on the capacitive element ($C_{L1}$).

8. Device according to claim 7, in which the device (3120; QSrc) for causing charge feed/removal is designed to feed/remove charge packets of a first charge amount until the device (3130; control) for inference detects a sign change in order to then feed/remove the charge packets of a second charge amount that is smaller than the first charge amount, in which the device for causing is designed to remove charge packets of the second charge amount when a charge packet of the first charge amount was previously fed and vice-versa.

9. Device according to one of the claims 1 to 8, in which the device (3120; QSrc) for causing charge feed/removal has at least one charge pump.

10. Device according to one of the claims 1 to 9, in which the device (3120; QSrc) for causing charge feed/removal has at least one current storage cell (SI-Mem).

11. Device (3400) for charge-based signal processing, with:

the capacitive element ($C_{L1}$, L1);
a first charge generator (3410);
a second charge generator (3420);
a charge generator control (3430) for coupling of the first charge generator (3410) and/or a second charge generator (3420) to the capacitive element ($C_{L1}$, L1);

a device (3100) for determination of a charge amount ($Q_{Pix}$) on the capacitive element (CL1, L1) according to one of the claims 1 to 10.

12. Device (3500) for charge-based signal processing, with:

a first line (L1; $C_{L1}$);
a second line (L2; $C_{L2}$);
device for setting the second line (L2; $C_{L2}$) with a predetermined voltage ($V_{PixRef}$), with:

a device (3110; A1) for comparison of a voltage (3204) on the second line (L2) with a reference voltage ($V_{comp}$);
a internal capacitive element(3240; $C_{L2}'$);
a driver stage (3242; $A_2$) in which the second line (L2; $C_{L2}$) is coupled to an output of the driver stage (3242; $A_2$) and the internal capacitive element ($C_{L2}'$) is coupled to an input of the driver stage (3242; $A_2$);
a device (3120; QSrc) to cause charge feed/removal (3122) to/from the capacitive element ($C_{L2}'$) until the comparison (3112) shows that the voltage on the second line (L2; $C_{L2}$) corresponds to the predetermined voltage ($V_{PixRef}$);

a first charge generator (3410) with an output node (3412);
a second charge generator (3420) with an output node (3422);
a charge generator control (3430) for coupling of an output node (3412) of the first charge generator (3410) and/or an output node (3422) of the second charge generator (3420) with the first line (L1; $C_{L1}$) and/or a second line (L2; $C_{L2}$); and

a device (3100) for determination of a charge amount ($Q_{Pix}$) on the first line (L1; $C_{L1}$) according to one of the claims 1 to 10.

13. Device for charge-based signal processing with:

a first line (L1; $C_{L1}$);
a second line (L2; $C_{L2}$);
a first charge generator (3410) with an output node (3412);
a second charge generator (3420) with an output node (3422);
a charge generator control (3430) for coupling of an output node (3412) of the first charge generator (3410) and/or an output node (3422) of the second charge generator (3420) with the first line (L1; $C_{L1}$) and/or a second line (L2; $C_{L2}$); and

a device (3100) for determining a charge amount ($Q_{Pix}$) on the first line (L1; $C_{L1}$) according to one of the claims 1 to 10; and

a device for setting the second line (L2; $C_{L2}$) at a voltage of the first line (L1; $C_{L1}$).

14. Method (3260) for determining a charge amount ($Q_{Pix}$) on a capacitive element ($C_{L1}$), comprising:

a comparison (3162) of a voltage ($V_{Pix}$) on the capacitive element ($C_{L1}$) with a reference voltage ($V_{comp}$) and for determining whether the voltage ($V_{Pix}$) on the capacitive element is greater or smaller than the reference voltage ($V_{comp}$);

causing (3164) a feed/removal (3122) to/from the capacitive element ($C_{L1}$) iteratively by means of charge packets in dependence of the comparison so that a difference between the voltage ($V_{Pix}$) and the capacitive element ($C_{L1}$) and the reference voltage ($V_{comp}$) becomes smaller, wherein a feed/removal to/from the capacitive element ($C_{L1}$) is caused in order to reduce the voltage at the capacitive element ($C_{L1}$) when the voltage at the capacitive element ($C_{L1}$) is greater than the reference voltage, and a feed/removal to/from the capacitive element ($C_{L1}$) is caused in order to raise the voltage at the capacitive element ($C_{L1}$) when the voltage at the capacitive element ($C_{L1}$) is smaller than the reference voltage; and

an inference (3166) of the charge ($Q_{Pix}$) on the capacitive element ($C_{L1}$) based on charge feed/removal (3122) and comparison of the voltage (3112) based on a count of the charge packets feed and removed during the iterative feed/removal (3122).

15. Method (3560) for charge-based signal processing, in which a second line (L2; $C_{L2}$) is coupled to an output of the driver stage (3242; $A_2$) and an internal capacitive element ($C_{L2}'$) is coupled to an input of the driver stage (3242; $A_2$), comprising a method for setting (3260) the second line (L2; $C_{L2}$) at a predetermined voltage ($V_{PixRef}$) in which setting of the second line includes:

comparison (3162) of a voltage (3204) on the second line (L2; $C_{L2}$) with a reference voltage ($V_{comp}$);

causing (3262) charge feed/removal to/from the internal capacitive element (3240; $C_{L2}'$) until the comparison shows that the voltage on the second line (L2; $C_{L2}$) corresponds to the predetermined voltage ($V_{PixRef}$);

coupling (3562) of an output node (3412) of a first charge generator (3410) and/or an output node (3422) of a second charge generator (3420) with the first line (L1; $C_{L1}$); and

a method for determination (3160) of a charge amount ($V_{Pix}$) on the first line (L1; $C_{L1}$) according to claim 14.

16. Method for charge-based signal processing, in which a second line (L2; $C_{L2}$) is coupled to an output of the driver stage (3242; $A_2$) and an internal capacitive element ($C_{L2}'$) is coupled to an input of the driver stage (3242; $A_2$), comprising

coupling (3562) of an output node (3412) of a first charge generator (3410) and/or an output node (3422) of a second charge generator (3420) with the first line (L1; $C_{L1}$); and

a method for determination (3160) of a charge amount ($V_{Pix}$) on the first line (L1; $C_{L1}$) according to claim 14; and

setting the second line (L2; $C_{L2}$) at a predetermined voltage ($V_{PixRef}$) of the first line (L1; $C_{L1}$).

17. Method (200) for determining a position of a maximum of an envelope of an analog amplitude-modulated signal by using a device according of claim 14, comprising:

sampling (202) the amplitude-modulated signal to create a sequence of analog sample values;

creating (204) a sequence of analog differential values, wherein an analog differential value of the sequence of analog differential values is based on a difference of two subsequent analog sample values of the sequence of analog sample values;

digitalizing (206) the analog differential values to create a sequence of digital differential values ($D_{Pix}$); and

determining (208) the position of the maximum of the envelope based on the sequence of digital differential values ($D_{Pix}$).

18. Method according to claim 17, wherein the amplitude-modulated signal is a temporally amplitude-modulated signal and the sampling creates a temporal sequence of analog sample values.

19. Method according to claim 17, wherein the amplitude-modulated signal is a spatially amplitude-modulated signal and the sampling creates a spatial sequence of analog sample values.

20. Method according to any one of claims 17 to 19, wherein determining the position of the maximum is based on determining a number of a sequence of zero crossings ($D_{SumZ}$) of the sequence of digital differential values ($D_{Pix}$).

21. Method according to claim 20, wherein, during determining the number of zero crossings ($D_{SumZ}$), only a part of the sequence of digital differential values ($D_{Pix}$; $I_{Pix}$) is considered, wherein

the part of the sequence of digital differential values ($D_{Pix}$) starts with a first digital differential value of the sequence of differential values ($I_{Pix}$; $D_{Pix}$) having a value greater than an upper threshold value ($I_{sp}$) or smaller than a lower threshold value ($I_{sn}$), and
wherein the part of the sequence of digital differential values ($I_{Pix}$) ends with a last digital differential value having a value greater than an upper threshold value ($I_{sp}$) or smaller than a lower threshold value ($I_{Sn}$).

22. Method according to claim 20 or 21, wherein the position of the maximum of the envelope is determined as a position of a middle zero crossing of the sequence of zero crossings.

23. Method according to any one of claims 19 to 22, wherein digitalizing comprises the following step:

creating the sequence ($D_{Pix}$) of digital differential values ($D_{Pix}$) based on the sequence of analog differential values such that
a digital value ($D_{Pix}$) of the sequence of digital differential values ($D_{Pix}$) has associated therewith a first value ("0") when a corresponding analog differential value of the sequence of analog differential values or a pre-digitalized version ($I_{Pix}$) thereof is smaller than an upper threshold value ($I_{Sp}$) and greater than a lower threshold value ($I_{Sn}$),
a digital value ($D_{Pix}$) of the sequence of digital differential values ($D_{Pix}$) has associated therewith a second value ("+1") when a corresponding analog differential value of the sequence of analog differential values or a pre-digitalized version ($I_{Pix}$) thereof is greater than the upper threshold value ($I_{Sp}$), and
a digital value ($D_{Pix}$) of the sequence of digital differential values ($D_{Pix}$) has associated therewith a third value ("-1") when a corresponding analog differential value of the sequence of analog differential values or a pre-digitalized version ($I_{Pix}$) thereof is smaller than the lower threshold value ($I_{Sp}$).

24. Method according to any one of claims 17 to 23, wherein digitalizing comprises the following step:

pre-digitalizing the analog differential values to create a first sequence of digital differential values ($I_{Pix}$); and
creating a second sequence ($D_{Pix}$) of digital differential values ($D_{Pix}$) as the sequence of digital differential values ($D_{Pix}$) based on the first sequence of analog differential values ($I_{Pix}$), wherein
a digital value ($D_{Pix}$) of the second sequence of digital differential values ($D_{Pix}$) has associated therewith a first value ("0") when a corresponding digital differential value ($I_{Pix}$) of the first sequence of differential values ($I_{Pix}$) is smaller than an upper threshold value ($I_{Sp}$) and greater than a lower threshold value ($I_{Sn}$),
a digital value ($D_{Pix}$) of the second sequence of digital differential values ($D_{Pix}$) has associated therewith a second value ("+1") when a corresponding digital differential value ($I_{Pix}$) of the first sequence of differential values ($I_{Pix}$) is greater than an upper threshold value ($I_{Sp}$), and
a digital value ($D_{Pix}$) of the second sequence of digital differential values ($D_{Pix}$) has associated therewith a third value ("-1") when a corresponding digital differential value ($I_{Pix}$) of the first sequence of differential values ($I_{Pix}$) is smaller than a lower threshold value ($I_{Sp}$).

25. Method according to any one of claims 17 to 24, wherein the sampling and the creating occurs in a pixel cell (100), amongst
creating (162) a first measurement current ($I_{DPh1}$) by a photographic sensor (110) in dependence of a radiation in a first measurement cycle;
applying (164) a current ($I_{M1}$) in a current storage device (120; SI-Mem) in a first operating mode in dependence of the first measurement current ($I_{DPh1}$) to hold the applied current ($I_{M1}$) in a second operating mode such that the applied current is detectable at the output node (104);
creating (166) a second measurement current ($I_{DPh2}$) by the photographic sensor (110) in dependence of a radiation in a second measurement cycle;
holding (168) the applied current ($I_{M1}$) in a second operating mode by the current storage device (120);
forming (170) a difference of the applied current ($I_{M1}$) and the second measurement current ($I_{DPh2}$) in a read-out cycle at the output node (104);
coupling (172) the output node with the output (102).

26. Method according to claim 17, wherein the digitalizing (206) of the analog differential values to create a sequence of digital differential values ($D_{Pix}$) comprises the following steps:

creating a first sequence of digital differential values ($I_{Pix}$), wherein a digital differential value ($I_{Pix}$) of the first sequence of digital differential values is based on a difference of two subsequent analog sample values of the sequence of analog sample values;

creating a second sequence ($D_{Pix}$) of digital differential values ($D_{Pix}$) based on the first sequence of digital differential values ($I_{Pix}$), wherein

a digital value ($D_{Pix}$) of the second sequence of digital differential values ($D_{Pix}$) has associated therewith a first value ("0") when a corresponding digital differential value ($I_{Pix}$) of the first sequence of differential values ($I_{Pix}$) is smaller than an upper threshold value ($I_{Sp}$) and greater than a lower threshold value ($I_{Sn}$),

a digital value ($D_{Pix}$) of the second sequence of digital differential values ($D_{Pix}$) has associated therewith a second value ("+1") when a corresponding digital differential value ($I_{Pix}$) of the first sequence of differential values ($I_{Pix}$) is greater than an upper threshold value ($I_{Sp}$), and

a digital value ($D_{Pix}$) of the second sequence of digital differential values ($D_{Pix}$) has associated therewith a third value ("-1") when a corresponding digital differential value ($I_{Pix}$) of the first sequence of differential values ($I_{Pix}$) is smaller than a lower threshold value ($I_{Sp}$).

**27.** Method according to claim 26, comprising:

creating a third sequence of digital differential values ($D_{PixM}$) based on the second sequence of digital differential values ($D_{Pix}$), wherein

a first digital differential value ($D_{PixM}$) of the third sequence has associated therewith a first value ("0"),

a digital differential value ($D_{PixM}(k)$) of the third sequence of differential values as associated therewith the value of a digital differential value ($D_{Pix}(k)$) of the second sequence, corresponding in sequence when the latter has not associated therewith the first value ("not equal 0"), and

a differential value ($D_{PixM}(k)$) of the third sequence digital differential values as associated therewith a digital differential value ($D_{Pix}$) of the second sequence of digital differential values of a preceding digital differential value ($D_{Pix}(k-1)$) of the second sequence when the digital differential value ($D_{Pix}(k)$) of the second sequence of digital differential values, corresponding in sequence to the differential value ($D_{PixM}(k)$) of third sequence of digital differential values, has associated therewith the first value ("0").

**28.** Method according to claim 27, comprising:

determining a zero crossing ($D_z = +/-1$) in the third sequence of digital differential values ($D_{PixM}$), wherein a zero crossing is detected ($D_z = +/-1$) when, in the third sequence of digital differential values ($D_{PixM}$) two subsequent digital differential values ($D_{PixM}(k-1)$, $D_{PixM}(k)$) comprise different values.

**29.** Method according to claim 28, comprising:

raising a zero crossing counter ($D_{SumZ}$) when a zero crossing ($D_z = +/-1$) is detected;

detecting a digital differential value ($D_{PixM}$) of the third sequence of differential values with a middle position with regard to a first zero crossing and a last zero crossing of the third sequence of differential values ($D_{PixM}$); and

determining the position of the maximum of the envelope based on the position of the digital differential value ($D_{PixM}$) of the third sequence of differential values with the middle position.

**30.** Method according to claim 29, comprising:

creating a third sequence of digital differential values ($D_s$) based on the second sequence of digital differential values ($D_{Pix}$), wherein

a digital differential value ($D_s(k)$) of the third sequence of differential values has associated therewith the second value ("+1") when a difference between a digital differential value ($D_{Pix}(k)$) of the second sequence of digital differential values ($D_{Pix}$), corresponding in sequence to a digital differential value ($D_s(k)$) of the third sequence of differential values, and a digital differential value ($D_{Pix}(k-1)$) of the second sequence of digital differential values ($D_{Pix}$), preceding the latter, is greater than zero,

a digital differential value ($D_s(k)$) of the third sequence of differential values has associated therewith the third value ("-1") when a difference between a digital differential value ($D_{Pix}(k)$) of the second sequence of digital differential values ($D_{Pix}$), corresponding in sequence to a digital differential value ($D_s(k)$) of the third sequence of differential values, and a digital differential value ($D_{Pix}(k-1)$) of the second sequence of digital differential values ($D_{Pix}$), preceding the latter, is smaller than zero, and

a digital differential value ($D_s(k)$) of the third sequence of digital differential values has associated therewith a digital differential value ($D_s(k-1)$) of the third sequence, preceding the same when a digital differential value ($D_{Pix}(k)$) of the second sequence of digital differential values ($D_{Pix}$), corresponding in sequence to the digital differential value ($D_S(k)$) of the third sequence of differential values, has associated therewith the same value as has a digital differential value ($D_{Pix}(k-1)$) of the second sequence of digital differential values ($D_{Pix}$), preceding the latter.

**31.** Method according to claim 30, comprising:

determining a direct zero crossing ($D_{Zd}$ = 1 or $D_{Zd}$ = -1) in the third sequence of digital differential values ($D_{Pix}$), wherein a direct zero crossing is detected when

in the second sequence of digital differential values ($D_{Pix}$), two subsequent digital differential values ($D_{Pix}(k-1)$), ($D_{Pix}(k)$) comprise different values and the preceding digital differential value ($D_{Pix}(k-1)$) has not associated therewith the first value ("0");

determining a first transition of the indirect zero crossing ($D_{Zi10}$ = 1 or $D_{Zi10}$ = -1) in the third sequence of digital differential values ($D_S$), wherein a first transition of indirect zero crossing is detected when

a digital differential value ($D_{Pix}(k)$) of the second sequence of digital differential values ($D_{Pix}$) corresponding in sequence to the digital differential value ($D_S(k)$) of the third sequence of differential values, has associated therewith the first value ("0"), and simultaneously a digital differential value ($D_S(k-1)$) of the third sequence of differential values, preceding this digital differential value ($D_S(k)$), and a digital differential value ($D_{Pix}(k-1)$) of the second sequence of differential values, corresponding in sequence to the same, have associated therewith the same value; and

determining a second transition of the indirect zero crossing ($D_{Zi01}$ = 1 or $D_{Zi01}$ = -1) in the third sequence of digital differential values ($D_S$), wherein a second transition of indirect zero crossing is detected when

a digital differential value ($D_{Pix}(k-1)$) of the second sequence of differential values, preceding this digital differential value ($D_S(k)$) of the third sequence of differential values, corresponding to the digital differential value ($D_S(k-1)$) of the third sequence of differential values, has associated therewith the first value ("0"); and simultaneously, a digital differential value ($D_S(k-1)$) of the third sequence of differential values, preceding this digital differential value ($D_S(k)$), and a digital differential value ($D_{Pix}(k)$) of the second sequence of differential values, corresponding in sequence to the former, have associated therewith the same value.

**32.** Method according to claim 31, comprising:

raising a zero crossing counter ($D_{SumZ}$) when a direct zero crossing or an indirect zero crossing of two subsequent transitions is detected;
determining a digital differential value ($D_{Pix}$) of the second sequence of differential values with a middle position with regard to a first zero crossing and a last zero crossing on the second sequence of differential values ($D_{Pix}$); and
determining the position of the maximum of the envelope based on the position of the digital differential value ($D_{Pix}$) of the second sequence ($D_{Pix}$) of differential values with the middle position.

**33.** Method according to any one of the claims 26 to 32, wherein the first value is "0", the second value is "+1" and the third value is "-1".

**34.** Method according to any one of the claims 26 to 33, wherein the upper threshold value ($I_{Sp}$) is a positive value and a lower threshold value ($I_{Sn}$) is a negative threshold value.

**35.** Method (160) according to any one of the claims 26 to 34, wherein sampling and
creating the first sequence occurs in a pixel cell (100), amongst
creating (162) of a first measurement current ($I_{DPh1}$) by a photographic sensor (110) in dependence of a radiation in a first measurement cycle;
applying (164) a current ($I_{M1}$) in a current storage device (120; SI-Mem) in a first separation mode in dependence of the first measurement current ($I_{DPh1}$) to hold the applied current ($I_{M1}$) in a second operating mode such that the applied currents at the output node (104) is detectable;
creating (166) a second measurement current ($I_{DPh2}$) by the photographic sensor (110) in dependence of a radiation in a second measurement cycle;

holding (168) the applied current ($I_{M1}$) in a second operating mode by the current storage device (120);

forming (170) a difference of the applied current ($I_{M1}$) and the second measurement current ($I_{DPh2}$) in a read-out cycle at the output node (104);

coupling (172) the output node with the output (102).

**36.** Computer program having a program code stored thereon for performing a method according to any one of the claims 14 to 35 when the computer program runs on a computer.

**Revendications**

**1.** Dispositif (3100) de détermination de la quantité de charge ($Q_{Pix}$) sur un élément capacitif, avec

un moyen (3100, $A_1$) destiné à comparer (3112) une tension ($V_{Pix}$) à l'élément capacitif ($C_{L1}$) avec une tension de référence ($V_{Comp}$) et à déterminer si la tension ($V_{Pix}$) est supérieure ou inférieure à la tension de référence ($V_{Comp}$);

un moyen (3120; QSrc) destiné à provoquer une alimentation/ évacuation (3122) de charge vers/de l'élément capacitif ($C_{L1}$) de manière itérative au moyen de paquets de charge en fonction de la comparaison, de sorte qu'une différence entre la tension ($V_{Pix}$) à l'élément capacitif ($C_{L1}$) et la tension de référence ($V_{Comp}$) devienne plus faible, où le moyen (3120; QSrc) destiné à provoquer est conçu pour provoquer une alimentation/évacuation de charge vers/de l'élément capacitif ($C_{L1}$) pour réduire la tension à l'élément capacitif ($C_{L1}$) lorsque la tension à l'élément capacitif ($C_{L1}$) est supérieure à la tension de référence, et pour provoquer une alimentation/évacuation de charge vers/de l'élément capacitif ($C_{L1}$) pour augmenter la tension à l'élément capacitif ($C_{L1}$) lorsque la tension à l'élément capacitif ($C_{L1}$) est inférieure à la tension de référence; et

un moyen (3130; Control) destiné à conclure de la charge ($Q_{Pix}$) sur l'élément capacitif ($C_{L1}$) sur base de l'alimentation/évacuation de charge (3122) et de la comparaison de la tension (3112), et ce sur base d'un nombre de paquets de charge qui sont évacués/alimentés dans le cadre de l'alimentation/évacuation de charge itérative (3122).

**2.** Dispositif selon la revendication 1, dans lequel le moyen (3130; Control) destiné à conclure est conçu pour détecter, lors de la comparaison de la tension ($V_{Pix}$) à l'élément capacitif ($C_{L1}$) et la tension de référence ($V_{Comp}$), un changement de signe par rapport une comparaison précédente de ces dernières, et pour déterminer, sur base d'une quantité de charge qui a été alimentée/évacuée vers/de l'élément capacitif jusqu'à la détection d'un changement de signe, la quantité de charge ($Q_{Pix}$) sur l'élément capacitif ($C_{L1}$).

**3.** Dispositif selon la revendication 1 ou 2, dans lequel une quantité de charge d'un paquet de charge est définie par une intensité de courant du paquet de charge et une durée du paquet de charge.

**4.** Dispositif selon l'une des revendications 1 à 3, qui réalise une conversion analogique-numérique de charge, et le dispositif destiné à conclure (3130; Control) est conçu pour déterminer une valeur numérique (3132; $D_{out}$) correspondant à la charge sur l'élément capacitif ($C_{L1}$).

**5.** Dispositif selon la revendication 3 ou 4, dans lequel le moyen (3120; QSrc) destiné à provoquer une alimentation/évacuation de charge est conçu pour alimenter/évacuer des paquets de charge à quantité de charge constante; et le moyen destiné à conclure (3130; Control) est conçu pour compter le nombre de paquets de charge à quantité de charge constante et pour déterminer la quantité de charge ($Q_{Pix}$) sur l'élément capacitif ($C_{L1}$) sur base du nombre de paquets de charge.

**6.** Dispositif selon la revendication 5, dans lequel le moyen (3120; 30 QSrc) destiné à provoquer une alimentation/évacuation de charge est conçu pour alimenter/évacuer des paquets de charge à quantité de charge variable; et le moyen (3130; Control) destiné à conclure est conçu pour compter le nombre de paquets de charge et pour déterminer la quantité de charge ($Q_{Pix}$) sur l'élément capacitif ($C_{L1}$) sur base du nombre de paquets de charge et des quantités de charge correspondantes.

**7.** Dispositif selon la revendication 6, dans lequel le moyen (3120; QSrc) destiné à provoquer une alimentation/évacuation de charge est conçu pour alimenter vers/évacuer de l'élément capacitif ($C_{L1}$) des paquets de charge à quantité de charge échelonnée de manière binaire, et est par ailleurs conçu pour commencer par un paquet de charge à la quantité de charge échelonnée de manière binaire et pour alimenter/évacuer, dans une étape suivante, un paquet de charge à la quantité de charge échelonnée de manière binaire immédiatement inférieure; et le moyen destiné à conclure (3130; Control) est conçu pour additionner ou soustraire une valeur numérique correspondant à la quantité de charge respective, pour déterminer une valeur numérique (3132; $D_{out}$) correspondant

à la charge sur l'élément capacitif ($C_{L1}$).

**8.** Dispositif selon la revendication 7, dans lequel le moyen (3120; QSrc) destiné à provoquer une alimentation/évacuation de charge est conçu pour alimenter/évacuer des paquets de charge à une première quantité de charge, jusqu'à ce que le moyen (3130; Control) destiné à conclure détecte un changement de signe, pour alimenter/évacuer alors des paquets de charge à une deuxième quantité de charge qui est inférieure à la première quantité de charge, dans lequel le dispositif destiné à provoquer est conçu pour évacuer des paquets de charge à la deuxième quantité de charge lorsqu'il a auparavant été alimenté un paquet de charge à la première quantité de charge, et inversement.

**9.** Dispositif selon l'une des revendications 1 à 8, dans lequel le moyen (3120; QSrc) destiné à provoquer une alimentation/ évacuation de charge présente au moins une pompe de charge.

**10.** Dispositif selon l'une des revendications 1 à 9, dans lequel le moyen (3120; QSrc) destiné à provoquer une alimentation/ évacuation de charge présente au moins une cellule d'accumulation de courant (SI-Mem).

**11.** Dispositif (3400) de traitement de signal sur base de charge, avec:

un élément capacitif ($C_{L1}$, L1);
un premier capteur de charge (3410);
un deuxième capteur de charge (3420);
une commande de capteurs de charge (3430) destinée à coupler le premier capteur de charge (3410) et/ou le deuxième capteur de charge (3420) à l'élément capacitif ($C_{L1}$, L1);

un dispositif (3100) destiné à déterminer une quantité de charge ($Q_{Pix}$) sur l'élément capacitif ($C_{L1}$, L1) selon l'une des revendications 1 à 10.

**12.** Dispositif (3500) de traitement de signal sur base de charge, avec:

une première ligne (L1; $C_{L1}$);
une deuxième ligne (L2; $C_{L2}$);
un moyen pour régler la deuxième ligne (L2; $C_{L2}$) à une tension prédéterminée ($V_{PixRef}$); avec:

un moyen (3110, A1) destiné à comparer une tension (3204) à la deuxième ligne (L2) avec une tension de référence ($V_{Comp}$);
un élément capacitif intérieur (3240; $C_{L2}'$);
un étage d'attaque (3242; $A_2$), où la deuxième ligne (L2; $C_{L2}$) est couplée à une sortie de l'étage d'attaque (3242; $A_2$), et l'élément capacitif intérieur ($C_{L2}'$) est couplé à une entrée de l'étage d'attaque (3242; $A_2$);
un moyen (3120; QSrc) destiné à provoquer une alimentation/évacuation de charge (3122) vers/de l'élément capacitif ($C_{L2}'$) jusqu'à ce que la comparaison (3112) indique que la tension à la deuxième ligne (L2; $C_{L2}$) correspond à la tension prédéterminée ($V_{PixRef}$);

un premier capteur de charge (3410) avec un noeud de sortie (3412);
un deuxième capteur de charge (3420) avec un noeud de sortie (3422);
une commande de capteurs de charge (3430) destinée à coupler un noeud de sortie (3412) du premier capteur de charge (3410) et/ou un noeud de sortie (3422) du deuxième capteur de charge (3420) à la première ligne (L1; $C_{L1}$) et/ou à la deuxième ligne (L2; $C_{L2}$); et

un dispositif (3100) destiné à déterminer une quantité de charge ($Q_{pix}$) sur la première ligne (L1; $C_{L1}$) selon l'une des revendications 1 à 10.

**13.** Dispositif de traitement de signal sur base de charge, avec:

une première ligne (L1; $C_{L1}$);
une deuxième ligne (L2; $C_{L2}$);
un premier capteur de charge (3410) avec un noeud de sortie (3412);
un deuxième capteur de charge (3420) avec un noeud de sortie (3422);
une commande de capteurs de charge (3430) destinée à coupler un noeud de sortie (3412) du premier capteur de charge (3410) et/ou un noeud de sortie (3422) du deuxième capteur de charge (3420) à la première ligne (L1; $C_{L1}$) et/ou à la deuxième ligne (L2; $C_{L2}$); et

un dispositif (3100) destiné à déterminer une quantité de charge ($Q_{Pix}$) sur la première ligne (L1; $C_{L1}$) selon l'une des revendications 1 à 10; et

un moyen destiné à régler la deuxième ligne (L2; $C_{L2}$) à une tension de la première ligne (L1; $C_{L1}$).

14. Procédé (3260) de détermination de la quantité de charge ($Q_{Pix}$) sur un élément capacitif ($C_{L1}$), avec le fait de comparer (3162) une tension ($V_{Pix}$) à l'élément capacitif ($C_{L1}$) avec une tension de référence ($V_{Comp}$) pour déterminer si la tension ($V_{Pix}$) est supérieure ou inférieure à la tension de référence ($V_{Comp}$); provoquer (3164) une alimentation/évacuation de charge (3122) vers/de l'élément capacitif ($C_{L1}$), et ce de manière itérative au moyen de paquets de charge en fonction de la comparaison, de sorte qu'une différence entre la tension ($V_{Pix}$) à l'élément capacitif ($C_{L1}$) et la tension de référence ($V_{Comp}$) devienne plus faible, où une alimentation/évacuation de charge vers/de l'élément capacitif ($C_{L1}$) est provoquée pour réduire la tension à l'élément capacitif ($C_{L1}$) lorsque la tension à l'élément capacitif ($C_{L1}$) est supérieure à la tension de référence, et une alimentation/évacuation de charge vers/de l'élément capacitif ($C_{L1}$) est provoquée pour augmenter la tension à l'élément capacitif ($C_{L1}$) lorsque la tension à l'élément capacitif ($C_{L1}$) est inférieure à la tension de référence; et
conclure (3166) de la charge ($Q_{Pix}$) sur l'élément capacitif ($C_{L1}$) sur base de l'alimentation/évacuation de charge (3122) et de la comparaison de la tension (3112), et ce sur base d'un nombre des paquets de charge qui sont alimentés/évacués dans le cadre de l'alimentation/évacuation de charge itérative (3122).

15. Procédé (3560) de traitement de signal sur base de charge, dans lequel une deuxième ligne (L2; $C_{L2}$) est couplée à une sortie d'un étage d'attaque (3242; $A_2$) et un élément capacitif intérieur ($C_{L2}'$) est couplé à une entrée de l'étage d'attaque (3242; $A_2$), avec:

un procédé de réglage (3260) de la deuxième ligne (L2; $C_{L2}$) à une tension prédéterminée ($V_{PixRef}$), où le réglage de la deuxième ligne comporte le fait de:

comparer (3162) une tension (3204) à la deuxième ligne (L2; $C_{L2}$) avec une tension de référence ($V_{Comp}$); provoquer (3262) une alimentation/évacuation de charge vers/de l'élément capacitif intérieur (3240; $C_{L2}'$) jusqu'à ce que la comparaison indique que la tension à la deuxième ligne (L2; $C_{L2}$) correspond à la tension prédéterminée ($V_{PixRef}$);

coupler (3562) un noeud de sortie (3412) d'un premier capteur de charge (3410) et/ou un noeud de sortie (3422) d'un deuxième capteur de charge (3420) à la première ligne (L1; $C_{L1}$); et

un procédé de détermination (3160) d'une quantité de charge ($V_{Pix}$) à la première ligne (L1; $C_{L1}$) selon la revendication 14.

16. Procédé de traitement de signal sur base de charge, dans lequel une deuxième ligne (L2; $C_{L2}$) est couplée à une sortie d'un étage d'attaque (3242; $A_2$) et un élément capacitif intérieur ($C_{L2}'$) est couplé à une entrée de l'étage d'attaque (3242; $A_2$), avec le fait de:

coupler (3562) un noeud de sortie (3412) d'un premier capteur de charge (3410) et/ou un noeud de sortie (3422) d'un deuxième capteur de charge (3420) à la première ligne (L1; $C_{L1}$); et

un procédé de détermination (3160) d'une quantité de charge ($V_{Pix}$) sur la première ligne (L1; $C_{L1}$) selon la revendication 14; et

régler la deuxième ligne (L2; $C_{L2}$) à une tension de la première ligne (L1; $C_{L1}$).

17. Procédé (200) de détermination d'une position d'un maximum d'une courbe d'enveloppe d'un signal modulé en amplitude analogique à l'aide d'un dispositif selon la revendication 14, avec le fait de:

balayer (202) le signal modulé en amplitude, pour générer une séquence de valeurs de balayage analogiques; générer (204) une séquence de valeurs de différence analogiques, où une valeur de différence analogique de la séquence de valeurs de différence analogiques est basée sur une différence entre deux valeurs de balayage analogiques successives de la séquence de valeurs de balayage analogiques;

numériser (206) les valeurs de différence analogiques, pour générer une séquence de valeurs de différence numériques ($D_{Pix}$); et

déterminer (208) la position du maximum de la courbe d'enveloppe sur base de la séquence de valeurs de différence numériques ($D_{Pix}$).

18. Procédé selon la revendication 17, dans lequel le signal modulé en amplitude est un signal modulé en amplitude dans le temps, et le balayage génère une séquence temporelle de valeurs de balayage analogiques.

19. Procédé selon la revendication 17, dans lequel le signal modulé en amplitude est un signal modulé en amplitude dans l'espace, et le balayage génère une séquence spatiale de valeurs de balayage analogiques.

20. Procédé selon l'une des revendications 17 à 19, dans lequel la détermination de la position du maximum est basée sur une détermination d'un nombre d'une séquence de passages à zéro ($D_{SumZ}$) de la séquence de valeurs de différence numériques ($D_{Pix}$).

21. Procédé selon la revendication 20, dans lequel, lors de la détermination du nombre de passages à zéro ($D_{SumZ}$), seule une partie de la séquence de valeurs de différence numériques ($D_{Pix;}$ $I_{Pix}$) est prise en compte, où la partie de la séquence de valeurs de différence numériques ($D_{Pix}$) commence par une première valeur différentielle numérique de la séquence de valeurs de différence ($I_{Pix;}$ $D_{Pix}$) dont la valeur est supérieure à une valeur de seuil supérieure ($I_{Sp}$) ou inférieure à une valeur de seuil inférieure ($I_{Sn}$), et dans lequel la partie de la séquence de valeurs de différence numériques ($I_{Pix}$) se termine par une dernière valeur de différence numérique dont la valeur est supérieure à la valeur de seuil supérieure ($I_{Sp}$) ou inférieure à la valeur de seuil inférieure ($I_{Sn}$).

22. Procédé selon l'une des revendications 20 ou 21, dans lequel la position du maximum de la courbe d'enveloppe est déterminée comme une position d'un passage à zéro central de la séquence de passages à zéro.

23. Procédé selon l'une des revendications 19 à 22, dans lequel la numérisation présente l'étape suivante consistant à:

générer la séquence ($D_{Pix}$) de valeurs de différence numériques ($D_{Pix}$) sur base de la séquence de valeurs de différence analogiques, de sorte que à une valeur numérique ($D_{Pix}$) de la séquence de valeurs de différence numériques ($D_{Pix}$) soit associée une première valeur ("0") lorsqu'une valeur de différence analogique correspondante de la séquence de valeurs de différence analogiques ou une version pré-numérisée ($I_{Pix}$) de cette dernière est inférieure à une valeur de seuil supérieure ($I_{Sp}$) et est supérieure à une valeur de seuil inférieure ($I_{Sn}$), à une valeur numérique ($D_{Pix}$) de la séquence de valeurs de différence numériques ($D_{Pix}$) soit associée une deuxième valeur ("+1") lorsqu'une valeur de différence analogique correspondante de la séquence de valeurs de différence analogiques ou une version pré-numérisée ($I_{Pix}$) de cette dernière est supérieure à la valeur de seuil supérieure ($I_{Sp}$), et à une valeur numérique ($D_{Pix}$) la séquence de valeurs de différence numériques ($D_{Pix}$) soit associée une troisième valeur ("-1") lorsqu'une valeur de différence analogique correspondante de la séquence de valeurs de différence analogiques ou une version pré-numérisée ($I_{Pix}$) de cette dernière est inférieure à la valeur de seuil inférieure ($I_{SP}$).

24. Procédé selon l'une des revendications 17 à 23, dans lequel la numérisation comporte l'étape suivante consistant à:

pré-numériser les valeurs de différence analogiques, pour générer une première séquence de valeurs de différence numériques ($I_{Pix}$); et

générer une deuxième séquence ($D_{Pix}$) de valeurs de différence numériques ($D_{Pix}$) comme séquence de valeurs de différence numériques ($D_{Pix}$) sur base de la première séquence de valeurs de différence numériques ($I_{Pix}$), où à une valeur numérique ($D_{Pix}$) de la deuxième séquence de valeurs de différence numériques ($D_{Pix}$) est associée une première valeur ("0") lorsqu'une valeur de différence numérique correspondante ($I_{-Pix}$) de la première séquence de valeurs de différence ($I_{Pix}$) est inférieure à une valeur de seuil numérique supérieure ($I_{Sp}$) et supérieure à une valeur de seuil numérique inférieure ($I_{Sn}$), à une valeur numérique ($D_{Pix}$) de la deuxième séquence de valeurs de différence numériques ($D_{Pix}$) est associée une deuxième valeur ("+1") lorsqu'une valeur de différence numérique correspondante ($I_{-Pix}$) de la première séquence de valeurs de différence ($I_{Pix}$) est supérieure à une valeur de seuil numérique supérieure ($I_{Sp}$), et à une valeur numérique ($D_{Pix}$) de la deuxième séquence de valeurs de différence numériques ($D_{Pix}$) est associée une troisième valeur ("-1") lorsqu'une valeur de différence numérique correspondante ($I_{-Pix}$) de la première séquence de valeurs de différence ($I_{Pix}$) est inférieure à une valeur de seuil numérique inférieure ($I_{Sp}$).

25. Procédé selon l'une des revendications 17 à 24, dans lequel le balayage et la génération ont lieu dans une cellule de pixels (100), et ce tout en
générant (162) un premier courant de mesure ($I_{DPh1}$) par un photo-détecteur (110) en fonction d'un rayonnement dans un premier cycle de mesure;
imprimant (164) un courant ($I_{M1}$) dans un dispositif d'accumulation de courant (120; SI-Mem) dans un premier mode de fonctionnement, en fonction du premier courant de mesure ($I_{DPh1}$), pour maintenir, dans un deuxième mode de fonctionnement, le courant imprimé ($I_{M1}$), de sorte que le courant imprimé puisse être détecté au noeud de sortie (104);
générant (166) un deuxième courant de mesure ($I_{DPh2}$) par le photo-détecteur (110) en fonction d'un rayonnement dans un deuxième cycle de mesure;
maintenant (168) le courant imprimé ($I_{M1}$) dans un deuxième mode de fonctionnement par le dispositif d'accumulation de courant (120);
formant (170) une différence entre le courant imprimé ($I_{M1}$) et le deuxième courant de mesure ($I_{DPh2}$) dans un cycle de lecture au noeud de sortie (104);
couplant (172) le noeud de sortie à la sortie (102).

26. Procédé selon la revendication 17, dans lequel la numérisation (206) des valeurs de différence analogiques pour générer une séquence de valeurs de différence numériques ($D_{Pix}$) présente les étapes suivantes consistant à:

générer une première séquence de valeurs de différence numériques ($I_{Pix}$), où une valeur différentielle numérique ($I_{Pix}$) de la première séquence de valeurs de différence numériques est basée sur une différence entre deux valeurs de balayage analogiques successives de la séquence de valeurs de balayage analogiques;
générer une deuxième séquence ($D_{Pix}$) de valeurs de différence numériques ($D_{Pix}$) sur base de la première séquence de valeurs de différence numériques ($I_{Pix}$), où
à une valeur numérique ($D_{Pix}$) de la deuxième séquence de valeurs de différence numériques ($D_{Pix}$) est associée une première valeur ("0") lorsqu'une valeur de différence numérique correspondante ($I_{-Pix}$) de la première séquence de valeurs de différence ($I_{Pix}$) est inférieure à une valeur de seuil numérique supérieure ($I_{Sp}$) et supérieure à une valeur de seuil numérique inférieure ($I_{Sn}$),
à une valeur numérique ($D_{Pix}$) de la deuxième séquence de valeurs de différence numériques ($D_{Pix}$) est associée une deuxième valeur ("+1") lorsqu'une valeur de différence numérique correspondante ($I_{-Pix}$) de la première séquence de valeurs de différence ($I_{Pix}$) est supérieure à une valeur de seuil numérique supérieure ($I_{Sp}$), et
à une valeur numérique ($D_{Pix}$) de la deuxième séquence de valeurs de différence numériques ($D_{Pix}$) est associée une troisième valeur ("-1") lorsqu'une valeur de différence numérique correspondante ($I_{-Pix}$) de la première séquence de valeurs de différence ($I_{Pix}$) est inférieure à une valeur de seuil numérique inférieure ($I_{Sp}$).

27. Procédé selon la revendication 26, avec le fait de:

générer une troisième séquence de valeurs de différence numériques ($D_{PixM}$) sur base de la deuxième séquence de valeurs de différence numériques (Dpix), où
à une première valeur de différence numérique ($D_{PixM}$) de la troisième séquence est associée la première valeur ("0"),
à une valeur de différence numérique ($D_{PixM}(k)$) de la troisième séquence de valeurs de différence est associée la valeur d'une valeur de différence numérique correspondante ($D_{Pix}(k)$) dans la séquence de la deuxième séquence lorsqu'à cette dernière n'est pas associée la première valeur ("différent de 0"), et
à une valeur de différence ($D_{PixM}(k)$) de la troisième séquence de valeurs de différence numériques est associée une valeur de différence numérique ($D_{Pix}$) de la deuxième séquence de valeurs de différence numériques d'une valeur de différence numérique précédente ($D_{Pix}(k-1)$) de la deuxième séquence lorsqu'à la valeur de différence numérique ($D_{Pix}(k)$) de la deuxième séquence de valeurs de différence numériques correspondant à la valeur de différence ($D_{PikM}(k)$) de la troisième séquence de valeurs de différence numériques dans la séquence est associée la première valeur ("0").

28. Procédé selon la revendication 27, avec le fait de
déterminer un passage à zéro ($D_z$ = +/-1) dans la troisième séquence de valeurs de différence numériques ($D_{PixM}$), où un passage à zéro ($D_z$ = +/- 1) est détecté lorsque, dans la troisième séquence de valeurs de différence numériques ($D_{PixM}$), deux valeurs de différence numériques successives ($D_{PixM}(k-1)$, $D_{PixM}(k)$) présentent des valeurs différentes.

**29.** Procédé selon la revendication 28, avec le fait de
incrémenter un compteur de passages à zéro (Dsumz) quand un passage à zéro ($D_z$ = +/- 1) est détecté;
déterminer une valeur de différence numérique ($D_{PixM}$) de la troisième séquence de valeurs de différence à une position centrale par rapport à un premier passage à zéro et un dernier passage à zéro de la troisième séquence de valeurs de différence ($D_{PixM}$); et
déterminer la position du maximum de la courbe d'enveloppe sur base de la position de la valeur de différence numérique ($D_{PixM}$) de la troisième séquence de valeurs de différence à la position centrale.

**30.** Procédé selon la revendication 29, avec le fait de
générer une troisième séquence de valeurs de différence numériques ($D_S$) sur base de la deuxième séquence de valeurs de différence numériques ($D_{Pix}$), où
à une valeur de différence numérique ($D_S(k)$) de la troisième séquence de valeurs de différence est associée la deuxième valeur ("+1") lorsqu'une différence entre une valeur de différence numérique ($D_{Pix}(k)$) de la deuxième séquence de valeurs de différence numériques ($D_{Pix}$) correspondant à la valeur de différence numérique ($D_S(k)$) de la troisième séquence de valeurs de différence dans la séquence et une valeur de différence numérique précédant cette dernière ($D_{Pix}(k-1)$) de la deuxième séquence de valeurs de différence numériques ($D_{Pix}$) est supérieure à zéro,
à une valeur de différence numérique ($D_S(k)$) de la troisième séquence de valeurs de différence est associée la troisième valeur ("-1") lorsqu'une différence entre une valeur de différence numérique ($D_{Pix}(k)$) de la deuxième séquence de valeurs numériques de différence ($D_{Pix}$) correspondant à la valeur de différence numérique ($D_S(k)$) de la troisième séquence de valeurs de différence dans la séquence et une valeur différentielle numérique ($D_{Pix}(k-1)$) de la deuxième séquence de valeurs de différence numériques ($D_{Pix}$) précédant cette dernière est inférieure à zéro, et
à une valeur de différence ($D_S(k)$) de la troisième séquence de valeurs de différence numériques est associée une valeur de différence numérique ($D_S(k-1)$) de la troisième séquence précédant cette dernière lorsqu'à une valeur de différence numérique ($D_{Pix}(k)$) de la deuxième séquence de valeurs de différence numériques ($D_{Pix}$) correspondant à la valeur de différence numérique ($D_S(k)$) de la troisième séquence de valeurs de différence dans la séquence est associée la même valeur qu'à une valeur de différence numérique ($D_{Pix}(k-1)$) de la deuxième séquence de valeurs de différence numériques ($D_{Pix}$) précédant cette dernière.

**31.** Procédé selon la revendication 30, avec le fait de:

déterminer un passage à zéro direct ($D_{Zd}$ = 1 ou $D_{Zd}$ = -1) dans la troisième séquence de valeurs de différence numériques ($D_{Pix}$), où un passage à zéro direct est détecté lorsque

dans la deuxième séquence de valeurs de différence numériques ($D_{Pix}$), deux valeurs de différence numériques successives ($D_{Pix}(k-1)$, $D_{Pix}(k)$) présentent des valeurs différentes et qu'à la valeur de différence numérique précédente ($D_{Pix}(k-1)$) n'est pas associée la première valeur ("0");

déterminer une première transition du passage à zéro indirect ($D_{Zi10}$ = 1 ou $D_{Zi10}$ = -1) dans la troisième séquence de valeurs de différence numériques ($D_S$), où une première transition du passage à zéro indirect est détectée lorsque

à une valeur de différence numérique ($D_{Pix}(k)$) de la deuxième séquence de valeurs de différence numériques ($D_{Pix}$) correspondant à la valeur de différence numérique ($D_S(k)$) de la troisième séquence est associée la première valeur ("0"), et qu'en même temps
à une valeur de différence numérique ($D_S(k-1)$) de la troisième séquence de valeurs de différence précédant cette valeur de différence numérique ($D_S(k)$) et à une valeur de différence numérique ($D_{Pix}(k-1)$) de la deuxième séquence de valeurs de différence correspondant à cette dernière dans la séquence est associée la même valeur; et

déterminer une deuxième transition du passage à zéro indirect ($D_{Zi01}$ = 1 ou $D_{Zi01}$ = -1) dans la troisième séquence de valeurs de différence numériques ($D_S$), où une deuxième transition du passage à zéro indirect est détectée lorsque

à une valeur de différence numérique ($D_{Pix}(k-1)$) de la deuxième séquence de valeurs de différence correspondant à une valeur de différence numérique ($D_S(k-1)$) précédant cette valeur de différence numérique ($D_S(k)$) de la troisième séquence de valeurs de différence est associée la première valeur ("0"); et
simultanément, à une valeur de différence numérique ($D_S(k-1)$) de la troisième séquence de valeurs de différence précédant cette valeur de différence numérique ($D_S$(k)) et à une valeur de différence numérique ($D_{Pix}$(k)) de la deuxième séquence de valeurs de différence correspondant à cette dernière dans la séquence est associée la même valeur.

32. Procédé selon la revendication 31, avec le fait de

incrémenter un compteur de passages à zéro ($D_{SumZ}$) lorsqu'il est détecté un passage à zéro direct ou un passage à zéro indirect à partir de deux transitions successives;

déterminer une valeur de différence numérique ($D_{Pix}$) de la deuxième séquence de valeurs de différence avec une position centrale par rapport à un premier passage à zéro et un dernier passage à zéro de la deuxième séquence de valeurs de différence ($D_{Pix}$); et

déterminer la position du maximum de la courbe d'enveloppe sur base de la position de la valeur de différence numérique ($D_{Pix}$) de la deuxième séquence ($D_{Pix}$) de valeurs de différence avec la position centrale.

33. Procédé selon l'une des revendications 26 à 32, dans lequel la première valeur est "0", la deuxième valeur est "+1", et la troisième valeur est "-1".

34. Procédé selon l'une des revendications 26 à 33, dans lequel la valeur de seuil supérieure ($I_{Sp}$) est une valeur positive et la valeur de seuil inférieure ($I_{Sn}$) est une valeur de seuil négative.

35. Procédé (160) selon l'une des revendications 26 à 34, dans lequel le balayage et la génération de la première séquence ont lieu dans une cellule de pixels (100), et ce tout en

générant (162) un premier courant de mesure ($I_{DPh1}$) par un photo-détecteur (110) en fonction d'un rayonnement dans un premier cycle de mesure;

imprimant (164) un courant ($I_{M1}$) dans un dispositif d'accumulation de courant (120; SI-Mem) dans un premier mode de fonctionnement, en fonction du premier courant de mesure ($I_{DPh1}$), pour maintenir, dans un deuxième mode de fonctionnement, le courant imprimé ($I_{M1}$), de sorte que le courant imprimé puisse être détecté au noeud de sortie (104);

générant (166) un deuxième courant de mesure ($I_{DPh2}$) par le photo-détecteur (110) en fonction d'un rayonnement dans un deuxième cycle de mesure;

maintenant (168) le courant imprimé ($I_{M1}$) dans un deuxième mode de fonctionnement par le dispositif d'accumulation de courant (120);

formant (170) une différence entre le courant imprimé ($I_{M1}$) et le deuxième courant de mesure ($I_{DPh2}$) dans un cycle de lecture au noeud de sortie (104);

couplant (172) le noeud de sortie à la sortie (102).

36. Programme d'ordinateur avec un code de programme pour réaliser un procédé selon l'une des revendications 14 à 35 lorsque le programme d'ordinateur est exécuté sur un ordinateur.

FIG 1

FIG 2

FIG 3

FIG 4A

FIG 4B

FIG | FIG
4A | 4B

**FIG 5**

FIG 6

70

(a)

(b)

FIG 7

$I_{Ref}$

$I_{Out}$

$V_{Out}$

$T_{Ref1}$

$T_1$

## FIG 8

$I_{Ref}$

$I_{Out}$

$V_{Out}$

②

$T_{Ref2}$

$T_2$

①

$T_{Ref1}$

$T_1$

## FIG 9

FIG 10

$I_{Ref}$

$I_{Out}$

$S_{1b}$

$S_2$

$S_{1a}$

$T_M$

$C_M$

FIG 11

FIG 12

FIG 13A

FIG 13B

FIG 14

FIG 15

EP 1 962 493 B1

**FIG 16**

EP 1 962 493 B1

FIG 17

(a)

(b)

FIG 18

FIG 19

FIG 20

FIG 21

FIG 22

FIG 23

Referenzebene

Referenzobjekt

⑤ $x_r$

②

Graufilter und
Kompensation

Messobjekt

Lichtquelle

①

③

Strahlteiler

$x'_r$

virtuelle
Referenzebene

④

Blende

telezentrische Optik

Bildsensor

FIG 24

FIG 25

FIG 26

**FIG 27**

FIG 28

FIG 29

FIG 30

## FIG 31A

**FIG 31B**

FIG 32

(a)

EP 1 962 493 B1

FIG 33

FIG 34

EP 1 962 493 B1

**FIG 35A**

**FIG 35B**

FIG 36

FIG 37

FIG 38

110

130

102

104

120

100

FIG 39A

Erzeugen eines ersten Messstroms ($I_{DPh1}$) in einem ersten Messzyklus; ──162

Einprägen eines Stroms ($I_{M1}$) in einer Stromspeichervorrichtung (120; SI-Mem) ──164

Erzeugen eines zweiten Messstroms ($I_{DPh2}$) in einem zweiten Messzyklus ──166

Halten des eingeprägten Stroms ($I_{M1}$) durch die Stromspeichervorrichtung (120) ──168

Bilden einer Differenz des eingeprägten Stroms ($I_{M1}$) und des zweiten Messstroms an dem Ausgangsknoten (104) ──170

Koppeln des Ausgangsknotens (104) mit dem Ausgang (102) ──172

<u>160</u>

# FIG 39B

Erzeugen eines Messstroms ($I_{DPh}$) in einem Messzyklus; ~182

Einprägen eines Stroms ($I_M$) in einer Stromspeichervorrichtung (120; SI-Mem) ~184

Bilden (184) des eingeprägten Stroms ($I_M$) mit umgekehrtem Vorzeichen an dem Ausgangsknoten (104) ~186

Koppeln des Ausgangsknotens (104) mit dem Ausgang (102) ~172

<u>180</u>

# FIG 39C

Abtasten des amplitudenmodulierten Signals, um eine Folge von analogen Abtastwerten zu erzeugen — 202

Erzeugen einer Folge von analogen Differenzwerten basierend auf der Folge von analogen Abtastwerten — 204

Digitalisieren der analogen Differenzwerte, um eine Folge von digitalen Differenzwerten ($D_{Pix}$) zu erzeugen — 206

Bestimmen der Position des Maximums der Hüllkurve basierend auf der Folge von digitalen Differenzwerten ($D_{Pix}$) — 208

200

# FIG 40

FIG 41A

Vergleichen einer Spannung ($V_{Pix}$)
an dem kapazitiven Element ($C_{L1}$)
mit einer Referenzspannung ($V_{comp}$)

3162

Bewirken einer Ladungszufuhr/-Abfuhr (3122)
zu/von dem kapazitiven Element ($C_{L1}$)

3164

Rückschließen auf die Ladung ($Q_{Pix}$)
auf dem kapazitiven Element ($C_{L1}$)
auf Basis der Ladungszufuhr/-Abfuhr (3122)
und dem Vergleich der Spannung (3112)

3166

3160

# FIG 41B

FIG 41C

Vergleichen einer Spannung (3204)
an dem Schaltungsknoten (3202; L1)
mit einer Referenzspannung ($V_{comp}$) — 3162

Bewirken einer Ladungszufuhr/-Abfuhr (3122)
zu/von dem Schaltungsknoten (3202; L1)
bis der Vergleich (3112) ergibt, dass die
Spannung an dem Schaltungsknoten (3204)
eine vorbestimmte Beziehung (3114)
zu der vorbestimmten Spannung ($V_{PixRef}$) aufweist — 3264

# FIG 41D

FIG 41E

Vergleichen (3162) einer Spannung (3204) an dem Schaltungsknoten (3204, L1, $C_{L1}$) mit einer Referenzspannung ($V_{comp}$) — 3162

Bewirken (3264´) einer Ladungszufuhr/-Abfuhr (3122) zu/von dem inneren kapazitiven Element (3240; $C_{L2}'$) bis der Vergleich ergibt, dass die Spannung an dem Schaltungsknoten (3204, L1, $C_{L1}$) eine vorbestimmte Beziehung (3114) zu der vorbestimmten Spannung ($V_{PixRef}$) aufweist — 3264´

3260´

## FIG 41F

FIG 41G

Vergleichen einer Spannung ($V_{Pix}$)
an dem kapazitiven Element ($C_{L1}$, L1)
mit einer Referenzspannung ($V_{comp}$) —— 3162

Bewirken einer Ladungszufuhr/-Abfuhr (3122)
zu/von dem kapazitiven Element ($C_{L1}$, L1) —— 3164

Rückschließen auf die Ladung
auf dem kapazitiven Element ($C_{L1}$, L1)
auf Basis der Ladungszufuhr/-Abfuhr (3122)
und dem Vergleich der Spannung (3112) —— 3166

einem Verfahren (3260) zum Setzen
des kapazitiven Elements ($C_{L1}$, L1) auf eine
vorbestimmte Spannung ($V_{PixRef}$) —— 3260

3360

# FIG 41H

FIG 41I

Koppeln des ersten Ladungsgebers (3410)
und/oder zweiten Ladungsgebers (3420)
mit dem kapazitiven Element ($C_{L1}$, L1)

~3462

einem Verfahren zum Bestimmen einer
Ladungsmenge ($Q_{pix}$) auf dem
kapazitiven Element ($C_{L1}$, L1)

~3160

# FIG 41J

FIG 41K

einem Verfahren zum Setzen (3260)
der zweiten Leitung (L2; $C_{L2}$) auf eine
vorbestimmte Spannung ($V_{PixRef}$)

— 3260

Koppeln eines Ausgangsknotens (3412)
eines ersten Ladungsgebers (3410) und/oder
eines Ausgangsknotens (3422) eines zweiten
Ladungsgebers (3420) mit der ersten Leitung (L1; $C_{L1}$)

— 3562

einem Verfahren zum Bestimmen (3160) einer
Ladungsmenge ($V_{pix}$) auf der ersten
Leitung (L1; $C_{L1}$)

— 3160

<u>3560</u>

# FIG 41L

FIG 42